# EUROPEAN PATENT APPLICATION

(11) **EP 2 180 031 A1**
(43) Date of publication of application: **28.04.2010**
(21) Application number: 08792015.3
(22) Date of filing: 31.07.2008
(51) Int. Cl.: C09K 11/59, C01B 21/082, C09K 11/64, H01L 33/00

(54) **PHOSPHOR AND METHOD FOR PRODUCING THE SAME, CRYSTALLINE SILICON NITRIDE AND METHOD FOR PRODUCING THE SAME, PHOSPHOR-CONTAINING COMPOSITION, LIGHT-EMITTING DEVICE USING THE PHOSPHOR, IMAGE DISPLAY DEVICE, AND ILLUMINATING DEVICE**

(30) Priority: 01.08.2007 JP 2007201238; 01.08.2007 JP 2007201239; 26.12.2007 JP 2007334882; 31.03.2008 JP 2008090396
(71) Applicant: Mitsubishi Chemical Corporation, Minato-ku Tokyo 108-0014 (JP)
(72) Inventor: SHIMOOKA, Satoshi, Yokohama-shi Kanagawa 227-8502 (JP); UEDA, Kyota, Yokohama-shi Kanagawa 227-8502 (JP); KIJIMA, Naoto, Yokohama-shi Kanagawa 227-8502 (JP); HASE, Takashi, Yokohama-shi Kanagawa 227-8502 (JP); SHIMOOKA, Chisato, Yokohama-shi Kanagawa 227-8502 (JP); WATANABE, Hiromu, Yokohama-shi Kanagawa 227-8502 (JP); KURUSHIMA, Tomoyuki, Yokohama-shi Kanagawa 227-8502 (JP)
(74) Representative: HOFFMANN EITLE
(86) International application number: PCT/JP2008/063802
(87) International publication number: WO 2009/017206

(57) **Abstract**

In order to improve quantum efficiency and/or durability of phosphors, a complex oxynitride phosphor is provided represented by the following formula, which can be obtained by firing a phosphor precursor in the presence of flux.

M¹ₓBa_{y}M²_{z}LᵤOᵥN_{w}

(In the formula, M¹ represents at least one kind of activation element selected from the group consisting of Mn, Ce, Pr, Nd, Sm, Eu, Tb, Dy, Ho, Er, Tm and Yb, M² represents at least one kind of bivalent metal element selected from the group consisting of Sr, Ca, Mg and Zn, L represents a metal element selected from the metal elements belonging to the fourth group or the fourteenth group of the periodic table, and 0.00001≤x≤3, 0≤y≤2.99999, 2.6≤x+y+z≤3, 0<u≤11, 6<v≤25, and 0<w≤17.)

## Description

### Technical Field

The present invention relates to a phosphor and a production method thereof, a crystalline silicon nitride and a production method thereof, a phosphor-containing composition comprising the phosphor, and also to a light emitting device, a display and a illuminating device using the phosphor. More particularly, it relates to a phosphor that emits green light when irradiated with light from an excitation light source such as a semiconductor luminous element, which serves as a first luminous body, and a production method thereof, a crystalline silicon nitride which can be used for producing the phosphor and a production method thereof, a phosphor-containing composition comprising the phosphor, and also to a high-efficiency light emitting device, an display and a illuminating device using the phosphor.

### Background Art

Though nitrides are inferior to oxides in stability and facilitation of production, not a few of them are known to have characteristics which oxides or other inorganic compounds do not have. Actually, such binary system nitrides as Si₃N₄, BN, AlN, GaN and TiN are used for various purposes such as substrate materials, semiconductors, light emitting diodes (hereinafter abbreviated as "LED(s)" as appropriate), structural ceramics and coating agents, and in industrial-scale production.

In addition, large numbers of new substances of ternary or higher nitrides are in production in these years. Among them, phosphor materials with superior characteristics, made of particularly multinary oxynitrides or nitrides based on silicon nitride, have been developed recently. It is known that these phosphor materials emit yellow to red light when excited by a blue LED or a near-ultraviolet LED. Such combinations of these phosphors and a blue or near-ultraviolet LED can constitute a light emitting device emitting white light.

White light, which is often used for illuminating devices and displays, is generally obtained by mixing blue, green and red light emissions in accordance with the additive mixing principle of light. For backlights of color liquid crystal displays, which are a field of uses of displays, it is preferable that each of blue, green and red luminous bodies has as high emission intensity as possible and good color purity, in order to reproduce colors having wide range of chromaticity coordinates efficiently. As an example of the indication of these characteristics, NTSC is known, which is a standard of color reproduction range of TV.

In these years, semiconductor light emitting devices have been tried to be used as light sources for these three colors of blue, green and red. However, when semiconductor light emitting devices are used for all of the three colors, a circuit for compensating a color shift is usually required. Therefore, it is practical to obtain desired three colors of blue, green and red by wavelength conversion of light which is emitted from a semiconductor luminous element using a wavelength conversion material such as a phosphor. Specifically, methods are known, in which blue, green and red lights are emitted using a near-ultraviolet semiconductor luminous element as the light source, and in which blue light from the semiconductor luminous element is used just as it is and green and red lights are obtained by wavelength conversion using phosphors.

Of the three colors of blue, green and red, green is particularly important compared to the other two colors because it is especially high in luminosity factor to human eyes and it greatly contributes to the brightness of the entire display. However, existing phosphors that emit green light are insufficient in conversion efficiency of blue or near-ultraviolet light and in color purity, and therefore development of a high-performance phosphor emitting green fluorescence (hereinafter referred to as "green phosphor" as appropriate) that can satisfy the above requirements has been desired.

Conventionally known arts of green phosphor include SrSi₂O₂N₂:Eu, GaSi₂ON₂:Eu and BaSi₂O₂N₂:Eu, which are shown in Patent Documents 1 and 2. These phosphors, having emission peak wavelengths of from 490 nm to 580 nm with respect to excitation light of 400-nm wavelength, show colors of blue green to yellow red. However, as is evident from the emission spectral maps of these phosphors shown in Patent Documents 1 and 2, their peak wavelengths are too short, or color purities of them are too low because of their broad full width at half maximums. Therefore, the color reproduction ranges of displays using these phosphors are narrow. In addition, the phosphors are low in brightnesses and thus they are insufficient for the above requirements.

In Patent Document 3, an oxynitride phosphor having luminescent color of blue green to yellow is disclosed. However, only the phosphors are disclosed in Patent Document 3 of which the compositions are the same as those described in the above known documents 1 and 2 or merely of which the metal element or silicon is substituted, and therefore they also have the same problems as described above.

Furthermore, in Patent Document 4, an Si-O-N based phosphor containing Al is disclosed. However, the phosphor disclosed in Patent Document 4 is also low in color purity because of its broad full width at half maximum of the emission spectrum. Therefore, it is still insufficient for the above-mentioned requirements.
On the other hand, in Non-Patent Document 1, synthesis methods of Ba₃Si₆O₉N₄ and Eu₃Si₆O₉N₄ as well as their X-ray structural analysis results are disclosed. However, none of these oxynitrides does not emit fluorescence.
Under such circumstances, the present inventors have found a phosphor with a new crystal structure (see Patent Document 5).
Furthermore, arts disclosed in Patent Documents 6 to 14 and Non-Patent Documents 2 and 3 are also known.

Patent Document 1: Japanese Patent Laid-Open Publication (Translation of PCT Application) No. 2005-530917
Patent Document 2: Japanese Patent Laid-Open Publication (Translation of PCT Application) No. 2006-503431
Patent Document 3: The pamphlet of International Publication No. 2004-039915
Patent Document 4: Japanese Patent Laid-Open Publication (Translation of PCT Application) No. 2005-529229
Patent Document 5: The pamphlet of International Publication No. 2007-088966
Patent Document 6: Japanese Patent Laid-Open Publication (Kokai) No. 2006-8721
Patent Document 7: Japanese Patent Laid-Open Publication (Kokai) No. 2006-8948
Patent Document 8: Japanese Patent Laid-Open Publication (Translation of PCT Application) No. 2005-530917
Patent Document 9: granted Japanese Patent Publication No. 3826131
Patent Document 10: Japanese Patent Laid-Open Publication (Kokai) No. 2005-255895
Patent Document 11: Japanese Patent Laid-Open Publication (Translation of PCT Application) No. 2003-515665
Patent Document 12: Japanese Patent Laid-Open Publication (Kokai) No. 2000-212475
Patent Document 13: Japanese Patent Laird-Open Publication (Kokai) No. 2005-97462
Patent Document 14: Japanese Patent Laid-Open Publication (Kokai) No. 2000-229809
Non-Patent Document 1: Z. Anorg. Allg. Chem., 2006, vol. 632, pp. 949-954
Non-Patent Document 2: a table on fine ceramics materials properties on Internet website of KYOCERA corporation, searched on July 18th, 2008, URL: http://www.kyocera.co.jp/prdct/fc/product/pdf/materia 1.pdf
Non-Patent Document 3: "Products" on Internet website of JAPAN FINE CERAMICS CO., LTD., product introduction searched on July 18th, 2008, URL: http://www.japan-fc.co.jp/products/pro_9.html

### Disclosure of the Invention

### Problem to Be Solved by the Invention

It is preferable that green luminous bodies for illuminating devices or displays have an emission peak wavelength around 525 nm and are high in the emission efficiency. In addition, it is preferable for them to be low in decrease in the emission efficiency accompanying temperature rising of the light emitting device and also in color shift. However, existing green phosphors are insufficient either in conversion efficiency of blue or near-ultraviolet light or in color purity. Therefore, a green phosphor having high performances and satisfying the above requirements has been desired.
In addition, since displays and illuminating devices with less color shift and long lasting quality have been desired more greatly, a way to enhance durability of phosphors is also demanded.

The present invention has been made in view of the above-mentioned problems. Namely, the object thereof is to provide a new phosphor that can emit green light and a production method thereof, a crystalline silicon nitride which can be used for producing the phosphor and a production method thereof, and also a phosphor-containing composition, a light emitting device, a display and a illuminating device using the phosphor.

### Means for Solving the Problem

The present inventors have found a previously-unknown, completely new oxynitride, and have succeeded in production of a new phosphor by adding a luminescent center element to that oxynitride, which serves as the host material. In addition, they have succeeded also in improvement of brightness, quantum efficiency, and durability of phosphors by investigating various appropriate manufacturing conditions.
Furthermore, as described in Patent Documents 6 to 14 and Non-Patent Documents 2 and 3, silicon nitrides are not only important as materials of nitride phosphors but are used as materials of engineering ceramics, heat shields, and cosmetics. The present inventors have also investigated them and found a silicon nitride having a specific new physicochemical property. In consequence, they have also found that a phosphor with higher brightness than previously can be produced by using that silicon nitride. These findings have led to the completion of the present invention.

Namely, the subject matter of the present invention lies in an oxynitride phosphor represented by the formula [I] which is produced by firing a phosphor precursor in the presence of a flux (claim 1).

MⁱₓBa_{y}M²_{z}LᵤOᵥN_{w} [I]

(In the above formula [I],
M¹ represents at least one kind of activation element selected from the group consisting of Mn, Ce, Pr, Nd, Sm, Eu, Tb, Dy, Ho, Er, Tm and Yb,
M² represents at least one kind of bivalent metal element selected from the group consisting of Sr, Ca, Mg and Zn,
L represents a metal element selected from the metal elements belonging to the fourth group or the fourteenth group of the periodic table, and
x, y, z, u, v and w are the numeric values in the following ranges:
   0.00001≤x≤3
   0≤y≤2.99999
   2.6≤x+y+z≤3
   0<u≤11
   6<v≤25
   0<w≤17.)

In the above formula [I], it is preferable that u, v and w satisfy 5≤u≤7, 9<v<15 and 0<w<4, respectively (claim 2).
Further, in the above formula [I], it is preferable that x satisfies 0.03≤x≤1.5 (claim 3).
Further, in the above formula [I], it is preferable that z satisfies 0≤z≤1.5 (claim 4).
Further, in the above formula [I], it is preferable that M¹ contains at least Eu and Pr (claim 5).

Further, it is preferable that, in the oxynitride phosphor of the present invention, change in the color coordinate CIEy based on JIS Z 8701 of the phosphor that is dispersed in a silicone resin at a concentration of 6 weight %, measured after an energization with a current density of 255 mA/mm² and a light output of 0.25 to 0.35 W/mm² for 500 hr at a temperature of 85°C and relative humidity of 85%, is within the range of ± 30% of the color coordinate CIEy based on JIS Z 8701 of the same phosphor measured before the energization (claim 6).

Further, in the oxynitride phosphor of the present invention, it is preferable that silicon nitride present in the phosphor precursor has a crystal phase and the silicon nitride is a crystalline silicon nitride having a reflectance of 85% or larger when irradiated with light of 525-nm wavelength (claim 7).

Another subject matter of the present invention lies in an oxynitride phosphor represented by the above formula [I] of which the non-luminous object color represented by the L*a*b* colorimetric system satisfies any one of L* value is 97 or larger, a* value is -21 or smaller, and b* value is 35 or larger (claim 8).

Still another subject matter of the present invention lies in an oxynitride phosphor represented by the above formula [I] of which the external quantum efficiency is 0.35 or larger (claim 9).

Still another subject matter of the present invention lies in a production method of an oxynitride phosphor of the present invention comprising steps of: a fusing process in which the phosphor precursor is fused; and a cooling process in which phosphor crystal is obtained by cooling the fused phosphor precursor (claim 10).

Still another subject matter of the present invention lies in a production method of an oxynitride phosphor of the present invention comprising steps of: a first firing process in which the phosphor precursor is fired; a washing process in which washing is performed after the first firing process; and a second firing process in which firing is performed after the washing process (claim 11).

Still another subject matter of the present invention lies in an oxynitride phosphor produced through a reheating process performed after a process in which a phosphor precursor is fired in the presence of a flux (claim 12). In this case, it is preferable that the oxynitride phosphor is a phosphor selected from the group consisting of nitrido-silicate, nitride-aluminosilicate, oxonitrido-silicate, oxonitrido-aluminosilicate, and carbonitrido-aluminosilicate (claim 13).

Still another subject matter of the present invention lies in a production method of an oxynitride phosphor comprising a step of a reheating process after a process in which a phosphor precursor is fired in the presence of a flux (claim 14).

Still another subject matter of the present invention lies in a crystalline silicon nitride having a crystal phase and a reflectance of 85% or larger when irradiated with light of 525-nm wavelength (claim 15).
In this case, it is preferable that the impurity carbon amount of the crystalline silicon nitride of the present invention is 0.06 weight % or smaller (claim 16).
Further, it is preferable that the crystal phase of the crystalline silicon nitride of the present invention is a β type (claim 17).

Still another subject matter of the present invention lies in a production method of an crystalline silicon nitride comprising a step of heat treatment of silicon nitride under an atmosphere containing nitrogen gas in which N₂ partial pressure is 0.4 MPa or higher at a temperature of 1500°C or higher (claim 18).
In this case, it is preferable that the silicon nitride is preliminarily subjected to a heat treatment under an atmosphere containing oxygen gas in which O₂ partial pressure is 0.01 MPa or higher at a temperature of 800°C to 1300°C (claim 19).
Further, it is also preferable that the heat treatment is performed in the presence of SiO₂ (claim 20).

Still another subject matter of the present invention lies in a phosphor produced by using, as its raw material, a crystalline silicon nitride of the present invention (claim 21). In this case, it is preferable that the phosphor is a phosphor selected from the group consisting of nitrido-silicate, nitrido-aluminosilicate, oxonitrido-silicate, oxonitrido-aluminosilicate, and carbonitrido-aluminosilicate (claim 22).

Still another subject matter of the present invention lies in a phosphor represented by the formula [II] below of which the non-luminous object color represented by the L*a*b* colorimetric system satisfies any one of L* value is 103 or larger, a* value is -23 or smaller, and b* value is 63 or larger (claim 23).

M³ₑ(Ga,Sr,Ba)₁₋ₑSi₂O₂N₂ [II]

(In the above formula [II],
M³ represents an activation element and
e represents a positive number satisfying 0<e≤0.2.)

In this case, it is preferable that the above phosphor is a phosphor represented by the formula [II'] below of which the emission-peak wavelength is 550 nm to 570 nm and the L* value is 100 or larger and b* value is 77 or larger (claim 24). M³ₑ(Sr,Ba)₁₋ₑSi₂O₂N₂ [II']
(In the above formula [II'],
M³ represents an activation element and
e represents a positive number satisfying 0<e≤0.2.)

Still another subject matter of the present invention lies in a phosphor represented by the above formula [II] of which the external quantum efficiency is 0.57 or larger (claim 25).

Still another subject matter of the present invention lies in a phosphor-containing composition comprising: the above-mentioned phosphor and a liquid medium (claim 26).

Still another subject matter of the present invention lies in a light emitting device comprising: a first luminous body and a second luminous body which emits visible light when irradiated with light from the first luminous body, wherein the second luminous body comprises, as a first phosphor, at least one kind of the above-mentioned phosphor (claim 27).
In this case, it is preferable that the second luminous body comprises, as a second phosphor, one or more kinds of phosphors of which emission-peak wavelength is different from that of the first phosphor (claim 28).

Still another subject matter of the present invention lies in an illuminating device comprising a light emitting device of the present invention (claim 29).

Still another subject matter of the present invention lies in a display comprising a light emitting device of the present invention (claim 30).

### Advantageous effect of the invention

According to the present invention, a new phosphor that can emit green light and a production method thereof, a crystalline silicon nitride which can be used for producing the phosphor and a production method thereof, and also a phosphor-containing composition, a light emitting device, a display and a illuminating device using the phosphor can be provided.

### Brief Description of the Drawings

[Fig. 1] Fig. 1 is a schematic perspective view illustrating the positional relationship between the excitation light source (first luminous body) and the phosphor-containing part (second luminous body) in an example of the light emitting device of the present invention.
[Fig. 2] Both Fig. 2(a) and Fig. 2(b) are schematic sectional views illustrating an example of the light emitting device comprising an excitation light source (first luminous body) and a phosphor-containing part (second luminous body).
[Fig. 3] Fig. 3 is a sectional view schematically illustrating an embodiment of the illuminating device of the present invention.
[Fig. 4] Figs. 4 are graphs showing emission spectral maps of the phosphors of Examples I-I to I-4 and Comparative Example I-1 in Example group I of the present invention. Fig. 4(a) shows emission spectra under excitation by light of 405-nm wavelength. Fig. 4(b) shows emission spectra under excitation by light of 455-nm wavelength.
[Fig. 5] Fig. 5 is a graph illustrating X-ray diffraction patterns of the phosphors of Examples I-6, I-12 and I-19 in Example group I of the present invention.
[Fig. 6] Fig. 6 is a graph illustrating excitation spectra of the phosphors of Examples I-6, 1-9, I-12, I-14, 1-17 and I-19 in Example group I of the present invention.
[Fig. 7] Figs. 7 are graphs showing emission spectral maps of the phosphors of Examples I-6, I-9, I-12, I-14, I-17 and I-19 in Example group I of the present invention. Fig. 7(a) shows emission spectra under excitation by light of 405-nm wavelength. Fig. 7(b) shows emission spectra under excitation by light of 455-nm wavelength.
[Fig. 8] Fig. 8 is a graph illustrating the X-ray diffraction patterns of the phosphors of Examples I-6, I-26 and I-28 in Example group I of the present invention.
[Fig. 9] Fig. 9 is a graph illustrating the X-ray diffraction patterns of the phosphors of Examples I-12, I-35 and I-37 in Example group I of the present invention.
[Fig. 10] Figs. 10 are graphs showing emission spectral maps of the phosphors of Examples I-22, I-24, I-26 and I-28 in Example group I of the present invention. Fig. 10(a) shows emission spectra under excitation by light of 405-nm wavelength. Fig. 10(b) shows emission spectra under excitation by light of 455-nm wavelength.
[Fig. 11] Figs. 11 are graphs showing emission spectral maps of the phosphors of Examples I-31, I-33, I-35 and I-37 in Example group I of the present invention. Fig. 11(a) shows emission spectra under excitation by light of 405-nm wavelength. Fig. 11(b) shows emission spectra under excitation by light of 455-nm wavelength.
[Fig. 12] Figs. 12 are photos taken with an SEM, which substitute for drawings, of the phosphor obtained in Example I-3 in Example group I of the present invention. Fig. 12(a) is taken at 3000-fold magnification. Fig. 12(b) is taken at 1000-fold magnification.
[Fig. 13] Fig. 13 is a photo taken with an SEM at 2000-fold magnification, which substitutes for a drawing, of the phosphor obtained in Example 1-43 in Example group I of the present invention.
[Fig. 14] Fig. 14 is a graph illustrating changes in persistence characteristic of the phosphor of Reference Example 1 of the present invention, for excitation-light irradiation times of 5 min, 10 min, and 20 min.
[Fig. 15] Fig. 15 is a graph illustrating a powder X-ray diffraction pattern of the phosphor prepared in Example I-57 of Example group I of the present invention.
[Fig. 16] Fig. 16 is a graph showing an emission spectral map of the phosphor prepared in Example I-57 in Example group I of the present invention under excitation by light of 400-nm wavelength.
[Fig. 17] Fig. 17 is a graph illustrating results of persistence characteristics evaluations of the phosphors prepared in Examples I-57 to I-59 in Example group I of the present invention.
[Fig. 18] Fig. 18 is a graph illustrating results of LED durability tests of the phosphors prepared in Examples I-57 to I-59 in Example group I of the present invention.
[Fig. 19] Fig. 19 is a graph illustrating a powder X-ray diffraction pattern of the phosphor prepared in Example 1-58 of Example group I of the present invention.
[Fig. 20] Fig. 20 is a graph illustrating a powder X-ray diffraction pattern of the phosphor prepared in Example I-59 of Example group I of the present invention.
[Fig. 21] Fig. 21 is a graph illustrating a powder X-ray diffraction pattern of the phosphor prepared in Example I-60 of Example group I of the present invention.
[Fig. 22] Fig. 22 is a graph illustrating results of persistence characteristics evaluations of the phosphors prepared in Examples 1-58, I-60 to 1-62 in Example group I of the present invention.
[Fig. 23] Fig. 23 is a graph showing emission spectral maps of the phosphors prepared in Examples I-60 to I-62 in Example group I of the present invention under excitation by light of 455-nm wavelength.
[Fig. 24] Fig. 24 is a graph illustrating a powder X-ray diffraction pattern of the phosphor prepared in Example I-61 of Example group I of the present invention.
[Fig. 25] Fig. 25 is a graph illustrating a powder X-ray diffraction pattern of the phosphor prepared in Example I-62 of Example group I of the present invention.
[Fig. 26] Fig. 26 is a graph illustrating results of LED durability tests of the phosphors prepared in Examples I-58 and I-62 in Example group I of the present invention.
[Fig. 27] Fig. 27 is a graph illustrating an excitation spectrum of the phosphor prepared in Example 1-62 of Example group I of the present invention.
[Fig. 28] Fig. 28 is a graph of reflection spectrum map of the silicon nitrides obtained in Examples II-1 to II-6 of Example group II of the present invention.
[Fig. 29] Fig. 29 is a graph illustrating X-ray diffraction patterns of the silicon nitrides obtained in Examples II-1 to II-6 of Example group II of the present invention.
[Fig. 30] Fig. 30 is a graph of reflection spectrum maps of the material silicon nitrides used in Comparative Examples II-24 to II-31 of Example group II of the present invention.
[Fig. 31] Fig. 31 is a graph illustrating X-ray diffraction patterns of the phosphors prepared in Examples II-7 to II-9 and Comparative Examples II-24 to II-31 of Example group II of the present invention.
[Fig. 32] Fig. 32 is a graph of emission spectral maps of the phosphors obtained in Examples II-7 to II-9 and Comparative Examples II-24 to II-31 of Example group II of the present invention under excitation by light of 455-nm wavelength.
[Fig. 33] Fig. 33 is a graph illustrating X-ray diffraction patterns of the phosphors prepared in Example II-10 and Comparative Example II-32 of Example group II of the present invention.
[Fig. 34] Fig. 34 is a graph of emission spectral maps of the phosphors obtained in Example II-10 and Comparative Example II-32 of Example group II of the present invention under excitation by light of 455-nm wavelength.
[Fig. 35] Fig. 35 is a graph illustrating X-ray diffraction patterns of the phosphors prepared in Examples II-13 to II-20 of Example group II of the present invention.
[Fig. 36] Fig. 36 is a graph illustrating X-ray diffraction patterns of the phosphors prepared in Comparative Examples II-35 to II-39 of Example group II of the present invention.
[Fig. 37] Fig. 37 is a graph of emission spectral maps of the phosphors obtained in Examples II-13 to II-15, II-17, and II-19 of Example group II of the present invention under excitation by light of 455-nm wavelength.
[Fig. 38] Fig. 38 is a graph of emission spectral maps of the phosphors obtained in Example II-21 and Comparative Examples II-40 to II-41 of Example group II of the present invention under excitation by light of 455-nm wavelength.
[Fig. 39] Fig. 39 is a graph of emission spectral maps of the phosphors obtained in Examples II-21 and II-22 of Example group II of the present invention under excitation by light of 455-nm wavelength.
[Fig. 40] Fig. 40 is a graph of emission spectral maps of the phosphors obtained in Examples II-21, and II-23 to II-25 of Example group II of the present invention under excitation by light of 455-nm wavelength.
[Fig. 41] Fig. 41 is a graph of emission spectral maps of the phosphors obtained in Example II-26 and Comparative Examples II-42 to II-43 of Example group II of the present invention under excitation by light of 455-nm wavelength.
[Fig. 42] Fig. 42 is a graph of emission spectral maps of the phosphors obtained in Example II-27 and Comparative Example II-44 of Example group II of the present invention under excitation by light of 455-nm wavelength.
[Fig. 43] Fig. 43 is a photo, which substitutes for a drawing, of the silicon nitride obtained in Example II-28 of Example group II of the present invention, taken with a scanning electron microscope.
[Fig. 44] Fig. 44 is a photo, which substitutes for a drawing, of the silicon nitride obtained in Example II-29 of Example group II of the present invention, taken with a scanning electron microscope.
[Fig. 45] Fig. 45 is a photo, which substitutes for a drawing, of the silicon nitride obtained in Example II-30 of Example group II of the present invention, taken with a scanning electron microscope.
[Fig. 46] Fig. 46 is a photo, which substitutes for a drawing, of the silicon nitride obtained in Example II-31 of Example group II of the present invention, taken with a scanning electron microscope.
[Fig. 47] Fig. 47 is a graph illustrating relationships between the driven times (hr) and the CIEy retention rates (%) of Examples III-3 to III-7 of Example group III of the present invention.
[Fig. 48] Fig. 48 is a graph illustrating a powder X-ray diffraction pattern of the phosphor prepared in Example III-14 of Example group III of the present invention.
[Fig. 49] Fig. 49 is a graph illustrating a result of LED durability test of the phosphor prepared in Example III-14 of Example group III of the present invention.
[Fig. 50] Fig. 50 is a graph illustrating a result of persistence characteristic evaluation of the phosphor prepared in Example III-14 of Example group III of the present invention.
[Fig. 51] Figs. 51 are graphs illustrating evaluation results of the phosphor prepared in Examples III-15 to III-17 of Example group III of the present invention. Fig. 51(a) is a graph illustrating the durabilities. Fig. 51(b) is a graph illustrating the persistence characteristics. Fig. 51(c) is a graph illustrating evaluation results of the thermoluminescences.
[Fig. 52] Figs. 52 are graphs illustrating evaluation results of the phosphor prepared in Examples III-15 to III-17 of Example group III of the present invention. Fig. 52(a) is a graph illustrating the emission spectra of the phosphors prepared in Examples III-15 to III-17. Fig. 52(b) is a graph illustrating the excitation spectra of the phosphors prepared in Examples III-15 to III-17. Fig. 52(c) is a graph illustrating temperature characteristics of the phosphors prepared in Examples III-15 to III-17.
[Fig. 53] Figs. 53 are graphs illustrating evaluation results of the phosphor prepared in Comparative Example III-1 and Examples III-18 to III-19 of Example group III of the present invention.
Figs. 53(a) and 53(b) are graphs illustrating the results of LED durability tests. Fig. 53(c) is a graph illustrating the results of persistence characteristics evaluations.

### Explanation of Letters or Numerals

1: second luminous body
2: surface-emitting type GaN-based LD (first luminous body)
3: substrate
4: light emitting device
5: mount lead
6: inner lead
7: first luminous body
8: phosphor-containing resinous part
9: conductive wire
10: mold member
11: surface-emitting illuminating device
12: holding case
13: light emitting device
14: diffusion plate
22: first luminous body
23: phosphor-containing resinous part (second luminous body)
24: frame
25: conductive wire
26, 27: electrode

### Best Modes for Carrying Out the Invention

An embodiment of the present invention will be explained in detail below. It is to be understood that the present invention is not limited to the following embodiment and any modification can be added thereto insofar as they do not depart from the scope of the present invention.
All the relationships between color names and their color coordinates in the present description comply with the Japanese Industrial Standards (JIS Z8110 and Z8701).

Each composition formula of the phosphors in this description is punctuated by a comma (,). Further, when two or more elements are juxtaposed with a comma (,) in between, one kind of or two or more kinds of the juxtaposed elements can be contained in the composition formula in any combination and in any composition. For example, a composition formula, "(Ca,Sr,Ba)Al₂O₄:Eu", inclusively indicates all of "CaAl₂O₄:Eu", "SrAl₂O₄:Eu", "BaAl₂O₄:Eu", "Ca₁₋ₓSrₓAl₂O₄:Eu", "Sr_{1- x}BaₓAl₂O₄:Eu", "Ca₁₋ₓBaₓAl₂O₄:Eu" and "Ca_{1-x-y}SrₓBa_{y}Al₂O₄:Eu" (here, in these formulae, 0<x<1, 0<y<1, 0<x+y<1).

### [1. Composition of oxynitride phosphor]

The oxynitride phosphor of the present invention (hereinafter referred to as "phosphor of the present invention" as appropriate) is a complex oxynitride phosphor having a composition range represented by the following general formula [I].

M¹xBa_{y}M²_{z}LᵤOᵥN_{w} [I]

(In the above formula [I], M¹ represents at least one kind of activation element selected from the group consisting of Mn, Ce, Pr, Nd, Sm, Eu, Tb, Dy, Ho, Er, Tm and Yb, M² represents at least one kind of bivalent metal element selected from the group consisting of Sr, Ca, Mg and Zn, L represents a metal element selected from the metal elements belonging to the fourth group or the fourteenth group of the periodic table, and x, y, z, u, v and w are the numeric values in the following ranges:
0.00001≤x≤3
0≤y≤2.99999
2.6≤x+y+z≤3
0<u≤11
6<v≤25
0<w≤17.)

In the above general formula [I], M¹ represents an activation element. The examples of M¹ include at least one kind of transition metal element or rare-earth element selected from the group consisting of Mn, Ce, Pr, Nd, Sm, Eu, Tb, Dy, Ho, Er, Tm and Yb. Of these, rare-earth elements of Eu, Ce, Sm, Tm and Yb are preferable. Among them, it is preferable that the M¹ includes at least Eu or Ce from the standpoint of higher luminescent quantum efficiency. It is more preferable that the M¹ contains at least Eu for an appropriate emission-peak wavelength, and especially preferably, it contains Eu only.

The M¹ may contain either just one kind of these elements or two or more kinds of them in any combination and in any ratio. When two or more kinds of elements are used as the M¹, the M¹ preferably contains at least Eu and Pr. In such a case, the ratio of the Pr to the Eu in M¹ is usually 0.01 mole percent or higher, preferably 0.1 mole percent or higher, more preferably 1 mole percent or higher, and usually 50 mole percent or lower, preferably 30 mole percent or lower, more preferably 10 mole percent or lower. When the ratio of Pr is both too low or too high, the persistence period tends to be longer.

Explanation will be given below on an advantage of short persistence period. Some phosphors emit phosphorescence. In such a case, the phosphor usually emits both fluorescence and phosphorescence. Phosphorescence has a characteristic that it is emitted relatively longer than fluorescence even after the irradiation of the excitation light on the phosphor is quitted. Such a phenomenon in which light is emitted from a phosphor still after excitation light irradiation is stopped is called persistence.

The above-mentioned "short persistence period" specifically indicates that 1/1000 persistence period is usually 160seconds or shorter, preferably 140seconds or shorter, more preferably 120seconds or shorter, particularly preferably 100seconds or shorter. In this case, the persistence characteristic is measured under conditions of time constant 2seconds and measurement interval 0.2seconds after irradiation of light having 254-nm wavelength (excitation light) at a temperature of 25°C and a humidity of 10∼70% sufficiently long for keeping the 1/1000 persistence period constant. A phosphor having short 1/1000 persistence period tends to have a crystal phase with such less lattice defects that it is a single phase or very close to a single phase (namely, crystal-phase state where all or almost of crystal phases are the same). When a phosphor has such kind of crystal phase, it can show high durability. On the other hand, the shorter the lower limit of the 1/1000 persistence period is, the more preferable, because phosphorescence is usually due to lattice defects. The lower limit is usually 1 × 10⁻⁶ seconds or longer, more ideally 1 × 10⁻⁹ seconds or longer.

In this context, 1/1000 persistence period indicates time required for decrease in the intensity of light (emission) from a phosphor to 1/1000 of that at the end of excitation-light irradiation.
Persistence period generally tends to be prolonged as the irradiation intensity of the excitation light gets stronger and the irradiation time thereof gets longer. However, when the irradiation intensity and irradiation time of the excitation light exceeds a threshold value, the persistence period is not prolonged any more, namely, it remains constant. In the measurement of 1/1000 persistence period according to the present invention, the 1/1000 persistence period is measured after irradiation of excitation light that is long enough to keep the 1/1000 persistence period constant even with the stronger irradiation intensity or longer irradiation time of the excitation light, making use of the above-mentioned property.

There is no special limitation on the method of decreasing the 1/1000 persistence period insofar as it is a method which can decrease lattice defects in phosphor crystal. Examples thereof include: enhancing the purity of phosphor materials (also referred to as material compounds), optimizations of mixing ratio and firing conditions of the phosphor materials, and improvement of crystallinity by a reheating process. However, the method for decreasing the 1/1000 persistence period is not limited to those exemplified above, and the advantageous effects mentioned before can be achieved even when decreasing the 1/1000 persistence period of the phosphor by other means.

The activation element M¹ is present in the phosphor of the present invention in a state of bivalent and/or trivalent cation. At this point, it is preferable that the content of bivalent cations is higher in the activation element M¹. For example when M¹ is Eu, the content of Eu²⁺ relative to the whole amount of Eu is usually 20 mole percent or more, preferably 50 mole percent or more, more preferably 80 mole percent, and particularly preferably 90 mole percent or more.

The content of Eu²⁺ relative to the whole amount of Eu contained in the phosphor of the present invention can be examined by an X-ray absorption fine structure measurement, for example. Namely, the content can be decided quantitatively from the areas of each-separated absorption peaks of Eu²⁺ and Eu³⁺, which can be obtained by a measurement of the L3-absorption edge of the Eu atom. The content of Eu²⁺ relative to the whole amount of Eu contained in the phosphor of the present invention can be decided also by an electron spin resonance (ESR) measurement.

In the above general formula [I], x is a numeric value in the range of 0.00001 or larger and 3 or smaller. Particularly, x is preferably 0.03 or larger, more preferably 0.06 or larger, much more preferably 0.12 or larger, still much more preferably 0.18 or larger, and particularly preferably 0.27 or larger. On the other hand, when the content ratio of the activation element M¹ is too large, a concentration quenching may occur. Therefore, it is preferably 1.5 or less, more preferably 1.2 or less, much more preferably 0.9 or less, still much more preferably 0.7 or less, and particularly preferably 0.45 or less.

In the above general formula [I], M² is an element that can substitute for Ba site. Specifically, it represents at least one kind of bivalent metal element selected from the group consisting of Sr, Ca, Mg and Zn. At this point, M² is preferably Sr, Ca and/or Zn, more preferably Sr and/or Ca, and further preferably Sr. Furthermore, a part of Ba and M² can be further substituted with these elements.
The above M² can include any one kind of these elements singly or two or more kinds of them together in any combination and in any ratio.

When the M² contains Ca, the content of Ca relative to the total amount of Ba and Ca is preferably 50 mole percent or less, more preferably 40 mole percent or less, still more preferably 30 mole percent or less. When the Ca amount is larger than the above range, the luminous wavelength may be longer and the emission intensity may decrease.
When the M² contains Sr, the content of Sr relative to the total amount of Ba and Sr is preferably 70 mole percent or less, more preferably 60 mole percent or less, still more preferably 50 mole percent or less. When the Sr amount is larger than the above range, the luminous wavelength may be longer and the emission intensity may decrease.
When the M² contains Zn, the content of Zn relative to the total amount of Ba and Zn is preferably 60 mole percent or less, more preferably 50 mole percent or less, still more preferably 40 mole percent or less. When the Zn amount is larger than the above range, the luminous wavelength may be longer and the emission intensity may decrease.
When the M² contains Mg, the content of Mg relative to the total amount of Ba and Mg is preferably 30 mole percent or less, more preferably 20 mole percent or less, still more preferably 10 mole percent or less. When the Mg amount is larger than the above range, the luminous wavelength may be longer and the emission intensity may decrease.

Therefore, in the above general formula [I], the amount of z can be decided in accordance with the kind of the substantive metal element M² and the value of y. The specific value of z is usually 0 or larger, and preferably 1.5 or smaller, more preferably 1.2 or smaller, much more preferably 0.9 or smaller, still much more preferably 0.6 or smaller, especially preferably 0.4 or smaller.

In the above general formula [I], y is a numeric value in the range of usually 0 or larger and usually 2.99999 or smaller. It is preferable that the phosphor of the present invention contains Ba from the standpoint of stability in its crystal structure. Therefore, in the above general formula [I], y is preferably larger than 0, more preferably 0.9 or larger, particularly preferably 1.2 or larger. In addition, in view of the relationship to the content of the activator element, it is preferably smaller than 2.99999, more preferably 2.99 or smaller, still more preferably 2.98 or smaller, and particularly preferably 2.95 or smaller.

In the phosphor of the present invention, Ba or M² element may be deficient, as well as the oxygen or nitrogen. Therefore, in the above general formula [I], the value x+y+z may be less than 3. Therefore, the x+y+z can usually take the value of 2.6 or larger and 3 or smaller, but ideally, x+y+z = 3. When the x+y+z is smaller than 2.6, there is a high probability that the crystal structure can not be maintained.

In the above general formula [I], L represents at least one kind of metal element selected from the metal elements belonging to the fourth group of the periodic table, such as Ti, Zr and HF, or the fourteenth group of the periodic table, such as Si and Ge. Of these, L is preferably Ti, Zr, Hf, Si or Ge, more preferably Si or Ge, and particularly preferably Si.
L can include any one kind of these metal elements singly or two or more kinds of them together in any combination and in any ratio.

At this point, in a part of the L can be mixed metal element that can be trivalent cation such as B, Al and Ga, insofar as the performance of the phosphor will not be affected in terms of the electric charge balance of the phosphor crystal. The mixing amount is usually 10 atomic percent or smaller and preferably 5 atomic percent or smaller, relative to the amount of L.

In the above general formula [I], u is a numeric value of usually 11 or smaller, preferably 9 or smaller, more preferably 7 or smaller, and usually larger than 0, preferably 3 or larger, more preferably 5 or larger.

The amounts of O ion and N ion are represented by numeric values v and w respectively in the general formula [I]. Specifically, in the above general formula [I], v is a numeric value of usually larger than 6, preferably larger than 7, more preferably larger than 8, still more preferably larger than 9, particularly preferably larger than 11, and usually 25 or smaller, preferably smaller than 20, more preferably smaller than 15, still more preferably smaller than 13.

N is an essential component in the phosphor of the present invention, which is an oxynitride. Therefore, in the above general formula [I], w is a numeric value of larger than 0, and usually 17 or smaller, preferably smaller than 10, more preferably smaller than 4, and still more preferably smaller than 2.4.

Therefore, from the above-mentioned standpoint, it is preferable that u, v and w satisfy 5≤u≤7, 9<v<15 and 0<w<4 respectively, and particularly preferable that they satisfy 5≤u≤7, 11<v<13 and 0<w<2.4 respectively, in the above general formula [I]. Thereby, the emission intensity can be enhanced.

At this point, in a part of the above-mentioned O site and N site can be mixed element that can be univalent or bivalent anion such as S or halogen atoms, insofar as the performance of the phosphor will not be affected in terms of the electric charge balance of the phosphor crystal. The mixing amount is usually 10 atomic percent or smaller and preferably 5 atomic percent or smaller relative to the total amount of O and N. Particularly, halogen elements may be mixed as flux used at the time of production, in addition to as impurities in the raw materials. In such cases, the halogen atom is contained in the phosphor usually at 1 ppm or higher. The upper limit of its content is usually 1000 ppm or lower, preferably 500 ppm or lower, more preferably 300 ppm or lower, though it depends on the method of washing the phosphor after a firing.

In the phosphor of the present invention, it is preferable that the ratio of the oxygen atoms to the metal elements such as (M¹+Ba+M²) and L is larger than that of the nitrogen atoms. Therefore, the ratio (N/O) of the nitrogen atoms to the oxygen atoms is preferably 70 mole percent or smaller, more preferably 50 mole percent or smaller, much more preferably 30 mole percent or smaller, and still much more preferably less than 20 mole percent. The lower limit thereof is usually larger than 0 mole percent, preferably 5 mole percent or larger, and more preferably 10 mole percent or larger.

Incidentally, the phosphor represented by the formula [I] includes a phosphor represented by the following general formula [I'] in which a part of Ba and L are substituted with Ln and Al respectively.

M¹ₓ(Ba,Ln)ₐ(L,Al)_{b}O_{c}N_{d} [I']

(In the formula [I'], M¹ represents at least one kind of activation element selected from the group consisting of Mn, Ce, Pr, Nd, Sm, Eu, Tb, Dy, Ho, Er, Tm and Yb. Ln represents one or more kinds of elements selected from the group consisting of La, Ce, Pr, Nd, Y and Gd. L represents a metal element selected from the metal elements belonging to the fourth group or the fourteenth group of the periodic table, and at least a part of L is Si element. χ, a, b, c and d represent numeric values in the ranges of 0.00001≤χ≤0.4, 2.6≤a≤2.99999, 5≤b≤7, 11<c<13, and 0<d<2.4 respectively.)

In the formula [I'], M¹ and L are similar to those of the formula [I]. Regarding L, the content of Al relative to the total amount of L and Al is usually 20 mole percent or lower, preferably 15 mole percent or lower, more preferably 10 mole percent or lower, still more preferably 5 mole percent or lower, and usually larger than 0 mole percent.

In the formula [I'], Ln represents one or more kinds of elements selected from the group consisting of La, Ce, Pr, Nd, Y and Gd. Ln may contain either just one kind of these elements or two or more kinds of them in any combination and in any ratio.
Particularly, it preferably contains one or more kinds of elements selected from the group consisting of at least La, Y and Gd, and more preferably, it contains Y.

The sum of La, Y and Gd amounts in the total amount of Ln accounts for usually 50 mole percent or more, preferably 80 mole percent or more, more preferably 90 mole percent or more, still more preferably 95 mole percent or more.
In the above formula [I'], the content of Ln relative to the total amount of Ba and Ln is usually 20 mole percent or lower, preferably 15 mole percent or lower, more preferably 10 mole percent or lower, still more preferably 5 mole percent or lower, and usually larger than 0 mole percent.

In the formula [I'], χ is a numerical value in the range of 0.00001≤χ≤0.4, a is a numerical value in the range of 2.6≤a≤2.99999, b is a numerical value in the range of 5≤b≤7, c is a numerical value in the range of 11<c<13, and d is a numerical value in the range of 0<d<2.4.

The phosphor represented by the above formula [I'] can be usually obtained as a solid solution of a phosphor represented by the formula [I] and a langasite.
In this context, the langasite means La₃Si₃Al₃O₁₂N_{2.}

Concerning the solid solubility ratio between the phosphor represented by the formula [I] and the langasite, in the case of forming a phosphor represented by the above formula [I'] as a solid solution described above, the molar ratio of the langasite, relative to the total number of moles of the phosphor represented by the formula [I] and the langasite, is usually 0.01 mole percent or higher, preferably 0.1 mole percent or higher, more preferably 1 mole percent or higher, and usually 30 mole percent or lower, preferably 20 mole percent or lower, more preferably 10 mole percent or lower. When the amount of the langasite is too large, BaAl₂Si₂O₈ may be formed as an impurity phase.

The preferable examples of the composition of the phosphor of the present invention will be listed in the following, but the composition of the phosphor of the present invention is not limited to these examples.
Preferable examples of the phosphor of the present invention include: (Ca,Sr,Ba)₃(Si,Ge)₆O₁₂N₂:(Eu,Ce,Mn), (Ca,Sr,Ba)₃(Si,Ge)₆O₉:(Eu,Ce,Mn), (Ca,Sr,Ba)₃(Si,Ge)₆O₃N₈:(Eu,Ce,Mn), (Ca,Sr,Ba)₃(Si,Ge)₇O₁₂N_{8/3}:(Eu,Ce,Mn), (Ca,Sr,Ba)₃(Si,Ge)₈O₁₂N_{14/3}:(Eu,Ce,Mn), (Ca,Sr,Ba)₃(Si,Ge)₈O₁₂N₆:(Eu,Ce,Mn), (Ca,Sr,Ba)₃(Si,Ge)_{28/3}O₁₂N_{22/3}:(Eu,Ce,Mn), (Ca,Sr,Ba)₃(Si,Ge)_{29/3}O₁₂N_{26/3}:(Eu,Ce,Mn), (Ca,Sr,Ba)₃(Si,Ge)_{6.5}O₁₃N₂:(Eu,Ce,Mn), (Ca,Sr,Ba)₃(Si,Ge)₇O₁₄N₂:(Eu,Ce,Mn), (Ca,Sr,Ba)₃(Si,Ge)₈O₁₆N₂:(Eu,Ce,Mn), (Ca,Sr,Ba)₃(Si,Ge)₉O₁₈N₂:(Eu,Ce,Mn), (Ca,Sr,Ba)₃(Su,Ge)₁₀O₂₀N₂: (Eu,Ce,Mn), and (Ca,Sr,Ba)₃(Si,Ge)₁₁O₂₂N₂:(Eu,Ce,Mn). Among them, more preferable examples include: Ba₃Si₆O₁₂N₂:Eu, Ba₃Si₆O₉N₄:Eu, Ba₃Si₆O₃N₈:Eu, Ba₃Si₇O₁₂N_{8/3}:Eu, Ba₃Si₈O₁₂N_{14/3}:Eu, Ba₃Si₈O₁₂N₆:Eu, Ba₃Si_{28/3}O₁₂N_{22/3}:Eu, Ba₃Si_{29/3}O₁₂N_{26/3}:Eu, Ba₃Si_{6.5}O₁₃N₂:Eu, Ba₃Si₇O₁₄N₂:Eu, Ba₃Si₈O₁₆N₂:Eu, Ba₃Si₉O₁₈N₂:Eu, Ba₃Si₁₀C₂₀N₂:Eu, Ba₃Si₁₁O₂₂N₂:Eu, Ba₂Si₆O₁₂N₂:Eu,Mn, Ba₃Si₆O₉N₄:Eu,Mn, Ba₃Si₆O₃N₈:Eu,Mn, Ba₃Si₇O₁₂N_{8/3}:Eu,Mn, Ba₃SiₛO₁₂N_{14/3}:Eu,Mn, Ba₃Si₈O₁₂N₆:Eu,Mn, Ba₃Si₂₈O₁₂N_{22/3:}Eu,Mn, Ba₃Si_{29/3}O₁₂N_{26/3}:Eu,MN, Ba₃Si_{6.5}O₁₃N₂:Eu,Mn, Ba₃Si₇O₁₄N₂:Eu,Mn, Ba₃Si₈O₁₆N₂:Eu,Mn, Ba₃Si₉O₁₉N₂:Eu,Mn, Ba₃Si₁₀O₂₀N₂:Eu,Mn, Ba₃Si₁₁O₂₂N₂:Eu,Mn, Ba₃Si₆O₁₂N₂:Ce, Ba₃Si₆O₉N₄:Ce, Ba₃Si₆O₃N₈:Ce, Ba₃Si₇O₁₂N_{8/3}:Ce, Ba₃Si₈O₁₂N_{14/3}:Ce, Ba₃Si₈O₁₂N₆:Ce, Ba₃Si_{28/3}O₁₂N_{22/3}:Ce, Ba₃Si_{29/3}O₁₂N_{26/3}:Ce, Ba₃Si_{6.5}O₁₃N₂:Ce, Ba₃Si₇O₁₄N₂:Ce, Ba₃Si₈O₁₂N₂:Ce, Ba₃Si₉O₁₈N₂:Ce, Ba₃Si₁₀O₂₀N₂:Ce, and Ba₃Si₁₁O₂₂N₂:Ce.

### [2. Production method of oxynitride phosphor]

The phosphor of the present invention is produced via a process of firing a phosphor material powder and/or a fired product which can be obtained by mixing and firing the phosphor material powder (they are collectively referred to as "phosphor precursor" in the present Description) in the presence of flux. Phosphor materials, production method and the like, for producing the phosphor of the present invention, are as follows.

The production method of the phosphor of the present invention is not particularly limited, insofar as the above-mentioned phosphor precursor is fired in the presence of flux. For example, it can be produced as follows. Materials for the elements in the general formula (I) are prepared as phosphor materials. Namely, material for the activation element M¹ (hereinafter referred to as "M¹ source" as appropriate), material for the Ba (hereinafter referred to as "Ba source" as appropriate), material for the metal element M² (hereinafter referred to as "M² source" as appropriate) and material for the L (hereinafter referred to as "L source" as appropriate) are prepared as phosphor materials. Then, the phosphor materials are mixed (mixing process). Subsequently, the mixture obtained (the material mixture) is fired (firing process).

### [2-1. Phosphor material]

Examples of the phosphor materials used to produce the phosphor of the present invention (namely, the M¹ source, Ba source, M² source, and L source) include simple substances and compounds containing the respective elements constituting the phosphor of the present invention (hereinafter referred to as "constituent elements of the phosphor" as appropriate) such as M¹, Ba, M² and L. Among them, preferable examples of them include: metals, alloys, imide compounds, amide compounds, oxynitrides, nitrides, oxides, hydroxides, carbonates, nitrates, sulfates, oxalates, carboxylates and halides. Phosphor materials can be selected as appropriate from these substances in light of reactivity into complex oxynitrides and the amount of NOₓ, SOₓ or the like generated at the time of firing.

Concerning impurities contained in the phosphor materials, there is no special limitation thereon insofar as they do not affect the performance of the phosphor. However, usually phosphor materials in which the contents of respective impurities of Fe, Co, Cr, and Ni are usually 1000 ppm or lower, preferably 100 ppm or lower, more preferably 50 ppm or lower, still more preferably 10 ppm or lower, particularly preferably 1 ppm or lower are used.
The weight median diameter of each phosphor material is usually 0.1 µm or larger, preferably 0.5 µm or larger, and usually 30 µm or smaller, preferably 20 µm or smaller, more preferably 10 µm or smaller, still more preferably 3 µm or smaller. To achieve this, pulverization may be carried out preliminarily with dry-type pulverizers such as jet mills depending on the kind of the phosphor material. In this way, each phosphor material is dispersed homogenously in the material mixture and the reactivity of the solid state reaction of the material mixture can be heightened owing to increased surface area of the phosphor material, thereby making it possible to inhibit impurity phase generations. Particularly for nitride materials, it is preferable to use ones having smaller particle diameters than the other phosphor materials from the standpoint of reactivity.

### [M¹ source]

Of the M¹ sources, examples of material for Eu (Eu source) include: Eu₂O₃, Eu₂(SO₄)₃, Eu₂(C₂a₄)ₐ·10H₂O, EuCl₂, EuCl₃, EuF₂, EuF₃, Eu(NO₃)₃·6H₂O, EuN, EuNH, and Eu(NH₂)₂. Of these, preferable are Eu₂O₃ and EuCl₂ is particularly preferable.

Of the M¹ sources, examples of the materials for the other activation elements such as Mn, Ce, Pr, Nd, Sm, Tb, Dy, Ho, Er, Tm and Yb (hereinafter referred to as "Mn sources", "Ce source", "Pr source,", Nd source", "Sm source", "Tb source", "Dy source", "Ho source", "Er source", "Tm source", and "Yb source" respectively) include those compounds exemplified as examples of the Eu source in which Eu is replaced by the other respective activation elements Mn, Ce, Pr, Nd, Sm, Tb, Dy, Ho, Er, Tm and Yb.

Examples of the Ba include: BaO, Ba(OH)₂·8H₂O, BaCO₃, Ba(NO₃)₂, BaSO₄, Ba(C₂O₄), Ba(OCOCH₃)₂, BaCl₂, BaF₂, Ba₂N, BaNH, and Ba(NH₂)₂. Of these, carbonates, oxides or the like can be preferably used. Since oxides react easily with atmospheric water, carbonates are more preferable from the standpoint of easy handling. Among them, BaCO₃ is preferable, because it is stable in air, easily decomposed by heat leaving no undesirable elements, and its highly purified material is easily available. When carbonate is used as the material, it is preferable to calcine the carbonate preliminarily before used as material.

### [M² source]

Of the M² sources, examples of the material for Sr (Sr source) include: SrO, Sr(OH)₂·8H₂O, SrCO₃, Sr(NO₃)₂, SrSO_{4,} Sr(C₂O₄)·H₂O, Sr(OCOCH₃)₂·0.5H₂O, SrCl₂, SrF₂, Sr₂N, SrNH, and Sr(NH₂)₂. Of these, preferable is SrCO₃, because it is stable in air, easily decomposed by heat leaving no undesirable elements, and its highly purified material is easily available.

Of the M² sources, examples of the material for Mg (Mg source) include: MgO, Mg(OH)₂, basic magnesium carbonates (mMgCO₃·Mg(OH)₂·nH₂O), Mg(NO₃)₂·6H₂O, MgSO₄, Mg(C₂O₄)·2H₂O, Mg(OCOCH₃)₂·4H₂O, MgCl₂, MgF₂, Mg₃N₂, MgNH, and Mg(NH₂)₂. Of these, preferable are MgO and basic magnesium carbonates.

Of the M² sources, examples of the material for Ca (Ca source) include: CaO, Ca(OH)₂, CaCO₃, Ca(NO₃)₂·4H₂O, CaSO₄·2H₂O, Ca(C₂O₄)·H₂O, Ca(OCOCH₃)₂·H₂O, CaCl₂, CaF₂, Ca₃N₂, CaNH, and Ca(NH₂)₂. Of these, preferable are CaCO₃ and dehydrated CaCl₂.

Of the M² sources, examples of the material for Zn (Zn source) include: zinc compounds (including hydrate) such as ZnO, ZnF₂, ZnCl₂, Zn(OH)₂, Zn₃N₂, ZnNH, and Zₙ(NH₂)₂. Of these, preferable are ZnF₂·4H₂O (and its anhydrate) or the like, from the standpoint of high efficiency of promoting the particle growth.
When carbonate is used as the M² source, it is preferable to calcine the carbonate preliminarily before used as material.

### [L source]

Of the L sources, it is preferable to use SiO₂ or Si₃N₄ as the material for Si (Si source). Si₃N₄ is more preferable. It is also possible to use compounds which can be converted to SiO₂. Examples of such compounds include: SiO₂ H₄SiO₄ and Si(COOCH₃)₄. Concerning Si₃N₄, ones of small particle diameters are preferable from the standpoint of reactivity, and ones with high purity are preferable from the standpoint of emission efficiency. Furthermore, from the standpoint of emission efficiency, β-Si₃N₄ is more preferable than α-Si₃N₄, and ones containing less carbon atoms, which are impurities, are particularly preferable. The smaller the content of the carbon atoms is, the more preferable. However, it is usually 0.01 weight % or more, and usually 0.3 weight % or less, preferably 0.1 weight % or less, more preferably 0.05 weight % or less. On the other hand, for the sake of achieving larger particle diameter of the phosphor particles, it is preferable that the particle diameter of Si₃N₄, a raw material, is larger.

Of the L sources, it is preferable to use GeO₂ or Ge₃N₄ as the Ge source. It is also possible to use compounds which can be converted to GeO₂. Examples of such compounds include: GeO₂, Ge(OH)₄, Ge(OCOCH₃)₄ and GeCl₄.
Examples of the other L sources include each compound exemplified above as the examples of the Si source and Ge source in which Si or Ge is replaced by metal elements such as Ti, Zr, and Hf.

### [Others regarding phosphor material]

Of the above-mentioned various phosphor materials, it is preferable to use ones with high purity and high degree of whiteness in order to heighten the emission efficiency of the resultant phosphor. Specifically, it is preferable to use phosphor materials whose reflectance in the wavelength region of from 380 nm to 780 nm is 60 % or higher, preferably 70 % or higher, more preferably 80 % or higher. In particular, at 525 nm, which is close to the emission-peak wavelength of the phosphor of the present invention, the reflectance of the phosphor materials is preferably 60 % or higher, more preferably 70 % or higher, still more preferably 80 % or higher, particularly preferably 90 % or higher.

Of the various phosphor materials, it is preferable for silicon nitride (Si₃N₄) in particular to have high reflectance. In order to achieve high reflectance of Si₃N₄, it is preferable that the content of impurity carbon in Si₃N₄ is usually 0.2 weight % or lower, preferably 0.1 weight % or lower, more preferably 0.05 weight % or lower, still more preferably 0.03 weight % or lower. The lower the content of the impurity carbon is, the more preferable. However, it is usually contained at 0.001 weight % or higher. The reflectance can be determined by measuring a reflectance spectrum. The method of measurement is the same as what will be described later in the section for the explanation of absorption efficiency, internal quantum efficiency, and external quantum efficiency.

From these standpoints, it is preferable to use crystalline silicon nitride of the present invention explained below (hereinafter referred to as "silicon nitride of the present invention", as appropriate), when silicon nitride is used as a phosphor material.

### [Silicon nitride of the present invention]

### · Crystallinity

Silicon nitride of the present invention is silicon nitride having a crystal phase.
As crystalline phase of silicon nitride, α-type, which is stable at low temperature, and β-type, which is stable at high temperature, are known. They can be identified by X-ray diffraction and by referring to the pattern registered in PDF (Powder Diffraction File, for example, α-type silicon nitride: 83-0700, 76-1407, 71-0570 etc., β-type silicon nitride: 29-1132, 73-1208, 82-0702 etc.).

The crystal phase of silicon nitride of the present invention may contain α-type alone, β-type alone or both α-type and β-type. It is preferable that it contains β-type at least. It is more preferable that it contains only β-type.

The silicon nitride of the present invention may contain an amorphous phase besides the above-mentioned crystal phase. It is preferable that the amorphous phase is small in amount. It is usually 50% or less, preferably 30% or less, more preferably 20% or less, still more preferably 10% or less, particularly preferably 5% or less. Most preferably, the amorphous phase does not exist.

### · Reflectance

The reflectance of the silicon nitride of the present invention, when irradiated with light of 525-nm wavelength, is 85% or more, preferably 88% or more, more preferably 90% or more, still more preferably 93% or more. The higher the reflectance is, the more preferable. The upper limit thereof is 100%.

The reflectance can be measured by any ordinary measurement method of reflection spectrum. Specifically, it can be measured by a following method.
Namely, a silicon nitride powder, the measurement object, is stuffed up in a cell with its surface smoothed sufficiently to keep high measurement accuracy, and then it is set on a condenser such as an integrating sphere. The reflected light which is obtained by irradiating the condenser such an integrating sphere with light, for example that from an Xe lamp, can be measured for its spectrum with a spectrometer, for example an MCPD2000 or MCPD7000 manufactured by Otsuka Electronics Co., Ltd. The reflectance value of each spectrum obtained as above can be calibrated on the basis of the reflectance of a substance (for example, "Spectralon" manufactured by Labsphere with 99% reflectance R with respect to the excitation light of 525-nm wavelength) of which the reflectance with respect to the light of the light source is already known. The reflectance can be determined in this way.

### · Carbon content

The content of impurity carbon of the silicon nitride of the present invention is usually 0.1 weight % or smaller. It is preferable that it is 0.06 weight % or smaller. More preferably, the impurity carbon amount is 0.05 weight % or smaller, still more preferably, it is 0.04 weight % or smaller, particularly preferably, it is 0.03 weight % or smaller. The smaller the impurity carbon content is, the more preferable. However, it is usually 0.000001 weight % or higher.
The content of such carbon can be measured by usual elementary analysis.

### · Production method of silicon nitride

There is no special limitation to the method of production of the silicon nitride of the present invention. It is preferable that the method includes a heat treatment process during which material silicon nitride is heated under predetermined conditions (hereinafter referred to as "production method of the silicon nitride of the present invention", as appropriate). Detailed explanation of the production method of the silicon nitride of the present invention will be given below.

### (Material silicon nitride)

There is no special limitation to material silicon nitride used as material to obtain silicon nitride of the present invention, and any silicon nitride prepared by known methods can be used. Concrete examples of the methods include (a) direct nitriding of metal silicon, (b) use of halogenated silicon as material and (c) reduction nitriding of silicon dioxide, as described below.

### (a) Direct nitriding method

3Si + 2N₂ → Si₃N₄

3Si + 4NH₃ → Si₃N₄ + 6H₂

Micropowder of a metal silicon is placed under controlled temperature-raising conditions starting from around 1100°C in the presence of N₂ or NH₃, and nitriding is completed at 1200°C ∼ 1450°C. The product is pulverized and, if necessary, purified.

### (b) Halogenated silicon method

Halogenated silicon method includes (1) imide decomposition method and (2) gas phase method, which are described below.

### (1) Imide decomposition method (Liquid phase method)

SiCl₄ + 6NH₃ → Si(NH)₂ + 4NH₄Cl

Si(NH)₂ → Si₃N₄ + 2NH₃

Silicon tetrachloride is allowed to react with ammonia in an organic solvent at ordinary or lower temperature to obtain silicon diimide. The product obtained is then subjected to heat decomposition at around 1100°C to obtain amorphous silicon nitride. This is then crystallized to α-type silicon nitride.

### (2) Gas phase method

3SiCl₄ + 4NH₃ → Si₃N, + 12HCl

3SiH₄+ 4NH₃→ Si₃N₄ + 12H₂

Silicon tetrachloride or SiH₄ is allowed to react with ammonia in a gas phase at 1100°C ∼ 1200°C to obtain amorphous silicon nitride. The product is then heated at 1450°C ∼ 1500°C to produce α-type silicon nitride.

### (c) Reduction nitriding method

3SiO₂ + 6C + 2N₂ → Si₃N₄ + 6CO

Material silicon dioxide and micropowder of carbon are subjected to reduction nitriding under a flow of N₂ gas at 1500°C. Subsequently, heat treatment is performed in an oxidizing environment at 700°C to remove residual carbon.

The reflectance of such material silicon nitride having a crystal phase as obtained above, when irradiated with light of 525-nm wavelength, is usually 83% or less, and more generally 80% or less. Its carbon content is usually 0.06 weight % or higher, more generally 0.09 weight % or higher.

### (Heat treatment)

In the production method of the silicon nitride of the present invention, material silicon nitride obtained as above is subjected to heat treatment at 1500°C or higher in a nitrogen gas-containing atmosphere whose N₂ partial pressure is 0.4 MPa or higher. Silicon nitride of the present invention is thus obtained.

Specifically, firing is performed after the material silicon nitride is placed in a heat-resistant vessel such as crucible or tray made of material of low reactivity. Material examples of heat-resistant vessels used for such a heat treatment include: ceramics such as alumina, boron nitride, silicon nitride, silicon carbide, magnesium and mullite; metals such as platinum, molybdenum, tungsten, tantalum, niobium, iridium and rhodium; alloys mainly constituted of these metals; and carbon (graphite). Of these, heat-resistant vessels made of boron nitride, alumina, silicon nitride, silicon carbide, platinum, molybdenum, tungsten and tantalum are preferable.

In the process of temperature elevation at the time of heat treatment, it is preferable to perform a part of the process under reduced pressure. Specifically, nitrogen-containing gas is introduced into the system under reduced pressure (specifically, 10⁻² Pa or higher and lower than 0.1 MPa as usual) in the temperature range of usually room temperature or higher, and preferably 1500°C or lower, more preferably 1200°C or lower, still more preferably 1000°C or lower.

In this case, the target temperature may be maintained, as needed, usually for 1minute or longer, preferably 5minutes or longer, more preferably 10minutes or longer. The maintenance period is usually 5hours or shorter, preferably 3hours or shorter, more preferably 1hours or shorter.

There is no special limitation to the nitrogen-containing gas insofar as the partial pressure of nitrogen is 0.4 MPa or higher and it is inert to a heater in the temperature raising apparatus and silicon nitride. The examples include a mixture of nitrogen gas with argon, CO, hydrogen, ammonia or the like. Preferable is nitrogen gas, or a mixture of nitrogen gas with argon or hydrogen. More preferable is nitrogen gas, or a mixture of nitrogen gas with argon gas. Especially preferable is nitrogen gas. The higher the partial pressure of nitrogen gas is, the more preferable. The nitrogen gas of 99.999 volume % is especially preferable.

In the heat treatment of silicon nitride, after the nitrogen-containing gas introduction, the temperature is usually raised to 1500°C or higher, preferably 1800°C or higher, more preferably 1900°C or higher. No particular limitation is imposed on the upper limit of the temperature of the heat treatment insofar as it is lower than the decomposition temperature of silicon nitride, although it depends on the pressure in the firing system. For example when the pressure in the firing system is 2 MPa or lower, the temperature is usually 2500°C or lower, preferably 2200°C or lower, more preferably 2100°C or lower.

The period of heat treatment is usually 0.5hours or longer, preferably 1hour or longer, more preferably 2hours or longer, although it also depends on the temperature of the heat treatment. The firing period, which is preferably longer, is usually 100hours or shorter, preferably 50hours or shorter, more preferably 24hours or shorter and still more preferably 12hours or shorter.

The above heat treatment of silicon nitride can be performed on material silicon nitride produced and isolated preliminarily by the method described above. Or it can be performed subsequent to nitriding treatment of the production process of material silicon nitride. In the latter case, it is possible to obtain the silicon nitride of the present invention as a one step process from the raw material of silicon nitride such as metal silicon, halogenated silicon and silicon dioxide.

Further, before the above heat treatment is performed, it is preferable to heat, as needed, the silicon nitride (preliminary heat treatment) under an atmosphere containing oxygen gas where O₂ partial pressure is usually 0.01 MPa or higher and usually 0.1 MPa or lower. The temperature thereof is usually 800°C or higher, preferably 900°C or higher, more preferably 1000°C or higher, still more preferably 1100°C or higher, and usually 1300°C or lower, preferably 1200°C or lower. By this treatment, it is possible to make the particle diameter of the resultant β-type silicon nitride larger.

Further, in the heat treatment of the material silicon nitride mentioned above, it is desirable to perform it in the presence of SiO₂ By this procedure, it is possible to make the particle diameter of the resultant β-type silicon nitride larger.
There is no special limitation to the amount of SiO₂ used. Usually it is 0.1 1 weight portion or more, relative to 100 weight portion of material silicon nitride, preferably 0.5 weight portion or more, more preferably 1 weight portion or more, and usually 15 weight portion or less, preferably 10 weight portion or less, more preferably 5 weight portion or less.

As mentioned above, the presence of a minute amount of oxygen at the time of heat treatment of silicon nitride tends to make the particle diameter of resultant β-type silicon nitride larger. Therefore, in order to make the particle diameter of the phosphor particle larger, it is desirable to use silicon nitride which has been subjected to the above treatment.

After completion of the heat treatment described above, the product is allowed to cool to room temperature, and treatment such as pulverization and sifting is performed as needed.
Examples of means of such pulverization include known methods such as use of dry type pulverizer like hammer mill, roll mill, ball mill and jet mill, and pulverization using mortar and pestle.
In sifting, it is possible to use various commercially available sieves. When silicon nitride obtained is used as material of phosphor, it is better to use a sieve of nylon mesh rather than metal mesh from the standpoint of preventing contamination.

There is no special limitation to the particle diameter of the silicon nitride of the present invention. It can be selected appropriately depending on its use. For example, when the silicon nitride of the present invention is used as phosphor material, its weight median diameter (D₅₀) is usually 0.01 µm or larger, preferably 0.1 µm or larger, more preferably 1 µm or larger, and usually 100 µm or smaller, preferably 30 µm or smaller, more preferably 20 µm or smaller.

The weight median diameter of silicon nitride of the present invention can be measured by any known methods. For example, a laser diffraction/scattering particle size distribution analyzer can be used.

### · Use application of silicon nitride

The silicon nitride of the present invention can be used as material of various phosphors as described above. Other application thereof includes: use as ceramics materials such as abrasive grain, abradant, insulator, dielectrics and heat-resistant material; pigments; and materials of various inorganic origin such as cosmetics. Further, as it has higher reflectance than that of previous ones and is white in color, use in the area of optical material can be expected in addition to the previously known area where heat-resistant and anti-shock property is required.

The phosphor materials of the present invention can be used as coprecipitated materials by performing a coprecipitatation. In the coprecipitated material, a part or all of the constituent elements of the phosphor are blended at the atomic level. The coprecipitatation is usually carried out by combining phosphor materials containing different constituent elements of the phosphor. Therefore, the coprecipitated material obtained then contains two or more kinds of the constituent elements of the phosphor. By using phosphor material after they are coprecipitated, a phosphor in which the constituent elements of the phosphor are uniformly blended can be obtained, which leads to the realization of a phosphor with excellent emission intensity. Particularly when using a coprecipitated material containing luminescent center element (usually activation element), a phosphor with more excellent emission intensity can be achieved because the luminescent center element can then be dispersed uniformly in the phosphor.

The above-mentioned M¹ source, Ba source, M² source, and L source can be used either as a single one or as a combination of two or more kinds in any combination and in any ratio.

N element, O element, and halogen element in the composition of the phosphor of the present invention are usually supplied as anion components of the phosphor materials for the above-mentioned respective constituent elements of the phosphor or as components contained in the firing atmosphere, at the time of production of the phosphor.

### [2-2. Production method of phosphor: mixing process]

The phosphor of the present invention can be obtained by weighing out the phosphor materials so as to give the desired composition, and firing them after mixing. At this point, it is preferable to perform the mixing sufficiently using a ball mill or the like.

It is preferable to weigh out the phosphor materials so that the charge composition of the constituent elements of the phosphor in the mixture is the same as the composition of the intended phosphor. At this point, deviations of the weighing of the respective phosphor materials are permitted to some extent. However, smaller deviations of the weighing is preferable for the purpose of obtaining crystals with little lattice defects or impurity phases. Specifically, the deviation of the respective molar amounts of M¹ element, M² element, and L element in the material mixture is in the range of ± 10% relative to the molar amount of intended phosphor composition (more specifically, the respective molar amounts are usually 90% or higher, preferably 95% or higher, and usually 110% or lower, preferably 105% or lower of the intended compositions).

For producing a phosphor containing at least Eu and Pr as the M¹ element of the composition of the formula [I], it is preferable to use materials containing Pr element at a molar ratio of usually 5% or lower, preferably 4% or lower, more preferably 3 % or lower relative to the total amount of Ba element and M² element and to fire them. Thereby, a phosphor excellent in durability can be more securely obtained. There is no limitation on the lower limit, but usually, it is 0.01 mole percent or higher.

There is no particular limitation on the method for the above-mentioned mixing. The known examples listed below as (A) and (B) can be used arbitrarily. These methods can be carried out under known conditions as appropriate, such as using two kinds of balls with different particle diameters while being mixed in a ball mill.
(A) Dry-type mixing methods in which the above-mentioned phosphor materials are pulverized and mixed by combining pulverization, which is done by means of a dry-type pulverizer such as a hammer mill, roll mill, ball mill and jet mill, or pestle/mortar, and mixing, which is done by means of a mixing apparatus such as a ribbon blender, V type blender and Henschel mixer, or pestle/mortar.
(B) Wet-type mixing methods in which a solvent or dispersion medium such as water or alcohol solvent like ethanol is added to the above-mentioned phosphor materials, and mixing is done by means of a pulverizer, pestle/mortar, evaporation dish/stirring rod or the like to make a solution or slurry, followed by drying by such methods as spray drying, heated drying, or air drying.

The phosphor materials may be sieved at the time of mixing and pulverization mentioned above if necessary. In such a case, various kinds of commercially available sieves can be used. However, sieves made of a resin such as nylon mesh are more preferable than ones made of metals such as a metal mesh for preventing contamination with impurities.

The mixing of the phosphor materials can be done by selecting either a dry-type method or a wet-type method from the above lists in accordance with the physicochemical properties of the phosphor materials.
When nitride is used as the material, the materials are mixed preferably within a glove box with controlled moisture content filled with inert gas such as argon gas or nitrogen gas using a mixer for preventing deterioration of the nitride from moisture.
The moisture content of the atmosphere for the mixing is preferably 10000 ppm or lower, more preferably 1000 ppm or lower, still more preferably 10 ppm or lower, and particularly preferably 1 ppm or lower. The oxygen content thereof is preferably 1% or lower, more preferably 1000 ppm or lower, still more preferably 100 ppm or lower, and particularly preferably 10 ppm or lower.

### [2-3. Production method of phosphor: firing process]

A phosphor is obtained by firing the mixture obtained. It is preferable to perform the firing at a predetermined temperature in a predetermined atmosphere with the phosphor materials filled in a vessel such as a crucible.
Concerning the vessel, it is preferable to use heat-resistant vessels such as crucibles or trays which are made of materials unlikely to react with each phosphor material. Material examples of such heat-resistant vessels used for such a firing process include: ceramics such as alumina, quartz, boron nitride, silicon nitride, silicon carbide, magnesium and mullite; metals such as platinum, molybdenum, tungsten, tantalum, niobium, iridium and rhodium; alloys mainly constituted of these metals; and carbon (graphite). Of these, heat-resistant vessels made of quartz can be used for heat treatment at relatively low temperatures such as 1200°C or lower, and the preferable temperature range of its use is 1000°C or lower.
Preferable examples of such heat-resistant vessels include: heat-resistant vessels made of boron nitride, alumina, silicon nitride, silicon carbide, platinum, molybdenum, tungsten, and tantalum. Ones made of boron nitride, alumina or molybdenum are more preferable. Particularly preferable are alumina ones because they are stable even when firing is done at firing temperatures for reducing atmospheres such as nitrogen-hydrogen mixed gas. However, when using phosphor materials which react with alumina, BN of molybdenum heat-resistant vessels can be preferably used.

The filling rates (hereinafter referred to as "filling rate into heat-resistant vessel") at which the phosphor materials are filled into the above-mentioned heat-resistant vessels differ depending on the firing conditions or the like. However, the rate may be such that the pulverization of the fired product will not be difficult at the post-treatment steps to be described later. Therefore, it is usually 10 volume % or larger, and usually 90 volume % or smaller. Meanwhile, there are gaps between the phosphor material particles filled in a crucible, and therefore, the volume which the phosphor materials occupy themselves in 100 ml of the heat-resistant vessel is usually 10 ml or larger, preferably 15 ml or larger, more preferably 20 ml or larger, and usually 50 ml or smaller, preferably 40 ml or smaller, more preferably 30 ml or smaller.

When a large amount of phosphor materials is treated at one time, it is preferable to make heat distributed uniformly within the heat-resistant vessel for example by decelerating the temperature rising rate.
The filling rate (hereinafter referred to as "filling rate into furnace" as appropriate) at which the heat-resistant vessels are filled into a furnace is preferably such that the heat-resistant vessels will be heated uniformly in the furnace.
When a large number of heat-resistant vessels are fired in the firing furnace, it is preferable for the sake of uniformity of firing to distribute heat uniformly to each heat-resistant vessel, for example by decelerating the above-mentioned temperature rising rate.

When a metal carbonate is used as a phosphor material, it is preferable to perform multistep firing and change the metal carbonate into metal oxide at least partly in the primary firing process, for the sake of preventing a firing furnace from being damaged owing to carbon dioxide formed.

A part of firing treatment is preferably carried out at reduced pressure on the way of temperature rising. Specifically, the reduced pressure condition (specifically, 10⁻² Pa or higher and lower than 0.1 MPa as usual) is preferably provided at a certain point of time when the temperature is preferably room temperature or higher and preferably 1500°C or lower, more preferably 1200°C or lower, still more preferably 1000°C or lower. Particularly, it is preferable to perform the temperature rising with an inert gas or reducing gas, to be described later, introduced in the system after reducing the pressure in the system.

During the pressure reduction, the temperature may be retained if necessary at a desired value for 1minute or longer, preferably 5minutes or longer, and more preferably 10minutes or longer. The retention period is usually 5hours or shorter, preferably 3hours or shorter, and more preferably 1hour or shorter.

Concerning the firing temperature for producing the phosphor of the present invention, at firing temperatures of over 1600°C, sintering of a fired powder may usually occur, resulting in lowering of the emission intensity. At firing temperatures of around 1400°C, powder of good crystallinity can be obtained. Therefore, the firing temperature is usually 1150°C or higher, preferably 1200°C or higher, and usually 1600°C or lower, preferably 1500°C or lower, more preferably 1450°C or lower.

No particular limitation is imposed on the atmosphere of the firing. Usually, the firing is performed in an atmosphere of inert gas or in a reducing atmosphere. As mentioned before, it is preferred that the valency of the activation element is mostly bivalent. Therefore, reducing atmospheres are preferable. The inert gas and reducing gas can be used either as a single one or as a combination of two or more kinds in any combination and in any ratio.

Examples of the inert gas and reducing gas include: carbon monoxide, hydrogen, nitrogen, argon, methane, and ammonia. Of these, preferable is nitrogen gas atmosphere, and more preferable is nitrogen gas atmosphere containing hydrogen gas. The purity of the above nitrogen (N₂) gas is preferably 99.9% or higher. When nitrogen containing hydrogen is used, it is preferable that oxygen concentration in an electric furnace is kept at 20 ppm or lower. Further, it is preferable that hydrogen content in the atmosphere is 1 volume % or higher, more preferably 2 volume % or higher, and 100 volume % or lower, more preferably 10 volume % or lower, still more preferably 5 volume % or lower. This is because, when the content of hydrogen in the atmosphere is too high, safety may not be guaranteed. When it is too low, sufficient reducing atmosphere may not be secured.

The above-mentioned inert gas or reducing gas can be introduced either before starting the temperature rising or in the course of the temperature rising. Or otherwise, it can be introduced when the temperature reaches a firing temperature. It is preferable to introduce it before or in the course of the temperature rising.
When the firing is carried out under a flow of such an inert gas or reducing gas, the flow rate is usually 0.1 L/min to 10 L/min.

The firing time differs depending on the temperature, pressure or the like at the time of the firing. It is usually 0.5hours or longer, preferably 1hour or longer. The longer the firing time is, the more preferable. However, it is usually 100hours or shorter, preferably 50hours or shorter, more preferably 24hours or shorter, still more preferably 12hours or shorter.

Pressure at the time of the firing differs depending on factors such as firing temperature and is not limited specially. Usually, it is 1 × 10⁻⁵ Pa or higher, preferably 1 × 10⁻³ Pa or higher, more preferably 0.01 MPa or higher, still more preferably 0.1 MPa or higher. The upper limit is usually 5 GPa or lower, preferably 1 GPa or lower, more preferably 200 MPa or lower, and still more preferably 100 MPa or lower. Industrially, from atmospheric pressure to 1 MPa is convenient and preferable from the standpoint of cost and convenience.

In the firing process, the material mixture described earlier may be fired at a temperature lower than the fusing temperature, or it may be fired at such a high temperature that the material mixture can be fused. In the latter case, in a fusing process (namely, the firing process) the material mixture is fused, and then in a cooling process the fused material mixture is cooled to form a phosphor crystal. By this production method, a phosphor with particularly excellent crystallinity can be obtained. This preferably makes the advantageous effect of the phosphor of the present invention more remarkable. In the following, explanation will be given on the fusing process and cooling process.

### · Fusing process

In the fusing process, the material mixture is fused.
In the fusing process, the material mixture is fused usually by heating. The temperature for the heating can be set appropriately in accordance with the kinds of the phosphor materials. It is usually 1250°C or higher, preferably 1300°C or higher, more preferably 1350°C or higher, and usually 1700°C or lower, preferably 1600°C or lower, more preferably 1550°C or lower. When the temperature is too low, the material mixtures tend to be difficult to fuse. When the temperature is too high, the emission intensity of the resultant phosphor tends to be lowered.

The time for which the materials are kept to be fused is usually 0.5hours or longer, preferably 1hour or longer, more preferably 1.5hours or longer, and usually 100hours or shorter, preferably 50hours or shorter, more preferably 24hours or shorter. For a secure promotion of the reaction, the fusing is maintained for a substantial period of time. However, when it is too long, the brightness of the phosphor tends to decrease.

By fusing the material mixture as described above, the phosphor materials contained therein can be mixed efficiently, and also impurities are ejected outside the system. This makes it possible to obtain a phosphor having a crystal phase with little lattice defect or impurity phase.

### · Cooling process

In the cooling process, the fused material mixture is cooled to form a phosphor crystal.
The cooling speed of the cooling process is usually 0.001 °C/min or higher, preferably 0.01 °C/min or higher, more preferably 1 °C/min or higher, and usually 100 °C/min or lower, preferably 50 °C/min or lower, more preferably 30 °C/min or lower. During such a cooling process, phosphor crystals are precipitated and the crystals grow. When the cooling speed is too high, phosphors with high crystallinity tend to be difficult to obtain. When the cooling speed is too low, longer cooling time tends to deteriorate the productivity.

In the firing process, a phosphor precursor other than the material mixture, such as a fired product obtained by mixing and firing a part or all of the phosphor materials, can be fired together with the material mixture or in place of the material mixture.

### [2-4. Flux]

The phosphor of the present invention is **characterized in that** a flux is present in the reaction system in its firing process. No particular limitation is imposed on the kind of flux. The examples include: ammonium halides such as NH₄Cl and NH₄F·HF; alkali metal carbonates such as Na₂CO₃ and LiCO₃; alkali metal halides such as LiCl, NaCl, KCl, CsCl, LiF, NaF, KF, CsF, LiI, NaI, KI and CsI; alkaline-earth metal halides such as CaCl₂, BaCl₂, SrCl₂, CaF₂, BaF₂, SrF₂, CaI₂, BaI₂ and SrI₂; alkaline-earth metal oxides such as CaO, SrO and BaO; boron oxides, boric acid and boric acid salts of alkali metals or alkaline-earth metals such as B₂O₃, H₃BO₃, Na₂B₄O₇ and K₂B₄O₇; phosphates such as Li₃PO₄, NH₄H₂PO₄, BaHPO₄ and Zn₃(PO₄)₂; aluminum halides such as AlF₃; zinc compounds such as zinc halides like ZnCl₂, ZnBr₂ and ZnF₂, zinc oxides, zinc sulfates, zinc borates and zinc phosphates; compounds of the 15th group elements of the periodic table such as Bi₂O₃; and nitrides of alkali metals, alkaline earth metals or the 13th group elements such as Li₃N, Ca₃N₂, Sr₃N₂, Ba₃N₂, Sr₂N, Ba₂N and BN. Of these, halides are preferable. Particularly preferable are alkali metal halides, alkaline-earth metal halides, phosphates, and Zn halides. Of these halides, fluorides and chlorides are preferable. Among them, more preferable are fluorides of alkaline-earth metals or Zn, and phosphates of alkaline-earth metals.

The amount of flux used differs depending on the kind of the phosphor materials, the kind of the flux, or the like. It is preferably in the range of usually 0.01 weight % or more, preferably 0.1 weight % or more, more preferably 1 weight % or more, and usually 20 weight % or less, preferably 10 weight % or less, for each flux. When the amount of the flux used is too small, the effect of the flux may not be exhibited. When the amount of the flux used is too large, the effect of the flux may be saturated, or it may be taken up into the host crystals, leading possibly to change in the luminescent color or decrease in the brightness. Therefore it is preferable to use flux compounds containing the same elements as the metal elements that constitute the host crystal.

The flux can be used either as a single one or as a mixture of two or more kinds in any combination and in any ratio. When two or more kinds of the fluxes are used in combination, the amount of the total fluxes used is usually 40 weight % or less, preferably 30 weight % or less, more preferably 25 weight % or less, and usually 0.01 weight % or more, preferably 0.1 weight % or more, more preferably 1 weight % or more.
When the flux has deliquescence, it is preferable to use its anhydride. When the phosphor is produced by a multistep firing, it is preferable that the flux is added in a firing process as late as possible.

### [2-5. Multistep firing]

In order to improve the crystallinity by promoting the solid state reaction in the firing process, the firing process may be performed not at a single step but at multiple steps. For example, after firing the material mixture obtained in the mixing process primarily (first firing process), the fired product is further fired (second firing process) one or more times. Before those additional firings, the fired product may be pulverized with a ball mill or the like if necessary. The additional firing (second firing process) can be performed repeatedly as secondary firing, tertiary firing, and the like. At this point, the fired product obtained by the primary firing can be introduced to the later firing steps either alone or together with the rest of the aforementioned phosphor materials (in the latter case, a part of the phosphor materials are subjected to the primary firing and then pulverized).

There is no special limitation on the temperature of the primary firing, insofar as the advantage of the present invention is not significantly impaired. However, it is usually 800°C or higher, preferably 1000°C or higher, and usually 1600°C or lower, preferably 1400°C or lower, more preferably 1300°C or lower.
In order to obtain a phosphor of uniform particle size, it is desirable to set the primary firing temperature low and allow the reaction to proceed in a solid phase in a state of powder. On the other hand, in order to obtain a phosphor with high brightness, it is desirable to set the primary firing temperature high and allow the reaction to proceed in a molten state for sufficient mixing and reaction, followed by a secondary firing for allowing crystal growth.
There is no special limitation on the length of time of the primary firing, insofar as the advantage of the present invention is not significantly impaired. However, it is usually 1hour or longer, preferably 2hours or longer, and usually 100hours or shorter, preferably 50 hours or shorter, more preferably 24hours or shorter, still more preferably 12hours or shorter.

The conditions such as temperature or length of time of the secondary and subsequent firings are basically the same as those described earlier for the aforementioned firing process.
Flux may be added either before the primary firing or before the secondary and subsequent firings. The firing conditions, such as atmosphere, may be changed between the primary firing and the secondary and subsequent firings.
The additional firings are performed under appropriately-selected firing conditions within the same ranges as described before. At this point, it is preferable to perform the latter firing process of certain two successive firing processes at higher firing temperature because it can accelerate the crystal growth of the phosphor and thus enhance the crystallinity.

In the above-mentioned multistep firing, it is preferable to wash the fired product obtained in the firing process (first firing process) at least one time (washing process) before it is subjected to the additional firing process (second firing process). Because of the washing process, impurity phase or the like attached to the fired product can be removed. This can realize shorter persistence period, smaller amount of impurity phase or the like of the phosphor. It is particularly effective to perform the washing after the first firing process and/or before the last firing process.

The washing can be done with, for example, water such as deionized water, organic solvent such as ethanol, and alkaline aqueous solution such as ammonia water. Further, water solutions of inorganic acids such as hydrochloric acid, nitric acid and sulfuric acid or water solutions of organic acids such as acetic acid can also be used, for example for the purpose of improving luminescent characteristics by removing impurity phases such as flux attached to the surface of the phosphor. In such a case, it is preferable that an additional washing is carried out with water after the washing with such an acidic aqueous solution.

It is preferable to perform the washing to the extent that the pH of the supernatant fluid obtained by dispersing the washed fired product in water which is 10 times as heavy as the phosphor and leaving it to stand for 1hour becomes neutral (pH of around 5 to 9). This is because a deviation toward basicity or acidity may affect the liquid medium, to be described later, or the like when the phosphor is mixed with the liquid medium.
The above-mentioned extent of washing can also be indicated by the electric conductivity of the supernatant fluid that is obtained by dispersing the washed fired product in water which is 10 times as heavy as the phosphor and leaving it to stand for 1 h. The lower the electric conductivity is, the more preferable, for the sake of higher luminescent characteristics. However, also in consideration of the productivity, it is preferable to repeat the washing treatments until the electric conductivity reaches usually 10 mS/m or lower, preferably 5 mS/m or lower, and more preferably 4 mS/m or lower.

The method for measuring the electric conductivity is as follows. The fired product particles, which have larger specific gravity than water, are allowed to precipitate spontaneously, by leaving them to stand for 1hour after they are stirred and dispersed in water which is 10 times as heavy as the fired product for a predetermined period of time, for example 10 min. The electric conductivity of the supernatant fluid at that time can be measured using a conductance meter "EC METER CM-30G" manufactured by DKK-TOA CORPORATION or the like. There is no special limitation on the water used for the washing treatment and measurement of the electric conductivity, but desalted water or distilled water is preferable. Among them, the one having low electric conductivity is particularly preferable. Its electric conductivity shall be usually 0.0064 mS/m or higher, and usually 1 mS/m or lower, preferably 0.5 mS/m or lower. The measurement of the electric conductivity is usually carried out at a room temperature (around 25°C).

A pulverization process is performed to pulverize the fired product when the fired product is too large. There is no special limitation on the method of such pulverization. For example, dry-type pulverization methods and wet-type pulverization methods that were listed in the section of mixing process of the phosphor materials can be used.

When carrying out a multistep firing, the flux can be added in any firing process. It is particularly effective to use it in the first firing process and/or the last firing process. In such a case, firing conditions such as atmosphere may differ between each of the firing processes.
When the number of crucibles set in the firing furnace during the above-mentioned firing is large, it is preferable to distribute heat uniformly to each crucible for example by decelerating the above-mentioned temperature rising rate, for the sake of uniformity of firing.

### · Preferable operation when using nitride as phosphor material

When using nitride as the phosphor material, it is preferable that the nitride is mixed and dispersed homogenously in the material mixture so as to enhance reactivity of the solid state reaction of the material mixture and prevent impurity phases from generating. In order to carry out it specifically, for example, phosphor materials other than the nitride are mixed, fired and pulverized preliminarily, followed by mixing the nitride and firing the mixture. Using a nitride preliminarily pulverized with a dry-type pulverizer such as a jet mill as a phosphor material is particularly preferable because the surface areas of the silicon nitride powder are increased and thus the reactivity of the solid state reaction of the nitride is enhanced. The methods exemplified above may be employed singly, but preferably they are employed in some combination.

### [2-6. Forming solid solution]

The method of producing a phosphor of the present invention represented by the formula [I'] through the formation of a solid solution of the phosphor of the present invention represented by the formula [I] and a langasite is as follows. The phosphor represented by the formula [I] and the langasite are first prepared separately according to the production method described above or a similar method thereto, followed by mixing and firing them to form a solid solution. Or otherwise, a material powder containing constituent elements of the solid solution is prepared in accordance with the composition of the intended formula [I'], followed by firing it to form the solid solution.

### [2-7. Post-treatment]

Reheating (anneal), pulverization, washing, drying, and classification treatment are performed if considered appropriate, after the heat treatment in the above-mentioned firing process.

### [Reheating process]

In the reheating process, the phosphor obtained in the firing process is heated at a lower temperature than the firing temperature. It is preferable to carry out this process for improving durability of the phosphor.
The heating temperature in the reheating process is, though it depends on the atmosphere at the time of the heating, usually lower than 1150°C, preferably 1050°C or lower, more preferably 1000°C or lower, still more preferably 900°C or lower, particularly preferably 800°C or lower, and usually 300°C or higher, preferably 400°C or higher, more preferably 500°C or higher, still more preferably 600°C or higher, particularly preferably 700°C or higher.

As the atmosphere in the reheating process, inert gases containing oxygen such as air or nitrogen gas containing oxygen can be used, in addition to ones described in the firing process section.
When using such oxygen-containing gases, it is preferable that the oxygen concentration is usually 1% or lower.

The pressure at the time of heat treatment in the reheating process can be selected from the range described for the firing process.
When it is necessary to eliminate hydrogen taken up into the phosphor crystal during the firing, it is preferable to select a reduced pressure condition.
For achieving a phosphor with high brightness and durability, the atmosphere, pressure, and time for the reheating can be adjusted appropriately so that the H₂ gas emission amount is usually 1 cm³/g or smaller, preferably 0.2 cm³/g or smaller, more preferably 0.1 cm³/g or smaller relative to the phosphor when measured using a temperature-programmed desorption gas analyzer with the phosphor heated in a vacuum up to 1000°C.
The heating time in the reheating process is usually 0.1hours or longer, preferably 0.5hours or longer, and from the standpoint of productivity, usually 100hours or shorter, preferably 50hours or shorter, more preferably 24hours or shorter, still more preferably 12hours or shorter.

It is probable that such a reheating process further reduces deformations or defects within the phosphor crystals, which makes it possible to improve the crystallinity of the phosphor, to reform the phosphor surface, and to contribute to improvement of the phosphor durability.
Especially for producing an oxynitride phosphor selected from the group consisting of, for example, nitrido-silicate, nitride-aluminosilicate, oxonitrido-silicate, oxonitrido-aluminosilicate, and carbonitrido-aluminosilicate, the above-mentioned reheating process, in which a heat treatment is done at a lower temperature than the firing temperature, is preferably performed because the advantageous effect can be remarkably exhibited.

The reheating process can be performed either on the phosphor after subjected to the firing process mentioned above or on the phosphor after subjected to treatments such as pulverization, washing or classification to be described later.
The reheating can be performed two or more times using different atmospheres. In such a case, it is preferable to perform, after a reheating under an atmosphere containing oxygen, another reheating under an atmosphere containing H₂.

### [Pulverization]

The pulverization treatment is performed on a fired product, for example when the phosphor obtained does not have desired particle diameters. There is no special limitation on the method of pulverization treatment. For example, dry-type pulverization methods and wet-type pulverization methods that were listed in the section of mixing process of the phosphor materials can be used. For the purpose of, for example, crushing the secondary particles while preventing destruction of the phosphor crystals generated, it is preferable to perform a ball milling for on the order of 10 minutes to 24 hours using, for example, a container made of alumina, silicon nitride, ZrO₂, glass or the like and balls made of the same materials as the container, iron-core urethane, or the like. In this case, a dispersant such as an organic acid or a alkaline phosphate like hexametaphosphate can be used at 0.05 weight % to 2 weight %.

### [Washing]

The washing can be done with, for example, water such as deionized water, organic solvent such as ethanol, and alkaline aqueous solution such as ammonia water. Further, water solutions of inorganic acids such as hydrochloric acid, nitric acid and sulfuric acid or water solutions of organic acids such as acetic acid can also be used, for example for the purpose of improving luminescent characteristics by removing impurity phases such as flux used attached to the surface of the phosphor. In such a case, it is preferable that an additional washing is carried out with water after the washing with acidic aqueous solution.

It is preferable to perform the washing to the extent that the pH of the supernatant fluid obtained by dispersing the washed phsphor in water which is 10 times as heavy as the phosphor and leaving it to stand for 1hour becomes neutral (pH of around 7 to 9). This is because a deviation toward basicity or acidity may affect the liquid medium, to be described later, or the like when the phosphor is mixed with the liquid medium.
The above-mentioned extent of washing can also be indicated by the electric conductivity of the supernatant fluid that is obtained by dispersing the washed phosphor in water which is 10 times as heavy as the phosphor and leaving it to stand for 1 hour. The lower the electric conductivity is, the more preferable, for the sake of higher luminescent characteristics. However, also in consideration of the productivity, it is preferable to repeat the washing treatments until the electric conductivity reaches usually 10 mS/m or lower, preferably 5 mS/m or lower, and more preferably 4 mS/m or lower.

The method for measuring the electric conductivity is as follows. The phosphor particles, which have larger specific gravity than water, are allowed to precipitate spontaneously, by leaving them to stand for 1 hour after they are stirred in water which is 10 times as heavy as the phosphor for a predetermined period of time, for example 10 minutes. The electric conductivity of the supernatant fluid at that time can be measured using a conductance meter "EC METER CM-30G" manufactured by DKK-TOA CORPORATION or the like. There is no special limitation on the water used for the washing treatment and measurement of the electric conductivity, but desalted water or distilled water is preferable. Among them, the one having low electric conductivity is particularly preferable. Its electric conductivity shall be usually 0.0064 mS/m or higher, and usually 1 mS/m or lower, preferably 0.5 mS/m or lower. The measurement of the electric conductivity is usually carried out at a room temperature (around 25°C).

The washing process can be performed, for example in the same way as the washing process performed between the first firing process and the second firing process.

### [Clissification]

The classification treatment can be done by means of, for example, levigation or elutriation. Or otherwise, it can be done using various classifiers such as an air current classifier or vibrating sieve. Particularly, a combination of dry classification using a nylon mesh and levigation can be preferably used to obtain a phosphor of good dispersibility with a weight median diameter of about 20 µm.
In a levigation or elutriation treatment, the pH of the aqueous medium shall be set at usually 4 or larger, preferably 5 or larger, and usually 9 or smaller, preferably 8 or smaller, usually in order for phosphor particles to be dispersed in an aqueous medium at a concentration of around 0.1 weight % to 10 weight % and also to prevent the degradation of the phosphor. In addition, for achieving the phosphor particles with a weight-average median diameter such as described above by a levigation or elutriation treatment, it is preferable to perform two-step sieving in which, for example, particles of 50 µm or smaller are sifted out and then particles of 30 µm or smaller are sifted out, from the standpoint of balance between the operating efficiency and yield. Regarding the lower limit of sieving, it is preferable to sift out particles of usually 1 µm or larger, preferably 5 µm or larger.

### [Surface treatment]

When a light emitting device is produced using the obtained phosphor of the present invention by a method described later, the surface of the phosphors may be subjected to surface treatment if necessary such as covering the surfaces with some foreign compound, in order to improve weatherability such as moisture resistance or improve dispersibility in a resin in the phosphor-containing part of the light emitting device described later.

Examples of the substance that can be applied to the phosphor surface (hereinafter referred to as "surface treatment substance" as appropriate) include: organic compounds, inorganic compounds, and glass materials.
Examples of the organic compounds include: thermofusible polymer such as acrylic resin, polycarbonate, polyamide and polyethylene; latex; and polyorganosiloxane.
Examples of the inorganic compounds includes: metal oxides such as magnesium oxide, aluminum oxide, silicon oxide, titanium oxide, zirconium oxide, tin oxide, germanium oxide, tantalum oxide, niobium oxide, vanadium oxide, boron oxide, antimony oxide, zinc oxide, yttrium oxide and bismuth oxide; metal nitrides such as silicon nitride and aluminum nitride; orthophosphates such as calcium phosphate, barium phosphate and strontium phosphate; polyphosphate; combinations of calcium salt and phosphates of alkali metals and/or alkaline-earth metals such as a combination of calcium nitrate and sodium phosphate; water-soluble fluorides such as NH₄F and KHF₂; and water-soluble aluminates such as aluminum sulfate.
Examples of the glass material include: boron silicate, phosphorus silicate, and alkali silicate.
These surface treatment substances can be used either as a single one or as a combination of two or more kinds in any combination and in any ratio.

The phosphor of the present invention obtained by the above surface treatment has a surface treatment substance existing on its surface. The mode of existence of the surface treatment substance can be as follows, for example.
(i) The above surface treatment substance constitutes a continuous layer and covers the surface of the phosphor.
(ii) The above surface treatment substance is attached to the surface of the phosphor as numerous microparticles and these microparticles cover the surface of the phosphor.

There is no special limitation on the amount of the surface treatment substance which can cover or be attached to the surface of the phosphor, insofar as the advantage of the present invention is not significantly impaired. However, the amount, relative to the weight of the phosphor, is usually 0.1 weight % or more, preferably 1 weight % or more, more preferably 5 weight % or more, still more preferably 10 weight % or more, and usually 50 weight % or less, preferably 30 weight % or less, more preferably 20 weight % or less. When the amount of the surface treatment substance relative to that of the phosphor is too large, the luminescent characteristics of the phosphor may be impaired. When it is too small, the coverage of the surface may be insufficient, and moisture resistance and dispersibility may not be improved.

There is no special limitation on the film thickness (layer thickness) of the surface treatment substance formed by the surface treatment, insofar as the advantage of the present invention is not significantly impaired. However, it is usually 10 nm or larger, preferably 50 nm or larger, and usually 2000 nm or smaller, preferably 1000 nm or smaller. When the layer is too thick, the luminescent characteristics of the phosphor may be impaired. When it is too thin, the coverage of the surface may be insufficient, and moisture resistance and dispersibility may not be improved.

No particular limitation is imposed on the method of such surface treatment. The examples include the following coating treatment method using a metal oxide (silicon oxide).
The phosphor of the present invention is added to an alcohol such as ethanol, mixed and stirred. To this is added an alkaline aqueous solution such as ammonia water, followed by stirring. A hydrolyzable silicic acid alkyl ester such as tetraethyl orthosilicate is then added and the mixture is stirred. The solution obtained is allowed to stand for 3 minutes to 60 minutes, and then the supernatant containing silicon oxide particles which remain unattached to the surface of the phosphor is removed by pipetting or the like. Then, mixing in alcohol, stirring, allowing to stand and removal of the supernatant are repeated several times and a drying is performed under a reduced pressure at 120°C to 150°C for 10 minutes to 5 hours, for example 2 hours. Thereby, a surface-treated phosphor is obtained.

Examples of other surface treatment methods of phosphors include: various known methods such as a method in which spherical silicon oxide fine powder is attached to the phosphor (Japanese Patent Laid-Open Publications No. Hei 2-209989 and No. Hei 2-233794), a method in which a coating film of Si-compound is attached to the phosphor (Japanese Patent Laid-Open Publication No. Hei 3-231987), a method in which the surface of the phosphor microparticles is covered with polymer microparticles (Japanese Patent Laid-Open Publication No. Hei 6-314593), a method in which the phosphor is coated with organic, inorganic, grass and the like materials (Japanese Patent Laid-Open Publication No. 2002-223008), a method in which the surface of the phosphor is covered by means of chemical vapor reaction (Japanese Patent Laid-Open Publication No. 2005-82788), and a method in which particles of a metal compound is attached (Japanese Patent Laid-Open Publication No. 2006-28458). Further, in addition to the above-mentioned treatments, generally known technique relating to publicly known phosphors, which are used for, for example, cathode-ray tube, plasma display panel, fluorescent lamp, fluorescent display tube, X-ray intensifying screen, can be utilized and appropriately selected depending on purposes and uses.

### [3. Characteristics of oxynitride phosphor]

### [3-1. Characteristics regarding crystal structure]

The phosphor of the present invention is usually an oxynitride phosphor having BSON crystal phase (also called Ba₃Si₆O₁₂N₂ crystal phase), which is a crystal phase defined as follows.

### BSON crystal phase:

A crystal phase of which diffraction peak is observed within the range (R0) of diffraction angle (2θ) of 26.9° ∼ 28.2°, in an X-ray diffraction measurement using a CuKα as X-ray source, wherein, when that diffraction peak (P0) is taken as the reference diffraction peak with 5 diffraction peaks (other than the diffraction peaks existing in the angle range of 20.9° ∼ 22.9°) derived from the Bragg angle (θ0) of P0 shown by P1, P2, P3, P4 and P5 respectively in increasing order of angle and with the diffraction angle ranges of these diffraction peaks shown by R1, R2., R3, R4 and R5, R1, R2, R3, R4 and R5 indicate the following angle ranges respectively: $R ⁢ 1 = R ⁢ 1 ⁢ s ∼ R ⁢ 1 ⁢ e , R ⁢ 2 = R ⁢ 2 ⁢ s ∼ R ⁢ 2 ⁢ e , R ⁢ 3 = R ⁢ 3 ⁢ s ∼ R ⁢ 3 ⁢ e , R ⁢ 4 = R ⁢ 4 ⁢ s ∼ R ⁢ 4 ⁢ e , R ⁢ 5 = R ⁢ 5 ⁢ s ∼ R ⁢ 5 ⁢ e ,$
at least one diffraction peak exists in each of the R1, R2, R3, R4 and R5 ranges, and, relative to the highest diffraction peak height among those of P0, P1, P2, P3, P4 and P5, P0 has an intensity of 20 % or stronger in terms of diffraction peak height ratio and at least one of P1, P2, P3, P4 and P5 has a peak intensity of 5 % or stronger, preferably 9 % or stronger in terms of diffraction peak height ratio.

In this context, when two or more diffraction peaks exist in each angle range R0, R1, R2, R3, R4 or R5, the peak having the highest peak intensity of them is taken as P0, P1, P2, P3, P4 or P5.
R1s, R2s, R3s, R4s and R5s, indicating the starting angles of R1 R2, R3, R4 and R5 respectively and R1e, R2e, R3e, R4e and R5e, indicating the ending angles of R1, R2, R3, R4 and R5 respectively, are the following angles: $R ⁢ 1 ⁢ s : 2 \times arcsin \left\{sin\left(θ⁢0\right)/\left(1.994\times 1.015\right)\right\}$ $R ⁢ 1 ⁢ e : 2 \times arcsin \left\{sin\left(θ⁢0\right)/\left(1.994\times 0.985\right)\right\}$ $R ⁢ 2 ⁢ s : 2 \times arcsin \left\{sin\left(θ⁢0\right)/\left(1.412\times 1.015\right)\right\}$ $R ⁢ 2 ⁢ e : 2 \times arcsin \left\{sin\left(θ⁢0\right)/\left(1.412\times 0.985\right)\right\}$ $R ⁢ 3 ⁢ s : 2 \times arcsin \left\{sin\left(θ⁢0\right)/\left(1.155\times 1.015\right)\right\}$ $R ⁢ 3 ⁢ e : 2 \times arcsin \left\{sin\left(θ⁢0\right)/\left(1.155\times 0.985\right)\right\}$ $R ⁢ 4 ⁢ s : 2 \times arcsin \left\{sin\left(θ⁢0\right)/\left(0.894\times 1.015\right)\right\}$ $R ⁢ 4 ⁢ e : 2 \times arcsin \left\{sin\left(θ⁢0\right)/\left(0.894\times 0.985\right)\right\}$ $R ⁢ 5 ⁢ s : 2 \times arcsin \left\{sin\left(θ⁢0\right)/\left(0.756\times 1.015\right)\right\}$ $R ⁢ 5 ⁢ e : 2 \times arcsin \left\{sin\left(θ⁢0\right)/\left(0.756\times 0.985\right)\right\}$

The phosphor of the present invention may show some impurity phase such as cristobalite, which is one of the crystalline forms of silicon dioxide, α-silicon nitride, and β-silicon nitride when carrying out an X-ray diffraction measurement using a CuKα as X-ray source. The content of these impurities can be examined by an X-ray diffraction measurement using a CuKα as X-ray source. Namely, it is preferable that the strongest peak intensity of the impurity phase of the X-ray diffraction measurement results, is usually 40% or weaker, preferably 30% or weaker, more preferably 20% or weaker, still more preferably 10% or weaker, relative to the strongest peak intensity of the P0, P1, P2, P3, P4 and P5. Particularly, it is preferable that a peak of the impurity phase is not observed and BSON crystal phase is present as a single phase. In such a case, the emission intensity can be enhanced.

Further, concerning crystal structure of the phosphor of the present invention, it is preferable that the strongest peak intensity of the impurity phase of the X-ray diffraction measurement results is, when carrying out an X-ray diffraction measurement using a CuKα as X-ray source, usually 2% or weaker, preferably 1.8% or weaker, more preferably 1.6% or weaker, and ideally 0%, relative to the strongest peak intensity of the intended phosphor phase. In this context, the intended crystal phase means a crystal phase occupying the largest portion of the crystal phases of the phosphor of the present invention, and the impurity phase means crystal phases other than the intended crystal phase. Examples of the impurity phase mainly include: glass phases, oxides and/or nitrides originating from raw materials. The above-mentioned small peak intensity ratio represents that there is little impurity phase contained in the phosphor of the present invention. Therefore, it is estimated that the phosphor of the present invention can exhibit superior durability.

Examples of the methods for decreasing the above-mentioned peak intensity ratios as described above include: optimization of the mixing ratio of the phosphor materials, optimization of the firing conditions for sufficient solid state reaction, and use of flux. However, the methods for decreasing the above-mentioned peak intensity ratios are not limited to those exemplified above, and the advantageous effects of the present invention can be achieved even when decreasing the above-mentioned peak intensity ratios by other means.

### [3-2. Characteristics regarding emission spectrum]

It is preferable that the phosphor of the present invention has the following emission spectrum characteristics when measured with excitation light of 400-nm wavelength, in consideration of its use as green phosphors.

First, it is preferable for the phosphor of the present invention to have a peak wavelength λₚ (nm) of the above-mentioned emission spectrum around 525 nm. Specifically, it is in the range of usually longer than 500 nm, particularly 510 nm or longer, further particularly 515 nm or longer, and usually 550 nm or shorter, particularly 540 nm or shorter, further particularly 535 nm or shorter. When the emission peak wavelength λₚ is too short, the color tends to be bluish green. On the other hand, when it is too long, the color tends to be yellowish green. In both cases, performance when used as green lights may deteriorate.

In addition, it is preferable that the phosphor of the present invention has a full width at half maximum (hereinafter abbreviated as "FWHM" as appropriate) of the emission peak in the above emission spectrum in the range of usually wider than 40 nm, particularly 50 nm or wider, further particularly 60 nm or wider, and usually narrower than 90 nm, particularly 80nm or narrower, further particularly 75 nm or narrower. When the full width at half maximum, FWHM, is too narrow, the emission brightness will decrease in use as illuminating devices, leading to too low color rendering. When it is too wide, the color purity will decrease in use as displays such as liquid crystal displays, leading to too narrow color reproduction range of the display.

For excitation of the phosphor of the present invention with 400-nm wavelength light, a GaN-based LED can be used, for example. The measurement of the emission spectrum of the phosphor of the present invention and the calculation of its emission peak wavelength, relative peak intensity and full width at half maximum of the peak can be carried out by using a fluorescence measurement apparatus (manufactured by JASCO corporation) equipped with a 150-W xenon lamp as excitation light source and a multichannel CCD detector C7041 (manufactured by Hamamatsu Photonics K.K.) as spectrum measurement apparatus, for example.

### [3-3. Temperature characteristics]

The phosphor of the present invention is also superior in temperature characteristics. Specifically, the ratio of the emission peak intensity in the emission spectral map at 150°C relative to the emission peak intensity value in the emission spectral map at 28°C is usually 55% or more, preferably 60% or more, and particularly preferably 70% or more, when irradiated with light having 455-nm wavelength.
In addition, the ratio of the emission peak intensity in the emission spectral map at 100°C relative to the emission peak intensity value in the emission spectral map at 20°C is usually 70% or more, preferably 75% or more, and particularly preferably 80% or more, when irradiated with light having 455-nm wavelength.
Furthermore, though this ratio of ordinary phosphors rarely exceeds 100% because its emission intensity decreases with increasing temperature, it can exceed 100% for some reason. However, over 150% of that ratio tends to lead to color shift due to the temperature change.

The phosphor of the present invention is superior not only in the above-mentioned emission peak intensity but also in brightness. More specifically, when irradiated with light having wavelength of 455 nm, the ratio of the brightness at 150°C to the brightness at 20°C is usually 55% or more, preferably 60% or more, and particularly preferably 70% or more.
In addition, when irradiated with light having wavelength of 455 nm, the ratio of the brightness at 100°C to the brightness at 20°C is usually 70% or more, preferably 75% or more, and particularly preferably 80% or more.

In the phosphor of the present invention, change in emission-peak wavelength associated with temperature change is also small. Specifically, when the emission-peak wavelength at 20°C is represented by λ₂₀, the emission-peak wavelength at 150°C is in the range of usually λ₂₀-10 nm or longer, preferably λ₂₀-5 nm or longer, more preferably λ₂₀-3 nm or longer, and usually λ₂₀+10 nm or shorter, preferably λ₂₀+5 nm or shorter, more preferably λ₂₀+3 nm or shorter.

Furthermore, change in luminescent color of the phosphor of the present invention is also small. Specifically, when the color coordinates X and Y at 20°C is represented by X₂₀ and Y₂₀ respectively according to color coordinates (CIEx, CIEy) based on JIS Z8701, the X value at 150°C is in the range of usually X₂₀-0.03 or larger, and usually X₂₀+0.03 or smaller, and the Y value at 150°C is in the range of usually Y₂₀-0.03 or larger, and usually Y₂₀+0.03 or smaller.

The above-mentioned temperature characteristics can be examined as follows, for example, using an emission spectrum device of multi-channel spectrum analyzer MCPD7000 manufactured by Otsuka Electronics Co., Ltd., a stage equipped with a cooling mechanism using a peltiert device and a heating mechanism using a heater, and a light source device equipped with a 150-W xenon lamp. A cell holding the phosphor sample is put on the stage, and the temperature is changed within the range from 20°C to 150°C. After verifying the surface temperature of the phosphor is held at 20°C or 150°C, the emission spectrum of the phosphor is measured when it is excited with light from the light source having wavelength of 455 nm, which is separated using a diffraction grating. Then the emission peak intensity and brightness can be decided from the measured emission spectrum. At this point, as the measurement value of the surface temperature of the phosphor on the side irradiated with the excitation light, is used a value corrected by the temperature values measured with a radiation thermometer and a thermocouple. When two or more emission peaks appear, the largest emission peak intensity preferably meets the above requirement.

The above-mentioned color coordinates can be calculated as color coordinates CTEx and CIEy in the XYZ colorimetric system defined in JIS Z8701 by a method according to JIS Z8724 from wavelength region data, namely, emission spectrum of 380 nm to 800 nm (for an excitation wavelength of 340 nm), 430 nm to 800 nm (for an excitation wavelength of 400 nm), and 480 nm to 800 nm (for an excitation wavelength of 455 nm) .

### [3-4. Excitation wavelength]

It is preferable that the phosphor of the present invention can be excited by light of which the wavelength range is from 200 nm to 500 nm. Furthermore, when it is used for a light emitting device in which a semiconductor element is used as the first luminous body and the light thereof is used as the excitation light source for the phosphor, it is preferable that, for example, it can be excited by light of blue region (wavelength range: 420 nm to 500 nm) and/or light of near-ultraviolet region (wavelength range: 300 nm to 420 nm).

In addition, it is preferable that the ratio of the emission peak intensity value in the emission spectral map when irradiated with light having wavelength of 410 nm relative to the peak intensity value in the emission spectral map when irradiated with light having wavelength of 390 nm is 90 % or more. The emission spectrum can be measured in the same way as described above by exciting the phosphor with light having wavelength of 390 nm or 410 nm, which is derived from a light source using a diffraction grating. Then the emission peak intensity can be decided from the measured emission spectrum. When two or more emission peaks appear, the largest emission peak intensity preferably meets the above requirement.

### [3-5. Luminescent color]

The chromaticity coordinates of the luminescent color of the phosphor of the present invention, according to JIS 28701, preferably satisfy the following relations. The value of x is usually 0.100 or larger, preferably 0.150 or larger, more preferably 0.200 or larger, and usually 0.400 or smaller, preferably 0.380 or smaller, more preferably 0.360 or smaller, still more preferably 0.3 or smaller, particularly preferably 0.29 or smaller. The value of y is usually 0.480 or larger, preferably 0.490 or larger, more preferably 0.495 or larger, still more preferably 0.5 or larger, especially preferably 0.55 or larger, particularly preferably 0.6 or larger, and usually 0.670 or smaller, preferably 0.660 or smaller, more preferably 0.655 or smaller. The luminescent color of the phosphor of the present invention can be varied within the above-mentioned ranges while maintaining the brightness by adjusting the amounts of M¹ element and M² element and carrying out firing in the presence of flux.

### [3-6. Solubility]

The phosphor of the present invention is usually difficult to solve in solvents such as acids. Preferably, it is insoluble in water and/or 1N hydrochloric acid.

### [3-7. Durability]

The phosphor of the present invention is not decomposed, in a durability test of 2-hours heating under a nitrogen atmosphere, even at usually 1000°C or higher, preferably 1200°C or higher, more preferably 1300°C, more preferably 1500°C or higher, and particularly preferably 1700°C or higher.

Further, the phosphor of the present invention, which is excellent in durability as described above, is **characterized in that** its emission intensity hardly decreases even after a long time use. Specifically, the phosphor of the present invention is stable in a durability test at a temperature of 85°C and relative humidity of 85% usually for over 200 h, preferably for over 500 h, more preferably for over 600 h, and particularly preferably for over 800 h. In such a case, the longer the time for which it is stable, the more preferable. However, it is usually fully sufficient for it to be stable for as long as 1000 h. In this context, the word "stable" means that the ratio of the emission intensity after the durability test relative to that before the durability test is 50% or larger. Such durability can be measured by energization with current of 20 mA at a temperature of 85°C and relative humidity of 85% using an LED aging system manufactured by Yamakatsu Electronics Industry Co., Ltd. However, it can be measured using other similar equipment.

Moreover, in the case of the phosphor of the present invention that is produced through a reheating process, change in the color coordinate CIEy based on JIS Z 8701 of the phosphor that is dispersed in a silicone resin at a concentration of 6 weight %, measured after an energization with a current density of 255 mA/mm² and a light output of 0.25 to 0.35 W/mm² for 500hours at a temperature of 85°C and relative humidity of 85%, is within the range of usually ± 30%, preferably ± 25%, more preferably ± 20 of the color coordinate CIEy based on JIS Z 8701 of the same phosphor measured before the energization.

The brightness retention rate of the light emission after 100 hours have passed from the beginning of the excitation light irradiation relative to that at the beginning of the excitation light irradiation is usually 83% or larger, preferably 85% or larger, more preferably 90% or larger.
To obtain an excitation light for irradiation on the phosphor having the above-mentioned current density and light output, for example, C460EZ290 (manufactured by Cree, Inc., wavelength range of 455 nm to 457.4 nm) energized with 20 mA can be used. As the silicone resin where the phosphor is dispersed, SCR1101 manufactured by Shin-Etsu Chemical Co., Ltd. can be used, for example.

The reason for which a reheating process can contribute to the durability as excellent as described above of the phosphor of the present invention is not clear. According to an investigation by the present inventors, it is probably due to decrease in the number of lattice defects, which trap electrons excited by light.

### [3-8. Particle diameter]

It is preferable that the weight median diameter D₅₀ of the phosphor of the present invention is in the range of usually 0.01 µm or larger, preferably 1 µm or larger, more preferably 5 µm or larger, still more preferably 10 µm or larger, and usually 100 µm or smaller, preferably 30 µm or smaller, more preferably 20 µm or smaller. When the weight median diameter D₅₀ is too small, the brightness will decrease and the phosphor particles tend to aggregate. On the other hand, the weight median diameter D₅₀ is too large, unevenness in coating, clogging in a dispenser, or the like may occur.

The particle diameter distribution QD of the phosphor of the present invention is usually 0.5 or smaller, preferably 0.3 or smaller, particularly preferably 0.25 or smaller, and usually 0.1 or larger.
When a mixture of two or more kinds of phosphors having different weight median diameters D₅₀ is used for the purpose of enhancing the emission efficiency and/or absorption efficiency, the QD of the phosphor mixture may be larger than 0.3.

The above-mentioned weight median diameter D₅₀ is a value obtained from the frequency-standard particle size distribution curve. The frequency-standard particle size distribution curve can be obtained from the measurement of the particle size distribution by laser diffraction/scattering method. Specifically, it can be obtained from a measurement on phosphor particles dispersed in water solution containing dispersant using a laser diffraction particle size analyzer (LA-300, manufactured by HORIBP, Ltd.) in a particle diameter range of from 0.1 µm to 600 µm. Weight median diameter D₅₀ is defined as the value of particle diameter whose integrated value is 50% in this frequency-standard particle size distribution curve. The particle diameters with 25% and 75% integrated values are represented by D₂₅ and D₇₅ respectively. The standard deviation (quantile deviation) QD is defined as: QD=(D₇₅-D₂₅)/(D₇₅+D₂₅). A small QD means a narrow particle size distribution.

The aspect ratio of phosphor particles can be obtained by dividing the length along the longer axis by the biggest thickness in the direction orthogonal to the longer axis, of the phosphor crystalline particle observed with a scanning electron microscope (SEM). In the phosphor of the present invention, the ratio of the crystalline particles with an aspect ratio of between 0.5 and 1 inclusive is usually 50% or higher, preferably 80% or higher, more preferably 90% or higher, particularly preferably 95%, when at least 50 crystalline particles are observed with an SEM by the above-mentioned method.

Particles of a phosphor are usually comprised of secondary particles, which is made of aggregated primary particles. The average particle diameter of the primary particles is usually 2 µm or larger, preferably 5 µm or larger, more preferably 10 µm or larger, and usually 30 µm or smaller, preferably 20 µm or smaller, more preferably 15 µm or wmaller.

The electric conductivity of the supernatant fluid of the dispersion liquid that is obtained by dispersing the phosphor of the present invention in water which is 10 times as heavy as the phosphor and leaving it to stand for 1hour is preferably low for the sake of higher luminescent characteristics. However, also in consideration of the productivity, it is usually 10 mS/m or lower, preferably 5 mS/m or lower, and more preferably 4 mS/m or lower. The pH of the supernatant fluid then is usually 4 or greater, preferably 5 or greater, more preferably 6 or greater, and usually 10 or smaller, preferably 9 or smaller, more preferably 8 or smaller.

The method for measuring the electric conductivity is as follows. The particles, which have larger specific gravity than water, are allowed to precipitate spontaneously, by leaving them to stand for 1hour after they are stirred in water which is 10 times as heavy as the phsophor for a predetermined period of time, for example 10 minutes. The electric conductivity of the supernatant fluid at that time can be measured using a conductance meter "EC METER CM-30G" manufactured by DKK-TOA CORPORATION or the like. There is no special limitation on the water used for the washing treatment and measurement of the electric conductivity, but desalted water or distilled water is preferable. Among them, the one having low electric conductivity is particularly preferable. Its electric conductivity shall be usually 0.0064 mS/m or higher, and usually 1 mS/m or lower, preferably 0.5 mS/m or lower. The measurement of the electric conductivity is usually carried out at a room temperature (around 25°C).

In the phosphor of the present invention, which is produced by firing in the presence of flux, the balance between the quantum efficiency and particle diameter can be improved. Specifically, there is a tendency that the particle diameters of the primary particles become large, and QD of the secondary particles becomes small.

### [3-9. Quantum efficiencies]

The higher the internal quantum efficiency of the phosphor of the present invention is, the more preferable. It is usually 0.5 or higher, preferably 0.6 or higher, more preferably 0.7 or higher, still more preferably 0.75 or higher, particularly preferably 0.8 or higher. In this context, internal quantum efficiency means ratio of the number of emitted photons to the number of photons of the excitation light that is absorbed into the phosphor. When internal quantum efficiency is low, emission efficiency, namely external quantum efficiency, tends to decrease.

Also, the higher the absorption efficiency of the phosphor of the present invention is, the more preferable. It is usually 0.5 or higher, preferably 0.6 or higher, more preferably 0.65 or higher, still more preferably 0.7 or higher. External quantum efficiency is calculated as the product of internal quantum efficiency and absorption efficiency. When absorption efficiency is low, emission efficiency, namely external quantum efficiency tends to decrease.

The external quantum efficiency is usually 0.2 or higher, preferably 0.3 or higher, more preferably 0.35 or higher, still more preferably 0.4 or higher, still further more preferably 0.45 or higher, particularly preferably 0.5 or higher. Especially when at least a part of L is Si element in the general formula [I], the external quantum efficiency can be adjusted to be 0.35 or higher by using a crystalline silicon nitride with high reflectance described earlier as material. The higher the external quantum efficiency is, the more preferable, for designing a light emitting device with high emission intensity.

### [Method for measuring absorption efficiency, internal quantum efficiency and external quantum efficiency]

In the following, methods for determining the absorption efficiency αq, internal quantum efficiency ηi and external quantum efficiency ηo of phosphors will be described.

First, a phosphor sample to be measured (for example in a state of powder or the like) is stuffed up in a cell with its surface smoothed sufficiently to keep high measurement accuracy, and then it is set on a condenser such as an integrating sphere. The reason for using a condenser such as an integrating sphere is to count up all the photons both reflected at and emitted, by fluorescence phenomenon, from the phosphor sample. In other words, it is to prevent failure in counting photons going out of the measurement system.

A light emission source for exciting the phosphor is attached on the condenser such as an integrating sphere. This light emission source, an Xe lamp for example, is adjusted using a filter, monochromator (grating monochromator) or the like so that the emission peak wavelength thereof will be that of a monochromatic light of for example, 405 nm or 455 nm. Then the spectra including those of emitted light (fluorescence) and reflected light are measured using a spectrometer, such as MCPD2000 or MCPD7000 manufactured by Otsuka Electronics Co., Ltd., by irradiating the phosphor sample to be measured with the light from the light emission source of which emission peak wavelength is adjusted. The lights of which spectra are measured actually include, among lights from the excitation light source (hereinafter simply referred to as "excitation lights"), reflected lights that are not absorbed in the phosphor and emitted lights (fluorescences) having different wavelengths from the reflected lights emitted by fluorescence phenomenon from the phosphor which absorbed the excitation lights. Namely, the region close to the excitation light corresponds to the reflection spectrum, and the region of which wavelengths are longer than that corresponds to the fluorescence spectrum (occasionally referred to as "emission spectrum").

Absorption efficiency αq takes the value of N_{abs}/N, where N_{abs} is the number of photons of the excitation light that is absorbed in the phosphor sample and N is the number of all the photons in the excitation light.

First, the latter one, the total number N of all the photons in the excitation light is determined as follows. That is, the reflection spectrum I_{ref}(λ) is measured using the spectrometer with respect to a substance to be measured, having reflectance R of approx. 100% to the excitation light, such as a reflection plate "Spectralon" manufactured by Labsphere (with 98% of reflectance to an excitation light of 450 nm wavelength), which is attached to the above condenser such as an integrating sphere in the same disposition as the phosphor sample. The value in the following (formula A), calculated from this reflection spectrum I_{ref}(λ), is proportional to N.

$\begin{matrix}\left[Mathematical Formula 1\right] \\ \frac{1}{R} \int λ ⋅ {I}_{ref} \left(λ\right) ⅆ λ\end{matrix}$

In this formula, the integration may be performed at only such intervals that I_{ref}(λ) takes a substantially significant value.
The number N_{abs} of the photons in the excitation light that is absorbed in the phosphor sample is proportional to the amount calculated in the following (formula B).

$\begin{matrix}\left[Mathematical Formula 2\right] \\ \frac{1}{R} \int λ ⋅ {I}_{ref} \left(λ\right) ⅆ λ - \int λ ⋅ I \left(λ\right) ⅆ λ\end{matrix}$

Here, the function I(λ) is a reflection spectrum when the target phosphor sample, of which absorption efficiency αq is intended to be determined, is attached. The integration interval in (formula B) is set to be the same as in (formula A). By restricting the integration interval as above, the second term in (formula B) comes to correspond to the number of photons emitted from the measurement object, namely the phosphor sample, by the reflection of the excitation light. In other words, it comes to correspond to the number of all photons emitted from the measurement object, namely the phosphor sample, except for the number of photons emitted by fluorescence phenomenon. Because the actual measurement value of the spectrum is generally obtained as digital data which are divided by a certain finite band width relating to λ, the integrations of (formula A) and (formula B) are calculated as a finite sum, based on the band width.
Consequently, αq can be calculated as: $αq = {N}_{abs} / N = \left(formula B\right) / \left(formula A\right) .$

Next, a method for determining internal quantum efficiency ηi will be described. The internal quantum efficiency ηi takes the value of N_{PL}/N_{abs}, where N_{PL} is the number of photons originating from the fluorescence phenomenon and N_{abs} is the number of photons absorbed in the phosphor sample.
Here, N_{PL} is proportional to the amount calculated by the following (formula C).

$\begin{matrix}\left[Mathematical Formula 3\right] \\ \int λ ⋅ I \left(λ\right) ⅆ λ\end{matrix}$

At this point, the integration interval is restricted to the wavelength region of photons that are originating from the fluorescence phenomenon of the phosphor sample. This is because contribution of the photons reflected from the phosphor sample can be eliminated from I(λ). More specifically, the lower limit of the integration interval in (formula C) takes the value of upper limit of the integration interval in (formula A), and the upper limit thereof takes the value that is necessary and sufficient for including the photons originating from the fluorescence.
Consequently, internal quantum efficiency ηi can be calculated as: ηi=(formula C)/(formula B).

Incidentally, the integration from spectra expressed by digital data can be performed in the same way as when absorption efficiency αq is calculated.
The external quantum efficiency ηo can be decided as the product of the absorption efficiency αq and internal quantum efficiency ηi, which are obtained as above. In another way, it can be determined using a relation of ηo=(formula C) / (formula A). The value ηo is equal to N_{PL}/N, where N_{PL} is the number of photons originating from the fluorescence and N is the number of total photons in the excitation light.

### [3-10. Non-luminous object color]

The non-luminous object color of the phosphor of the present invention, when it is produced using crystalline silicon nitride with high reflectance describe earlier as material silicon nitride, is usually more brilliant than that of conventional phosphors having the same composition. Specifically, it is preferable that the non-luminous object color represented by the L*a*b* colorimetric system satisfies any one of L* value is 97 or larger, a* value is -21 or smaller, and b* value is 35 or larger.
A larger L* value indicates a more brilliant color. It is preferably 100 or larger, more preferably 103 or larger.
A smaller a* value indicates a more brilliant green color. It is preferably -23 or smaller, more preferably -25 or smaller. It usually takes a value of -60 or larger.
A larger b* value indicates a more bright green color. It is preferably 35 or larger, more preferably 40 or larger. On the other hand, the upper limit of b* value is theoretically 200 or smaller. However, it is preferable that it is usually 120 or smaller. This is because too large a b* value shifts luminous wavelengths to longer wavelengths, leading possibly to decrease in emission intensity.

A non-luminous object color represents the color of light reflected on a substance, and it can be expressed by the L*a*b* colorimetric system (see JIS Z8113). In the present invention, L*, a* and b* values are determined by irradiating measurement objects (namely, phosphors) with a predetermined light source (a white light source, for example, the standard illuminant D65) and separating the obtained reflected light with a filter. The measurement values are such that, though they depend on the hue of each phosphor, the larger the numerical value of L* is, and the larger the absolute values of a* and b* are, the color tends to be more brilliant.

L* values of phosphor non-luminous object colors sometimes exceed 100 because luminescence excited by an irradiation light source is sometimes superimposed on the reflected light. However, it is usually 110 or smaller. Non-luminous object colors of the phosphors of the present invention can be measured with, for example, a commercially available apparatus for measuring non-luminous object color (such as, CR-300, manufactured by MINOLTA).

### [4. Phosphor produced using silicon nitride of the present invention as phosphor material]

As described earlier, phosphors produced using silicon nitrides of the present invention as at least a part of the phosphor materials usually have higher quantum efficiency and higher chroma of non-luminous object color, preferably as well as higher brightness, than known phosphors having the same compositions. These are advantageous effects that can be achieved even by the phosphors other than those represented by the above-mentioned general formula [I]. Such a relationship between phosphor characteristics, such as quantum efficiency and chroma of non-luminous object color, and the reflectance of the phosphor material (in particular, of the above-mentioned silicon nitride) is newly discovered by the present inventors. Hereinafter, explanation will be given focusing on phosphors produced by using silicon nitrides of the present invention as a phosphor material. In the explanation below, "phosphors of the present invention" does not indicate phosphors represented by the formula [I] alone, but widely indicates phosphors according to the present invention.

Examples of phosphors produced by using silicon nitrides of the present invention as a phosphor material include: nitride phosphors and oxynitride phosphors containing silicon atom.

Examples of such nitride phosphors and oxynitride phosphors containing silicon atom include: nitrido-silicates typified by alkaline-earth metal silicon nitride phosphors such as CaSiN₂:Eu, ZnSiN₂:Mn, (Ca, Sr, Ea, Zn)₂Si₅N₈:Eu, (Ca,Sr,Ba,Zn)Si₇N₁₀:Eu and (Ca,Sr,Ba)Si(N,O)₂:Eu, and trivalent rare-earth element-containing silicon nitride phosphors such as La₃Si₆(N,O)₁₁:Ce and LaSi₃(N,O)₅:Ce; nitrido-aluminosilicates typified by Si and Al-containing nitride phosphors such as (Ca,Sr)AlSi(N,O)₃:Eu, (Ca,Sr,Ba)AlSi(N,O)₃:Ce, (Ca,Sr)AlSi₄(N,O)₇:Eu and (Ca,Sr,Ba)AlSi₄(N,O)₇:Ce; oxonitrido-silicates typified by alkaline-earth metal silicon nitride phosphors such as (Ca,Sr,Ba)Si₂O₂N₂:Eu, Ba₃Si₆O₁₂N₂:Eu, (Ca,Sr,Ba)₃(Si,Ge)₆O₁₂N₂:(Eu,Ce,Mn), (Ca,Sr,Ba)₃(Si,Ge)₆O₉N₄:(Eu,Ce,Mn), (Ca,Sr,Ba)₃(Si,Se)₆O₃N₈:(Eu,Ce,Mn), (Ca,Sr,Ba)₃(Si,Ge)₇O₁₂N_{8/3}:(Eu,Ce,Mn), (Ca,Sr,Ba)₃(Si,Ge)₈O₁₂N_{14/3}:(Eu,Ce,Mn), (Ca,Sr,Ba)₃(Si,Ge)₈O₁₂N₆:(Eu,Ce,Mn), (Ca,Sr,Ba)₃(Si,Ge)_{28/3}O₁₂N_{22/3}:(Eu,Ce,Mn), (Ca,Sr,Ba)₃(Si,Ge)_{29/3}O₁₂N_{26/3}:(Eu,Ce,Mn), (Ca,Sr,Ba)₃(Si,Ge)_{6.5}O₁₃N₂:(Eu,Ce,Mn), (Ca,Sr,Ba)₃(Si,Ge)₇O₁₄N₂:(Eu,Ce,Mn), (Ca,Sr,Ba)₃(Si,Ge)₈O₁₆N₂:(Eu,Ce,Mn), (Ca,Sr,Ba)₃(Si,Ge)₉O₁₈N₂:(Eu,Ce,Mn), (Ca,Sr,Ba)₃(Si,Ge)₁₀O₂₀N₂:(Eu,Ce,Mn) and (Ca,Sr,Ba)₃(Si,Ge)₁₁O₂₂N₂:(Eu,Ce,Mn), and trivalent rare-earth element-containing silicon nitride phosphors such as La₃Si₈O₄N₁₁:Ce and La₃Si₆O₁₂N₂:Ce; oxonitrido-aluminosilicates typified by Si and Al-containing oxynitride phosphors such as Ca-α-SiAlON:Eu, Y-α-SiAION:Ce, β-SiAION:Eu, SrSi₉Al₁₉ON₃₁:Eu and SrSiAl₂O₃N₂:Eu; and carbonitrido-aluminosilicates typified by phosphors of which the host crystal is CaSi₅N₆.

Of these, phosphors represented by the formulas [II] to [IV] below, in addition to phosphors represented by the above-mentioned formula [I], are preferable. In particular, phosphors represented by the formula [II] below are preferable because they can exhibit the above-mentioned advantageous effects remarkably.

M³ₑ(Ca,Sr,Ba)₁₋ₑSi₂O₂N₂ [II]

(In the formula [II], M³ represents an activation element and e represents a positive number satisfying 0<e≤0.2.)

M⁴_{f}M⁵gAlSiX₃ [III]

(In the formula [III], M⁴ represents an activation element containing at least Eu, M⁵ represents one or more kinds of elements selected from alkaline-earth metal elements, X represents one or more kinds of elements selected from the group consisting of O and N, and f and g represent positive numbers satisfying 0<f≤0.2 and 0.9≤-f+g≤1.)

m⁶ₕ(Ca,Sr,Ba,Zn)ⱼSi₅X₈ [IV]

(In the formula [IV], M⁶ represents an activation element, X represents one or more kinds of elements selected from the group consisting of O and N,hours represents a posit-ive number satisfying 0<h≤0.4, and j represents a numerical value satisfying 1-h<j≤2-h.)

### [4-1. Composition of phosphor of the present invention represented by the formula [II]]

M³ₑ(Ca,Sr,Ea)₁₋ₑSi₂O₂N₂ [II]

(In the formula [II], M³ represents an activation element and e represents a positive number satisfying 0 < e ≤ 0.2.)

In the above-mentioned formula [III], M³ represents an activation element. Examples of M³ include the same metal elements as exemplified for M¹ of the above-mentioned formula [I].
In the formula [II], e represents a numerical value of larger than 0, preferably 0.001 or larger, more preferably 0.005 or larger, and the upper limit thereof is 0.2 or smaller, more preferably 0.15 or smaller.

### [4-2. Characteristics of phosphor of the present invention represented by the formula [II]]

### (Characteristics regarding emission spectrum)

The emission-peak wavelength of the phosphor of the present invention represented by the formula [II] changes within the range of blue or green to yellow, depending on the kind of the alkaline-earth metal used. It is preferable that it shows the following characteristics when measuring the emission spectrum with excitation light of 400-nm wavelength, in consideration of its use as phosphors.

First, it is preferable for the phosphor of the present invention represented by the formula [II] to have a peak wavelength λp (nm) of the above-mentioned emission spectrum, when the number of moles of Ba of (Ca,Sr,Ba) is 70% or larger, in the range of usually 410 nm or longer, particularly 420 nm or longer, further particularly 430 nm or longer, and usually 480 nm or shorter, particularly 470 nm or shorter. On the other hand, when the molar ratio of Ba of (Ca,Sr,Ba) is smaller than 70%, the peak wavelength λp (nm) of the above-mentioned emission spectrum is in the range of usually longer than 500 nm, preferably 510 nm or longer, more preferably 515 nm or longer, and usually 600 nm or shorter, preferably 590 nm or shorter, more preferably 580 nm or shorter.

In addition, it is preferable that the phosphor of the present invention represented by the formula [II] has an FWHM of the emission peak in the above emission spectrum in the range of usually wider than 40 nm, particularly 50 nm or wider, further particularly 60 nm or wider, and usually narrower than 120 nm or narrower, particularly 110 or narrower, further particularly 100 nm or narrower. When the full width at half maximum, FWHM, is too narrow, the emission brightness will decrease in use as illuminating devices, leading to too low color rendering. When it is too wide, the color purity will decrease in use as displays such as liquid crystal displays, leading to too narrow color reproduction range of the display.

In the phosphor of the present invention represented by the formula [II], the emission spectrum can be measured, and the emission-peak wavelength, relative peak intensity and full width at half maximum of the peak of the emission spectrum can be calculated, in the same way as described in the section of the phosphor of the present invention represented by the formula [I].

### (Luminescent color)

The color coordinates according to JIS Z8701 of the luminescent color of the phosphor of the present invention represented by the formula [II] in the case of blue-light emission is as follows. Namely, in the case of blue light emission, x is usually 0.3 or smaller, preferably 0.25 or smaller, more preferably 0.2 or smaller, and y is usually 0.6 or smaller, preferably 0.5 or smaller, more preferably 0.4 or smaller. On the other hand, in the case of green to yellow light emission, x is usually 0.2 or larger, 0.65 or smaller, and y is usually 0.35 or larger, 0.7 or smaller.

### (Non-luminous object color)

The non-luminous object color of the phosphor of the present invention represented by the formula [II] is usually more brilliant than that of conventional phosphors having the same composition. Specifically, it is preferable that the non-luminous object color represented by the L*a*b* colorimetric system satisfies any one of L* value of 103 or larger, a* value of -23 or smaller, and b* value of 63 or larger.
A larger L* value indicates a more brilliant color. It is preferably 70 or larger, preferably 80 or larger, more preferably 90 or larger, much more preferably 100 or larger, still much more preferably 103 or larger, particularly preferably 105 or larger.
A smaller a* value indicates a more brilliant green color. It is preferably -20 or smaller, more preferably -23 or smaller, much more preferably -24 or smaller. It usually takes a value of -60 or larger.
A larger b* value indicates a more bright green color. It is usually 35 or larger, preferably 45 or larger, much more preferably 63 or larger, particularly preferably 70 or larger. On the other hand, the upper limit of b* value is theoretically 200 or smaller. However, it is preferable that it is usually 120 or smaller. This is because too large a b* value shifts luminous wavelengths to longer wavelengths, leading possibly to decrease in brightness.

### (Quantum efficiencies)

The phosphor of the present invention represented by the formula [II] has an external quantum efficiency higher than that of conventional phosphors having the same composition. Specifically, the external quantum efficiency is usually 0.57 or higher, preferably 0.60 or higher, more preferably 0.62 or higher. The higher the external quantum efficiency is, the more preferable, for designing a light emitting device with high emission intensity.

The internal quantum efficiency of the phosphor of the present invention represented by the formula [II] is usually 0.5 or higher, preferably 0.6 or higher, more preferably 0.7 or higher, still more preferably 0.75 or higher. In this context, internal quantum efficiency means ratio of the number of emitted photons to the number of photons of the excitation light that is absorbed into the phosphor. When the internal quantum efficiency is low, the emission efficiency tends to decrease.

Also, the higher the absorption efficiency of the phosphor of the present invention represented by the formula [II] is, the more preferable. It is usually 0.6 or higher, preferably 0.7 or higher, more preferably 0.75 or higher, still more preferably 0.8 or higher. Since external quantum efficiency is calculated as the product of internal quantum efficiency and absorption efficiency, the higher the absorption efficiency is, the more preferable, for higher external quantum efficiency.

The characteristics of the phosphor of the present invention represented by the formula [II] other than described above, such as temperature characteristics, excitation wavelength, solubility, durability, and particle diameter, are usually the same as those of the phosphor of the present invention represented by the formula [I].

### [4-3. Characteristics of phosphor of the present invention represented by the formula [II']]

Among the phosphors of the present invention represented by the formula [II], yellow phosphors represented by the formula [II'] below, of which the emission-peak wavelength is 550 nm to 570 nm, has a characteristic feature that its L* value is 100 or larger and b* value is 77 or larger.

M³ₑ(Sr,Ea)₁₋ₑSi₂O₂N₂ [II']

(In the above formula [II'], M³ represents an activation element and e represents a positive number satisfying 0<e≤0.2.)

### [4-4. Production method of phosphor using silicon nitride of the present invention as phosphor material]

There is no special limitation on the production method of phosphors of the present invention using the silicon nitride of the present invention as a phosphor material, insofar as the above-mentioned silicon nitride is used as at least a part of the raw materials. Any known production method of phosphors can be adopted. In particular, the phosphor of the present invention represented by the formula [II] can be produced in the same way as when producing the above-mentioned phosphor of the present invention represented by the formula [I] except that the phosphor materials corresponding to the formula [II] are used and the silicon nitride of the present invention is used as at least a part of Si source. In such a way, the same advantageous effects as those for the phosphor of the present invention represented by the formula [I] can be preferably achieved.

However, the optimum firing temperature differs for each target phosphor. In the case of production of the phosphor of the present invention represented by the formula [II], a powder with good crystallinity can be obtained by firing at temperatures around 1500°C. Therefore, the firing temperature for producing the phosphor of the present invention represented by the formula [II] is usually 1250°C or higher, preferably 1300°C or higher, and usually 1700°C or lower, preferably 1600°C or lower.

Furthermore, for the production of it, methods described in the aforementioned sections [2-5. Multistep firing] and [2-7. Post treatment] can be utilized, such as:
(i) Phosphors are obtained by firing in the presence of a flux, the firing process including a first firing process and second firing process.
(ii) Phosphors are obtained through a reheating process performed after firing of a phosphor precursor in the presence of a flux.
By these production methods, the respectively corresponding advantageous effects can be usually obtained.
For the phosphor represented by the formula [II], its heat treatment temperature in the reheating process is, though it depends on the atmosphere of the heat treatment, usually 1250°C or lower, preferably 1200°C or lower, and usually 600°C or higher, preferably 800°C or higher.

### [6. Use of phosphor]

The phosphor of the present invention can be used for any purpose in which phosphors are used. Particularly, it can be used preferably for various light emitting devices ("light emitting devices of the present invention" to be described later), making the most of such characteristics that it can be excited by blue light or near-ultraviolet light. In that case, by adjusting kinds or contents of phosphors used together, light emitting devices having various luminescent colors can be produced. Hight-performance white light emitting device also can be realized. Light emitting devices obtained as above can be used for illuminant portions (especially, backlights of liquid crystal displays) of displays or for illuminating devices.
Particularly when using a green phosphor of the present invention, a white light emitting device can be produced by adding an excitation light source emitting blue light, a phosphor emitting orange to red fluorescence (orange to red phosphor). In this case, the luminescent color can be modified freely by means of adjusting the luminous wavelength of the phosphor of the present invention or the additional orange to red phosphor. For example, even an emission spectrum that is similar to the so-called pseudo-white (the luminescent color of a light emitting device combining a blue LED and a yellow phosphor, for example) emission spectrum can be obtained. Furthermore, by incorporating a phosphor emitting red fluorescence (red phosphor) into this white light emitting device, a light emitting device that extremely excels in red color rendering or that emits warm white light can be produced. In another way, a white light emitting device can be produced also by combining an excitation light source emitting near-ultraviolet light, a phosphor of the present invention, a phosphor emitting blue fluorescence (blue phosphor) and a red phosphor.

### [7. Phosphor-containing composition]

The phosphor of the present invention can be used as a mixture with a liquid medium. Especially when the phosphor of the present invention is used for light emitting devices or the like, it is preferable to use it by dispersing it in a liquid medium and curing it by heat or light after it is sealed. The phosphor of the present invention that is dispersed in a liquid medium will be referred to as the "phosphor-containing composition of the present invention" as appropriate.

### [7-1. Phosphor]

There is no limitation on the type of the phosphor of the present invention to be contained in the phosphor-containing composition of the present invention, and any of that can be selected from those described above. The phosphor of the present invention to be contained in the phosphor-containing composition of the present invention can be used as a single kind thereof or as a mixture of two or more kinds in any combination and in any ratio. Furthermore, in the phosphor-containing composition of the present invention, phosphors other than the phosphor of the present invention can be contained, insofar as the advantage of the present invention is not significantly impaired.

### [7-2. Liquid medium]

There is no special limitation on the kind of a liquid medium used for the phosphor-containing composition of the present invention, insofar as the performance of the phosphor can be sufficient enough to achieve the object of the present invention. For example, any inorganic material and/or organic material can be used, insofar as it exhibits liquid characteristics under a desired use condition and lets the phosphor of the present invention be dispersed preferably without any unfavorable reaction.

Examples of the inorganic materials include: metal alkoxide, ceramic precursor polymer, a solution obtained by hydrolytic polymerization of a solution containing metal alkoxide using a sol-gel method (such as an inorganic material containing siloxane bond).

Examples of the organic materials include: thermoplastic resin, thermosetting resin and light curing resin. More specifically, the examples include: methacrylic resin such as polymethacrylate methyl; styrene resin such as polystyrene, styreneacrylonitrile copolymer; polycarbonate resin; polyester resin; phenoxy resin; butyral resin; polyvinyl alcohol; cellulose resin such as ethyl cellulose, cellulose acetate and cellulose acetate butyrate; epoxy resin; phenol resin; and silicone resin.

Of these, silicon-containing compounds can be preferably used as a liquid medium from the standpoint of high heat resistance, high light resistance and the like, particularly when the phosphor of the present invention is used for high-power light emitting devices such as illuminating device
Silicon-containing compound means a compound of which molecular contains a silicon atom. Examples thereof include: organic materials (silicone materials) such as polyorganosiloxane, inorganic materials such as silicon oxide, silicon nitride and silicon oxynitride, glass materials such as borosilicate, phosphosilicate and alkali silicate. Among them, silicone materials are preferably used from the standpoint of ease in handling or the like.

The above-mentioned silicone material usually indicates organic polymers having a siloxane bond as the main chain. Examples thereof include: compounds represented by the following general composition formula (i) and/or mixtures of them.

(R¹R²R³SiO_{1/2})_{M}(R⁴R⁵SiO_{2/2})ₙ(R⁶SiO_{3/2})_{T}(SiO_{4/2})_{Q} formula (i)

In the general composition formula (i), R¹ to R⁶ are each selected from the group consisting of organic functional group, hydroxyl group and hydrogen atom. R¹ to R⁶ can be the same as or different from each other.
In addition, M, D, T and Q of the above-mentioned formula (i) are each number of 0 or greater and smaller than 1, and they satisfy M+D+T+Q=1.

Such silicone material can be used as a liquid silicone material followed by being cured with heat or light, when used for sealing a semiconductor luminous element.

When categorizing silicone materials based on the curing mechanism, they usually fall into such categories as addition polymerization-curable type, polycondensation-curable type, ultraviolet ray-curable type and peroxide vulcanized type. Of these, preferable are addition polymerization-curable type (addition type silicone resin) and condensation-curable type (condensing type silicone resin) and ultraviolet ray-curable type. In the following, addition type silicone material and condensing type silicone material will be explained.

Addition type silicone material represents a material in which polyorganosiloxane chain is crosslinked by means of organic additional bond. Typical examples thereof include: compounds having an Si-C-C-Si bond as the crosslinking point, which can be obtained through a reaction between vinylsilane and hydrosilane in the presence of an addition type catalyst such as Pt catalyst. As such compounds, commercially available ones can be used. Examples of commercial names of such an addition polymerization-curable type include: "LPS-1400", "LPS-2410" and "LPS-3400" manufactured by Shin-Etsu Chemical Co., Ltd.

Examples of condensing type silicone materials include: compounds having an Si-O-Si bond as the crosslinking point, which can be obtained through hydrolysis and polycondensation of alkyl alkoxysilane. Examples thereof include: a polycondensate obtained by performing hydrolysis and polycondensation of compounds represented by the following general formula (ii) and/or (iii), and/or an oligomer thereof.

M^{m+}XₙY¹ₘ₋ₙ (ii)

(In the formula (ii), M represents at least one element selected from silicon, aluminum, zirconium and titanium, X represents a hydrolyzable group, Y¹ represents a monovalent organic group, m represents an integer of 1 or larger representing the valence of M, and n represents an integer of 1 or larger representing the number of X groups, where m≥n.)

(M^{s+}XₜY¹ₛ₋ₜ₋₁)ᵤY² (iii)

(In the formula (iii), M represents at least one element selected from silicon, aluminum, zirconium and titanium, X represents a hydrolyzable group, Y¹ represents a monovalent organic group, Y² represents a u-valent organic group,secondsrepresents an integer of 1 or larger representing the valence of M, t represents an integer of 1 or larger and s-1 or smaller, and u represents an integer of 2 or larger.)

The condensing type silicone material may contain a curing catalyst. As the curing catalyst, a metal chelate compound can be used preferably, for example. The metal chelate compound preferably contains at least one of Ti, Ta and Zr, and more preferably contains Zr. The curing catalysts may be used either as a single kind thereof or as a mixture of more than one kind in any combination and in any ratio.

As such condensing type silicone materials can be used preferably, for example, semiconductor light emitting device members disclosed in Japanese Patent Laid-Open Publications (Kokai) No. 2007-112973 to No. 2007-112975, Japanese Patent Laid-Open Publication (Kokai) No. 2007-19459, and Japanese Patent Application No. 2006-176468.

In the following, particularly preferable ones among condensing type silicone materials will be explained.
Silicone materials generally have such problems as low adhesiveness to the semiconductor laminous element, the substrate at which the element is disposed, the package and the like. However, as silicone materials with especially high adhesion can be preferably used condensing type silicone materials having the following characteristics [1] to [3].

[1] The silicon content is 20 weight % or more.
[2] In its solid Si-nuclear magnetic resonance (NMR) spectrum, measured by a method to be described later in detail, it has at least one of Si-originated peaks of the following (a) and/or (b).
   (a) A peak whose peak top position is in an area of a chemical shift of -40 ppm or more and 0 ppm or less, with reference to tetramethoxysilane, and whose peak full width at half maximum is 0.3 ppm or more and 3.0 ppm or less.
   (b) A peak whose peak top position is in an area of a chemical shift of -80 ppm or more and less than -40 ppm, with reference to tetramethoxysilane, and whose peak full width at half maximum is 0.3 ppm or more and 5.0 ppm or less.
[3] The silanol content is 0.1 weight % or more and 10 weight % or less.

It is preferable that the silicone material in the present invention has the characteristic [1], among the above-mentioned characteristics [1] to [3]. It is more preferable that the silicone material has the above-mentioned characteristics [11] and [2]. It is particularly preferable that the silicone material has all the above-mentioned characteristics [1] to [3].
In the following, the above-mentioned characteristics [1] to [3] will be explained.

### [7-2-1. Characteristic [1] (silicon content)]

The silicon content in the silicone material that is preferable for the present invention is usually 20 weight % or more. However, it is particularly preferably 25 weight % or more, and more particularly preferably 30 weight % or more. On the other hand, the upper limit thereof is usually 47 weight %, because the silicon content of a glass consisting only of SiO₂ is 47 weight %.

The silicon content of a silicone material can be calculated based on the result of an inductively coupled plasma spectrometry (hereinafter abbreviated as "ICP" when appropriate) analysis, carried out in accordance with, for example, a method described below

### {Measurement of silicon content}

A silicone material is kept in a platinum crucible in the air at 450°C for 1hour and then at 750°C for 1hour and at 950°C for 1.5hours for firing. After removal of carbon components, the small amount of residue obtained is added with a 10-fold amount or more of sodium carbonate, and then heated by a burner to melt it. Then the melted product is cooled and added with desalted water, being diluted to several ppm in silicon, while adjusting pH value to around neutrality using hydrochloric acid. And then ICP analysis is performed.

### [7-2-2. Characteristic [2] (solid Si-NMR spectrum)]

When measuring the solid Si-NMR spectrum of a silicone material preferable for the present invention, at least one, preferably two or more of peaks can be observed in the aforementioned peak regions (a) and/or (b) originating from a silicon atom directly bonded with a carbon atom of an organic group.

When summarizing in terms of chemical shifts, in a silicone material preferable for the present invention, the full width at half maximum of the peak described in (a) is generally smaller than that of the peak of (b) described later, due to smaller constraints of molecular motion. Actually, it is in the range of usually 3.0 ppm or less, preferably 2.0 ppm or less, and usually 0.3 ppm or more.
On the other hand, the full width at half maximum of the peak described in (b) is in the range of usually 5.0 ppm or less, preferably 4.0 ppm or less, and usually 0.3 ppm or more, preferably 0.4 ppm or more.

If the full width at half maximum of a peak observed in the above chemical shift areas is too large, a state in which constraints of molecular motion are large and thus the distortion is large is created, tending to make cracks and leading possibly to forming a member inferior in heat resistance and weather resistance. For example when a lot of tetrafunctional silane is used or when large internal stress is generated by a rapid drying in the drying process, the range of the full width at half maximum will be larger than the above range.

If the full width at half maximum of the peak is too small, Si atoms existing in its environment are not involved in the siloxane crosslinking. In such a case, for example when trifunctional silane remains in a non-crosslinked state, the obtained member may be inferior in heat resistance and weather resistance to materials formed mainly of siloxane bonds.
However, even if a peak of the above-mentioned range of the full width at half maximum is observed in an area of -80 ppm or more in a silicone material containing a small amount of Si component in a large amount of organic components, the heat resistance, light resistance and coating properties may not be excellent.

The chemical shift value of a silicone material preferable for the present invention can be calculated based on the results of a solid Si-NMR measurement performed by, for example, a method described below. Also, the measured data (the full width at half maximum, silanol amount and so on) is analyzed by a method in which each peak is divided and extracted by the waveform separation analysis or the like utilizing, for example, the Gauss function or Lorentz function.

### {Solid Si-NMR spectrum measurement and calculation of the silanol content}

When measuring the solid Si-NMR spectrum of a silicone material, the solid Si-NMR spectrum measurement and the waveform separation analysis are performed under the following conditions. Further, the full width at half maximum of each peak is determined for the silicone material based on the obtained waveform data. In addition, the silanol content is determined by comparing the ratio (%) of silicon atoms in silanol to all silicon atoms, decided from the ratio of peak areas originating from silanol to all peak areas, with the silicon content ratio analyzed separately.

### {Device conditions}

Device: Infinity CMX-400 nuclear magnetic resonance spectroscope manufactured by Chemagnetics Inc.
²⁹Si resonance frequency: 79.436 MHz
Probe: 7.5 mm φ CP/MAS probe
Temperature: Room temperature
Rotational frequency of sample: 4 kHz
Measurement method: Single pulse method
¹H decoupling frequency: 50 kHz
²⁹Si flip angle: 90°
²⁹Si 90° pulse width: 5.0 µs
Repetition time: 600 s
Total count: 128 times
Observation width: 30 kHz
Broadening factor: 20 Hz
Authentic sample: tetramethoxysilane

For a silicone material, 512 points are taken in as measured data and zero-filled to 8192 points, before Fourier transformation is performed.

### {Waveform separation analysis method}

For each peak of the spectrum after Fourier transformation, an optimization calculation is performed by a nonlinear least square method using as variable parameters the center position, height and full width at half maximum of a peak shape created by a Lorentz waveform. Gauss waveform or a mixture of both.
For identification of a peak, refer to AIChE Journal, 44(5), p. 1141, 1998 or the like.

### [7-2-3. Characteristic [3] (silanol content)]

The silanol content of a silicone material preferable for the present invention is in the range of usually 0.1 weight % or more, preferably 0.3 weight % or more, and usually 10 weight % or less, preferably 8 weight % or less, more preferably 5 weight % or less. When the silanol content is small, the silanol material varies little over time and can be superior in long-term performance stability, as well as in low hygroscopicity and low moisture permeability. However, no silanol content results only in poor adhesion, and therefore, there is such appropriate range of the silanol content as described above.

The silanol content of a silicone material can be decided by such method as described before for {Solid Si-NNR spectrum measurement and calculation of the silanol content} in [7-2-2. Characteristic [2] (solid Si-NMR spectrum)], for example. In such a method, the ratio (%) of silicon atoms in silanol relative to all silicon atoms is determined from the ratio of peak areas originating from silanol relative to all peak areas by means of the solid Si-NMR spectrum measurement, and then, the silanol content can be calculated by comparing the determined silicon ratio with the silicon content analyzed separately.

A silicone material preferable for the present invention contains an appropriate amount of silanol, which is usually bound through hydrogen bond to a polar portion existing on the device surface, and therefore, adhesive property is developed. Examples of the polar portion include: hydroxyl group and oxygen in a metalloxane bond.

In addition, a silicone material preferable for the present invention usually forms, due to dehydration condensation, a covalent bond with a hydroxyl group on the device surface when heated in the presence of an appropriate catalyst, leading to a development of still firmer adhesion.

With too much content of silanol, on the other hand, thickening in the system may make the coating difficult, and also, with increased activity, the occurrence of curing before low-boiling point components volatilize by heating may induce a foaming and an increase in internal stress, which may result in crack generations.

### [7-3. Content of liquid medium]

There is no special limitation on the content of the liquid medium, insofar as the advantage of the present invention is not significantly impaired. However, it is usually 50 weight % or more, preferably 75 weight % or more, and usually 99 weight % or less, preferably 95 weight % or less, to the whole phosphor-containing composition of the present invention. Even a large amount of liquid medium does not induce any problems particularly, but in order to achieve desired color coordinate, color rendering index, emission efficiency or the like when it is used for a semiconductor light emitting device, it is preferable that the liquid medium is used usually in the above-mentioned proportion. With too small amount of the liquid medium, on the other hand, its handling may be difficult due to too little fluidity.

The liquid medium serves mainly as binder, in the phosphor-containing composition of the present invention. The liquid medium can be used either as a single one or as a mixture of two or more kinds in any combination and in any ratio. For example, when a silicon-containing compound is used for the purpose of high heat resistance or light resistance, other thermosetting resin such as epoxy resin can be included to the extent that the durability of the silicon-containing compound will not be impaired. In such a case, it is preferable that the content of the other thermosetting resin is usually 25 weight % or lower, preferably 10 weight % or lower, to the whole amount of the liquid medium, which serves as the binder.

### [7-4. Other component]

In the phosphor-containing composition of the present invention, other components can be contained in addition to the phosphor and liquid medium, insofar as the advantage of the present invention is not significantly impaired. The other components may be used either as a single kind thereof or as a mixture of more than one kind in any combination and in any ratio.

### [7-5. Advantageous effect of phosphor-containing composition]

The phosphor-containing composition of the present invention can fix the phosphor of the present invention at a desired location easily. For example when the phosphor-containing composition of the present invention is used for a light emitting device, the phosphor of the present invention can be easily fixed at a desired location by forming the phosphor-containing composition of the present invention at a desired location and curing the liquid medium for sealing the phosphor of the present invention with the liquid medium.

### [8. Light emitting device]

The light emitting device of the present invention (hereinafter referred to as "the light emitting device" as appropriate) comprises a first luminous body (excitation light source) and a second luminous body which emits visible light when irradiated with light from the first luminous body. The light emitting device comprises one or more kinds of phosphors of the present invention as the first phosphor in the second luminous body.

The light emitting device of the present invention can take any known device configuration, specifically in which an excitation light source to be described later is used as the first luminous body and a phosphor adjusted in its kind or content is used as the second luminous body. With such a configuration, the light emitting device of the present invention can emit any color of light.
For example, a white light emitting device can be produced by combining an excitation light source emitting blue light, a phosphor emitting green fluorescence (green phosphor), and a phosphor emitting orange to red fluorescence (orange to red phosphor). In this case, the luminescent color can be modified freely by means of adjusting the luminous wavelength of the phosphor of the present invention. For example, even an emission spectrum that is similar to the so-called pseudo-white (the luminescent color of a light emitting device combining a blue LED and a yellow phosphor, for example) emission spectrum can be obtained. Furthermore, by incorporating a phosphor emitting red fluorescence (red phosphor) into this white light emitting device, a light emitting device that extremely excels in red color rendering or that emits warm white light can be produced. A white light emitting device can be produced also by combining an excitation light source emitting near-ultraviolet light, a phosphor emitting blue fluorescence (blue phosphor), a green phosphor, and a red phosphor.

In this context, the white color of the white light emitting device includes all of (Yellowish) White, (Greenish) White, (Bluish) White, (Purplish) White and White, which are defined in JIS Z8701. Of these, preferable is White.

Moreover, light emitting devices emitting any color of light can be produced by combining, as needed, a yellow phosphor (a phosphor emitting yellow fluorescence), blue phosphor, orange or red phosphor, and another kind of green phosphor, as well as adjusting the kinds or the contents of the phosphors.
The phosphor of the present invention can be used either as a single kind or as a mixture of two or more kinds in any combination and in any ratio.

The emission spectrum peak in the green region of the light emitting device of the present invention exists preferably in the wavelength range of from 515 nm to 535 nm, specifically. The emission spectrum peak in the red region thereof preferably exists in the wavelength range of from 580 nm to 680 nm. The emission spectrum peak in the blue region thereof preferably exists in the wavelength range of from 430 nm to 480 nm. The emission spectrum peak in the yellow region thereof preferably exists in the wavelength range of from 540 nm to 580 nm.

The emission spectrum of the light emitting device can be measured in a room of which temperature is kept at 25±1°C with energization of 20 mA, using a software for measuring color and illumination intensity, manufactured by Ocean Optics, Inc., and a spectroscope of USB2000 series (integrating sphere version). From this emission spectrum data in the wavelength region of 380 nm to 780 nm, can be calculated the chromaticity value (x, y, z) as color coordinates of xyz colorimetric system, defined in JIS Z8701. In this case, the relational expression of x+y+z=1 holds. In the present Description, the aforementioned XYZ colorimetric system is occasionally referred to as XY colorimetric system and the value thereof is usually represented as (x,y) .

Emission efficiency can be determined by calculating the total luminous flux from the results of emission-spectrum measurement using a light emitting device mentioned earlier and then dividing the lumen value (1m) obtained by the power consumption (W). The power consumption can be obtained as the product of the current value and the voltage value, which is measured using True RMS Multimeters Model 187 and 189 manufactured by Fluke Corporation while 20-mA energization.
The general color rendering index (Ra) and special color rendering index R9 of light emitting device of the present invention take the values of usually 80 or larger, preferably 90 or larger, and more preferably 95 or larger.
When a phosphor emitting green fluorescence (hereinafter referred to as "green phosphor of the present invention" as appropriate), upon light irradiation from an excitation light source, is used as the phosphor of the present invention, the light emitting device of the present invention becomes a light emitting device excellent in terms of emission efficiency with respect to from near-ultraviolet to blue excitation light sources (the first luminous body) and color reproduction range as a white light emitting device such as light sources for liquid crystal displays.

Further, when the green phosphor of the present invention is used for a light emitting device, it is preferable that the CIE color coordinates x and y in accordance with JIS Z8701 of its luminescent color falls within the following ranges respectively. Namely, it is preferable that the CIE color coordinate x of the green phosphor of the present invention is usually 0.100 or larger, preferably 0.150 or larger, more preferably 0.200 or larger, and usually 0.400 or smaller, preferably 0.380 or smaller, more preferably 0.360 or smaller. In addition, it is preferable that the CIE color coordinate y of the green phosphor of the present invention is usually 0.480 or larger, preferably 0.490 or larger, more preferably 0.495 or larger, and usually 0.670 or smaller, preferably 0.660 or smaller, more preferably 0.655 or smaller. When the CIE color coordinates x and y are within the above ranges, an advantage of wide color reproduction range when synthesizing white light can be achieved.

Further, it is preferable that the weight median diameter of the green phosphor of the present invention is in the range of usually 0.01 µm or larger, preferably 1 µm or larger, more preferably 5 µm or larger, still more preferably 10 µm or larger, and usually 100 µm or smaller, preferably 30 µm or smaller, more preferably 20 µm or smaller, when it is used for a light emitting device. When the weight median diameter is too small, the brightness tends to decrease and the phosphor particles tend to aggregate. On the other hand, when the weight median diameter is too large, unevenness in coating, clogging in a dispenser or the like tends to occur.

Other physical property values of the phosphor such as emission spectrum, color coordinate, and the like can be measured by the same methods as described above in the section of [3. Characteristics of oxynitride phosphor].

Preferable examples of the green phosphor of the present invention used for the light emitting device of the present invention include the aforementioned phosphors of the present invention described in the sections of [1. Composition of oxynitride phosphor] and [4. Phosphor produced using silicon nitride of the present invention as phosphor material] and phosphors used in respective Examples in the section [Example] described later.

The emission spectrum of the light emitting device n can be measured in a room of which temperature is kept at 25±1°C with energization of 20 mA, using a software for measuring color and illumination intensity, manufactured by Ocean Optics, Inc., and a spectroscope of USB2000 series (integrating sphere version). From this emission spectrum data in the wavelength region of 380 nm to 780 nm, can be calculated the chromaticity value (x, y, z) as color coordinates of xyz colorimetric system, defined in JIS Z8701. In this case, the relational expression of x+y+z=1 holds. In the present Description, the aforementioned XYZ colorimetric system is occasionally referred to as XY colorimetric system and the value thereof is usually represented as (x,y).

The light emitting device of the present invention also has a characteristic of high NTSC ratio, especially when it is constructed as a white light emitting device. More specifically, the NTSC ratio (%) of the light emitting device of the present invention is usually 70 or higher, preferably 72 or higher, and more preferably 74 or higher. The higher the value of NTSC ratio is, the more preferable. However, it is theoretically 150 or lower.

A method for determining NTSC ratios is as follows.
In NTSC system, the standard of Japanese color TV, the reference R, G, B chromaticity points are defined as follows, using (x,y) expression of the CIE color coordinate.
R(0.67,0.33), G(0.21,0.71), B(0.14, 0.08)
NTSC ratio can be obtained as the area of the triangle formed by R, G and B of the display to be measured, letting the area of the triangle formed by the above reference R, G and B be 100. More specifically, the NTSC ratio (%) can be obtained by multiplying by 100 the value of the area of the triangle, formed by plotting the chromaticity points (x,y) measured of monochromatic R, G and B emitted by the display to be measured on the CIE chromaticity diagram, divided by the area of the NTSC reference triangle.

### [8-1. Constitution of light emitting device (luminous body)]

### (First luminous body)

The first luminous body of the light emitting device of the present invention emits light for exciting the second luminous body to be described later.

The first luminous body has no particular limitation on its luminous wavelength, insofar as it overlaps the absorption wavelength of the second luminous body to be described later, and therefore, various luminous bodies with wide range of luminous wavelength regions are applicable. Usually a luminous body having luminous wavelength from ultraviolet region to blue region is used. Among them, particularly preferable are luminous bodies having luminous wavelength from near-ultraviolet region to blue region.

It is preferable that the specific value of the emission peak wavelength of the first luminous body is usually 200 nm or longer. Among them, it is preferable that, when a near-ultraviolet light is used as the excitation light, a luminous body with a peak luminous wavelength of usually 300 nm or longer, preferably 330 nm or longer, more preferably 360 nm or longer, and usually 420 nm or shorter is used. When a blue light is used as the excitation light, it is preferable that a luminous body with a peak luminous wavelength of usually 420 nm or longer, preferably 430 nm or longer, and usually 500 nm or shorter, preferably 480 nm or shorter is used. Both of these conditions are required from the stand point of color purity of the light emitting device.

As the first luminous body, a semiconductor luminous element is generally used. Concretely, an LED, semiconductor laser diode (hereinafter, abbreviated as "LD" as appropriate) or the like can be used. Other examples of the luminous body that can be used as the first luminous body include organic electroluminescence luminous elements, inorganic electroluminescence luminous elements or the like. However, the luminous body that can be used as the first luminous body is not restricted to those exemplified in the present Description.

Among them, GaN-based LEDs and GaN-based LDs, using GaN-based compound semiconductors, are preferable for the first luminous body. This is because GaN-based LEDs and GaN-based LDs have light output and external quantum efficiency far greater than those of SiC-based LEDs and the like that emit the same range of light and therefore they can give very bright luminescence with very low electric power when used in combination with the above-mentioned phosphor. For example, when applying current load of 20 mA, GaN-based LEDs and GaN-based LDs usually have emission intensity 100 times or higher than that of SiC-based ones. As GaN-based LED or GaN-based LD, one having an AlₓGa_{y}N luminous layer, GaN luminous layer or InₓGa_{y}N luminous layer is preferable. Among the GaN-based LEDs, one having an InₓGa_{y}N luminous layer is particularly preferable due to its remarkably high emission intensity. Among the GaN-based LEDs one having a multiple quantum well structure of the InₓGa_{y}N layer and GaN layer is particularly preferable also due to its remarkably high emission intensity.

In the above description, the X+Y usually takes a value in the range of 0.8 to 1.2. GaN-based LEDs having such kind of luminous layers that are doped with Zn or Si or without any dopant are preferable for the purpose of adjusting the luminescent characteristics.

A GaN-based LED contains, as its basic components, a such kind of luminous layer, p layer, n layer, electrode and substrate. Among them, GaN-based LEDs having such heterostructures that sandwich the luminous layer with n type and p type of AlₓGa_{y}N layers, GaN layers, InₓGa_{y}N layers or the likes are preferable, for the sake of high emission efficiency. Moreover, ones whose heterostructures are replaced by a quantum well structure are more preferable because they can show higher emission efficiency.
The first luminous body can be used either as a single one or as a mixture of two or more of them in any combination and in any ratio.

### (Second luminous body)

The second luminous body of the light emitting device of the present invention is a luminous body which emits visible light when irradiated with light from the above-mentioned first luminous body. It comprises the aforementioned phosphor of the present invention (for example, green phosphor) as the first phosphor, as well as the second phosphor (red phosphor, blue phosphor, orange phosphor, and the like) to be described later as appropriate depending on its use of the like. The second luminous body is formed, for example, in such a way that the first and the second phosphors are dispersed in a sealing material.

There is no special limitation on the composition of phosphors used in the second luminous body other than the phosphor of the present invention. The examples include compounds incorporating a host crystal, such as metal oxides typified by Y₂O₃, YVO₄, Zn₂SiO₄, Y₃Al₅O₁₂ and Sr₂SiO₄, metal nitrides typified by Sr₂Si₅N₈, phosphates typified by Ca₅(PO₄)₃Cl, sulfides typified by ZnS, SrS and CaS and oxysulfides typified by Y₂O₂S and La₂O₂S, with an activation element or coactivation element such as ions of rare earth metals including Ce, Pr, Nd, Pm, Sm, Eu, Tb, Dy, Ho, Er, Tm or Yb, or metal ions of Ag, Cu, Au, Al, Mn or Sb.

Preferable examples of the host crystal include: sulfides such as (Zn,Cd)S, SrGa₂S₄, SrS and ZnS; oxysulfides such as Y₂O₂S; aluminates such as (Y,Gd)₃Al₅O₁₂, YAlO₃, BaMgAl₁₀O₁₇, (Ba,Sr) (Mg,Mn)Al₁₀O₁₇, (Ba,Sr,Ca) (Mg,Zn,Mn)Al₁₀O₁₇, BaAl₁₂O₁₉, CeMgAl₁₁O₁₉, (Ba,Sr,Mg)O·Al₂O₃, BaAl₂Si₂O₈, SrAl₂O₄, Sr₄Al₁₄O₂₅ and Y₃Al₅O₁₂; silicates such as Y₂SiO₅ and Zn₂SiO₄; oxides such as SnO₂ and Y₂O₃; borates such as GdMgB₅O₁₀ and (Y,Gd)BO₃; halophosphates such as Ca₁₀(PO₄)₆(F,Cl)₂ and (Sr,Ca,Ba,Mg)₁₀(PO₄)₆Cl₂; and phosphates such as Sr₂P₂O₇ and (La,Ce)PO₄.

No particular limitation is imposed on the element compositions of the above-mentioned host crystals, and activation elements or coactivation elements. Partial substitution with elements of the same group is possible. Any phosphor obtained can be used so long as it can absorb light in the near-ultraviolet to visible region and emit visible light.

More specifically, those listed below can be used as the phosphor. However, the lists are just examples and phosphors that can be used in the present invention are not limited to those examples. In the following examples, phosphors with different partial structure are shown in a way appropriately abbreviated for the sake of convenience, as mentioned earlier.

### (First phosphor)

The second luminous body in the light emitting device of the present invention contains at least the above-mentioned phosphor of the present invention as the first phosphor. The phosphor of the present invention can be used either as a single kind or as a mixture of two or more kinds in any combination and in any ratio. Use of the phosphor of the present invention can enhance the emission efficiency of the light emitting device. Furthermore, by making use of excellent characteristics of the phosphor of the present invention, a light emitting device whose decrease in emission efficiency associated with temperature rising is small, brightness is high, and color reproduction range is broad can be realized.

In addition, the first phosphor may contain, in addition to the phosphor of the present invention, a phosphor ("combined same-color phosphor") emitting a fluorescence of the same color as that of the phosphor of the present invention. For example when the phosphor of the present invention is a green phosphor, another kind of green phosphor can be used as the first phosphor in combination with the phosphor of the present invention. When the phosphor of the present invention is a orange to red phosphor, another kind of orange to red phosphor can be used as the first phosphor in combination with the phosphor of the present invention. When the phosphor of the present invention is a blue phosphor, another kind of blue phosphor can be used as the first phosphor in combination with the phosphor of the present invention. In addition, when the phosphor of the present invention is a yellow phosphor, another kind of yellow phosphor can be used as the first phosphor in combination with the phosphor of the present invention.
There is no limitation on these phosphors, insofar as the advantage of the present invention is not significantly impaired.

### (Green phosphor)

It is preferable that the emission-peak wavelength of such a green phosphor is in the range of usually longer than 500 nm, particularly 510 nm or longer, further particularly 515 nm or longer, and usually 550 nm or shorter, particularly 540 nm or shorter, further particularly 535 nm or shorter. When that emission-peak wavelength λₚ is too short, the color tends to be bluish green. On the other hand, when it is too long, the color tends to be yellowish green. In both cases, the characteristics of its green light may deteriorate.

The full width at half maximum of emission peak of such a green phosphor is usually in the range of 40 nm to 80 nm.
The external quantum efficiency of such a green phosphor is usually 60% or higher, and preferably 70% or higher. The weight-average median diameter thereof is usually 1 µm or larger, preferably 5 µm or larger, more preferably 10 µm or larger, and usually 30 µm or smaller, preferably 20 µm or smaller, more preferably 15 µm or smaller. Examples of such a green phosphor include an europium-activated alkaline earth silicon oxynitride phosphor represented by (Mg,Ca,Sr,Ba)Si₂O₂N₂:Eu, which is constituted by fractured particles having a fractured surface and emits light in the green region. Other examples of such green phosphor include: Eu-activated aluminate phosphor such as Sr₄Al₁₄O₂₅:Eu and (Ba,Sr,Ca)Al₂O₄:Eu; Eu-activated silicate phosphor such as (Sr,Ba)Al₂Si₂O₈:Eu, (Ba,Mg)₂SiO₄:Eu, (Ba,Sr,Ca,Mg)₂SiO₄:Eu and (Ba,Sr,Ca)₂(Mg,Zn)Si₂O₇:Eu, and (Ba,Ca,Sr,Mg)₉(Sc,Y,Lu,Gd)₂(Si,Ge)₆O₂₄:Eu; Ce,Tb-activated silicate phosphor such as Y₂SiO₅:Ce,Tb; Eu-activated borophosphate phosphor such as Sr₂P₂O₇-Sr₂B₂O₅:Eu; Eu-activated halosilicate phosphor such as Sr₂Si₃O₈-2SrCl₂:Eu; Mn-activated silicate phosphor such as Zn₂SiO₄Mn; Tb-activated aluminate phosphor such as CeMgAl₁₁O₁₉:Tb and Y₃Al₅O₁₂:Tb; Tb-activated silicate phosphor such as Ca₂Y₈(SiO₄)₆O₂:Tb and La₃Ga₅SiO₁₄:Tb; Eu,Tb,Sm-activated thiogalate phosphor such as (Sr,Ba,Ca)Ga₂S₄:Eu,Tb,Sm; Ce-activated aluminate phosphor such as Y₃(Al,Ga)₅O₁₂:Ce and (Y,Ga,Tb,La,Sm,Pr,Lu)₃(Al,Ga)₅O₁₂:Ce; Ce-activated silicate phosphor such as Ca₃Sc₂Si₃O₁₂:Ce and Ca₃(Sc,Mg,Na,Li)₂Si₃O₁₂:Ce; Ce-activated oxide phosphor such as CaSC₂O₄:Ce; Eu-activated oxynitride phosphor such as Eu-activated β-sialon; Eu,Mn-activated aluminate phosphor such as BaMgAl₁₀O₁₇:Eu; Eu-activated aluminate phosphor such as SrAl₂O₄:Eu; Tb-activated oxysulfide phosphor such as (La,Gd,Y)₂O₂S:Tb; Ce,Tb-activated phosphate phosphor such as LaPO₄:Ce,Tb; sulfide phosphor such as ZnS:Cu,Al and ZnS:Cu,Au,Al; Ce,Tb-activated borate phosphor such as (Y,Ga,Lu,Sc,La)BO₃:Ce,Tb, Na₂Gd₂B₂O₇:Ce,Tb and (Ba,Sr)₂(Ca,Mg,Zn)B₂O₆:K,Ce,Tb; Eu,Mn-activated halosilicate phosphor such as Ca₈Mg(SiO₄)₄Cl₂:Eu,Mn; Eu-activated thioaluminate or thiogallate phosphor such as (Sr,Ca,Ba) (Al,Ga,In)₂S₄:Eu; Eu,Mn-activated halosilicate phosphor such as (Ca,Sr)₈(Mg,Zn) (SiO₄)₄Cl₂:Eu,Mn; and Eu-activated oxynitride phosphor such as M₃Si₆O₉N₄:Eu and M₃Si₆O₁₂N₂:Eu (here, M represents alkaline earth metal element).

Also applicable as the green phosphor are fluorescent dyes such as pyridine-phthalimide condensed derivative, benzoxadinone compound, quinazoline compound, coumarine compound, quinophthalone compound, naphthalimide compound, and organic phosphors such as terbium complex.
The green phosphor exemplified above can be used either as a single kind or as a mixture of two or more kinds in any combination and in any ratio.

It is preferable that the emission-peak wavelength λₚ (nm) of the first green phosphor used for the light emitting device of the present invention is in the range of usually longer than 500 nm, particularly 510 nm or longer, further particularly 515 nm or longer, and usually 550 nm or shorter, particularly 542 nm or shorter, further particularly 535 nm or shorter. When that emission-peak wavelength λₚ is too short, the color tends to be bluish green. On the other hand, when it is too long, the color tends to be yellowish green. In both cases, the characteristics of its green light may deteriorate.

In addition, it is preferable that the first green phosphor used for the light emitting device of the present invention has a full width at half maximum (hereinafter abbreviated as "FWHM" as appropriate) of the emission peak, in the above-mentioned emission spectrum, in the range of usually 10 nm or larger, preferably 20 nm or larger, more preferably 25 nm or larger, still more preferably 40 nm or larger, and usually 85 nm or smaller, particularly 80 nm or smaller, more particularly 75 nm or smaller, still more preferably 70 nm or smaller. When the full width at half maximum FWHM is too large, the emission intensity may decrease. When it is too small, the color purity may decrease.

The external quantum efficiency of the first green phosphor used for the light emitting device of the present invention is usually 60% or higher, and preferably 70% or higher. The weight median diameter thereof is usually 1 µm or larger, preferably 5 µm or larger, more preferably 10 µm or larger, and usually 30 µm or smaller, preferably 20 µm or smaller, more preferably 15 µm or smaller.

### (Orange to red phosphor)

When an orange to red phosphor is used as the second phosphor, any kind of orange to red phosphor can be used, insofar as the advantage of the present invention is not significantly impaired. It is preferable that the emission-peak wavelength of the orange to red phosphor is in the wavelength range of usually 570 nm or longer, preferably 580 nm or longer, more preferably 585 nm or longer, and usually 780 nm or shorter, preferably 700 nm or shorter, more preferably 680 nm or shorter.

Examples of such an orange or red phosphor include an europium-activated alkaline earth silicon nitride phosphor represented by (Mg,Ca,Sr,Ea)₂Si₅N₈:Eu, which is constituted by fractured particles having red fractured surfaces and emits light in red region, and an europium-activated rare-earth oxychalcogenide phosphor represented by (Y,La,Gd,Lu)₂O₂S:Eu, which is constituted by growing particles having a nearly spherical shapes typical of regular crystal growth and emits light in red region.

Also applicable in the present embodiment is an phosphor containing oxynitride and/or oxysulfide which include at least one element selected from the group consisting of Ti, Zr, Hf, Nb, Ta, W and Mo, described in Japanese Patent Laid-Open Publication (Kokai) No. 2004-300247, and containing an oxynitride having an α-sialon structure in which all or part of Al elements are replaced by Ga elements. These are phosphors which contain oxynitride and/or oxysulfide.

Other examples of the orange to red phosphor include: Eu-activated oxysulfide phosphor such as (La,Y)₂O₂S:Eu; Eu-activated oxide phosphor such as Y(V,P)O₄:Eu and Y₂O₃:Eu; Eu,Mn-activated silicate phosphor such as (Ba,Mg)₂SiO₄:Eu,Mn and (Ba,Sr,Ca,Mg)₂SiO₄:Eu,Mn; Eu-activated tungstate phosphor such as LiW₂O₈:Eu, LiW₂O₈:Eu,Sm, Eu₂W₂O₉, Eu₂W₂O₉:Nb, Eu₂W₂O₉:Sm; Eu-activated sulfide phosphor such as (Ca,Sr)S:Eu; Eu-activated aluminate phosphor such as YAlO₃:Eu; Eu-activated silicate phosphor such as Ca₂Y₈(SiO₄)₆O₂:Eu, LiY₉(SiO₄)₆O₂:Eu, (Sr,Ba,Ca)₃SiO₅:Eu and Sr₂BaSiO₅:Eu; Ce-activated aluminate phosphor such as (Y,Gd)₃Al₅O₁₂:Ce and (Tb,Gd)₃Al₅O₁₂:Ce; Eu-activated oxide, nitride or oxynitride phosphor such as (Mg,Ca,Sr,Ba)₂Si₅(N,O)₈:Eu, (Mg,Ca,Sr,Ba)Si(N,O)₂:Eu and (Mg,Ca,Sr,Ba)AlSi(N,O)₃:Eu; Ce-activated oxide, nitride or oxynitride phosphor such as (Mg,Ca,Sr,Ba)AlSi(N,O)₃:Ce; Eu,Mn-activated halophosphate phosphor such as (Sr,Ca,Ba,Mg)₁₀(PO₄)₆Cl₂:Eu,Mn; Eu,Mn-activated silicate phosphor such as (Ba₃Mg)Si₂O₈:Eu,Mn and (Ba,Sr,Ca,Mg)₃(Zn,Mg)Sis₂O₈:Eu,Mn; Mn⁴⁺-activated phosphor such as 3.5MgO·0.5MgF₂·GeO₂:Mn and K₂TiF₆; Eu-activated oxynitride phosphor such as Eu-activated α-sialon; Eu,Bi-activated oxide phosphor such as (Gd,Y,Lu,La)₂O₃:Eu,Bi; Eu,Bi-activated oxysulfide phosphor such as (Gd,Y,Lu,La)₂O₂S:Eu,Bi; Eu,Bi-activated vanadate phosphor such as (Gd,Y,Lu,La)VO₄:Eu,Bi; Eu,Ce-activated sulfide phosphor such as SrY₂,S₄:Eu,Ce; Ce-activated sulfide phosphor such as CaLa₂S₄:Ce; Eu,Mn-activated phosphate phosphor such as (Ba,Sr,Ca)MgP₂O₇:Eu,Mn and (Sr,Ca,Ba,Mg,Zn)₂P₂O₇:Eu,Mn, Eu,Mo-activated tungstate phosphor such as (Y,Lu)₂WO₆:Eu,Mo; Eu,Ce-activated nitride phosphor such as (Ba,Sr,Ca)ₓSi_{y}N_{z}:Eu,Ce (x,y,z being an integer of 1 or larger); Eu,Mn-activated halophosphate phosphor such as (Ca,Sr,Ba,Mg)₁₀(PO₄)₆(F,Cl,Br,OH)₂:Eu,Mn; and Ce-activated silicate phosphor such as ((Y,Lu,Gd,Tb)_{1-x-y}SCₓCe_{y})₂(Ca,Mg)₁₋ᵣ(Mg,Tn)₂₊ᵣSi_{z-q}Ge_{q}O_{12+δ}.

Also applicable examples of the red phosphor include: red organic phosphor consisting of rare-earth element ion complex containing anions of such as β-diketonate, β-diketone, aromatic carboxylic acid or Bronsted acid as ligands, perylene pigment (for example, dibenzo{[f,f']-4,4',7,7'-tetraphenyl}diindeno[1,2,3-cd:1',2',3'-lm]perylene), anthraquinone pigment, lake pigment, azo pigment, quinacridone pigment, anthracene pigment, isoindoline pigment, isoindolinone pigment, phthalocyanine pigment, triphenylmethane series basic dye, indanthrone pigment, indophenol pigment, cyanine pigment and dioxazine pigment.

Among them, it is preferable that the red phosphor contains (Ca,Sr,Ba)₂Si₅(N,O)₈:Eu, (Ca,Sr,Ba)Si(N,O)₂:Eu, (Ca,Sr,Ba)AlSi(N,O)₃:Eu, (Sr,Ba)₃SiO₅:Eu, (Ca,Sr)S:Eu, (La,Y)₂O₂S:Eu or Eu complex. It is more preferable that it contains (Ca,Sr,Ba)₂Si₅(N,O)₈:Eu, (Ca,Sr,Ba)Si(N,O)₂:Eu, (Ca,Sr,Ba)AlSi(N,O)₃:Eu, (Sr,Ba)₃SiO₅:Eu, (Ca,Sr)S:Eu, (La,Y)₂O₂S:Eu, β-diketone Eu complex such as Eu(dibenzoylmethane)₃·1,10-phenanthroline complex or carboxylic acid Eu complex. Of these, especially preferable are (Ca,Sr,Ba)₂Sl₅(N,O)₈:Eu, (Sr,Ca)AlSi(N,O)₃:EU and (La,Y)₂O₂S:Eu.

Among the above examples, a phosphor that can be preferably used as the orange phosphor is (Ca,Sr,Ba)AiSi(N,O)₃:Ge and (Sr,Ba)₃SiO₅:Eu.
Such orange to red phosphors may be used either as a single kind thereof or as a mixture of more than one kind in any combination and in any ratio.

### (Blue phosphor)

When a blue phosphor is used as the second phosphor, any kind of blue phosphor can be used insofar as the advantage of the present invention is not significantly impaired. It is preferable that the emission-peak wavelength of such a blue phosphor is in the range of usually 420 nm or longer, preferably 430 nm or longer, more preferably 440 nm or longer, and usually 490 nm or shorter, preferably 480 nm or shorter, more preferably 470 nm or shorter, still more preferably 460 nm or shorter.

The full width at half maximum of the emission peak of such a blue phosphor is usually in the range of 20 nm to 80 nm.
The external quantum efficiency of such a blue phosphor is usually 60% or higher, and preferably 70% or higher. The weight median diameter thereof is usually 1 µm or larger, preferably 5 µm or larger, more preferably 10 µm or larger, and usually 30 µm or smaller, preferably 20 µm or smaller, more preferably 15 µm or smaller.

Examples of such a blue phosphor include: europium-activated barium magnesium aluminate phosphors represented by (Ba,Sr,Ca)MgAl₁₀O₁₇:Eu, which is constituted by growing particles having a nearly hexagonal shape typical of regular crystal growth and emits light in the blue region, europium-activated calcium halphosphate phosphors represented by (Mg,Ca,Sr,Ba)₅(PO₄)₃(Cl,F):Eu, which is constituted by growing particles having a nearly spherical shape typical of regular crystal growth and emits light in the blue region, europium-activated alkaline earth chloroborate phosphors represented by (Ca,Sr,Ba)₂B₅O₉Cl:Eu, which is constituted by growing particles having a nearly cubic shape typical of regular crystal growth and emits light in the blue region, and europium-activated alkaline earth aluminate phosphors represented by (Sr,Ca,Ba)Al₂O₄:Eu or (Sr,Ca,Ba)₄Al₁₄O₂₅:Eu, which is constituted by fractured particles having fractured surfaces and emits light in the blue green region.

Other examples of such a blue phosphor include: Sn-activated phosphate phosphor such as Sr₂P₂O₇:Sn; Eu-activated aluminate phosphor such as (Sr,Ca,Ba)Al₂O₄:Eu or (Sr,Ca,Ba)₄Al₁₄O₂₅:Eu, BaMgAl₁₀O₁₇:Eu, (Ba,Sr,Ca)MgAl₁₀O₁₇:Eu, BaMgAl₁₀O₁₇:Eu,Tb,Sm and BaAl₈O₁₃:Eu; Ce-activated thiogalate phosphor such as SrGa₂S₄:Ce and CaGa₂S₄:Ce; Eu,Mn-activated aluminate phosphor such as (Ba,Sr,Ca)MgAl₁₀O₁₇:Eu,Mn; Eu-activated halophosphate phosphor such as (Sr,Ca,Ba,Mg)₁₀(PO₄)₆Cl₂:Eu and (Ba, Sr, Ca)₅(PO₄)₃(Cl, F, Br,OH):Eu,Mn,Sb; Eu-activated silicate phosphor such as BaAl₂Si₂O₈:Eu, (Sr,Ba)₃MgSi₂O₈:Eu; Eu-activated phosphate phosphor such as Sr₂P₂O₇:Eu; sulfide phosphor such as ZnS:Ag and ZnS:Ag,Al; Ce-activated silicate phosphor such as Y₂SiO₅:Ce; tungstate phosphor such as CaWO₄; Eu,Mn-activated borophosphate phosphor such as (Ba,Sr,Ca)BPO₅:Eu,Mn, (Sr,Ca)₁₀(PO₄)₆·nB₂O₃:Eu and 2SrO·0.84P₂O₅·0.16B₂O₃:Eu; Eu-activated halosilicate phosphor such as Sr₂Si₃O₈·2SrCl₂:Eu; Eu-activated oxynitride phosphor such as SrSi₉Al₁₉ON₃₁:Eu and EuSi₉Al₁₉ON₃₁; and Ce-activated oxynitride phosphor such as La₁₋ₓCeₓAl(Si_{6-z}Al_{z}) (N_{10-z}O_{z}) (here, x and z are numbers satisfying 0≤x≤1 and 0≤z≤6, respectively) and La_{1-x-y}CeₓCa_{y}Al(Si_{6-z}Al_{z}) (N_{10-z}O_{z}) (here, x, y and z are numbers satisfying 0≤x≤1, 0≤y≤1 and 0≤z≤6, respectively).

Also applicable as the blue phosphor are, for example, fluorescent dyes such as naphthalimide compound, benzoxazole compound, styryl compound, coumarine compound, pyrazoline compound and triazole compound, and organic phosphors such as thlium complex.

Among them, it is preferable that the blue phosphor contains (Ca,Sr,Ba)MgAl₁₀O₁₇:Eu, (Sr,Ca,Ba,Mg)₁₀(PO₄)₆(Cl,F)₂:Eu or (Ba,Ca,Mg,Sr)₂SiO₄:Eu. It is more preferable that it contains (Ca,Sr,Ba)MgAl₁₀O₁₇:Eu, (Sr,Ca,Ba,Mg)₁₀(PO₄)₆(Cl,F)₂:Eu or (Ba,Ca,Sr)₃MgSi₂O₈:Eu. It is still more preferable that it contains BaMgAl₁₀O₁₇:Eu, Sr₁₀(PO₄)₆(Cl,F)₂:Eu or Ba₃MgSi₂O₈:Eu. Of these, (Sr,Ca,Ba,Mg)₁₀(PO₄)₆Cl₂:Eu or (Ca,Sr,Ea)MgAl₁₀O₁₇:Eu is particularly preferable in uses for a illuminating device and a display.
Such a blue phosphor may be used either as a single kind thereof or as a mixture of more than one kind in any combination and in any ratio.

### (Yellow phosphor)

When a yellow phosphor is used as the second phosphor, any kind of yellow phosphor can be used, insofar as the advantage of the present invention is not significantly impaired. It is preferable that the emission-peak wavelength of such a yellow phosphor is in the wavelength range of usually 530 nm or longer, preferably 540 nm or longer, more preferably 550 nm or longer, and usually 620 nm or shorter, preferably 600 nm or shorter, more preferably 580 nm or shorter.

The full width at half maximum of emission peak of such a yellow phosphor is usually in the range of 60 nm to 200 nm.
The external quantum efficiency of such a yellow phosphor is usually 60% or higher, and preferably 70% or higher. The weight median diameter thereof is usually 1 µm or larger, preferably 5 µm or larger, more preferably 10 µm or larger, and usually 30 µm or smaller, preferably 20 µm or smaller, more preferably 15 µm or smaller.

Examples of such a yellow phosphor include various phosphors of such as oxide, nitride, oxynitride, sulfide and oxysulfide.
Particularly preferable examples include garnet phosphors having garnet structures, represented by RE₃M₅O₁₂:Ce (here, RE indicates at least one element selected from the group consisting of Y, Tb, Gd, Lu and Sm, M indicates at least one element selected from the group consisting of Al, Ga and Sc) and M^{a}₃M^{b}₂M^{c}₃O₁₂:Ce (here, M^{a}, M^{b} and M^{c} are divalent, trivalent and tetravalent metal element respectively), for example; orthosilicate phosphors represented by AE₂M^{d}O₄:Eu (here, AE indicates at least one element selected from the group consisting of Ba, Sr, Ca, Mg and Zn, M^{d} indicates Si and/or Ge), for example; oxynitride phosphors in which a part of the oxygen, contained in the above types of phosphors as constituent element, are substituted by nitrogen; and Ce-activated nitride phosphors having CaAlSiN₃ structures such as AEAlSi(N,O)₃:Ce (here, AE indicates at least one element selected from the group consisting of Ba, Sr, Ca, Mg and Zn).

Also applicable as the yellow phosphor are: Eu-activated phosphors including sulfide phosphors such as CaGa₂S₄:Eu, (Ca,Sr)Ga₂S₄:Eu and (Ca, Sr) (Ga,Al)₂S₄:Eu and oxynitrides phosphors having SiAlON structure such as Caₓ(Si,Al)₁₂(O,N)₁₆:Eu; and rare-earth-activated phosphors having La₃Si₆N₁₁ structure which may contain alkaline-earth metal elements.

Other examples of the yellow phosphor include: fluorescent dyes such as brilliant sulfoflavine FF (Color Index Number 56205), basic yellow HG (Color Index Number 46040), eosine (Color Index Number 45380) and rhodamine 6G (Color Index Number 45160).
Such a yellow phosphor may be used either as a single kind thereof or as a mixture of more than one kind in any combination and in any ratio.

### (Second phosphor)

The second luminous body of the light emitting device of the present invention may contain another phosphor (namely, a second phosphor) in addition to the above-mentioned first phosphor, depending on its use. The second phosphor is a phosphor having a different emission-peak wavelength from that of the first phosphor. Such a second phosphor is usually used for adjusting color tone of light emission of the second luminous body. Therefore, as the second phosphor, mostly phosphors emitting different-color fluorescences from the first phosphor are used.
As described above, when a green phosphor is used as the first phosphor, a phosphor other than green phosphor, such as orange or red phosphor, blue phosphor, or yellow phosphor, is used as the second phosphor. When an orange or red phosphor is used as the first phosphor, a phosphor other than orange or red phosphor, such as green phosphor, blue phosphor, or yellow phosphor, is used as the second phosphor. When a blue phosphor is used as the first phosphor, a phosphor other than blue phosphor, such as green phosphor, orange or red phosphor, or yellow phosphor, is used as the second phosphor. When a yellow phosphor is used as the first phosphor, a phosphor other than yellow phosphor, such as green phosphor, orange or red phosphor, or blue phosphor, is used as the second phosphor.
Examples of such green, orange to red, blue and yellow phosphors include the same phosphors listed above in the chapter of the first phosphor.

It is preferable that the weight median diameter of the second phosphor used for the light emitting device of the present invention is in the range of usually 10 µm or larger, preferably 12 µm or larger, and usually 30 µm or smaller, preferably 25 µm or smaller. When the weight median diameter is too small, the brightness tends to decrease and the phosphor particles tend to aggregate. On the other hand, the weight median diameter is too large, unevenness in coating, clogging in a dispenser or the like tend to occur.

### (Combination of second phosphors)

The second phosphor can be used either as a single kind thereof or as a mixture of two or more kinds in any combination and in any ratio. There is no special limitation on the ratio between the first phosphor and the second phosphor, insofar as the advantage of the present invention is not significantly impaired. Accordingly, the amount of the second phosphor used, as well as the combination and the mixing ratio of the second phosphors used, can be specified arbitrarily according to the use or the like of the light emitting device.

The phosphor of the present invention can be used as a mixture with another phosphor (in this context, "mixture" does not necessary means to blend the phosphors with each other, but means to use different kinds of phosphors in combination). Among them, the combined uses of phosphors described above will provide preferable phosphor mixtures. There is no special limitation on the kind or the ratio of the phosphors mixed.

Whether the above-described second phosphors are used or not and what kind of them are used in the light emitting device of the present invention can be decided as appropriate depending on the use of the light emitting device. For example when the light emitting device of the present invention is constructed as a green light emitting device, it usually requires only a green phosphor as the first phosphor and no second phosphor.

On the other hand, preferable examples of the combination of the first luminous body, first phosphor and second phosphor, when the light emitting device of the present invention is constructed as a white light emitting device using a green phosphor as the first phosphor, include the following combinations (i) to (iii).

(i) A blue luminous body (blue LED or the like) is used as the first luminous body. A green phosphor (a phosphor of the present invention or the like) is used as the first phosphor. A red phosphor is used as the second phosphor. In this case, as the red phosphor, one or more kinds of red phosphors selected from the group consisting of K₂TiF₆:Mn and (Sr,Ca)AlSi(N,O)₃:Eu are preferable.

(ii) A near-ultraviolet luminous body (near-ultraviolet LED or the like) is used as the first luminous body. A green phosphor (a phosphor of the present invention or the like) is used as the first phosphor. A blue phosphor and a red phosphor is combined as the second phosphor. In this case, as the blue phosphor, one or more kinds of blue phosphors selected from the group consisting of (Ba,Sr,Ca)MgAl₁₀O₁₇:Eu and (Mg,Ca,Sr,Ba)₅(PO₄)₃(Cl,F):Eu are preferable. As the red phosphor, one or more kinds of red phosphors selected from the group consisting of (Sr,Ca)AlSiN₃:Eu and La₂O₂S:Eu are preferable. Among them, it is particularly preferable to combine a near-ultraviolet LED, a phosphor of the present invention, BaMgAl₁₀O₁₇:Eu as the blue phosphor, and (Sr,Ca)AlSi(N,O)₃:Eu as the red phosphor.

(iii) A blue luminous body (blue LED or the like) is used as the first luminous body. A green phosphor (a phosphor of the present invention or the like) is used as the first phosphor. An orange phosphor is used as the second phosphor. In this case, as the orange phosphor, one or more kinds of orange phosphors selected from the group consisting of (Sr,Ca)AlSi(N,O)₃:Ce and (Sr,Ba)₃SiO₅:Eu are preferable.

### (Sealing material)

The above-mentioned first and/or second phosphors are usually used by being dispersed in a liquid medium, which serves as a sealing material, in the light emitting device of the present invention. Examples of such a liquid medium include the same ones as described in the aforementioned section [7. Phosphor-containing composition].

The liquid medium may contain a metal element that can be a metal oxide having high refractive index, for the purpose of adjusting the refractive index of the sealing member. Examples of such a metal element that can be a metal oxide having high refractive index include: Si, Al, Zr, Ti, Y, Nb and B. These metal elements can be used as a single kind or as a mixture of two or more kinds in any combination and in any ratio.

There is no special limitation on the state of existence of such metal elements, insofar as the transparency of the sealing member does not deteriorate. For example, they may exist as a uniform grass layer of metalloxane bonds or as particles in the sealing member. When they exist in a state of particles, the structure inside the particles may be either amorphous or crystal structure. However, for higher refractive index, crystal structure is preferable. In such a case, the particle diameter thereof is usually equal to or smaller than the luminous wavelength of a semiconductor luminous element, and preferably 100 nm or smaller, more preferably 50 nm or smaller, particularly preferably 30 nm or smaller, in order not to impair the transparency of the sealing member. The above-mentioned metal elements in a state of particles contained in the sealing member can be obtained for example by means of adding, to a silicone material, such particles as silicon oxide, aluminium oxide, zirconium oxide, titanium oxide, yttrium oxide, niobium oxide or the like.

Furthermore, the above-mentioned liquid medium may be further added with a known additive such as diffusing agent, filler, viscosity modifier and UV absorbing agent. These additives can be used either as a single one or as a combination of two or more kinds in any combination and in any ratio.

### [8-2. (Other) constitutions of light emitting device]

There is no special limitation on the other configurations of the light emitting device of the present invention, insofar as it comprises the above-mentioned first luminous body and second luminous body. However, it usually comprises a frame on which the above-mentioned first luminous body and second luminous body are located. The location is configured so that the second luminous body is excited (namely, the first and second phosphors are excited) by the light emitted from the first luminous body to emit light and the lights from the first luminous body and/or from the second luminous body are radiated to the outside. At this point, it is not always necessary for the first and the second phosphors to be contained in the same layer. Each of different colored phosphors may be contained in a different layer from each other. For example, a layer containing the second phosphor can be laminated on a layer containing the first phosphor.

The light emitting device of the present invention may also utilize a member other than the above-mentioned excitation light source (the first luminous body), the phosphor (the second luminous body) and a frame. The examples include the aforementioned sealing material. The sealing material can be used for, in addition to dispersing the phosphor (the second luminous body), adhering the excitation light source (the first luminous body), the phosphor (the second luminous body) and the frame to each other, in the light emitting device.

### [8-3. Embodiment of light emitting device]

The light emitting device of the present invention will be explained in detail below with reference to specific embodiments. However, it is to be noted that the present invention is by no means restricted to the following embodiments and any modifications can be added thereto insofar as they do not depart from the scope of the present invention.

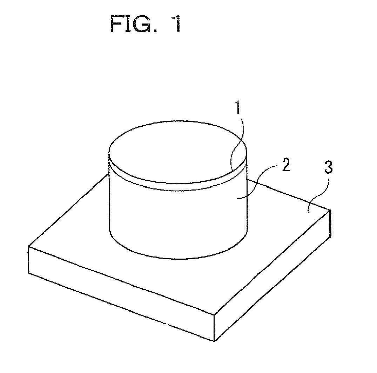

Fig. 1 is a schematic perspective view illustrating the positional relationship between the first luminous body, which functions as the excitation light source, and the second luminous body, constructed as the phosphor-containing part containing a phosphor, in an example of the light emitting device of the present invention. In Fig. 1, the numeral 1 indicates a phosphor-containing part (second luminous body), the numeral 2 indicates a surface emitting type GaN-based LD as an excitation light source (first luminous body), and the numeral 3 indicates a substrate. In order to configure them so that they are in contact with each other, the LD (2) and the phosphor-containing part (second luminous body) (1), prepared separately, may be made contact with each other in their surfaces by means of adhesive or the like, or otherwise, a layer of the phosphor-containing part (second luminous body) may be formed (molded) on the emission surface of the LD (2). With such configurations, the LD (2) and the phosphor-containing part (second luminous body) (1) can be kept contact with each other.

With such device configurations, light quantity loss, induced by a leakage of light emitted from the excitation light source (first luminous body) and reflected on the layer surface of the phosphor-containing part (second luminous body) to outside, can be avoided, which makes possible enhancement in emission efficiency of the entire device.

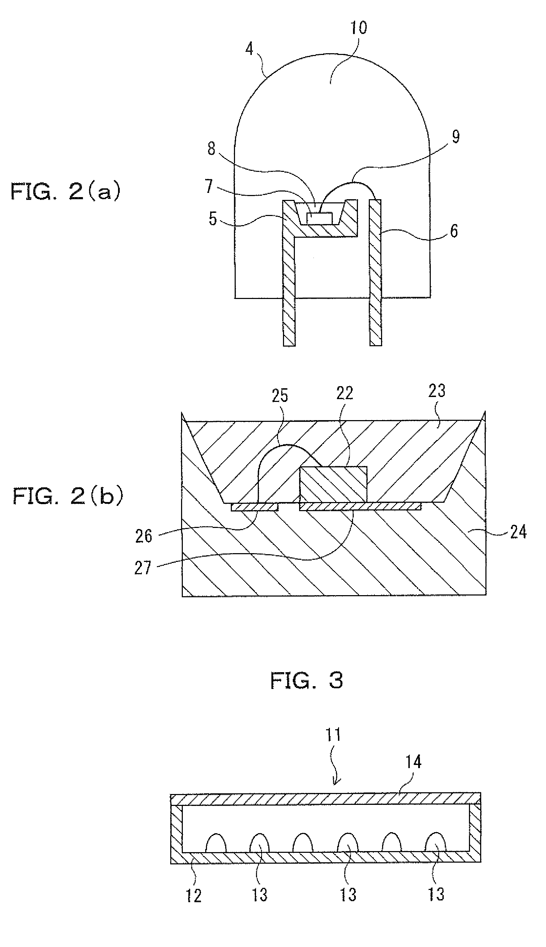

Fig. 2(a) shows a typical example of a light emitting device generally called a shell type. It is a schematic sectional view illustrating an example of the light emitting device comprising an excitation light source (first luminous body) and a phosphor-containing part (second luminous body). In this light emitting device (4), the numeral 5, numeral 6, numeral 7, numeral 8, numeral 9 and numeral 10 indicate a mount lead, inner lead, excitation light source (first luminous body), phosphor-containing resinous part, conductive wire and mold member, respectively.

Fig. 2(b) shows a typical example of a light emitting device generally called a surface-mount type. It is a schematic sectional view illustrating an example of the light emitting device comprising an excitation light source (first luminous body) and a phosphor-containing part (second luminous body). In the figure, the numeral 22, numeral 23, numeral 24, numeral 25 and numerals 26, 27 indicate an excitation light source (first luminous body), a phosphor-containing resinous part as phosphor-containing part (second luminous body), a frame, a conductive wire and electrodes, respectively.

### [8-4. Use of light emitting device]

There is no special limitation on the use of the light emitting device of the present invention, and therefore it can be used in various fields where a usual light emitting device is used. However, owing to its wide color reproduction range and high color rendering, it can be particularly preferably used as light sources for illuminating devices or displays.

### [8-4-1. Illuminating device]

The application of the light emitting device of the present invention to illuminating devices can be carried out by incorporating a light emitting device such as described earlier into a known illuminating device as appropriate. Examples of such a illuminating device include a surface-emitting illuminating device (11) shown in Fig. 3 incorporating the aforementioned light emitting device (4).

Fig. 3 is a sectional view schematically illustrating an embodiment of the illuminating device of the present invention. As shown in this Fig. 3, the surface-emitting illuminating device comprises a large number of light emitting devices (13) (corresponding to the aforementioned light emitting device (4)) on the bottom surface of a rectangular holding case (12), of which the inner surfaces are made to be opaque ones such as white smooth surfaces, and a power supply, circuit and the like (not shown in the figure) for driving the light emitting devices (13) outside the holding case. In addition, it comprises a milky-white diffusion plate (14), such as an acrylic plate, at the place corresponding to the cover part of the holding case (12) for homogenizing the light emitted.

When the surface-emitting illuminating device (11) is driven by means of applying a voltage to the excitation light source (the first luminous body) of the light emitting device (13), light is emitted from the light source and the aforementioned phosphor in the phosphor-containing resinous part, which serves as phosphor-containing part (the second luminous body), absorbs a part of the emitted light and emits visible light. On the other hand, the blue light that is not absorbed in the phosphor is mixed with the visible light to form a light emission with high color rendering, and then the mixed light passes through the diffusion plate (14) to be radiated in the upward direction of the figure. Consequently, an illumination light with a brightness that is uniform within the surface of the diffusion plate (14) of the holding case (12) can be obtained.

### [8-4-2. Display]

When the light emitting device of the present invention is used as a light source in an display, there is no limitation on the concrete configuration of the display. However, it is preferable to be used together with a color filter. For example, a color display, which is a kind of display, utilizing a color liquid-crystal display element can be formed by combining the above-mentioned light emitting device as the backlight, optical shutter utilizing liquid crystal, and color filters having red, green and blue picture elements.

The NTSC ratio of the color reproduction range of the light passed through the color filter is usually 60% or higher, preferably 80% or higher, more preferably 90% or higher, still more preferably 100% or higher, and usually 150% or lower.
The transmitted light amount from each color filter relative to the transmitted light amount from the entire color filters (namely, light utilization efficiency) is usually 20% or higher, preferably 25% or higher, more preferably 28% or higher, and still more preferably 30% or higher. The higher the utilization efficiency is, the more preferable. However, since three kinds of filters red, green and blue are used, the efficiencies are usually 33% or lower.

### Example

In the following, the present invention will be explained in more detail by referring to Examples. It is to be understood that the present invention is by no means limited by the following Examples insofar as they do not depart from the intent of the invention.

### [1. Method for measurement and evaluation of phosphor]

Various evaluations of phosphor particles were carried out by the following methods in each Example, Comparative Example and Reference Example to be described later.

### [Measurement method of emission spectrum]

The emission spectra were measured by using a fluorescence measurement apparatus (manufactured by JASCO corporation) equipped with an excitation light source of 150-W xenon lamp and a spectrum measurement apparatus of multichannel CCD detector C7041 (manufactured by Hamamatsu Photonics K.K.). The lights from the excitation light source were passed through a grating monochromator with focal length of 10 cm so as to isolate the excitation lights of 405-nm or 455-nm wavelength, and the isolated excitation lights were radiated onto the phosphors via an optical fiber. The lights emitted from the phosphors by irradiation of the excitation light were separated using a grating monochromator with focal length of 25 cm, and the emission intensity of each wavelength of the lights was measured using the spectrum measurement apparatus in the wavelength range of from 300 nm to 800 nm. Then, through a signal processing such as sensitivity correction by a personal computer, the emission spectra were obtained. The slit width of the receiving spectroscope was set at 1 nm during the measurement.

The emission peak wavelengths and full width at half maximums were read out from the obtained emission spectra. The emission-peak intensities and brightnesses were indicated relatively to the reference value 100, which was the peak intensity of a phosphor LP-B4 manufacture by Kasei Optonics, Ltd. at the time of 365-nm wavelength excitation. The higher the relative emission-peak intensity and brightness are, the more preferable.

### [Method for measuring color coordinate]

The color coordinates CIEx and CIEy in the XYZ colorimetric system defined in JIS Z8701 were calculated from the emission spectrum data in the wavelength region of 430 nm to 800 nm (in the case of 405-nm excitation wavelength),or 480 nm to 800 nm (in the case of 455-nm excitation wavelength) in accordance with the method of JIS 28724.

### [Method for measuring excitation spectrum]

Excitation spectra were determined in the wavelength range of 250 nm to 500 nm using a fluorescence spectrophotometer F-4500 manufactured by Hitachi, Ltd. with a monitoring wavelength corresponding to each emission-peak wavelength.

### [Temperature quenching characteristics (emission-intensity retention rate and brightness retention rate)]

The characteristics were measured using an emission spectrum measurement device of multi-channel spectrum analyzer MCPD7000 manufactured by Otsuka Electronics Co., Ltd., a stage equipped with a cooling mechanism using a peltiert device and a heating mechanism using a heater, and an apparatus equipped with a 150-W xenon lamp as light source.

A cell holding the phosphor sample was put on the stage, and the temperature was changed within the range from 20°C to 175°C. Namely, after verifying the surface temperature of the phosphor was held constant at 20°C, 25°C, 50°C, 75°C, 100°C, 125°C, 150°C and 175°C, the emission spectrum of the phosphor was measured when it is excited with light from the light source having wavelength of 455 nm, which was separated using a diffraction grating. Then, the emission-peak intensity and brightness at each temperature were calculated from each measured emission spectrum, and indicated by their ratios to the emission-peak intensity and brightness at 20°C as a percentage.
At this point, as the measurement value of the surface temperature of the phosphor on the side irradiated with the excitation light, was used a value corrected by the temperature values measured with a radiation thermometer and a thermocouple.

### [Internal quantum efficiency, external quantum efficiency, and absorption efficiency]

The absorption efficiency αq, internal quantum efficiency ηi, and external quantum efficiency ηo of the phosphor were determined by the following procedure. First, the phosphor sample to be measured is stuffed up in a cell with its surface smoothed sufficiently to keep high measurement accuracy, and then it was set on an integrating sphere.

The integrating sphere was irradiated with light from a light emission source (150-W Xe lamp) for exciting the phosphor using an optical fiber. The light from the aforementioned light emission source was adjusted to be a monochromatic light having an emission-peak wavelength of 455 nm using a monochromator (grating monochromator) or the like. Then the spectra of the emitted light (fluorescence) and the reflected light from the phosphor sample were measured using a spectrometer (MCPD7000, manufactured by Otsuka Electronics Co., Ltd.) by irradiating the phosphor sample to be measured with the above monochromatic excitation light. The light within the integrating sphere was guided to the spectrometer with an optical fiber.

Absorption efficiency αq takes the value of N_{abs}/N, where N_{abs} is the number of photons of the excitation light that is absorbed in the phosphor sample and N is the number of all the photons in the excitation light.

First, the latter one, namely the total number N of all the photons in the excitation light is proportional to the numerical value obtained by the (formula A) below. Therefore, the reflection spectrum I_{ref}(λ) was measured using a spectrometer for a reflection plate "Spectralon" with reflectance R of approx. 100 % to excitation lights (actually with reflectance of 99% to the 450-nm excitation light) manufactured by Labsphere, by attaching it to the above-mentioned integrating sphere in the same disposition as the phosphor sample and radiating the excitation light thereon, and then the value of the (formula A) below was calculated.

$\begin{matrix}\left[Mathematical Formula 4\right] \\ \frac{1}{R} \int λ ⋅ {I}_{ref} \left(λ\right) ⅆ λ\end{matrix}$

The integration interval was set at from 410 nm to 480 nm. The number N_{abs} of the photons in the excitation light absorbed in the phosphor sample is proportional to the amount calculated in the following (formula B).

$\begin{matrix}\left[Mathematical Formula 5\right] \\ \frac{1}{R} \int λ ⋅ {I}_{ref} \left(λ\right) ⅆ λ - \int λ ⋅ I \left(λ\right) ⅆ λ\end{matrix}$

Therefore, the reflection spectrum I(λ) was decided with the phosphor sample of which absorption efficiency αq is intended to be determined attached. The integration interval in (formula B) was set to be the same as in (formula A). Since the actual measurement value of the spectrum is generally obtained as digital data which are divided by a certain finite band width relating to λ, the integrations of (formula A) and (formula B) were calculated as finite sum based on the band width.
Then, the value of αq=N_{abs}/N=(formula B)/formula A) was calculated.

Next, the internal quantum efficiency ηi was decided according to the following procedure. The internal quantum efficiency ηi takes the value of N_{PL}/N_{abs}, where N_{PL} is the number of photons originating from the fluorescence phenomenon and N_{abs} is the number of photons absorbed in the phosphor sample.
Here, N_{PL} is proportional to the amount calculated by the following (formula C). Therefore, the amount calculated by the following (formula C) was determined.

$\begin{matrix}\left[Mathematical Formula 6\right] \\ \int λ ⋅ I \left(λ\right) ⅆ λ\end{matrix}$

The integration interval was set at from 481 nm to 800 nm.
Then, the internal quantum efficiency ηi was determined by the calculation of ηi = (formula C) / (formula B).

Incidentally, the integration from spectra expressed by digital data was carried out in the same way as when the absorption efficiency αq was calculated.
The external quantum efficiency ηo was then decided as a product of the absorption efficiencyαq and internal quantum efficiency ηi, which were determined as above.

### [Weight median diameter]

The weight median diameter was measured using a laser diffraction/scattering particle size distribution analyzer LA-300 manufactured by HORIBA, Ltd., and a dispersion medium of water.

### [Powder X-ray diffractometry]

Precise measurements of powder X-ray diffractometry were made using a powder X-ray diffractometry apparatus, X'Pert, manufactured by Analytical. The measurement conditions were as follows. The measurement data were subjected to an automated background processing using data processing software X'Pert High Score (manufactured by PANalytical) with a bending filter set at 5.
Use of a Cukα tube
X-ray output: 45KV, 40mA
Divergence slit: 1/4⁰, X-ray mirror
Detector: semiconductor array detector X'Celerator, with Ni filter
Scan range: 2θ of 10 to 65 degree
Reading width: 0.05 degree
Counting time: 33 secconds

### [LED-durability test]

Explanation will be given by referring to Fig. 2(b). A blue light emitting diode (C460 EZ290, manufactured by Cree, Inc.) was used as the first luminous body (22) by being bonded to an electrode (27) disposed at the bottom of the recess in a frame (24) by means of die bonding using silver paste as adhesive. After curing the silver paste by heating at 150°C for 2 hours, the blue LED (22) and the electrode (26) disposed on the frame (24) were bonded through wire bonding. As the wire, a gold wire with a diameter of 25 µm was used.
A phosphor slurry was prepared by mixing 0.08 g of each phosphor dried at 150°C for 2hours with 1.415 g of a silicone resin (SCR1011, manufactured by Shin-Etsu Chemical Co., Ltd.). A phosphor-containing part (23) was formed by pouring the slurry into the recess of the frame and curing it by heating at 70°C for 1 hour, then at 150°C for 5 hours. A surface-mount green light emitting device was thus produced.
The blue LED, of the obtained light emitting device, was energized with 20-mA current to emit light under a condition of 85°C temperature and 85% humidity. The color coordinate CIEy, which significantly affects green color, was measured every 50 hours so as to determine the CIEy retention rate when letting the CIEy value just after the beginning of the energization be 100.

### [Evaluation of persistence characteristics]

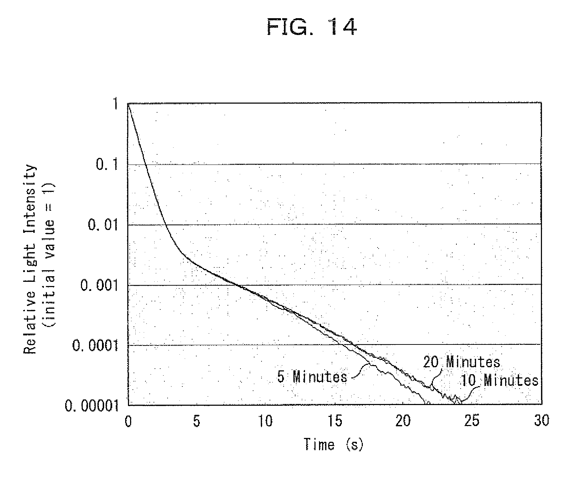

Phosphor samples were irradiated with excitation light of 254-nm wavelength by using a fluorescence spectrophotometer F-4500 manufactured by Hitachi, Ltd. at a temperature of 25°C and a humidity of 40%. The intensity of the emission (monitoring wavelength: 525 nm) from the phosphor after stopping the irradiation was measured under such conditions as time constant of 2secondsand measurement intervals of 0.2 seconds.
Changes in persistence characteristic of the phosphor of Reference Example 1 (described later) are shown in Fig. 14, for excitation-light irradiation times of 5 minutes, 10 minutes, and 20 minutes. From those measurement results, sufficient irradiation time was determined to be 10minutes with respect to the phosphor represented by the formula Therefore, persistence characteristic evaluations were performed with the irradiation time set at 10minutes in the following Examples and Comparative Examples.

### [Measurement of thermoluminescence]

Phosphor powder is coated onto a substrate to be measured by liquid glass precipitation method described below and its thermoluminescence spectrum was measured by using the substrate.

### (Liquid glass precipitation method)

After washing the substrate with alkali, phosphor was coated thereon.
Namely, into a 500 ml beaker were transferred 200 ml of water and 10 grains (about 2.5 g) of sodium hydroxide. After stirring with a glass rod, the substrate (11 mm × 27 mm, plated with copper/nickel, oxygen-free) was immersed into it.

The beaker containing the substrate was placed on a heater. The substrate was heated for 2 hours, taken out of the beaker and dried by wiping its surface with cloth moistened with acetone.
Ion-exchange water 250 ml and commercially available barium acetate powder 0.125 g were mixed to prepare a 0.05-weight % barium acetate water solution. This barium acetate solution 25 ml was transferred to a 100-ml beaker and the above mentioned substrate, retained on an aluminum substrate support, was dipped into the solution slowly.

Ohka seal B (TOKYO OHKA KOGYO CO., LTD.) was mixed with ion-exchange water in a ratio of 1:7 to prepare 3.4-weight % liquid glass. This liquid glass 20 ml was transferred to a 50ml beaker and 0.3 g of phosphor sample was added. The beaker was covered with Parafilm, for example, and subjected to ultra sonic oscillation for 10minutes to effect good dispersion, to prepare a liquid glass solution containing the phosphor.

While the liquid glass solution was stirred with a medicine spoon, it was poured into the barium acetate solution mentioned above and allowed to stand for over 4 hours, allowing the phosphor material to precipitate.
The supernatant was siphoned off and the substrate was taken out. The substrate taken out was stored in a sample substrate case and air-dried at room temperature for over 12 hours. Then it was dried in a vacuum dryer set at 100°C for 1 hour.

### (Method of measuring thermoluminescence)

The powdered phosphor sample, coated on the oxygen-free copper substrate obtained above, was fitted to a head portion of a temperature-controllable cryostat (MINISTAT, type CRT-006-0000, Iwatani Corporation). This cryostat can effect cooling of samples to as low as about 50K by means of adiabatic expansion of He gas in a closed system and also can effect heating to as high as 600K by means of a heater installed at a sample retention portion. For temperature control, a temperature controller (type 331, manufactured by Lake Shore Cryotronics, Inc.) can be used which can elevate sample temperature constantly at a maximum temperature rising rate of 10 K/min.

As measurement of persistence around room temperature is not affected much by thermoluminescence at low temperature, the measurement was performed in the temperature range of 65K to 600K at an temperature rising rate of 10 K/min.
Fluorescence emitted by the sample is to be collected by a lens and input into a photomultiplier and its output is to be fed into a personal computer via digital multimeter (334401A, Hewlett Packard). The sample temperature is also input into the personal computer via the above temperature controller and a program has been made to display thermoluminescence intensity against the temperature.

The sample, which had been cooled to 65K prior to measurement, was irradiated with excitation light. The excitation light consisting mainly of 254-nm wavelength was screened by combining a low pressure mercury lamp (UL-N type ultraviolet apparatus, Shimadzu) and a glass filter UV-31. Irradiation period was set at 40 minutes. After irradiation, a shutter placed in front of the sample was closed and time was allowed until no persistence was detected. Usually, this time period is 20 minutes. When no persistence was detected, sample temperature was raised and thermoluminescence glow curve was displayed on the basis of the temperature and emission intensity input into the personal computer.

### [Method for measuring reflection spectrum]

For measuring reflection spectra, a 150-W xenon lamp was used as the excitation light source, an integrating sphere was used as the condenser, and a multi-channel spectrum measurement apparatus MCPD7000 manufactured by Otsuka Electronics Co., Ltd. was used as the spectrum measurement apparatus. First, the reflection spectrum of a standard white surface board was determined by irradiating a substance with approx. 100% reflectance R with respect to the excitation light ("Spectralon" manufactured by Labsphere with 99% reflectance R with respect to the excitation light of 450-nm wavelength) with light from the 150-W xenon lamp, measuring the reflection intensities of respective wavelengths in the wavelength range from 380 nm to 780 nm using the spectrum measurement apparatus, and signal processing such as sensitivity correction using a personal computer. Next, a silicon nitride sample, the measurement object, stuffed up in a cell with its surface smoothed sufficiently for adequate measurement accuracy, was measured for its reflection intensities of respective wavelengths in the same way as above. Then, the reflection spectrum of the sample was determined by the ratio of the reflection intensity to that of the standard white surface board.

### [Method for measuring non-luminous object color]

The non-luminous object color L*, a*, and b* were measured with a colorimeter CR-300 manufactured by MINOLTA using D₆₅ as the light source. First, white calibration was performed by putting a measuring head on a calibration standard board perpendicularly via a transparent glass plate. Next, a phosphor sample, the measurement object, stuffed up in a cell with its surface smoothed sufficiently for adequate measurement accuracy, was measured for its non-luminous object color in the same way as above also via a transparent glass plate.

### [Example group I: Verification of effect of flux and investigation on phosphor composition]

### [Raw materials used]

As phosphor materials, the following products were used unless otherwise specified.
BaCO₃ (manufactured by Hakushin Chemical Laboratory Co, Ltd.)
SiO₂ (manufactured by Tatsumori, Ltd.)
Si₃N₄ (SN-E10 manufactured by Ube Industries, Ltd., which was heated for 4hours at 2000°C under 0.92 MPa of N₂ atmosphere)
Eu₂O₃ (manufactured by Shin-Etsu Chemical Co., Ltd.)
BaF₂ (manufactured by KANTO CHEMICAL CO., INC., purity of 99%), ZnF₂•4H₂O (manufactured by Wako Pure Chemical Industries, Ltd., purity of 99%)
Zn₃(PO₄)₂•4H₂O (manufactured by Wako Pure Chemical Industries, Ltd., purity of 95%)
BaI₂ (manufactured by Strem Chemicals, Inc., purity of 97%)
BaHPO₄ (manufactured by Hakushin Chemical Laboratory Co, Ltd., Phosphor Grade)
K₂B₄O₇•4H₂O (manufactured by Wako Pure Chemical Industries, Ltd.)

### [Examples I-1, I-2 and Comparative Example I-1]

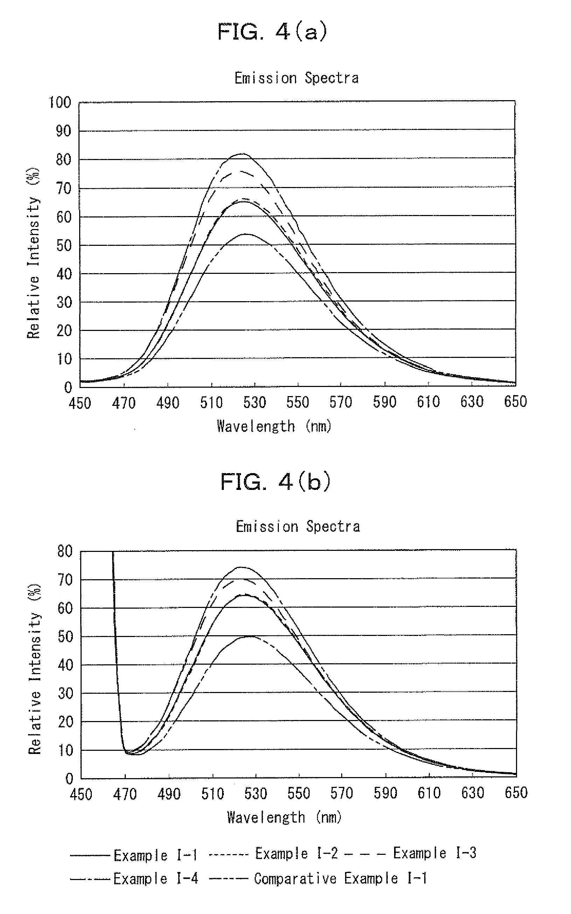

BaCO₃, SiO₂, Si₃N₄, Eu₂O₃, BaF₂ and ZnF₂•4H₂O, weighed out according to Table I-1 (the Eu concentration is 6 mole percent relative to Ba), were mixed by dry-type mixing and then filled into an alumina crucible. This was placed in a resistance-heating tubular electric furnace fitted with a temperature regulator and heated from room temperature to 1200°C at a temperature rising rate of 5.0 °C/min in a 0.5-1/min mixed current of 96 volume % of nitrogen + 4 volume % of hydrogen under atmospheric pressure. That temperature was maintained for 6 hours, and then the mixture was allowed to cool to room temperature. The sample obtained was pulverized in an alumina mortar and the pulverized sample was again filled into an alumina crucible. This alumina crucible was placed in a resistance-heating tubular electric furnace fitted with a temperature regulator and heated from room temperature to 1350°C at a temperature rising rate of 5.0 °C/min in a 0.5-1/main mixed current of 96 volume % of nitrogen + 4 volume % of hydrogen under atmospheric pressure. That temperature was maintained for 8 hours, and then the product was allowed to cool to room temperature. The obtained phosphor was measured for its emission spectrum. The spectrum maps were shown in Fig. 4(a) and 4(b). The results of various characteristics evaluations were summarized in Table 1-2. Fig. 4(a) shows emission spectra under excitation by light of 405-nm wavelength. Fig. 4(b) shows emission spectra under excitation by light of 455-nm wavelength.

**[Table 1]**

| [Table I-1. Raw Materials] | | | | | | |
|---|---|---|---|---|---|---|
| | Eu₂O₃ (g) | BaCO₃ (g) | SiO₂ (g) | Si₃N₄ (g) | BaF₂ (g) | ZnF₂•4H₂O (g) |
| Examples I-1 | 0.34 | 6.02 | 2.87 | 2.23 | 0.1 | 0 |
| Example I-2 | 0.34 | 6.02 | 2.87 | 2.23 | 0 | 0.1 |
| Comparative Example I-1 | 0.34 | 6.02 | 2.87 | 2.23 | 0 | 0 |

**[Table 2]**

| [Table 1-2. Characteristics Evaluation Results of Phosphors under Excitation by Light of 455-nm Wavelength | | | | | | | |
|---|---|---|---|---|---|---|---|
| | flux | addition amount | emission peak wavelength (nm) | emission peak intensity | brightness | CIEx | CIEy |
| Example I-1 | BaF₂ | 1 weight % | 525 | 64.4 | 689 | 0.274 | 0.644 |
| Examples I-2 | ZnF₂·4H₂O | 1 weight % | 526 | 64.7 | 695 | 0.276 | 0.643 |
| Comparative Example I-1 | non flux | | 529 | 49.7 | 544 | 0.281 | 0.640 |

As can be seen in Table I-2, the emission-peak intensities and brightnesses of Example I-1, in which BaF₂ was added, and Example 1-2, in which ZnF₂ was added, were higher than those of Comparative Example I-1, in which neither BaF₂ nor ZnF₂ was added. This means the brightness was improved by the effects of fluxes BaF₂ and ZnF₂.

### [Examples I-3 and I-4]

BaCO₃, SiO₂ and Eu₂O₃, weighed out according to Table I-3, were mixed by dry-type mixing and then filled into an alumina crucible. This was placed in a resistance-heating electric furnace fitted with a temperature regulator and heated from room temperature to 1200°C at a temperature rising rate of 5.0 °C/minute under atmospheric pressure. That temperature was maintained for 6 hour, and then the mixture was allowed to cool to room temperature. After pulverizing the fired product removed, Si₃N₄ and fluxes (BaF₂, ZnF₂) were added thereto in amounts according to Table I-4, and then they were mixed by dry-type mixing. The mixed sample was again filled into an alumina crucible. This alumina crucible was placed in a resistance-heating electric furnace fitted with a temperature regulator and heated from room temperature to 1350°C at a temperature rising rate of 5.0 °C/minute in a 0.5-1/main mixed current of 96 volume % of nitrogen + 4 volume % of hydrogen under atmospheric pressure. That temperature was maintained for 8 hour, and then the product was allowed to cool to room temperature. The fired product obtained was crushed lightly and passed through a 305-mesh nylon sieve. The resultant powder was thrown into 1-N HCl, stirred for 30 minutes, and allowed to stand, followed by ejection of the supernatant fluid (decantation). Subsequently, it was washed with desalted water repeatedly 4 times. After the washings, it was dried for 3hours at 120°C, resulted in giving a phosphor. The obtained phosphor was measured for its emission spectrum. The spectrum maps were shown in Fig. 4(a) and 4(b). The results of various characteristics evaluations were summarized in Table 1-4.

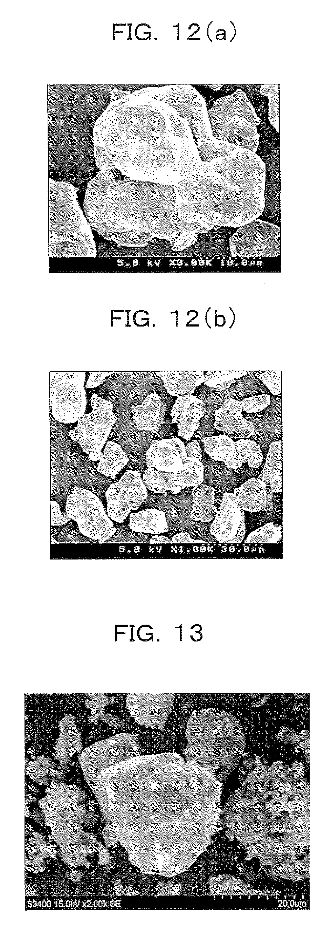

Photos, which substitute for drawings, of the phosphor prepared in Example I-3 of the present invention taken with a scanning electron microscope (SEM) are shown in Figs. 12(a) and 12(b). Fig. 12(a) is taken at 3000-fold magnification. Fig. 12(b) is taken at 1000-fold magnification.

**[Table 3]**

| [Table I-3. Raw Materials] | | | | | | |
|---|---|---|---|---|---|---|
| | Eu₂O₃ (g) | BaCO₃ (g) | SiO₂ (g) | Si₃N₄ (g) | BaF₂ (g) | ZnF₂·4H₂O (g) |
| Example I-3 | 0.34 | 6.02 | 2.87 | 2.23 | 0.15 | 0 |
| Example 1-4 | 0.34 | 6.02 | 2.87 | 2.23 | 0 | 0.15 |

**[Table 4]**

| [Table I-4. Characteristics Evaluation Results of Phosphors under Excitation by Light of 455-nm Wavelength] | | | | | | | |
|---|---|---|---|---|---|---|---|
| | flux | addition amount | emission peak wavelength (nm) | emission peak intensity | brightness | CIEx | CIEy |
| Example I-3 | BaF2 | 1.5 weight % | 522 | 70.1 | 727 | 0.264 | 0.646 |
| Example I-4 | ZnF₂·4H₂O | 1.5 weight % | 523 | 74.2 | 775 | 0.267 | 0.646 |

As can be seen from results shown in Table I-4, the brightness was further improved in Examples I-3 and I-4 compared to Examples I-1 and I-2. This makes possible to infer that there is an optimum value for the amount of fluxes BaF₂ and ZnF₂ to be added.
In addition, analyses on F, Zn and Al contents in this phosphor were carried out. The results were summarized in Table I-5.
Al and Zn contents were measured by an ICP-AES analysis method with an ICP-AES analyzer Ultima 2C manufactured by HORIBA JOBIN YVON S.A.S. using a phosphor subjected to a chemical decomposition treatment.
F content was measured by a combustion-ion chromatography (IC) analysis method. For the measurement, a combustion and absorption equipment AQF-100 manufactured by DIA INSTRUMENTS and an IC analyzer DX-500 manufactured by Dionex Corporation was used.
As is evident from results shown in Table I-5, F is contained in the crystal, but Zn is hardly contained therein. Al is probably due to the alumina crucible used.

**[Table 5]**

| [Table I-5] | | | | | |
|---|---|---|---|---|---|
| | flux | addition amount | F (weight %) | Zn (weight %) | AI (weight %) |
| Example I-3 | BaF2 | 1.5 weight % | 0.025 | - | - |
| Example I-4 | ZnF₂·4H2O | 1.5 weight % | 0.023 | <0.0005 | 0.01 |

### [Examples I-38 to I-40]

A phosphor was produced in the same way as Example I-3 except that the phosphor materials were weighed out to give a charge composition of Ba_{2.7}Eu_{0.3}Si₉O₁₂N₆, fluxes listed in the following Table I-15 were used, and the firing temperature under 96 volume % of nitrogen + 4 volume % of hydrogen was set at 1300°C. Occurring of BSON crystal phases were verified with an X-ray measurement. The emission spectra of these phosphors were measured, and various characteristics evaluated from the spectra were shown in the following Table I-15.

**[Table 6]**

| [Table I-15. Characteristics Evaluation Results of Phosphors under Excitation by Light of 455-nm Wavelength] | | | | | | | |
|---|---|---|---|---|---|---|---|
| | flux | addition amount | emission peak wavelength (nm) | emission peak intensity | brightness | CIEx | CIEy |
| Example I-38 | Zn₃(PO₄)₂ | 1.5 weight% | 529 | 70.6 | 786 | 0.292 | 0.64 |
| Example I-39 | BaI₂ | 1.5 weight % | 528 | 73.8 | 814 | 0.289 | 0.641 |
| Example I-40 | BaHPO₄ | 1.5 weight % | 529 | 71.2 | 789 | 0.291 | 0.64 |

### [Example I-41]

The phosphor materials were weighed out to give a charge composition of Ba_{2.7}Eu_{0.3}Si₉O₁₂N₆. As fluxes, ZnF₂ and BaI₂ were used. After BaCO₃ (300.95 g), SiO₂ (143.30 g) and Eu₂O₃ (28 g) were mixed and stirred sufficiently for 30minutes in a vibration mill, they were tightly filled in an alumina crucible. This was placed in a resistance-heating tubular electric furnace fitted with a temperature regulator and heated to 1200°C at a temperature rising rate of 5.0 °C/minute under atmospheric pressure. That temperature was maintained for 6 hour, and then the mixture was allowed to cool to room temperature.
The sample obtained as above (60.00 g), Si₃N₄ (17.10 g), ZnF₂·4H₂O (1.16 g) and BaI₂ (0.77 g) were mixed in a nylon bag, followed by sieving out particles of 250 µm or smaller diameter. It was filled into an alumina crucible and heated up to 1350°C in an atmosphere of 96 volume % of nitrogen + 4 volume % of hydrogen under atmospheric pressure. That temperature was maintained for 10hours and then the product was allowed to cool to room temperature. The sample obtained was pulverized in an alumina mortar and then washed to remove impurities.
A BSON crystal phase formed in the phosphor obtained was verified by an X-ray measurement. The weight median diameter thereof was 31 µm. The emission spectrum of the phosphor was measured, and various characteristics evaluated from the spectrum were shown in the following Table 1-16.

### [Example I-42]

The phosphor materials were weighed out to give a charge composition of Ba_{2.7}Eu_{0.3}Si_{6.9}O₁₂N_{3.2}. After BaCO₃ (267 g), SiO₂ (136 g) and Eu₂O₃ (26.5 g) were mixed and stirred sufficiently, the mixture was filled in an alumina crucible. This was placed in a resistance-heating tubular electric furnace fitted with a temperature regulator and heated up to 1100°C at a temperature rising rate of 5 °C/minute under atmospheric pressure. That temperature was maintained for 5 hour, and then the mixture was allowed to cool to room temperature. The sample obtained was pulverized in an alumina mortar to 100 µm or smaller.
The sample obtained as above (295 g) and a phosphor material, Si3N₄ (45 g), were mixed and stirred sufficiently. It was filled into an alumina crucible and heated up to 1200°C under a 0.51/minute flow of mixed gas including 96 volume % of nitrogen + 4 volume % of hydrogen under atmospheric pressure. That temperature was maintained for 5 hour, and then the product was allowed to cool to room temperature. The fired powder obtained was pulverized in an alumina mortar to 100 µm or smaller.
The fired powder (300 g) obtained in the above primary firing and fluxes, BaF₂ (6 g) and BaHPO₄ (6 g), were mixed and stirred sufficiently. They were filled into an alumina crucible and subjected to a secondary firing up to 1350°C under a 0.51/min flow of mixed gas including 96 volume % of nitrogen + 4 volume % of hydrogen under atmospheric pressure. That temperature was maintained for 8 hour, and then the product was allowed to cool to room temperature. The fired powder obtained was pulverized in an alumina mortar to 100 µm or smaller.
Further, the sample (70 g) obtained in the above secondary firing and fluxes, BaCl₂ (5.6 g) and BaHPO₄ (3.5 g), were mixed and stirred sufficiently. They were filled into an alumina crucible and subjected to a tertiary firing up to 1200°C under a 0.51/min flow of mixed gas including 96 volume % of nitrogen + 4 volume % of hydrogen under atmospheric pressure. That temperature was maintained for 5 hour, and then the product was allowed to cool to room temperature. The fired powder obtained was dispersed by using glass beads to form a slurry. After sieving out particles of 100 µm or smaller, washing treatment was performed. Then, a surface coating treatment with calcium phosphate was done by using a calcium solution and a phosphate solution. A BSON crystal phase formed in the phosphor obtained was verified by an X-ray measurement. The weight median diameter thereof was 19 µm. The emission spectrum of the phosphor was measured, and various characteristics evaluated from the spectrum were shown in the following Table I-16.

### [Example I-43]

The phosphor materials were weighed out to give a charge composition of Ba_{2.7}Eu_{0.3}Si₆O_{11.25}N_{2.5}. After BaCO₃ (6.92 g), SiO₂ g) and Eu₂O₃ (0.67 g) were mixed and stirred sufficiently, the mixture was filled in an alumina crucible. This was placed in a resistance-heating tubular electric furnace fitted with a temperature regulator and heated up to 1200°C at a temperature rising rate of 5 °C/min under atmospheric pressure. That temperature was maintained for 6 hour, and then the mixture was allowed to cool to room temperature. The sample obtained was pulverized in an alumina mortar to 100 µm or smaller.
The sample obtained as above (7.72 g), a phosphor material, Si₃N₄ (1.79 g), and a flux, K₂B₄O₇·4H₂O (0.5 g) were mixed and stirred sufficiently. The mixture was filled into an alumina crucible and heated up to 1300°C under a 0.51/min flow of mixed gas including 96 volume % of nitrogen + 4 volume % of hydrogen under atmospheric pressure. That temperature was maintained for 4 h, and then the mixture was allowed to cool to room temperature. The fired powder obtained was pulverized in an alumina mortar to 100 µm or smaller, followed by sieving. Then it was washed to remove impurities. A BSON crystal phase formed in the phosphor obtained was verified by an X-ray measurement. The weight median diameter thereof was 48.7 µm. The emission spectrum of the phosphor was measured, and various characteristics evaluated from the spectrum were shown in the following Table I-16.
Fig. 13 shows a photo, which substitutes for a drawing, of this phosphor taken with an SEM (scanning electron microscope). The phosphor has an effectively large average primary particle diameter of about 20 µm.

**[Table 7]**

| [Table T-16. Characteristics Evaluation Results of Phosphors under Excitation by Light of 455-nm Wavelength] | | | | | | |
|---|---|---|---|---|---|---|
| | flux | emission peak wavelength (nm) | emission peak intensity | brightness | CIEx | CIEy |
| Example I-41 | BaI₂ + ZnF₂ | 528 | 85 | 918 | 0.284 | 0.644 |
| Example I-42 | BaF₂ + BaHPO₄ → BaCl₂ + BaHPO₄ | 529 | 71 | 785 | 0.291 | 0.641 |
| Example I-43 | K2B4O7 | 528 | 49 | 534 | 0.284 | 0.641 |

### [Examples I-5 to I-19]

BaCO₃, SiO₂, Si₃N₄ and Eu₂O₃ were respectively weighed out according to Table 1-6. ZnF₂·4H₂O was added at a ratio of 1.5 weight % relative to the total weight of the materials.
These material powders were all transferred to an agate automatic mortar, and ethanol was added thereto. They were mixed well until they became homogeneous by a wet-type mixing method. The pasty mixture thus obtained was dried, filled into an alumina crucible, and compression-molded by applying a slight weight. This was placed in a resistance-heating tubular electric furnace fitted with a temperature regulator and heated from room temperature to 800°C at a temperature rising rate of 4.8 °C/minute, then from 800°C to 1200°C at a temperature rising rate of 3.0 °C/minute, in a 0.51/min mixed current of 96 volume % of nitrogen + 4 volume % of hydrogen under atmospheric pressure. That temperature was maintained for 4 hour and then the mixture was allowed to cool to room temperature. The sample obtained was pulverized in an alumina mortar. The pulverized sample was again filled into an alumina crucible and compression-molded by applying a slight weight. This alumina crucible was placed in a resistance-heating tubular electric furnace fitted with a temperature regulator and heated from room temperature to 800°C at a temperature rising rate of 4.8 °C/mninute, then from 800°C to 1300°C at a temperature rising rate of 3.0 °C/minute, in a 0.51/minute mixed current of 96 volume % of nitrogen + 4 volume % of hydrogen under atmospheric pressure. That temperature was maintained for 4 hours and then the product was allowed to cool to room temperature. The fired product obtained was crushed lightly and passed through a 305-mesh nylon sieve. The resultant powder was thrown into 1-N HCl, stirred for 30 minutes, and allowed to stand, followed by ejection of the supernatant fluid (decantation). Subsequently, washings were done with desalted water 4 times. After the washings, it was dried for 3hours at 120°C, resulted in giving a phosphor.
The weight median diameters of the phosphors of Examples I-6, 1-12 and I-13 are shown in Table I-7, of these phosphors.

**[Table 8]**

| [Table I-6. Raw Materials] | | | | | |
|---|---|---|---|---|---|
| | Eu₂O₃ (g) | BaCO₃ (g) | SiO₂ (g) | Si₃N₄ (g) | ZnF₂·4H₂O (g) |
| Example I-5 | 0.0557 | 6.357 | 2.8727 | 2.2353 | 0.17 |
| Example I-6 | 0.1129 | 6.2879 | 2.8713 | 2.2334 | 0.17 |
| Example I-7 | 0.2245 | 6.1537 | 2.8679 | 2.2354 | 0.17 |
| Example I-8 | 0.2805 | 6.0875 | 2.8657 | 2.232 | 0.17 |
| Example I-9 | 0.3349 | 6.0188 | 2.8653 | 2.2318 | 0.17 |
| Example I-10 | 0.3926 | 5.9513 | 2.866 | 2.2296 | 0.17 |
| Example I-11 | 0.446 | 5.8852 | 2.8635 | 2.2273 | 0.17 |
| Example I-12 | 0.5578 | 5.7537 | 2.8627 | 2.2275 | 0.17 |
| Example I-13 | 0.6699 | 5.6194 | 2.8583 | 2.2264 | 0.17 |
| Example I-14 | 0.7522 | 5.5191 | 2.8555 | 2.2226 | 0.17 |
| Example I-15 | 0.8351 | 5.4233 | 2.8531 | 2.2219 | 0.17 |
| Example I-16 | 0.9749 | 5.2553 | 2.85 | 2.2172 | 0.17 |
| Example I-17 | 1.112 | 5.0892 | 2.8456 | 2.2167 | 0.17 |
| Example I-18 | 1.3859 | 4.764 | 2.8405 | 2.2137 | 0.17 |
| Example I-19 | 1.6622 | 4.4318 | 2.8349 | 2.2058 | 0.17 |

**[Table 9]**

| [Table I-7. Weight Median Diameter of Phosphors] | |
|---|---|
| | weight median diameter (µm) |
| Example I-6 | 17.33 |
| Example I-12 | 17.28 |
| Example I-13 | 23.54 |

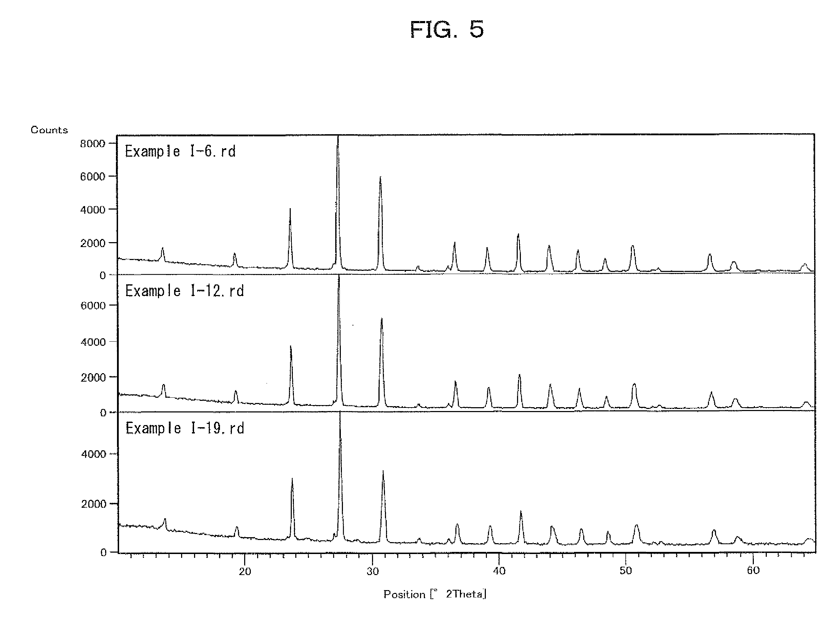

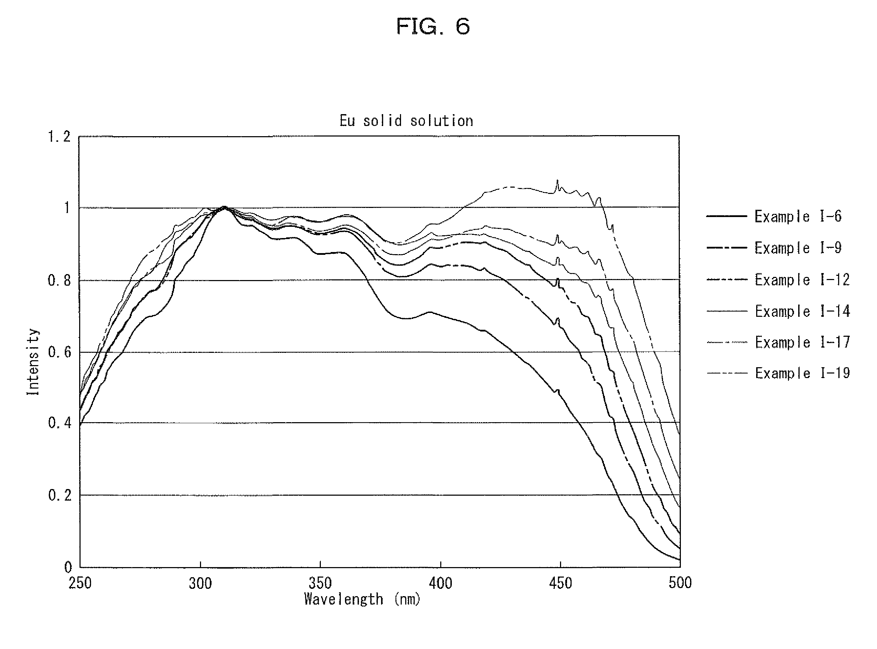

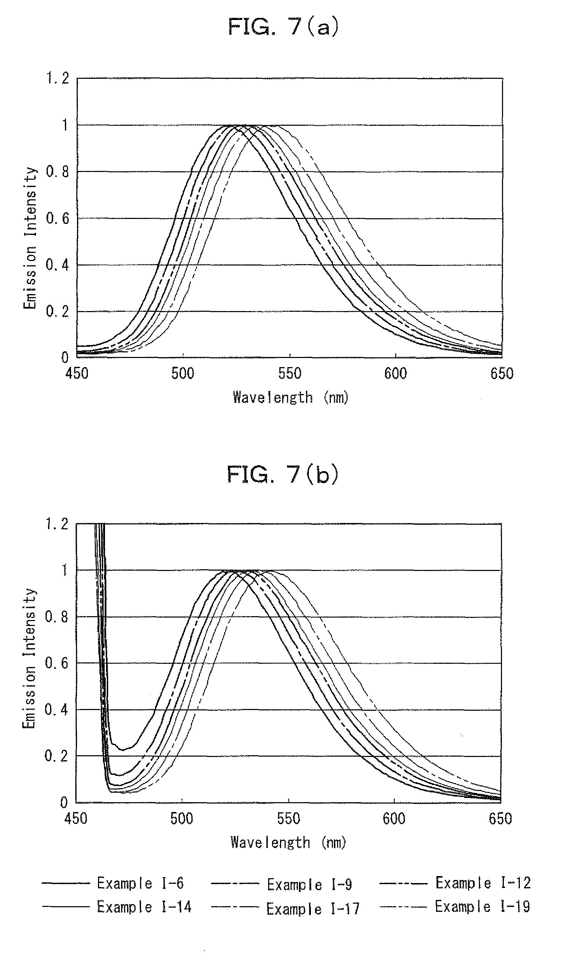

The X-ray diffraction patterns of the phosphors obtained are shown in Fig. 5. In Fig. 5, the X-ray diffraction patterns of Examples I-6, I-12 and I-19 are illustrated. It is evident that BSON phases were formed even when changed the amount of Eu added.
Also, the excitation spectra of the phosphors of Examples I-6, I-9, I-12, 1-14, 1-17 and I-19 are shown in Fig. 6. The emission spectra under excitation by 405-nm and 455-nm wavelengths are shown in Fig. 7(a) and Fig. 7(b), respectively. Fig. 6 is normalized by the value of 310-nm wavelength. Figs. 7(a) and 7(b) are normalized by the emission-peak wavelength.
It is evident from these results that, when the Eu concentration is higher, the excitation band intensity around a wavelength of 400 nm to 450 nm becomes higher and the emission-peak wavelength shifts to longer wavelength.

The luminescent characteristics of the phosphors of Examples I-5 to I-19 under excitation by light of 405 nm and 455 nm are shown in Table I-8 and Table I-9, respectively.

**[Table 10]**

| [Table I-8. Luminescent Characteristics under Excitation by Light of 405-nm Wavelength] | | | | | | |
|---|---|---|---|---|---|---|
| | Eu concentration | emission peak wavelength (nm) | emission peak intensity | brightness | CIEx | CIEy |
| Examples I-5 | 1 | 519 | 49.1 | 483.0 | 0.238 | 0.617 |
| Example I-6 | 2 | 521 | 62.7 | 624.7 | 0.245 | 0.624 |
| Example I-7 | 4 | 522 | 76.1 | 785.1 | 0.258 | 0.631 |
| Example I-8 | 5 | 524 | 78.5 | 822.8 | 0.264 | 0.632 |
| Example I-9 | 6 | 526 | 78.2 | 831.0 | 0.269 | 0.632 |
| Example I-10 | 7 | 526 | 78.4 | 848.2 | 0.276 | 0.632 |
| Example I-11 | 8 | 525 | 78.8 | 863.4 | 0.281 | 0.633 |
| Example I-12 | 10 | 530 | 76.3 | 855.4 | 0.291 | 0.631 |
| Example I-13 | 12 | 531 | 71.9 | 825.7 | 0.301 | 0.628 |
| Example I-14 | 13.5 | 529 | 70.4 | 810.2 | 0.308 | 0.636 |
| Example I-15 | 15 | 534 | 66.1 | 774.0 | 0.313 | 0.632 |
| Example I-16 | 17.5 | 534 | 61.4 | 730.9 | 0.322 | 0.629 |
| Example I-17 | 20 | 537 | 59.3 | 713.3 | 0.33 | 0.626 |
| Example I-18 | 25 | 538 | 48.7 | 600.8 | 0.345 | 0.617 |
| Example I-19 | 30 | 540 | 34.5 | 435.8 | 0.358 | 0.609 |

| | | | | | | |
|---|---|---|---|---|---|---|
| * Eu concentrations were calculated as [(Eu number of moles)/{(Ba number of moles) + (Eu number of moles)} × 100] on the basis of number of moles of charged materials. | | | | | | |

**[Table 11]**

| [Table I-9. Luminescent Characteristics under Excitation by Light of 455-nm Wavelength] | | | | | | | | | | | |
|---|---|---|---|---|---|---|---|---|---|---|---|
| | Eu concentration | emission peak wavelength (nm) | emission peak intensity | brightness | CIEx | CIEy | internal quantum efficiency (%) | absorption efficiency (%) | external quantum efficiency (%) | intensity retention rate at 150°C (%) | brightness retention rate at 150°C (%) |
| Example I-5 | 1 | 521 | 34.9 | 345.8 | 0.244 | 0.640 | 84.7 | 39.1 | 33.1 | 74 | 77 |
| Example I-6 | 2 | 521 | 48.7 | 488.1 | 0.251 | 0.644 | 89.0 | 48.7 | 43.3 | 76 | 78 |
| Example I-7 | 4 | 523 | 66.4 | 686.2 | 0.263 | 0.646 | 86.1 | 64.1 | 55.2 | 83 | 85 |
| Example I-8 | 5 | 524 | 70.1 | 737.9 | 0.269 | 0.645 | 83.8 | 67.6 | 56.7 | 81 | 83 |
| Example I-9 | 6 | 524 | 70.0 | 747.8 | 0.274 | 0.644 | 84.1 | 71.3 | 60.0 | 78 | 79 |
| Example I-10 | 7 | 525 | 73.2 | 792.6 | 0.281 | 0.643 | 82.8 | 73.8 | 61.1 | 78 | 80 |
| Example I-11 | 8 | 527 | 75.7 | 830.3 | 0.286 | 0.642 | 82.2 | 75.5 | 62.0 | 73 | 75 |
| Example I-12 | 10 | 529 | 75.9 | 855.5 | 0.296 | 0.639 | 78.3 | 79.5 | 62.2 | 68 | 70 |
| Example I-13 | 12 | 531 | 72.3 | 834.5 | 0.306 | 0.634 | 73.1 | 81.9 | 59.8 | 64 | 66 |
| Example I-14 | 13.5 | 532 | 74.3 | 860.7 | 0.310 | 0.634 | 72.8 | 85.7 | 62.4 | 62 | 64 |
| Example I-15 | 15 | 534 | 69.0 | 813.5 | 0.315 | 0.631 | 71.0 | 85.6 | 60.8 | 62 | 64 |
| Example I-16 | 17.5 | 534 | 66.9 | 800.6 | 0.324 | 0.627 | 67.0 | 87.7 | 58.8 | 63 | 65 |
| Example I-17 | 20 | 535 | 67.6 | 818.7 | 0.332 | 0.624 | 63.6 | 89.6 | 57.0 | 59 | 61 |
| Example I-18 | 25 | 540 | 58.2 | 722.9 | 0.347 | 0.616 | 55.8 | 89.4 | 49.9 | 54 | 56 |
| Example I-19 | 30 | 541 | 44.3 | 562.2 | 0.360 | 0.607 | 44.1 | 89.4 | 39.4 | 45 | 47 |

| | | | | | | | | | | | |
|---|---|---|---|---|---|---|---|---|---|---|---|
| * Eu concentrations were calculated as [(Eu number of moles)/{(Ba number of moles) + (Eu number of mole)} × 100] on the basis of number of moles of charged materials. | | | | | | | | | | | |

As can be seen from these results, the preferable range of Eu concentration is 5 mole % to 10 mole % in the case of 405-nm wavelength, and 8 mole % to 13.5 mole % in the case of 455-nm wavelength.
The internal quantum efficiency is the highest around the Eu concentration of 2 mole percent, and it becomes lower with increasing Eu concentration. In contrast, the absorption efficiency becomes higher with increasing Eu concentration. The external quantum efficiency, which is the product of the above two efficiencies, becomes high when the Eu concentration is 5 mole % to 15 mole %, in which case the desired, high-relative brightness phosphors can be obtained. It is also clear that the brightness retention rate at high temperature (150°C) tends to be high when the Eu concentration is low.

### [Examples 1-20 to I-37]

BaCO₃, SrCO₃, SiO₂, Si₃N₄ and Eu₂O₃ were respectively weighed out according to Table I-10. ZnF₂·4H₂O was added at a ratio of 1.5 weight % relative to the total weight of the materials. The subsequent processes were performed in the same way as Example I-5, thereby preparing phosphors.

**[Table 12]**

| [Table I-10. Raw Materials] | | | | | | |
|---|---|---|---|---|---|---|
| | Eu₂O₃ (g) | BaCO₃ (g) | SrCO₃ (g) | SiO₂ (g) | Si₃N₄ (g) | ZnF₂·4H₂O (g) |
| Example I-20 | 0.1122 | 6.2591 | 0.0248 | 2.8749 | 2.239 | 0.17 |
| Example I-21 | 0.1126 | 6.2322 | 0.0483 | 2.8744 | 2.2392 | 0.17 |
| Example I-22 | 0.113 | 6.178 | 0.0973 | 2.8808 | 2.2423 | 0.17 |
| Example I-23 | 0.1136 | 6.0669 | 0.1939 | 2.8861 | 2.2475 | 0.17 |
| Example I-24 | 0.1142 | 5.9562 | 0.2903 | 2.8964 | 2.2548 | 0.17 |
| Example I-25 | 0.1137 | 5.8488 | 0.3879 | 2.966 | 2.2631 | 0.17 |
| Example I-26 | 0.1135 | 5.7366 | 0.4876 | 2.9187 | 2.2718 | 0.17 |
| Example I-27 | 0.1153 | 5.454 | 0.739 | 2.9418 | 2.288 | 0.17 |
| Example I-28 | 0.1153 | 5.1676 | 0.9913 | 2.9662 | 2.3068 | 0.17 |
| Example I-29 | 0.5579 | 5.7263 | 0.0236 | 2.863 | 2.2291 | 0.17 |
| Example I-3D | 0.5588 | 5.6969 | 0.0476 | 2.8678 | 2.2299 | 0.17 |
| Example I-31 | 0.5613 | 5.6428 | 0.0941 | 2.8656 | 2.2338 | 0.17 |
| Example I-32 | 0.5632 | 5.5305 | 0.1937 | 2.8794 | 2.2417 | 0.17 |
| Examples I-33 | 0.5642 | 5.4218 | 0.2897 | 2.8873 | 2.2474 | 0.17 |
| Example I-34 | 0.5662 | 5.3076 | 0.3874 | 2.8921 | 2.2589 | 0.17 |
| Example 1-35 | 0.5693 | 5.1969 | 0.4854 | 2.9065 | 2.2623 | 0.17 |
| Example I-36 | 0.5719 | 4.9081 | 0.734 | 2.9295 | 2.2811 | 0.17 |
| Example I-37 | 0.5771 | 4.6182 | 0.9877 | 2.9568 | 2.2997 | 0.17 |

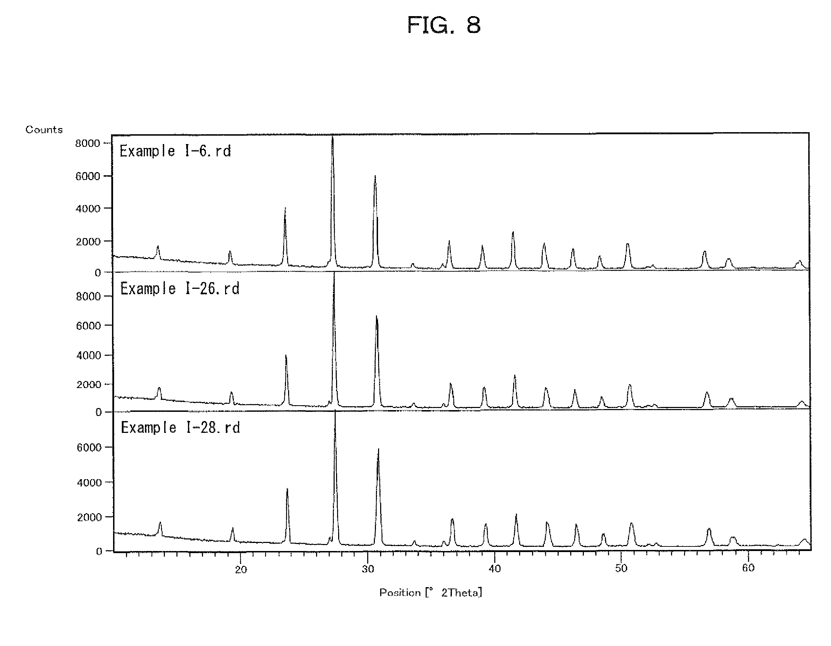

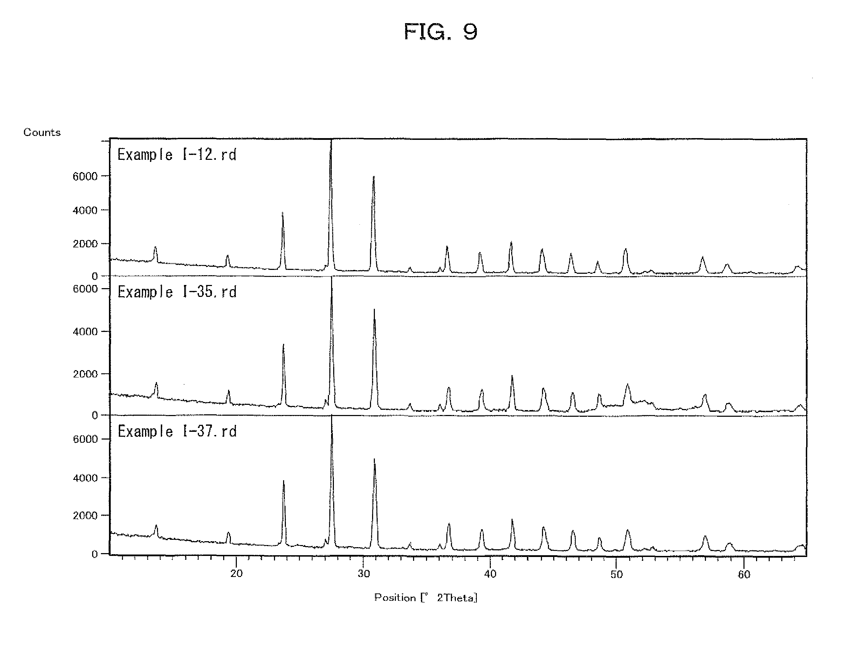

The X-ray diffraction patterns of the phosphors obtained are shown in Figs. 8 and 9. Fig. 8 shows the X-ray diffraction patterns of Examples I-6, I-26 and I-28, and Fig. 9 shows the X-ray diffraction patterns of Examples 1-12, I-35 and I-37. It is evident from Fig. 8 that BSON crystal phase is formed even when Sr substitution amount is changed while keeping Eu at 2 mole %. It is also evident from Fig. 9 that BSON phase is formed even when Sr substitution amount is changed while keeping Eu at 10 mole %.

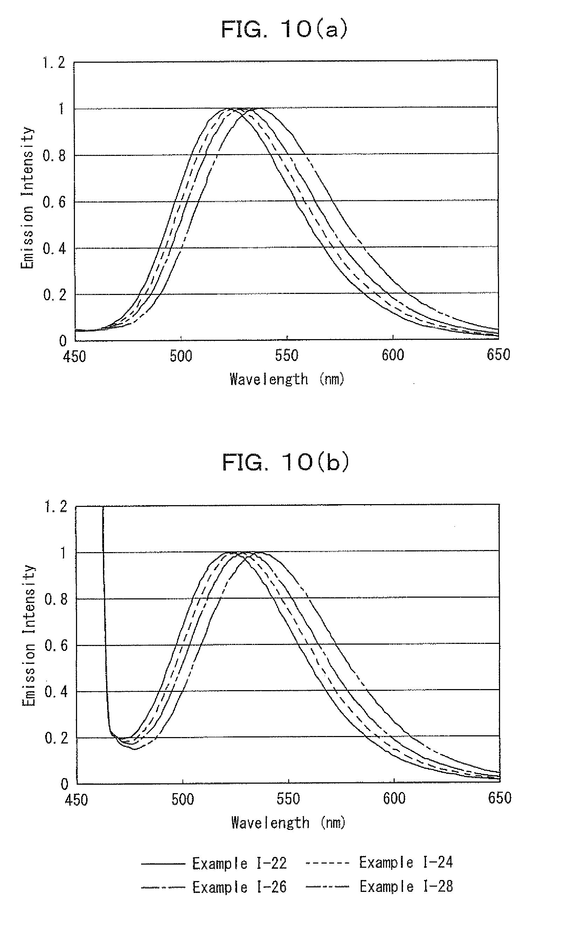

The emission spectra of the phosphors of Examples I-22, I-24, I-26 and I-28 under excitations by 405-nm and 455-nm wavelengths are shown in Fig. 10(a) and Fig. 10(b), respectively. Figs. 10(a) and 10(b) are normalized by the emission-peak wavelength.
Moreover, the luminescent characteristics of the phosphors of Examples I-20 to I-28 under excitations by light of 405 nm and 455 nm are shown in Table I-11 and Table I-12.

**[Table 13]**

| [Table I-11. Luminescent Characteristics under Excitation by Light of 405-nm Wavelength] | | | | | | | |
|---|---|---|---|---|---|---|---|
| | Eu concentration | Sr concentration | emission peak wavelength (nm) | emission peak intensity | brightness | CIEx | CIEy |
| Example I-20 | 2 | 0.5 | 522 | 61.5 | 615.8 | 0.251 | 0.648 |
| Example I-21 | 2 | 1 | 521 | 63.5 | 641.4 | 0.254 | 0.648 |
| Example I-22 | 2 | 2 | 522 | 65.4 | 669.5 | 0.259 | 0.647 |
| Example I-23 | 2 | 4 | 524 | 63 | 668 | 0.27 | 0.644 |
| Example I-24 | 2 | 6 | 527 | 62.4 | 676.7 | 0.278 | 0.642 |
| Example 1-25 | 2 | 8 | 528 | 58.7 | 654.9 | 0.288 | 0.639 |
| Example I-26 | 2 | 10 | 529 | 57.8 | 663.3 | 0.299 | 0.635 |
| Example I-27 | 2 | 15 | 534 | 54.7 | 658.8 | 0.318 | 0.626 |
| Example I-28 | 2 | 20 | 538 | 52.2 | 648.3 | 0.333 | 0.619 |

| | | | | | | | |
|---|---|---|---|---|---|---|---|
| * Eu concentrations were calculated as [(Eu number of moles)/{(Ba number of moles) + (Eu number of moles) + (Sr number of moles)} × 100] on the basis of number of moles of charged materials. * Sr concentrations were calculated as [(Sr number of moles){(Ba number of moles) + (Eu number of moles) + (Sr number of moles)} × 100] on the basis of number of moles of charged materials. | | | | | | | |

**[Table 14]**

| [Table I-12. Luminescent Characteristics under Excitation by Light of 455-nm Wavelength] | | | | | | | | | | | | |
|---|---|---|---|---|---|---|---|---|---|---|---|---|
| | Eu concentration | Sr concentration | emission peak wavelength (nm) | emission peak intensity | brightness | CIEx | GIEy | internal quantum efficiency (%) | absorption efficiency (%) | external quantum efficiency (%) | intensity retention rate at 150°C (%) | brightness retention rate at |
| Example I-20 | 2 | 0.5 | 521 | 47.4 | 478.3 | 0.251 | 0.644 | 87.2 | 49.4 | 43.0 | 77 | 80 |
| Example I-21 | 2 | 1 | 521 | 49.6 | 503.8 | 0.254 | 0.644 | 88.6 | 48.2 | 42.7 | 77 | 79 |
| Example I-22 | 2 | 2 | 522 | 51.9 | 537.3 | 0.259 | 0.643 | 87.8 | 51.2 | 45.0 | 78 | 81 |
| Example I-23 | 2 | 4 | 527 | 50.8 | 543.9 | 0.270 | 0.641 | 87.4 | 51.5 | 45.0 | 78 | 80 |
| Example I-24 | 2 | 6 | 527 | 50.7 | 555.8 | 0.279 | 0.639 | 86.3 | 54.5 | 47.0 | 78 | 80 |
| Example I-25 | 2 | 8 | 528 | 48.0 | 540.6 | 0.289 | 0.635 | 86.0 | 55.4 | 47.6 | 78 | 79 |
| Example I-26 | 2 | 10 | 531 | 48.0 | 557.9 | 0.300 | 0.631 | 85.4 | 54.2 | 46.3 | 77 | 78 |
| Example I-27 | 2 | 15 | 535 | 46.9 | 570.0 | 0.319 | 0.622 | 83.9 | 56.2 | 47.2 | 72 | 74 |
| Example I-28 | 2 | 20 | 537 | 45.9 | 576.0 | 0.334 | 0.615 | 84.3 | 55.3 | 46.7 | 76 | 78 |

| | | | | | | | | | | | | |
|---|---|---|---|---|---|---|---|---|---|---|---|---|
| * Eu concentrations were calculated as [(Eu number of moles)/{(Ba number of moles) + (Eu number of moles)} × 100] on the basis of number of moles of charged materials. * Sr concentrations were calculated as [(Sr number of moles) / {(Ba number of moles) + (Eu number of moles) + (Sr number of moles)} × 100] on the basis of number of moles of charged materials. | | | | | | | | | | | | |

It is evident from these results that, when Sr substitution amount increases, the luminous wavelength shifts to longer wavelength and the color coordinates x, y shift to yellow green and that, though the relative brightnesses are slightly low, the brightness retention rates at thigh temperature (150°C) are high.

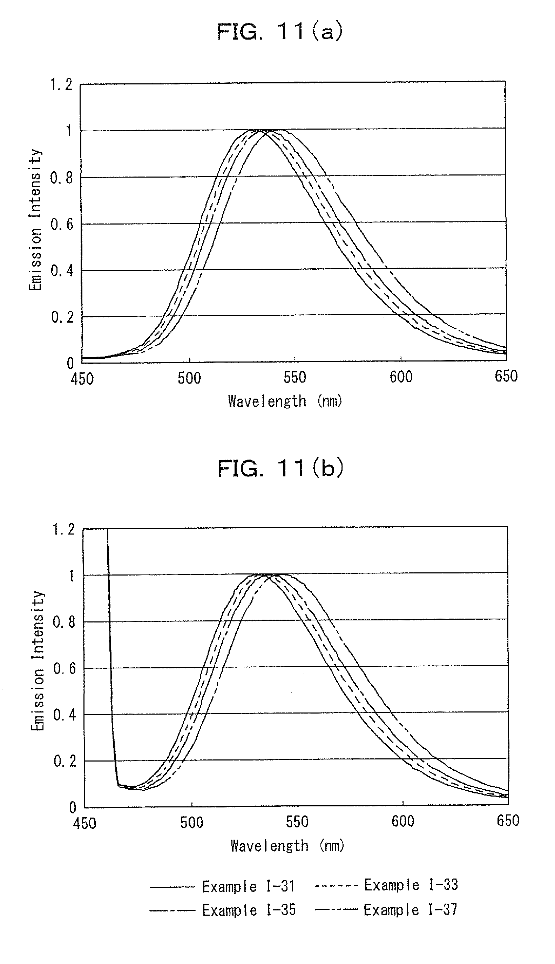

The emission spectra of the phosphors of Examples I-31, I-33, I-35 and I-37 under excitation by 405-nm and 455-nm wavelengths are shown in Fig. 11(a) and Fig. 11(b), respectively. Figs. 11 (a) and 11(b) are normalized by the emission-peak wavelength.
The luminescent characteristics of the phosphors of Examples I-29 to 1-37 under excitations by light of 405 nm and 455 nm are shown in Table 1-13 and Table I-14.

**[Table 15]**

| [Table I-11. Luminescent Characteristics under Excitation by Light of 405-nm Wavelength] | | | | | | | |
|---|---|---|---|---|---|---|---|
| | Eu concentration | Sr concentration | emission peak wavelength (nm) | emission peak intensity | brightness | CIEx | CIEy |
| Example I-29 | 10 | 0.5 | 529 | 77.8 | 876.3 | 0.292 | 0.621 |
| Example I-30 | 10 | 1 | 529 | 74.9 | 850.6 | 0.293 | 0.620 |
| Example I-31 | 10 | 2 | 529 | 73.8 | 852.6 | 0.301 | 0.617 |
| Example I-32 | 10 | 4 | 533 | 72.3 | 852.2 | 0.309 | 0.615 |
| Example I-33 | 10 | 6 | 535 | 69.9 | 835.9 | 0.316 | 0.612 |
| Example I-34 | 10 | 8 | 537 | 69.4 | 841.4 | 0.323 | 0.610 |
| Example I-35 | 10 | 10 | 538 | 66.8 | 824.1 | 0.331 | 0.606 |
| Example I-36 | 10 | 15 | 540 | 63.3 | 800.1 | 0.346 | 0.598 |
| Example I-37 | 10 | 20 | 544 | 57.3 | 740.1 | 0.358 | 0.590 |

| | | | | | | | |
|---|---|---|---|---|---|---|---|
| * Eu concentrations were calculated as [(Eu number of moles)/{(Ba number of moles) + (Eu number of moles) + (Sr number of moles)} × 100] on the basis of number of moles of charged materials. * Sr concentrations were calculated as [(Sr number of moles)/{(Ba number of moles) + (Eu number of moles) + (Sr number of moles)} × 100] on the basis of number of moles of charged materials. | | | | | | | |

**[Table 16]**

| [Table 1-14. Luminescent Characteristics under Excitation by Light of 455-nm Wavelength] | | | | | | | | | | | | |
|---|---|---|---|---|---|---|---|---|---|---|---|---|
| | Eu concentration | Sr concentration | emission peak wavelength (nm) | emission peak intensity | brightness | CIEx | CIEy | internal quantum efficiency (%) | absorption efficiency (%) | external quantum efficiency (%) | intensity retention rate at 150°C (%) | brightness retention rate at 150°C (%) |
| Example I-29 | 10 | 0.5 | 530 | 77.0 | 870.4 | 0.299 | 0.638 | 79.4 | 79.2 | 62.9 | 74 | 76 |
| Example I-30 | 10 | 1 | 531 | 74.8 | 850.9 | 0.301 | 0.637 | 78.7 | 78.4 | 61.7 | 73 | 75 |
| Example I-31 | 10 | 2 | 532 | 72.5 | 841.7 | 0.308 | 0.633 | 79.3 | 76.7 | 60.8 | 73 | 75 |
| Example I-32 | 10 | 4 | 534 | 73.7 | 874.1 | 0.316 | 0.629 | 80.9 | 76.1 | 61.6 | 73 | 74 |
| Example I-33 | 10 | 6 | 534 | 70.5 | 848.2 | 0.324 | 0.626 | 70.8 | 77.7 | 61.2 | 72 | 74 |
| Example I-34 | 10 | 8 | 537 | 71.6 | 871.3 | 0.330 | 0.622 | 78.2 | 79.2 | 67.9 | 70 | 72 |
| Example I-35 | 10 | 10 | 538 | 69.5 | 861.0 | 0.338 | 0.618 | 77.4 | 80.0 | 61.9 | 69 | 71 |
| Example I-36 | 10 | 15 | 539 | 67.5 | 858.6 | 0.353 | 0.609 | 75.4 | 80.2 | 60.5 | 66 | 68 |
| Example I-37 | 10 | 20 | 543 | 62.5 | 811.0 | 0.365 | 0.601 | 74.8 | 78.2 | 58.5 | 67 | 70 |

| | | | | | | | | | | | | |
|---|---|---|---|---|---|---|---|---|---|---|---|---|
| * Eu concentrations were calculated as [(Eu number of moles)/{(Ba number of moles) + (Eu number of moles) + (Sr number of moles)} × 100] on the basis of number of moles of charged materials. * Sr concentrations were calculated as [(Sr number of moles)/{(Ba number of moles) + (Eu number of moles) + (Sr number of moles)} × 100] on the basis of number of moles of charged materials. | | | | | | | | | | | | |

These results show the following facts. When the Sr substitution amount increases, the luminous wavelength shifts to longer wavelength and the color coordinates x, y shift to yellow green, in the same way as Examples 1-20 to I-28. The relative brightnesses are high. The brightness retention rates at high temperature (150°C) are higher than those in Examples I-5 to I-19, in which no Sr substitution was adopted.

It is evident from these results that the relative brightness of all the phosphors obtained in Examples using BaF₂ or ZnF₂ is high. This shows effectiveness of the fluxes.
Also, phosphors with high brightness retention rate at high temperature could be obtained even when the Eu concentration was relatively high, by substituting Ba with Sr.
Namely, the new phosphors having BSON phase are a green phosphor that can be enhanced in brightness by using flux, and can be adjusted finely in wavelength according to its purpose and enhanced in brightness retention rate at high temperature by appropriate adjusting of the Eu amount and/or Ba substitution amount with Sr.

### [Reference Example 1 and Examples I-57 to I-621

The phosphor materials listed below were used in Reference Example 1 and Examples I-57 to I-62 described in the following.
BaCO₃ (manufactured by Hakushin Chemical Laboratory Co, Ltd., purity of 98%)
SiO₂ (manufactured by Tatsumori, Ltd., purity of 99.99%)
Eu₂O₃ (manufactured by Shin-Etsu Chemical Co., Ltd., purity of 99.99%)
Pr₆O₁₁ (manufactured by Furuuchi Chemical Corporation)

As Si₃N₄, β-Si₃N₄ obtained through the following treatments was used, unless otherwise specified.
292 g of α-Si₃N₄ (manufactured by Ube Industries, Ltd.) was filled into a boron nitride crucible just as in its powder state and compression-molded by applying a slight weight. This boron nitride crucible was placed in a resistance-heating vacuum pressurized-atmosphere heat-treating furnace (manufactured by Fujidenpa Kogyo Co., Ltd.), which was vacuum heated from room temperature to 800°C at a temperature rising rate of 20 °C/minute under a reduced pressure of <5×10⁻³ Pa. When the temperature reached 800°C, a high-purity (99.9995%) nitrogen gas was introduced in 30minutes until the pressure reached 0.92 MPa while maintaining the temperature. After the nitrogen gas introduction, the pressure of 0.92 MPa was maintained and the temperature was raised further to 1200°C at a temperature rising rate of 20°C/minute. After that temperature was maintained for 5 minutes, the thermometer was changed from a thermocouple to a radiation thermometer. Then, the temperature was raised again to 2000°C at a temperature rising rate of 20°C/minute, of which the temperature was maintained for further 4 h. After the firing, the temperature was lowered to 1200°C at a temperature decreasing rate of 20 °C/minute, and the product was then allowed to cool spontaneously.
An X-ray diffraction measurement and reflection spectrum measurement were performed on the Si₃N₄ before and after the above-mentioned treatments. By comparing their X-ray diffraction patterns with peaks of α-Si₃N₄ and β-Si₃N₄, which are registered in PDF (Powder Diffraction File) of 76-1407 and 75-0950, the phase of α-Si₃N₄ was verified to be completely transformed to β-Si₃N₄ by the above-mentioned treatments.

Further, as fluxes ZnE₂·4H₂O, BaI₂, BaF₂, BaCl₂ and BaHPO₄, those listed below were used in Reference Example 1 and Examples I-57 to I-62, unless otherwise specified.
ZnF₂·4H₂O (manufactured by Wako Pure Chemical Industries, Ltd., 99.99%)
BaI₂ (manufactured by Strem Chemicals, Inc., 99.99%)
BaF₂ (manufactured by Wako Pure Chemical Industries, Ltd., 99.99%)
BaCl₂ (manufactured by KANTO CHEMICAL CO., INC., 99.99%)
BaHPO₄ (manufactured by KANTO CHEMICAL CO., INC., 99.99%)

The temperature characteristics measurements were carried out in the same way as described earlier except that the temperature was changed with the range from 20°C to 1.50°C and the emission-peak intensities were determined at phosphor surface temperatures of 20°C and 150°C.
The color coordinates CIEx and CIEy were calculated in the same way as describe earlier except that the emission spectrum data in a wavelength region from 480 nm to 800 nm were used.

### [Reference Example 1]

The phosphor materials BaCO₃ (6.02 g), SiO₂ (2.86 g), Si₃N₄ (2.23 g) and Eu₂O₃ (0.33 g) were weighed out to give a charge composition of phosphor constituent element of Ba₂.82Eu_{0.81}Si₉O₁₂N6. These were transferred to an agate automatic mortar and ethanol was added thereto, followed by dry-type mixing until they became homogenous. The pasty mixture thus obtained was dried, and then tightly filled into an alumina crucible. This was placed in a resistance-heating tubular electric furnace fitted with a temperature regulator and heated from room temperature to 800°C at a temperature rising rate of 4.8 °C/minute, then from 800°C to 1350°C at a temperature rising rate of 3.0 °C/minute, in an atmosphere of 96 volume % of nitrogen + 4 volume % of hydrogen under atmospheric pressure. That temperature was maintained for 72 hour, and then the mixture was allowed to cool to room temperature. The sample obtained was pulverized in an alumina mortar, followed by sieving out particles with a size of 250 µm or smaller.
This phosphor was measured for its relationship between the excitation light irradiation time and the change in persistence characteristics, according to the method described in the aforementioned section [Persistence characteristic evaluation], thereby to determine an appropriate excitation light irradiation time for phosphors represented by the formula [I].

### [Example I-57]

The phosphor materials BaCO₃ (17.04 g), SiO₂ (11.30 g) and Eu₂O₃ (1.66 g) were weighed out to give a charge composition of phosphor constituent elements of Ba_{2.7}Eu_{0.3}Si₆O₁₂N₂. These were mixed and stirred sufficiently in a nylon bag, and then filled in an alumina crucible tightly. This was placed in a resistance-heating tabular electric furnace fitted with a temperature regulator and heated up to 1200°C at a temperature rising rate of 5.0 °C/minute under atmospheric pressure. That temperature was maintained for 6 hour, and then the mixture was allowed to cool to room temperature. The sample obtained was pulverized in an alumina mortar, followed by sieving out particles with a size of 250 µm or smaller.

The sample obtained as above (18.30 g) and a phosphor material Si₃N₄ (17.10 g) were pulverized and mixed in an alumina mortar, followed by sieving out particles with a size of 250 µm or smaller diameter. Then, it was filled into a boron nitride crucible and heated up to 1500°C under a nitrogen atmosphere at 0.92 MPa. The temperature was maintained for 4 hour, and then the product was allowed to cool spontaneously. The sample obtained was pulverized in an alumina mortar, followed by sieving out particles with a size of 250 µm or smaller. Then, the impurities were removed by washing the sample while stirring it for 30minutes with dilute hydrochloric acid.

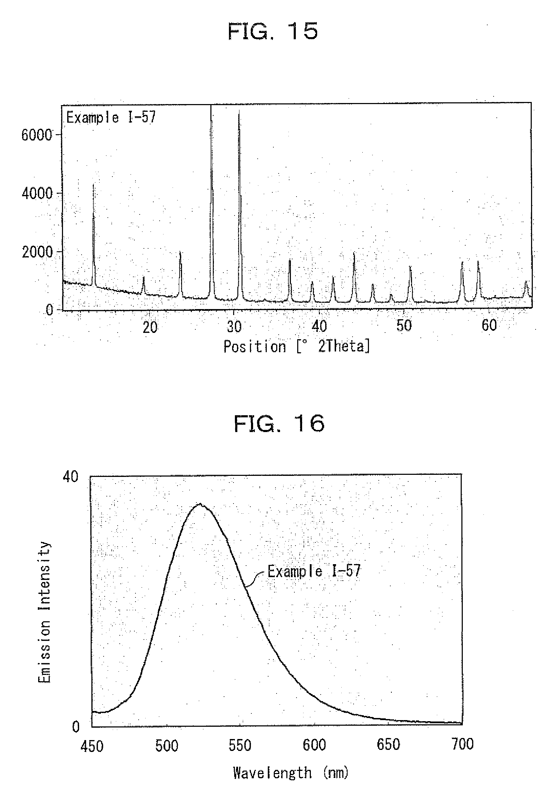

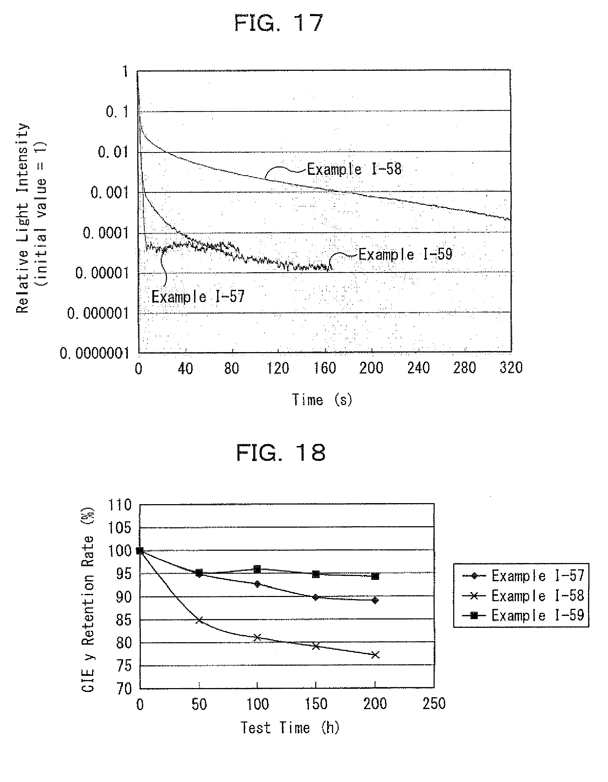

A powder X-ray diffractometry was carried out on the obtained fired product (phosphor). Fig. 15 shows the measured X-ray diffraction pattern.
Also, the ratio of the strongest peak intensity of the impurity phase relative to the strongest peak intensity of the intended phosphor phase was calculated from the above result. The result is shown in Table I-18.
Furthermore, the obtained phosphor was measured for its emission spectrum under excitation by light of 400-nm wavelength. The result is shown in Table 16. From that result, the full width at half maximum of the emission peak was found to be 67 nm.
Moreover, a persistence characteristic evaluation was performed on the obtained phosphor. The measurement result is shown in Fig. 17.
In addition, an LED durability test was performed on the obtained phosphor. The result is shown in Fig. 18.

From Fig. 15, formation of BSON phase has been recognized in the phosphor obtained by the present Example.
From Fig. 17, it has been shown that the persistence period of the phosphor of the present Example was much shorter than that of Example I-58 (described later).
From Fig. 18, it has been shown that the durability of the phosphor of the present Example was improved compared to that of Example I-58 (described later).

Further, the obtained phosphor was measured for its temperature characteristics under excitation by light of 455-nm excitation wavelength. The result is shown in Table I-17.

**[Table 17]**

| [Table I-17. Temperature Characteristics under Excitation by Light of 455-nm Wavelength] | | | | | |
|---|---|---|---|---|---|
| | emission peak wavelength | CIEx | CIEy | brightness retention rate | emission intensity retention rate |
| 20°C | 526 nm | 0.281 | 0.646 | - | - |
| 150°C | 524 nm | 0.273 | 0.624 | 68% | 65% |

From the above results, it is evident that the changes in emission peak and color coordinates at 150°C are small in the phosphor of the present Example, which indicates superior temperature characteristics.
Moreover, the phosphor of the present Example shows superior brightness retention rate and intensity retention rate of 65% or higher at 150°C even when the Eu concentration is as high as 0.30.

### [Example I-58]

The phosphor materials BaCO₃ (300.95 g), SiO₂ (143.30 g) and Eu₂O₃ (28 g) were weighed out to give a charge composition of Ba_{2.7}Eu_{0.3}Si₉O₁₂N₆. These were mixed and stirred sufficiently in a vibration mill, and then filled in an alumina crucible tightly. This was placed in a resistance-heating tubular electric furnace fitted with a temperature regulator and heated up to 1200°C at a temperature rising rate of 5.0 °C/min under atmospheric pressure. That temperature was maintained for 6 hour, and then the mixture was allowed to cool to room temperature.

The sample obtained as above (60.00 g), a phosphor material Si₃N₄ (17.10 g), and fluxes ZnF₂.4H₂O (1.16 g) and BaI₂ (0.77 g) were mixed in a nylon bag, followed by sieving out particles with a size of 250 µm or smaller. It was then filled into an alumina crucible. It was heated up to 1350°C under a 0.51/min flow of a mixed gas of 96 volume % of nitrogen + 4 volume % of hydrogen under atmospheric pressure. That temperature was maintained for 10 hour, and then the mixture was allowed to cool spontaneously. The sample obtained was pulverized in an alumina mortar and then washed to remove impurities.

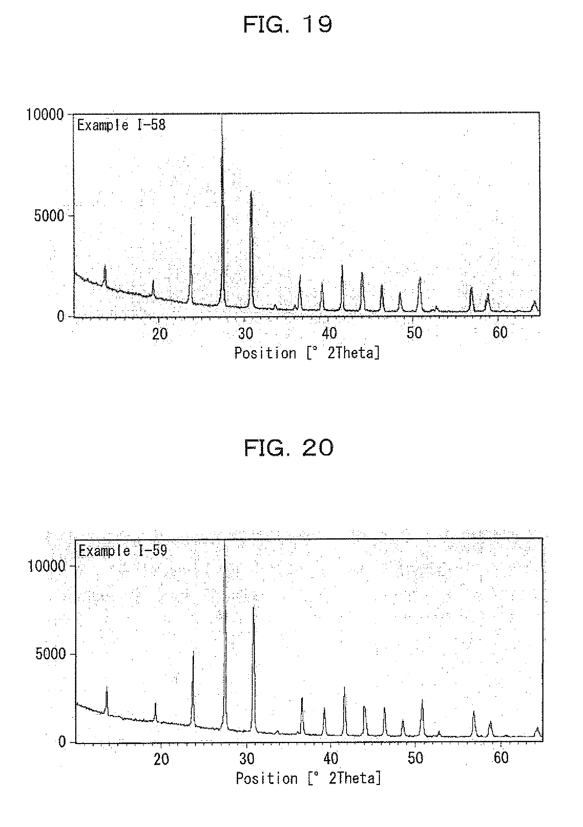

A powder X-ray diffractometry was carried out on the obtained fired product (phosphor). Fig. 19 shows the measured X-ray diffraction pattern.
Also, the ratio of the strongest peak intensity of the impurity phase relative to the strongest peak intensity of the intended phosphor phase was calculated from the above result. The result is shown in Table I-18.
Moreover, a persistence characteristic evaluation was performed on the obtained phosphor. The measurement result is shown in Fig. 17.
In addition, an LED durability test was performed on the obtained phosphor. The result is shown in Fig. 18.

### [Example I-59]

The phosphor materials BaCO₃ (17.04 g), SiO₂ (11.30 g) and Eu₂O₃ (1.66 g) were weighed out to give a charge composition of Ba_{2.7}Eu_{0.3}Si₆O₁₂N₂. These were mixed and stirred sufficiently in a nylon bag, and then filled in an alumina crucible tightly. This was placed in a resistance-heating tubular electric furnace fitted with a temperature regulator and heated up to 1200°C at a temperature rising rate of 5.0 °C/minute under atmospheric pressure. That temperature was maintained for 6 hours, and then the mixture was allowed to cool to room temperature.
The sample obtained was pulverized in an alumina mortar, followed by sieving out particles with a size of 250 µm or smaller.

The sample obtained as above (18.30 g), a phosphor material Si₃N₄ (1.75 g), and a flux BaF₂ (0.30 g) were pulverized and mixed in an alumina mortar, followed by sieving out particles with a size of 250 µm or smaller. It was filled into an alumina crucible and heated, as the primary firing, up to 1200°C under a 0.51/min flow of a mixed gas of 96 volume % of nitrogen + 4 volume % of hydrogen under atmospheric pressure. That temperature was maintained for 4hours and then the product was allowed to cool spontaneously. After sieving out the obtained sample particles with a size of 250 µm or smaller, it was washed with acid to remove impurities. The mixture was again filled into an alumina crucible and heated, as the secondary firing, up to 1300°C under a 0.51/minute flow of a mixed gas of 96 volume % of nitrogen + 4 volume % of hydrogen. That temperature was maintained for 4 hour, and then the mixture was allowed to cool spontaneously. The sample obtained was pulverized in an alumina mortar, followed by sieving out particles with a size of 250 µm or smaller. Subsequently, it was washed with dilute hydrochloric acid for 30minutes under stirring to remove impurities.

A powder X-ray diffractometry was carried out on the obtained fired product (phosphor). Fig. 20 shows the measured X-ray diffraction pattern.
Also, the ratio of the strongest peak intensity of the impurity phase relative to the strongest peak intensity of the intended phosphor phase was calculated from the above result. The result is shown in Table I-18.
Furthermore, the obtained phosphor was measured for its emission spectrum under excitation by light of 400-nm wavelength. From that result, it was shown that the full width at half maximum of the emission peak was 69 nm.
Moreover, a persistence characteristic evaluation was performed on the obtained phosphor. The result is shown in Fig. 17.
In addition, an LED durability test was performed on the obtained phosphor. The result is shown in Fig. 18.

From Fig. 20, formation of BSON phase has been recognized in the phosphor obtained by the present Example.
From Fig. 17, it has been shown that the persistence period of the phosphor of the present Example was much shorter than that of Example I-58.
From Fig. 18, it has been shown that the durability of the phosphor of the present Example was improved compared to that of Example I-58.

**[Table 18]**

| [Table I-18] | | | | | |
|---|---|---|---|---|---|
| | maximum peak of intended phosphor phase | | maximum peak of impurity phase | | ratio |
| | peak intensity | 2θ | peak intensity | (crystal phase) 2θ | |
| Example I-57 | 6835.79 | 27.5 | 71.23 | (β-Si₃N₄) 33.7 | 1.0% |
| Example I-59 | 10824.66 | 27.5 | 156.82 | (β-Si₃N₄) 33.7 | 1.4% |
| Example I-58 | 9473.89 | 27.5 | 258.06 | (β-Si₃N₄) 36.1 | 2.7% |

From the above results, it is evident that the durability of the phosphor can be improved by bringing the charge composition of the materials closer to the intended phosphor composition. This is probably because an excessive amount of silicon nitride, which may cause formation of defects in the structure, does not go in the phosphor crystal as an impurity phase then. This can be inferred also by the fact that the persistence period of the phosphor of Example I-58 is longer than those of the phosphors of Examples I-57 and I-59.

### [Example I-60]

The phosphor materials BaCO₃ (300.95 g), SiO₂ (143.30 g) and Eu₂O₃ (28 g) were weighed out to give a charge composition of Ba_{2.7}Eu_{0.3}Si₉O₁₂N₆. These were mixed and stirred sufficiently in a vibration mill, and then filled in an alumina crucible tightly. This was placed in a resistance-heating tubular electric furnace fitted with a temperature regulator and heated up to 1200°C at a temperature rising rate of 5.0 °C/minute under atmospheric pressure. That temperature was maintained for 6 hour, and then the mixture was allowed to cool to room temperature.

The sample obtained as above (60.00 g), phosphor materials Si₃N₄ (17.10 g) and Pr₆O₁₁ (0.07 g), and fluxes ZnF₂·4H₂O (1.16 g) and BaI₆ (0.77 g) were mixed in a nylon bag, followed by sieving out particles with a size of 250 µm or smaller. It was then filled into an alumina crucible. It was heated up to 1350°C under a 0.51/min flow of a mixed gas of 96 volume % of nitrogen + 4 volume % of hydrogen under atmospheric pressure. That temperature was maintained for 10 hour, and then the mixture was allowed to cool spontaneously. The sample obtained was pulverized in an alumina mortar and then washed to remove impurities.

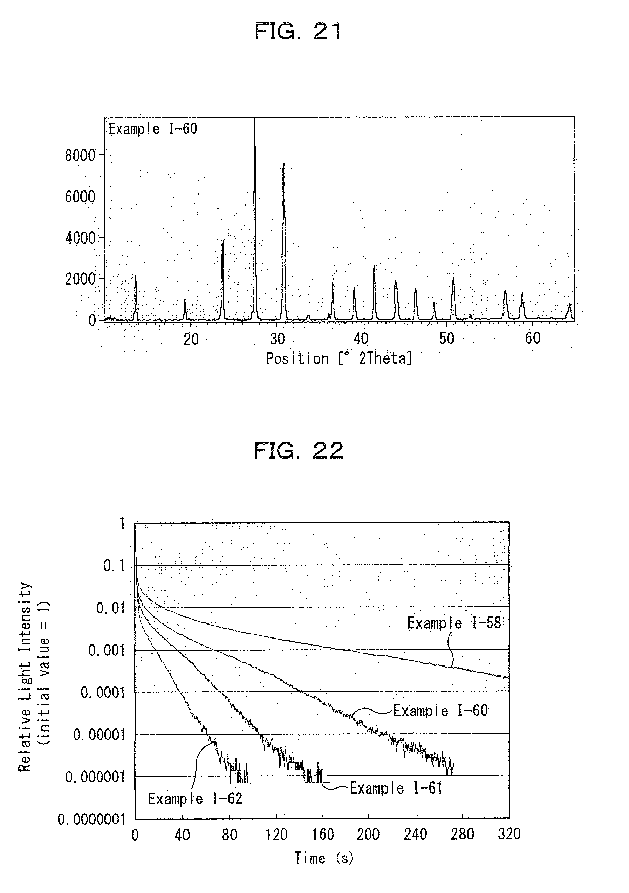

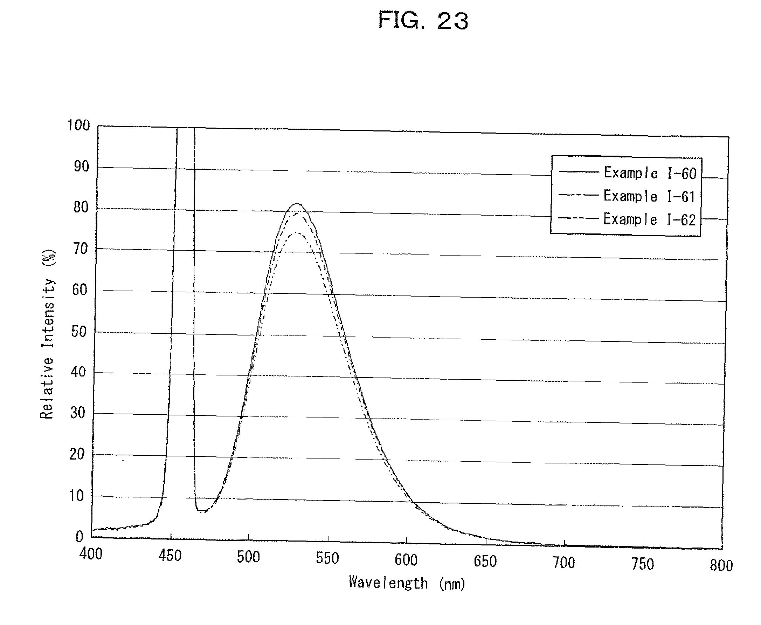

A powder X-ray diffractometry was carried out on the obtained fired product (phosphor Ba_{2.7}(Pr_{0.016}Eu_{0.984})_{0.3}Si₆O₁₂N₂). Fig. 21 shows the measured X-ray diffraction pattern.
Moreover, a persistence characteristic evaluation was performed on the obtained phosphor. The result is shown in Fig. 22. In Fig. 22, the measurement result of Example I-58 is also shown.
Furthermore, the emission spectrum of the obtained phosphor under excitation by light of 455-nm wavelength is shown in Fig. 23.

From Fig. 21, formation of BSON crystal phase has been recognized in the phosphor obtained by the present Example.
From Fig. 22, it has been shown that the persistence period of the phosphor of the present Example was much shorter than that of Example I-58.

### [Example I-61]

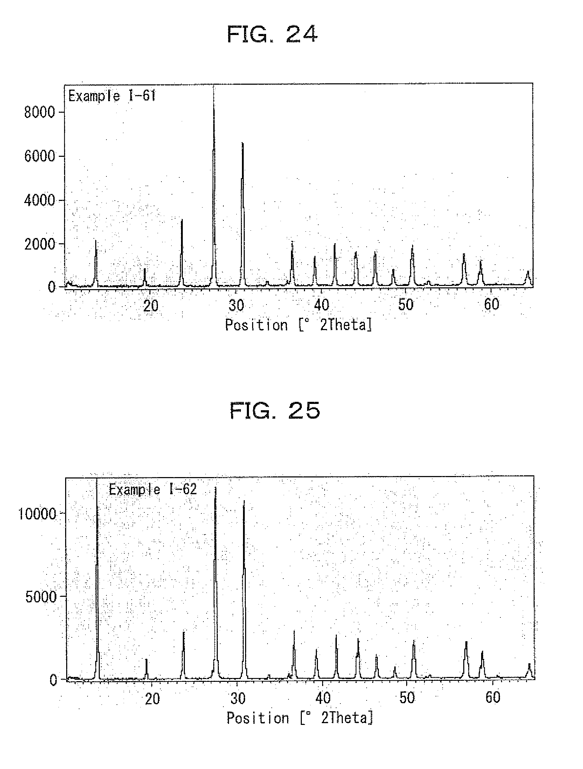

A phosphor, Ba_{2.7}(Pr_{0.033}Eu_{0.967})_{0.3}Si₆O₁₂N₂, was prepared in the same way as Example I-60 except that the amount of Pr₆O₁₁ was set at 0.14 g.
A powder X-ray diffractometry was carried out on the obtained fired product (phosphor). Fig. 24 shows the measured X-ray diffraction pattern.
Moreover, a persistence characteristic evaluation was performed on the obtained phosphor. The result is shown in Fig. 22.
Furthermore, the emission spectrum of the obtained phosphor under excitation by light of 455-nm wavelength is shown in Fig. 23.

From Fig. 24, formation of BSON crystal phase has been recognized in the phosphor obtained by the present Example.
From Fig. 22, it has been shown that the persistence period of the phosphor of the present Example was much shorter than that of Example I-58.

### [Example I-62]

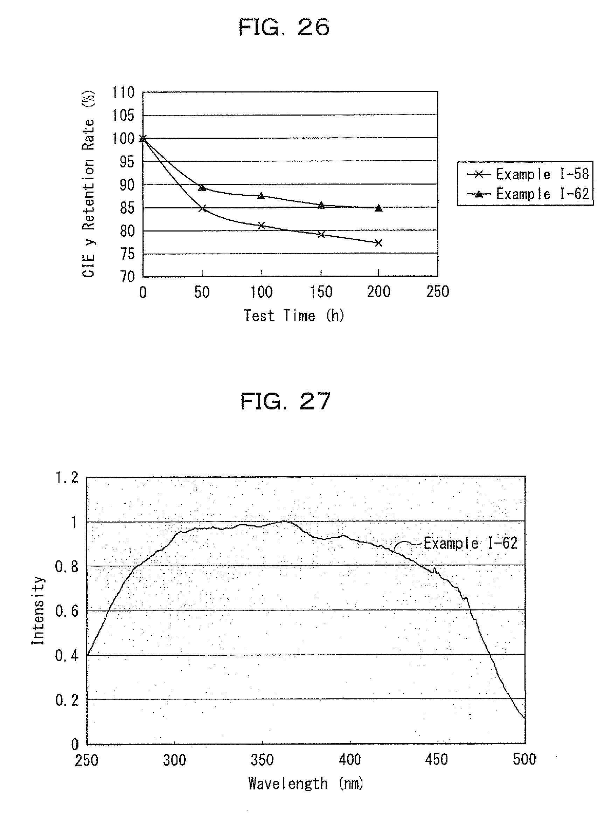

A phosphor, Ba_{2.7}(Pr_{0.063}Eu_{0.937})_{0.3}Si₆O₁₂N_{2,} was prepared in the same way as Example I-60 except that the amount of Pr₆O₁₁ was set at 0.28 g.
A powder X-ray diffractometry was carried out on the obtained fired product (phosphor). Fig. 25 shows the measured X-ray diffraction pattern.
Moreover, a persistence characteristic evaluation was performed on the obtained phosphor. The result is shown in Fig. 22.
Furthermore, the emission spectrum of the obtained phosphor under excitation by light of 455-nm wavelength is shown in Fig. 23.
In addition, an LED durability test was performed on the obtained phosphor. The result is shown in Fig. 26. In Fig. 26, the measurement result of Example I-58 is also shown.
Furthermore, the obtained phosphor was measured for its excitation spectrum. The excitation spectrum measured is shown in Fig. 27.

From Fig. 25, formation of BSON phase has been recognized in the phosphor obtained by the present Example.
From Fig. 22, it has been shown that the persistence period of the phosphor of the present Example was much shorter than that of Example I-58.
From Fig. 26, it has been shown that the durability of the phosphor of the present Example was improved compared to that of Example I-58.

Further, the obtained phosphor was measured for its temperature characteristics under excitation by light of 455-nm excitation wavelength. The result is shown in Table I-19.

**[Table 19]**

| [Table I-19. Temperature Characteristics under Excitation by Light of 455-nm Wavelength] | | | | | |
|---|---|---|---|---|---|
| | emission peak wavelength | CIEx | CIEy | brightness retention rate | emission intensity retention rate |
| 20°C | 530 nm | 0.296 | 0.646 | - | - |
| 150°C | 527 nm | 0.289 | 0.631 | 63% | 62% |

From the above results, the following facts can be clearly shown. Namely, in the phosphor of the present Example, which contains Pr in addition to Eu as an activation element, the changes of emission peak and color coordinates at 150°C are small, which indicates superior temperature characteristics, though the amount of silicon nitride of the phosphor of the present Example is in excess of stoichiometric amount of the intended composition. Moreover, the phosphor of the present Example shows superior brightness retention rate and intensity retention rate of 60% or higher at 150°C even when the Eu concentration is as high as 0.28.

### [Example group II: Investigation on material silicon nitride]

### [Example II-1]

300 g of α-Si₃N₄ (SN-E10, manufactured by Ube Industries, Ltd.) was filled into a boron nitride crucible. This boron nitride crucible was placed in a resistance-heating vacuum pressurized-atmosphere heat-treating furnace (manufactured by Fujidenpa Kogyo Co., Ltd.), which was vacuum heated from room temperature to 800°C at a temperature rising rate of 20 °C/min under a reduced pressure of <5 × 10⁻³ Pa. When the temperature reached 800°C, a high-purity (99.9995%) nitrogen gas was introduced in 30minutes until the pressure reached 0.92 MPa with the temperature maintained. Subsequently, while the pressure is maintained at 0.92 MPa, the temperature was raised further to 1200°C at a temperature rising rate of 20 °C/minute. After that temperature was maintained for 5 minutes, the thermometer was changed from a thermocouple to a radiation thermometer. Then, the temperature was raised again to 2000°C at a temperature rising rate of 20 °C/minute, of which the temperature was maintained for further 3 hours. The temperature was lowered to 1200°C at a temperature decreasing rate of 20 °C/minute, and then the product was allowed to cool spontaneously. Then, the particles with particle diameters of 250 µm or smaller were isolated by sieving.

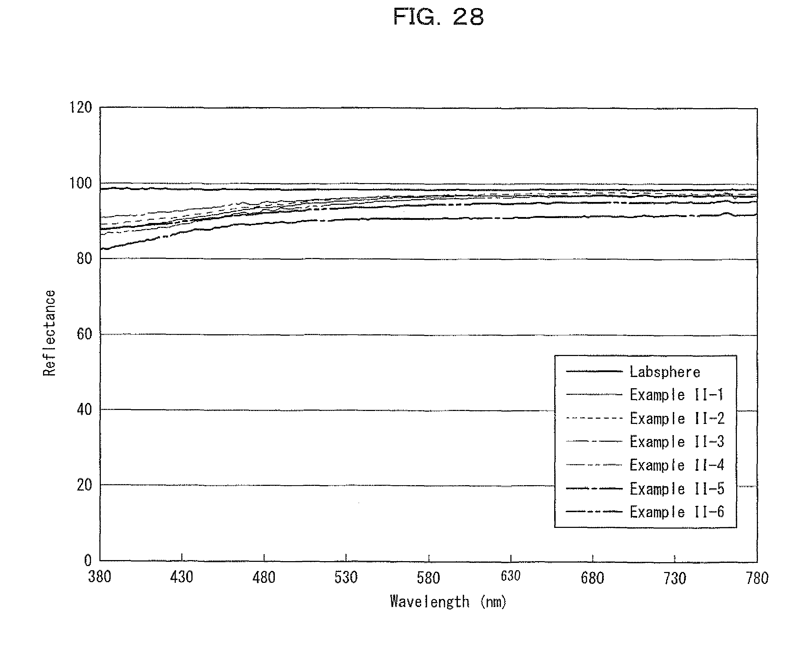

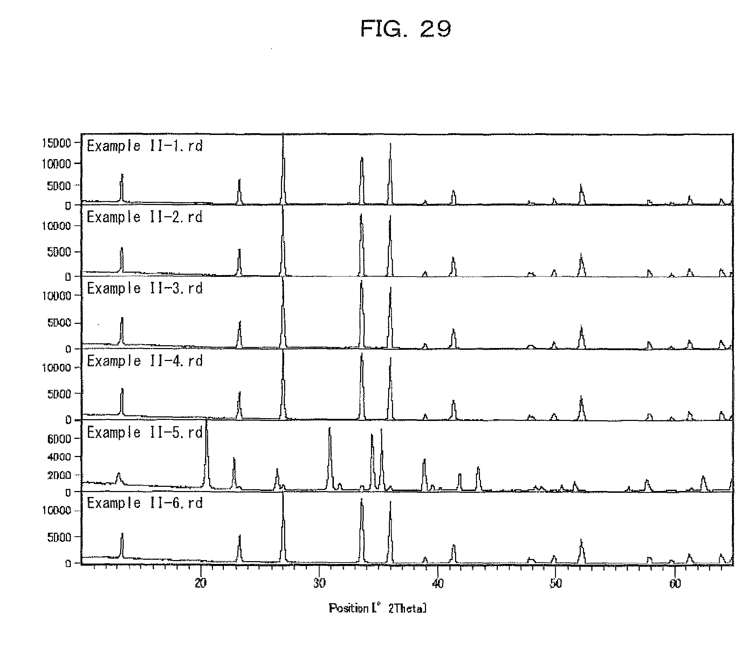

The reflection spectrum of the β-Si₃N₄ obtained is shown in Fig. 28. The powder X-ray diffractometry thereof is shown in Fig. 29. Also, the reflectance determined from the above result, the carbon content measured with a high-frequency combustion furnace and a nondispersive infrared analyzer (EMIA520FA type, manufactured by HORIBA, Ltd.), and the object color obtained by visual inspection are shown in Table II-1.

### [Example II-2]

Particles of α-Si₃N₄ (SN-E10, manufactured by Ube Industries, Ltd.) with diameters of 250 µm or smaller were isolated by sieving. The powder, 250 g, filled into a boron nitride crucible was subjected to a heat treatment in the same way as Example II-1.
The reflection spectrum of the silicon nitride is shown in Fig. 28. The X-ray diffraction pattern thereof is shown in Fig. 29. Also, the reflectance determined from the above result, the carbon content measured with a high-frequency combustion furnace and a nondispersive infrared analyzer (EMIA520FA type, manufactured by HORIBA, Ltd.), and the object color obtained by visual inspection are shown in Table II-1.

### [Examples II-3 to II-6]

Treatments were carried out in the same way as Example II-2 except that the treatment temperature, treatment time and treatment pressure were changed according to Table II-1.
The reflection spectrum of each silicon nitride is shown in Fig. 28. The X-ray diffraction pattern thereof is shown in Fig. 29. Also, the reflectance determined from the above result, the carbon content measured with a high-frequency combustion furnace and a nondispersive infrared analyzer (EMIA520FA type, manufactured by HORIBA, Ltd.), and the object color obtained by visual inspection are shown in Table II-1.

**[Table 20]**

| [Table II-1. Results of Examples II-1 to II-6] | | | | | | | | | |
|---|---|---|---|---|---|---|---|---|---|
| | treatment conditions | | | visually-observed object color | carbon content (weight %) | reflectance | | | |
| | temperature | time | pressure | | | average reflectance (%) | 455 nm (%) | 525 nm (%) | 650 nm (%) |
| Example II-1 | 2000°C | 3 hours | 0.92 MPa | white | 0.02 | 95 | 92 | 95 | 97 |
| Example II-2 | 2000°C | 4 hours | 0.92 MPa | white | 0.03 | 96 | 93 | 96 | 97 |
| Example II-3 | 2000°C | 5 hours | 0.92 MPa | white | 0.03 | 96 | 94 | 96 | 97 |
| Example II-4 | 2000°C | 6 hours | 0.92 MPa | white | 0.04 | 94 | 91 | 94 | 96 |
| Example II-5 | 1800°C | 3 hours | 0.7 MPa | white | 0.06 | 90 | 89 | 90 | 91 |
| Example II-6 | 1975°C | 8 hours | 0.75 MPa | white | 0.03 | 93 | 91 | 93 | 95 |

| | | | | | | | | | |
|---|---|---|---|---|---|---|---|---|---|
| * Average reflectance in the above table is an average amount of the reflectance in the wavelength region of 380 nm to 780 new. | | | | | | | | | |

### [Comparative Examples II-1 to II-23]

Measurement results of various commercially available Si₃N₄ for their object color observed by visual inspection, reflectance, and carbon content (measured with a high-frequency combustion furnace and a nondispersive infrared analyzer (EMIA520FA type, manufactured by HORIBA, Ltd.)) are shown in Table II-2.

**[Table 21]**

| [Table II-2. Results of Examples II-1 to II-23] | | | | | | | |
|---|---|---|---|---|---|---|---|
| | manufacturer | visually-observed object color | carbon content (weight %) | reflectance | | | |
| | | | | average reflectance (%) | 455 nm (%) | 525 nm (%) | 650 nm (%) |
| Comparative Example II-1 | alpha phase K11J11, by Alfa Aesar | gray | 0.11 | 58 | 51 | 57 | 63 |
| Comparative Example II-2 | alpha PhaseC20R062, by Alfa Aesar | gray | 0.16 | 79 | 77 | 80 | 82 |
| Comparative Example II-3 | Electronic Grade K14N14, by Alfa Aesar | gray | 0.17 | 79 | 76 | 79 | 81 |
| Comparative Example II-4 | amorphous G07R005, by Alfa Aesar | gray | 0.08 | 85 | 81 | 87 | 89 |
| Comparative Example II-5 | beta phaseH20N04, by Alfa Aesar | gray | 0.42 | 61 | 58 | 61 | 64 |
| Comparative Example II-6 | SN-7 7387 by Denki Kagaku Kogyo Kabushiki Kaisya | gray | 0.14 | 55 | 51 | 54 | 57 |
| Comparative Example II-7 | SN-9 82196 by Denki Kagaku Kogyo Kabushiki | gray | 0.09 | 59 | 57 | 59 | 61 |
| Comparative Example II-8 | SN-9S 92196 by Denki Kasaku Kogyo Kabushiki | gray | 0.11 | 60 | 57 | 60 | 63 |
| Comparative Example II-9 | SN-9FWS 925428 by Denki Kagaku Kogyo Kabushiki | gray | 0.16 | 70 | 68 | 71 | 73 |
| Comparative Example II-10 | NP-200 6201 by Denki Kagaku Kogyo Kabushiki | gray | 0.38 | 62 | 58 | 62 | 65 |
| Comparative Example II-11 | NP-600 6602 by Denki Kagaku Kogyo Kabushiki | gray | 0.31 | 68 | 62 | 67 | 72 |
| Comparative Example II-12 | SN-F2 11025 by Denki Kagaku Kogyo Kabushiki | gray | 0.32 | 57 | 55 | 57 | 59 |
| Comparative Example II-13 | 11520 by Denki Kagaku Kogyo Kabushiki | gray | 0.30 | 62 | 59 | 61 | 64 |
| Comparative Example II-14 | 0.6 µm 30917-30 by RARE METALIC Co., Jtd. | gray | 0.16 | 73 | 70 | 73 | 75 |
| Comparative Example II-15 | whisker 167229 by Kojundo Chemical Lab. Co., Ltd. | gray | 0.50 | 60 | 58 | 61 | 63 |
| Comparative Example II-16 | 53 µm pass 167228 by Kojundo Chemical Lab. Co., Ltd. | gray | 0.13 | 72 | 69 | 72 | 74 |
| Comparative Example II-17 | 0.5 µm 167230 by Kojundo Chemical Lab. Co., Ltd. | gray | 0.15 | 79 | 77 | 80 | 82 |
| Comparative Example II-18 | 5 micron B7342045, by Strem Chemicals, Inc. | gray | 0.13 | 61 | 54 | 60 | 67 |
| Comparative Example II-19 | DPK0707, by Wako Pure Chemical Industries, Ltd. | gray | 0.06 | 66 | 58 | 64 | 71 |
| Comparative Example II-20 | SN-ESP S66X01, by Ube Industries, Ltd. | gray | 0.14 | 77 | 72 | 76 | 81 |
| Comparative Example II-21 | SN-E03 B65Z01, by Ube Industries, Ltd. | gray | 0.12 | 75 | 69 | 74 | 80 |
| Comparative Example II-22 | SN-ED5 B65Y01, by Ube Industries, Ltd. | gravy | 0.13 | 80 | 75 | 79 | 84 |
| Comparative Example II-23 | SN-E10 B65310, by Ube Industries. Ltd. | gray | 0.11 | 84 | 79 | 83 | 88 |

| | | | | | | | |
|---|---|---|---|---|---|---|---|
| * In the above Table II-2, average reflectance is an average value of reflectances in the wavelength range of 380 nm to 780 nm. | | | | | | | |

From the above results, it has been shown that even the silicon nitride of the Example II-5 having the smallest reflectance of Examples II-1 to II-6, which was 89% at a wavelength of 455 nm, 90% at 525 nm, and 91% at 650 nm, has higher reflectance than the Comparative Example II-4, of which the reflectance was the highest of all Comparative Examples. Specifically, it was higher by 10% or more at 455 nm, 3% or more at 525 nm, and 2% or more at 650 nm.

### [Example II-7]

BaCO₃ (manufactured by Hakushin Chemical Laboratory Co., Ltd., purity of 98%), SiO₂ (manufactured by Tatsumori, Ltd., 99.99%), Eu₂O₃ (manufactured by Shin-Etsu Chemical Co., Ltd., purity of 99.99%), Si₃N₄ obtained in Example II-3, and a flux BaF₂ (manufactured by Wako Pure Chemical Industries, Ltd., 99.99%) were weighed out to give a charge composition of the phosphor materials of Ba_{2.82}Eu_{0.18}Si₉O₁₂N₆.

Material powders of BaCO₃ (5.21 g), SiO₂ (2.52 g), and Eu₂O₃ (0.30 g) were mixed and stirred sufficiently in a nylon bag, and then filled in an alumina crucible tightly. This was placed in a resistance-heating electric furnace fitted with a temperature regulator and heated, as the primary firing, up to 1100°C at a temperature rising rate of 5.0 °C/minute under atmospheric pressure. That temperature was maintained for 6 hour, and then the mixture was allowed to cool to room temperature.

The sample obtained as above, the Si₃N₄ (1.97 g) obtained through a heat treatment in Example II-3, and a flux BaF₂ (0.1 g) were pulverized and mixed in an alumina mortar. The particles with particle diameters of 250 µm or smaller were isolated by sieving, followed by filling them into an alumina crucible tightly. This was placed in a resistance-heating tubular electric furnace fitted with a temperature regulator and heated, as the secondary firing, from room temperature to 800°C at a temperature rising rate of 4.8 °C/min, then from 800°C to 1300°C at a temperature rising rate of 3.0 °C/mi;ute, in a 0.51/minute mixed current of 96 volume % of nitrogen + 4 volume % of hydrogen under atmospheric pressure. The temperature was maintained for 8hours and the product was allowed to cool to room temperature. Then, it was pulverized in an alumina mortar.

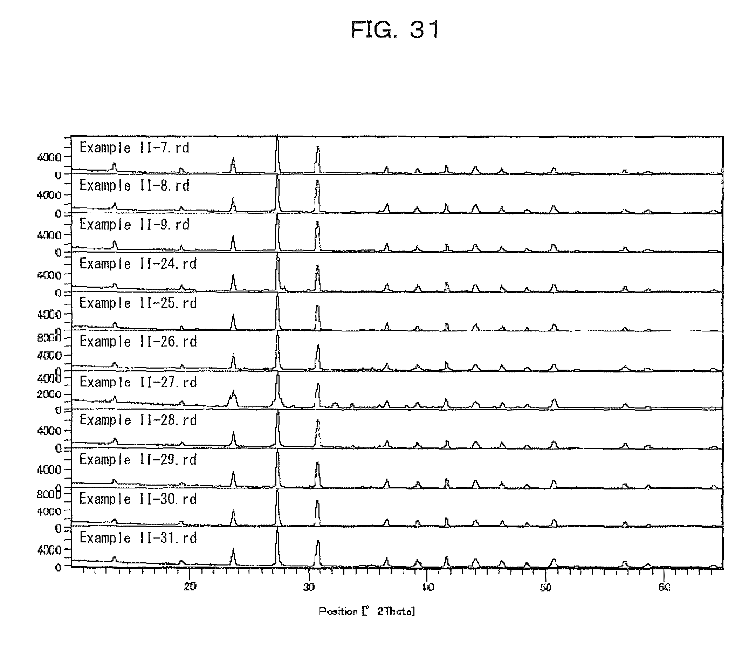

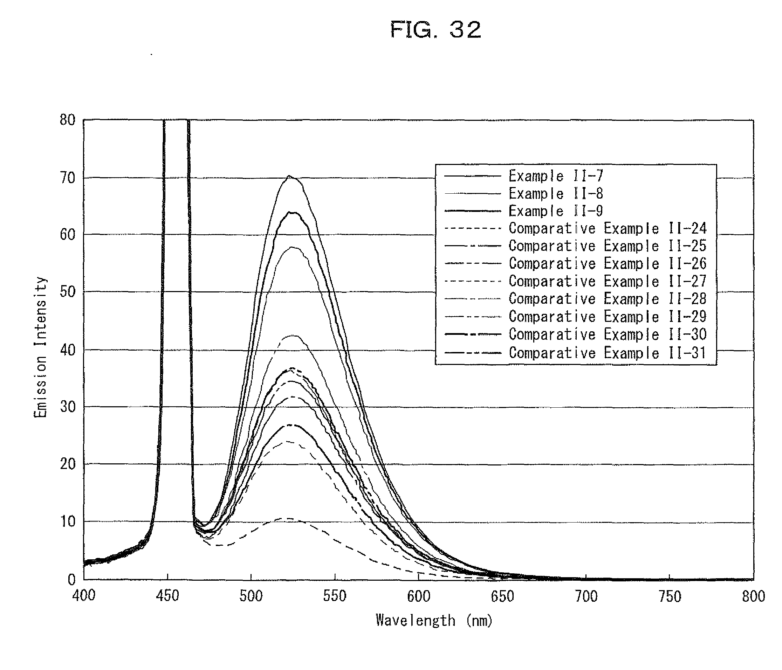

The fired product thrown in 100 ml of 1-N hydrochloric acid was stirred for 30minutes and then left to stand for 2 hour, followed by ejecting the supernatant fluid. A washing was done by adding 100 ml of purified water to the product, stirring for 15 minutes, leaving it to stand for 30 minutes, and then ejecting the supernatant fluid. After repeating the washings three times, the product was filtered out and dried at 110°C for 12 hours. The X-ray diffraction pattern of the obtained fired product is shown in Fig. 31. The emission spectral map thereof under excitation by light of 455-nm wavelength is shown in Fig. 32.

The above X-ray diffraction pattern has revealed that the fired product obtained in Example II-7 has a new crystal phase. An X-ray structural analysis on the fired product having that crystal phase has shown that the composition formula of an inorganic compound constituting that crystal phase was Ba₃Si₆O₁₂N₂.
Also, the luminescent characteristics were evaluated on the basis of the emission spectrum. The results are shown in Table II-3.

### [Examples II-8 and II-9]

Phosphors were produced in the same way as Example II-7 except that the Si₃N₄s obtained in Examples II-5 and II-6 were used respectively as the silicon nitride used in place of the Si₃N₄ obtained in Example II-3. The X-ray diffraction patterns of the obtained phosphors are shown in Fig. 31. The emission spectral maps thereof under excitation by light of 455-nm wavelength are shown in Fig. 32. Also, the luminescent characteristics were evaluated on the basis of the emission spectrum. The results are shown in Table II-3.

### [Comparative Examples II-24 to II-31]

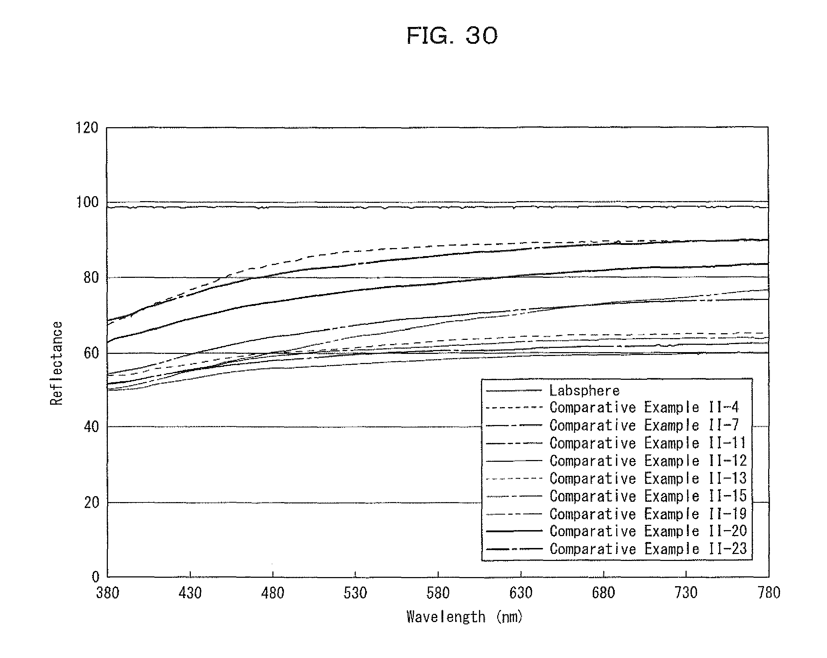

Phosphors were produced in the same way as Example II-7 except that such various kinds of Si₃N₄s that listed in Table II-3 having different kinds of crystal phases or impurity carbon amounts were used respectively, in place of the Si₃N₄ obtained in Example II-3, as the silicon nitride used. X-ray diffraction measurements and emission spectrum measurements were performed on the phosphors. The reflection spectra of the material silicon nitrides are shown in Fig. 30. The X-ray diffraction patterns of the obtained fired products are shown in Fig. 31. The emission spectral maps thereof under excitation by light of 455-nm wavelength are shown in Fig. 32. The luminescent characteristics thereof are shown in Table II-3.

**[Table 22]**

| [Table II-3. Examples II-7 to II-9 and Comparative Examples II-24 to II-31] | | | | | | | | | | | |
|---|---|---|---|---|---|---|---|---|---|---|---|
| | material Si₃N₄ | luminescent characteristics ex. 455 nm | | | | quantum efficiency ex. 455 nm | | | non-luminous object color (L*a*b* colorimetric system) | | |
| | | emission peak wavelength (nm) | emission peak intensity | CIEx | CIEy | internal quantum efficiency | absorption efficiency | external quantum efficiency | L* | a* | b* |
| Example II-7 | Example II-3 | 522 | 70 | 0.267 | 0.646 | 0.82 | 0.71 | 0.58 | 105 | -31 | 51 |
| Example II-8 | Example II-5 | 524 | 58 | 0.273 | 0.642 | 0.76 | 0.66 | 0.50 | 104 | -26 | 44 |
| Example II-9 | Example II-6 | 523 | 64 | 0.271 | 0.644 | 0.81 | 0.67 | 0.54 | 105 | -29 | 47 |
| Comparative Example II-24 | Comparative Example II-4 | 521 | 11 | 0.251 | 0.626 | 0.14 | 0.58 | 0.08 | 76 | -9 | 2 |
| Comparative Example II-25 | Comparative Example II-7 | 523 | 32 | 0.272 | 0.637 | 0.37 | 0.67 | 0.25 | 89 | -17 | 28 |
| Comparative Example II-26 | Comparative Example II-11 | 522 | 35 | 0.268 | 0.637 | 0.48 | 0.59 | 0.28 | 95 | -17 | 29 |
| Comparative Example II-27 | Comparative Example II-12 | 522 | 24 | 0.258 | 0.637 | 0.27 | 0.66 | 0.18 | 84 | -14 | 21 |
| Comparative Example II-28 | Comparative Example II-13 | 522 | 36 | 0.263 | 0.640 | 0.43 | 0.66 | 0.28 | 91 | -19 | 29 |
| Comparative Example II-29 | Comparative 15 Example II-15 | 524 | 43 | 0.271 | 0.639 | 0.53 | 0.63 | 0.33 | 95 | -20 | 32 |
| Comparative Example II-30 | Comparative Example II-19 | 525 | 27 | 0.266 | 0.635 | 0.39 | 0.56 | 0.22 | 92 | -13 | 23 |
| Comparative Example II-31 | Comparative Example II-23 | 525 | 37 | 0.270 | 0.638 | 0.52 | 0.59 | 0.30 | 96 | -17 | 31 |

| | | | | | | | | | | | |
|---|---|---|---|---|---|---|---|---|---|---|---|
| * In the above Table II-3, emission peak intensity is represented by a relative value when letting emission peak intensity of LP-B4 (manufactured by Kasei Optonics, Ltd.) excited by light of 365-nm wavelength be 100. | | | | | | | | | | | |

As can be seen from the X-ray diffraction patterns, the phosphors of Comparative Examples II-24 to II-31 have the same crystal phase as that of the phosphors of Examples II-7 to II-9. On the other hand, the non-luminous object colors of them were darker than those of Examples. Moreover, concerning the luminescent characteristics, they show lower emission efficiencies, such as lower peak heights or lower external quantum efficiencies, than that of Example II-8.

### [Example II-10]

BaCO₃ (manufactured by Hakushin Chemical Laboratory Co., Ltd., purity of 98%), SrCO₃ (manufactured by Hakushin Chemical Laboratory Co., Ltd., purity of 98%), SiO₂ (manufactured by Tatsumori, Ltd., 99.99%), Si₃N₄ obtained in Example II-3, Eu₂O₃ (manufactured by Shin-Etsu Chemical Co., Ltd., purity of 99.99%), and NH₄Cl (manufactured by RARE METALLIC Co., Ltd.) were weighed out to give a charge composition of the phosphor materials of Sr_{0.7}Ba_{0.25}Eu_{0.05}Si₂O₂N₂.

The material powders of the BaCO₃ (2.58 g), SrCO₃ (5.38 g), SiO₂ (1.59 g), and Eu₂O₃ (0.48 g) were all transferred to an agate automatic mortar, and ethanol was added thereto. Then, they were mixed well until they became homogeneous by a wet-type mixing method. The pasty mixture thus obtained was dried, and then tightly filled into an alumina crucible. This was placed in a resistance-heating electric furnace fitted with a temperature regulator and heated, as the primary firing, up to 1200°C at a temperature rising rate of 5.0 °C/min under atmospheric pressure. That temperature was maintained for 3 hours, and then the mixture was allowed to cool to room temperature.

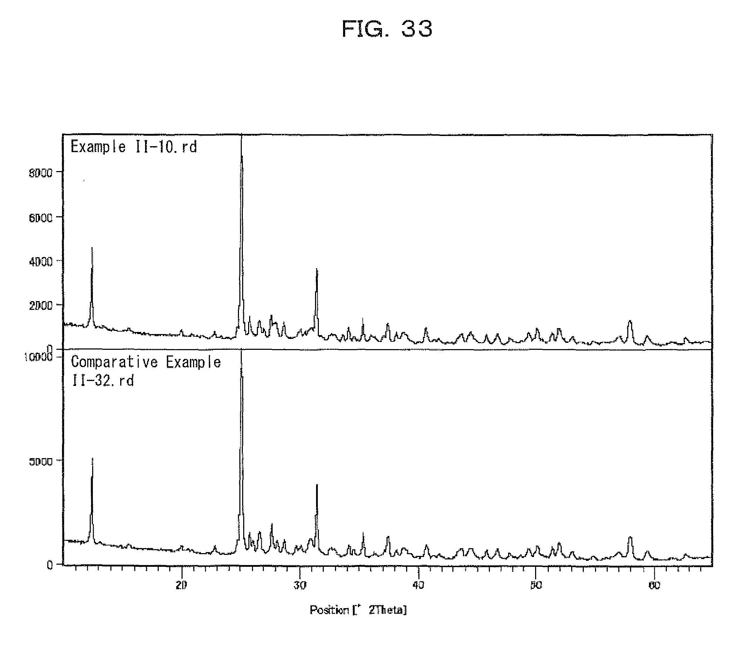

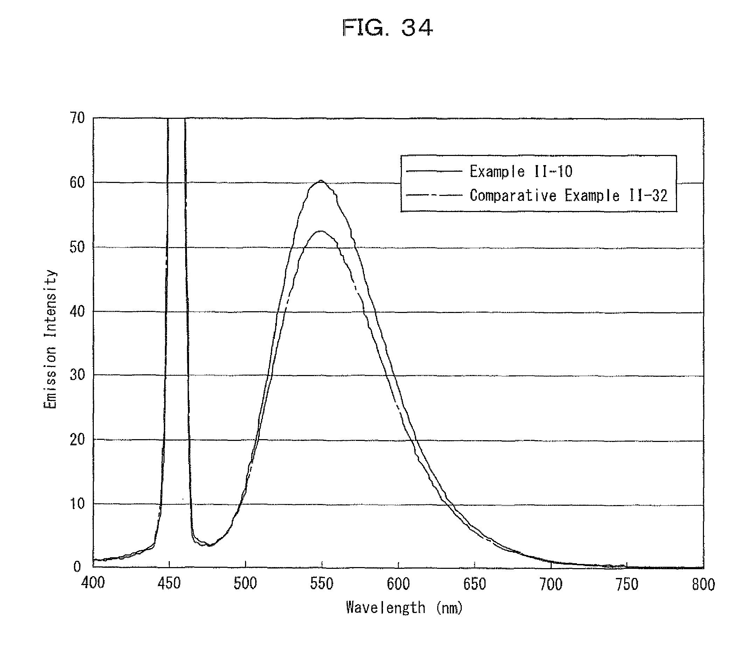

The sample obtained as above, the Si₃N₄ (3.66 g) obtained through a heat treatment in Example II-3, and a flux NH₄Cl (0.08 g) were pulverized and mixed in an alumina mortar. The particles with particle diameters of 250 µm or smaller were isolated by sieving. It was then filled in an alumina crucible tightly. This was placed in a resistance-heating tubular electric furnace fitted with a temperature regulator and heated, as the secondary firing, from room temperature to 800°C at a temperature rising rate of 4.8 °C/minute, then from 800°C to 1430°C at a temperature rising rate of 3.0 °C/min, in a 0.51/minute mixed current of 96 volume % of nitrogen + 4 volute % of hydrogen under atmospheric pressure. The temperature was maintained for 8hours and the product was allowed to cool to room temperature. Then, it was pulverized in an alumina mortar. The X-ray diffraction pattern of the obtained fired product is shown in Fig. 33. The emission spectral map thereof under excitation by light of 455-nm wavelength is shown in Fig. 34.
Also, the luminescent characteristics were evaluated on the basis of the emission spectrum. The results are shown in Table II-4.

### [Comparative Example II-32]

A phosphor was produced in the same way as Example II-10 except that the Si₃N₄ of the above Comparative Example II-23 was used as Si₃N₄. An X-ray diffraction measurement and emission spectrum measurement were performed on the phosphor. The X-ray diffraction pattern is shown in Fig. 33. The emission spectral map under excitation by light of 455-nm wavelength is shown in Fig. 34. The luminescent characteristics are shown in Table II-4.

**[Table 23]**

| [Table II-4. Results of Example II-10 and Comparative Example II-32] | | | | | | | | | | |
|---|---|---|---|---|---|---|---|---|---|---|
| | luminescent characteristics ex. 455 nm | | | | quantum efficiency ex. 455 nm | | | non-luminous object color (L*a*b* colorimetric system) | | |
| | emission peak wavelength (nm) | emission peak intensity | CIEx | CIEy | internal quantum efficiency | absorption efficiency | external quantum efficiency | L* | a* | b* |
| Example II-10 | 549 | 60 | 0.395 | 0.578 | 0.77 | 0.82 | 0.64 | 106 | -25 | 74 |
| Comparative Example II-32 | 549 | 53 | 0.394 | 0.577 | 0.72 | 0.77 | 0.55 | 102 | -22 | 62 |

| | | | | | | | | | | |
|---|---|---|---|---|---|---|---|---|---|---|
| * In the above Table II-4, emission peak intensity is represented by a relative value when letting emission peak intensity of LP-B4 (manufactured by Kasei Optonics, Ltd.) excited by light of 365-nm wavelength be 100. | | | | | | | | | | |

As can be seen from the X-ray diffraction pattern, the phosphor of Comparative Example II-32 has the same crystal phase as that of the phosphor of Example II-10. On the other hand, the neon-luminous object color thereof was darker than that of the Example. Moreover, concerning the luminescent characteristics, it shows lower emission efficiency, such as lower peak height or lower external quantum efficiency, than that of Example II-10.

### [Example II-21]

Phosphor materials were weighed out to give a charge composition of Sr_{0.5525}Ba_{0.2975}Eu_{0.15}Si₂O₂N₂. Namely, phosphor materials SrCO₃ (24.45 g), BaCO₃ (17.60 g), SiO₂ (9.00 g), and Eu₂O₃ (7.91 g) were transferred to an agate automatic mortar, and ethanol was added thereto. Then, they were mixed well until they became homogeneous by a wet-type mixing method. The pasty mixture thus obtained was dried, and then tightly filled into an alumina crucible. This was placed in a resistance-heating tubular electric furnace fitted with a temperature regulator and heated from room temperature to 800°C at a temperature rising rate of 4.8 °C/minute, then from 800°C to 1200°C at a temperature rising rate of 3.0 °C/minute, in a 0.51/main mixed current of 96 volume % of nitrogen + 4 volume % of hydrogen under atmospheric pressure. That temperature was maintained for 6 hours, and then the mixture was allowed to cool to room temperature. The obtained sample was pulverized in an alumina mortar.

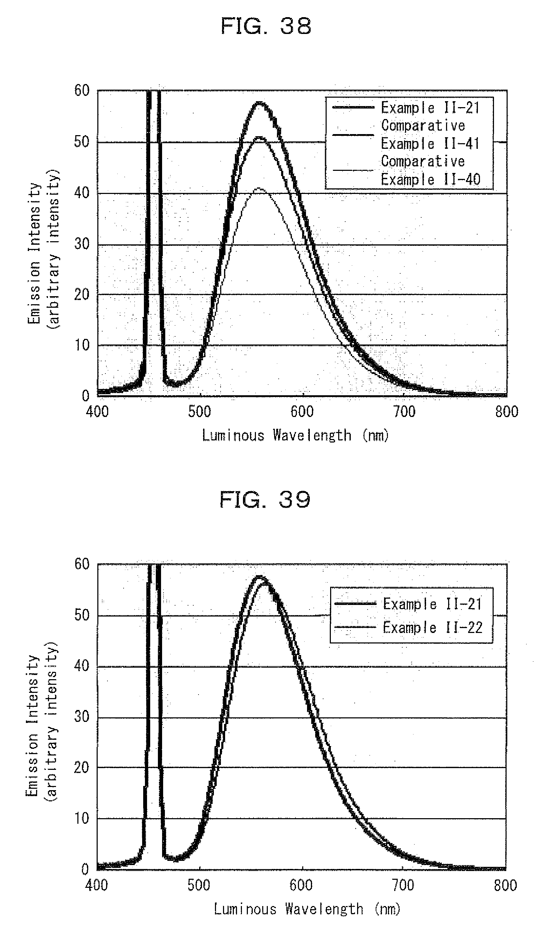

Next, the sample (6.927 g) obtained by the above primary firing, Si₃N₄ (3.07 g) of Example II-3, and NH₄Cl (0.10 g) were transferred to an agate automatic mortar, and ethanol was added thereto. Then, they were mixed well until they became homogeneous by a wet-type mixing method. The pasty mixture thus obtained was dried, and then tightly filled into an alumina crucible. This was placed in a resistance-heating electric furnace fitted with a temperature regulator and heated, as the secondary firing, from room temperature to 800°C at a temperature rising rate of 5.0 °C/minute, then from 800°C to 1500°C at a temperature rising rate of 4.0 °C/zninute, in a 0.51/minute mixed current of 96 volume % of nitrogen + 4 volume % of hydrogen under atmospheric pressure. That temperature was maintained for 6 hours, and then the mixture was allowed to cool to room temperature. The obtained fired product was pulverized in an alumina mortar. The emission spectral map of the obtained fired product under excitation by light of 455-nm wavelength is shown in Fig. 38.
Also, the luminescent characteristics evaluated on the basis of the emission spectrum are shown in Table II-8.

### [Comparative Examples II-40 and II-41]

A mixing and firing were performed in the same way as Example II-21 except that the Si₃N₄ of Example II-21 was changed to the Si₃N₄S of Comparative Examples II-15 and II-23 in Table II-2. The obtained fired product was pulverized in an alumina mortar. The emission spectral map of the obtained fired product under excitation by light of 455-nm wavelength is shown in Fig. 38.
Also, the luminescent characteristics evaluated on the basis of the emission spectrum are shown in Table II-8.

**[Table 24]**

| [Table II-8. Results of Example II-21 and Comparative Examples II-40, II-41] | | | | | | | | | | | |
|---|---|---|---|---|---|---|---|---|---|---|---|
| | material Si₃N₄ | luminescent characteristics | | | | L*a*b* colorimetric system | | | quantum efficiency | | |
| | | emission peak | emission peak | CIEx | CIEy | L* | a* | b* | internal quantum | absorption efficiency | external quantum |
| Example II-21 | Example II-3 | 558 | 57.6 | 0.437 | 0.546 | 102.0 | -19.5 | 86.4 | 0.65 | 0.89 | 0.58 |
| Comparative Example II-40 | Comparative Example II-15 | 558 | 41.0 | 0.433 | 0.547 | 94.8 | -18.3 | 69.1 | 0.47 | 0.86 | 0.41 |
| Comparative Example II-41 | Comparative Example II-23 | 559 | 50.8 | 0.435 | 0.546 | 99.9 | -18.2 | 75.1 | 0.60 | 0.87 | 0.52 |

From the above results, it is evident that the phosphor of Example II-21 has more brilliant non-luminous object color and, concerning luminescent characteristics, higher emission efficiency such as higher peak height and quantum efficiency than those of Comparative Examples II-40 and II-41.

### [Example II-22]

A mixing and firing were performed and the luminescent characteristics and the like were evaluated in the same way as Example II-21 except that the NH₄Cl (0.10 g) of Example II-21 was changed to ZnF₂·4H₂O (0.10 g).
The emission spectral map under excitation by light of 455-nm wavelength is shown in Fig. 39. The luminescent characteristics are shown in Table II-9.

**[Table 25]**

| [Table II-9. Results of Examples II-21 and II-22] | | | | | | | | | | | |
|---|---|---|---|---|---|---|---|---|---|---|---|
| | flux | luminescent characteristics | | | | L*a*b* colorimetric system | | | quantum efficiency | | |
| | | emission peak wavelength (nm) | emission peak intensity | CIEx | CIEy | L* | a* | b* | internal quantum efficiency | absorptio n efficiency | external quantum efficiency |
| Example II-21 | NH₄Cl | 558 | 57.6 | 0.437 | 0.546 | 102.0 | -19.5 | 86.4 | 0.65 | 0.89 | 0.58 |
| Example II-22 | ZnF₂·4H₂O | 563 | 56.2 | 0.456 | 0.530 | 101.3 | -15.5 | 88.2 | 0.63 | 0.91 | 0.58 |

It is evident from the above results that, even when the kind of flux is changed from NH₄Cl to ZnF₂·4H₂O, more of the same performance can be achieved.

### [Examples II-23 to II-25]

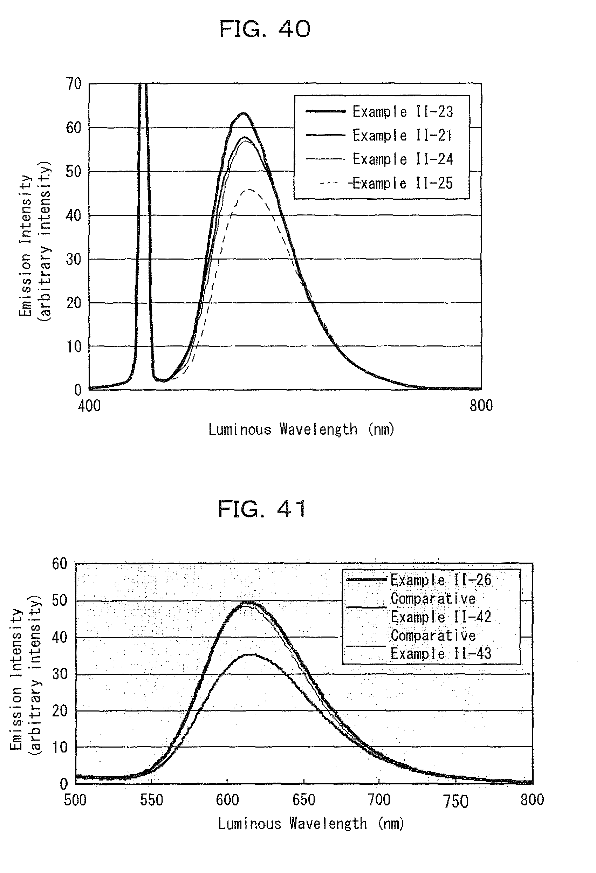

A mixing and firing were performed and the luminescent characteristics and the like were evaluated in the same way as Example 11-21 except that the weighed amount of each phosphor material is changed so that it gave charge compositions according to Table II-10.
The emission spectral maps under excitation by light of 455-nm wavelength are shown in Fig. 40. The luminescent characteristics are shown in Table II-10.

**[Table 26]**

| [Table II-10. Results of Examples II-21, and II-23 to II-25] | | | | | | | | | | | |
|---|---|---|---|---|---|---|---|---|---|---|---|
| | charge composition | luminescent characteristics | | | | L*a*6* colorimetric system | | | quantum efficiency | | |
| | | emission peak wavelength (nm) | emission peak intensity | CIEx | CIEy | L* | a* | b* | internal quantum efficiency | absorption efficiency | external quantum efficiency |
| Example II-23 | Sr_{0.895}Ba_{0.255}Eu_{0.15}Si₂O₂N₂ | 557 | 63.3 | 0.427 | 0.555 | 104.1 | -21.3 | 90.9 | 0.67 | 0.91 | 0.61 |
| Example II-21 | Sr_{0.5525}Ba_{0.2975}Eu_{0.15}Si₂O₂N₂ | 558 | 57.6 | 0.437 | 0.546 | 102.0 | -19.5 | 86.4 | 0.65 | 0.89 | 0.58 |
| Example II-24 | Sr_{0.51}Ba_{0.34}Eu_{0.15}Si₂O₂N₂ | 561 | 57.0 | 0.445 | 0.539 | 102.8 | -17.4 | 88.8 | 0.64 | 0.90 | 0.58 |
| Example II-25 | Sr_{0.4675}Ba_{0.3825}Eu_{0.15}Si₂O₂N₂ | 564 | 46.0 | 0.454 | 0.531 | 100.0 | -14.1 | 79.5 | 0.56 | 0.86 | 0.48 |

### [Example II-11]

Ca₃N₂ (manufactured by CERAC, inc., purity of 99%), AlN (manufactured by TOKUYAMA Corp., purity of 99%), Eu₂O₃ (manufactured by Shin-Etsu Chemical Co., Ltd., purity of 99.99%), and Si₃N₄ obtained in Example II-3 were weighed out to give a charge composition of the phosphor materials of Ca_{0.992}Eu_{0.008}AlSiN₃.

The material powders of the Ca₃N₂ (0.72 g), Si₃N₄ (0.68 g), AlN (0.60 g), and Eu₂O₃ (0.02 g) were transferred to an agate automatic mortar within a glove box filled with nitrogen gas, and they were mixed well until they became homogeneous by a dry-type mixing method. The mixture thus obtained was tightly filled into a boron nitride crucible. This boron nitride crucible was placed in a resistance-heating vacuum pressurized-atmosphere heat-treating furnace (manufactured by Fujidenpa Kogyo Co., Ltd.) and vacuum heated from room temperature to 800°C at a temperature rising rate of 20 °C/minute under a reduced pressure of <5 × 10⁻³ Pa. When the temperature reached 800°C, a high-purity (99.9995%) nitrogen gas was introduced in 30minutes until the pressure reached 0.92 MPa with the temperature maintained. Subsequently, while the pressure is maintained at 0.92 MPa, the temperature was raised further to 1200°C at a temperature rising rate of 20 °C/minute. After that temperature was maintained for 5 minutes, the thermometer was changed from a thermocouple to a radiation thermometer. Then, the temperature was raised again to 1600°C at a temperature rising rate of 20 °C/minute, of which the temperature was maintained for further 2 hours. Then, the temperature was raised further to 1800°C at a temperature rising rate of 20 °C/min, of which the temperature was maintained for further 2 hours. The temperature was lowered to 1200°C at a temperature decreasing rate of 20 °C/min, and then the product was allowed to cool spontaneously. Subsequently, it was pulverized in an alumina mortar. The luminescent characteristics of the obtained fired product evaluated on the basis of the emission spectrum under excitation by light of 455-nm wavelength are shown in Table II-5.

### [Comparative Example II-33]

A phosphor was produced in the same way as Example II-11 except that the silicon nitride of the above Comparative Example II-23 was used as Si₃N₄. The luminescent characteristics of the obtained fired product evaluated on the basis of the emission spectrum under excitation by light of 455-nm wavelength are shown in Table II-5.

### [Example II-12]

Ca₃N₂ (manufactured by CERAC, inc., purity of 99%), Eu₂O₃ (manufactured by Shin-Etsu Chemical Co., Ltd., purity of 99.99%), and Si₃N₄ obtained in Example II-3 were weighed out to give a charge composition of the phosphor materials of Ca_{1.98}Eu_{0.02}Si₅N₈.

The material powders of the Ca₃N₂ (0.59 g), Si₃N₄ (1.40 g), and Eu₂O₃ (0.02 g) were transferred to an agate automatic mortar within a glove box filled with nitrogen gas, and they were mixed well until they became homogeneous by a dry-type mixing method. The mixture thus obtained was tightly filled into a boron nitride crucible. This boron nitride crucible was placed in a resistance-heating vacuum pressurized-atmosphere heat-treating furnace (manufactured by Fujidenpa Kogyo Co., Ltd.) and vacuum heated from room temperature to 800°C at a temperature rising rate of 20 °C/minute under a reduced pressure of <5 × 10⁻³ Pa. When the temperature reached 800°C, a high-purity (99.9995%) nitrogen gas was introduced in 30 minutes, with the temperature maintained, until the pressure reached 0.92 MPa. Subsequently, while the pressure is maintained at 0.92 MPa, the temperature was raised further to 1200°C at a temperature rising rate of 20 °C/minute. After that temperature was maintained for 5 minnutes, the thermometer was changed from a thermocouple to a radiation thermometer. Then, the temperature was raised again to 1600°C at a temperature rising rate of 20 °C/minute, of which the temperature was maintained for further 2 hours. Then, the temperature was raised further to 1800°C at a temperature rising rate of 20 °C/minute, of which the temperature was maintained for further 2 hours. The temperature was lowered to 1200°C at a temperature decreasing rate of 20 °C/minute, and then the product was allowed to cool spontaneously. Subsequently, it was pulverized in an alumina mortar. The luminescent characteristics of the obtained fired product evaluated on the basis of the emission spectrum under excitation by light of 455-nm wavelength are shown in Table II-5.

### [Comparative Example II-34]

A phosphor was produced in the same way as Example II-12 except that the silicon nitride of the above Comparative Example II-23 was used as Si₃N₄. The luminescent characteristics of the obtained fired product evaluated on the basis of the emission spectrum under excitation by light of 455-nm, wavelength are shown in Table II-5.

**[Table 27]**

| [Table II-5. Results of Examples II-11, II-12 and Comparative Examples II-33, II-34] | | | | | | | | | | | |
|---|---|---|---|---|---|---|---|---|---|---|---|
| | phosphor charge composition | luminescent characteristics ex. 455 nm | | | | quantum efficiency ex. 455 nm | | | non-luminous object color (L*a*b* colorimetric system) | | |
| | | emission peak wavelength (nm) | emission peak intensity | CIEx | CIEy | internal quantum efficiency | absorption efficiency | external quantum efficiency | L* | a* | b* |
| Example II-11 | Ca_{0.992}Eu_{0.008}AlSiN3 | 650 | 50 | 0.649 | 0.344 | 0.76 | 0.82 | 0.62 | 81 | 40 | 44 |
| Comparative Example II-33 | Ca_{0.992}Eu_{0.008}AlSiN3 | 647 | 48 | 0.647 | 0.345 | 0.77 | 0.79 | 0.61 | 82 | 37 | 41 |
| Example II-12 | Ca_{1.98}Eu_{0.02}Si5N8 | 605 | 45 | 0.584 | 0.410 | 0.73 | 0.80 | 0.59 | 96 | 21 | 66 |
| Comparative Example II-34 | Ca_{1.98}Eu_{0.02}Si₅N₈ | 607 | 43 | 0.585 | 0.409 | 0.74 | 0.78 | 0.58 | 96 | 22 | 62 |

| | | | | | | | | | | | |
|---|---|---|---|---|---|---|---|---|---|---|---|
| * In the above Table II-5, emission peak intensity is represented by a relative value when letting emission peak intensity of LP-B4 (manufactured by Kasei Optonics, Ltd.) excited by light of 365-nm wavelength be 100. | | | | | | | | | | | |

### [Example II-26]

Phosphor materials SrNH (1.38 g), Si₃N₄ (1.59 g) of Example II-3, and Eu₂O₃ (0.02 g) were weighed out within a glove box filled with nitrogen to give a phosphor-material charge composition of Sr_{1.98}Eu_{0.02}Si₅N₈. They were then mixed well until they became homogeneous in an alumina mortar. The mixed powder thus obtained was tightly filled into a boron nitride crucible. It was heated up to 1400°C under a nitrogen atmosphere at 0.92 MPa, after which the temperature was maintained for 4 hours, followed by allowing to cool it spontaneously. The sample obtained was pulverized in an alumina mortar. It was again heated up to 1600°C under a nitrogen atmosphere at 0.92 MPa, after which the temperature was maintained for 4 hours, followed by allowing to cool it spontaneously. The obtained fired product was pulverized in an alumina mortar. The emission spectral map under excitation by light of 455-nm wavelength is shown in Fig. 41.
Also, the luminescent characteristics evaluated on the basis of the emission spectrum are shown in Table II-11.

### [Comparative Examples II-42 and II-43]

A mixing and firing were performed in the same way as Example II-26 except that the Si₃N₄ of Example II-26 was changed to the Si₃N₄s of Comparative Examples II-15 and II-23 in Table II-2. The obtained fired product was pulverized in an alumina mortar. The emission spectral map of the obtained fired product under excitation by light of 455-nm wavelength is shown in Fig. 41.
Also, the luminescent characteristics evaluated on the basis of the emission spectrum are shown in Table II-11.

**[Table 28]**

| [Table II-11. Results of Example II-26 and Comparative Examples II-42, II-43] | | | | | | | | | | | |
|---|---|---|---|---|---|---|---|---|---|---|---|
| | material Si3N4 | luminescent characteristics | | | | L*a*b* colorimetric system | | | quantum efficiency | | |
| | | emission peak wavelength (nm) | emission peak intensity | CIEx | CIEy | L* | a* | b* | internal quantum efficiency | absorption efficiency | external quantum efficiency |
| Example II-26 | Example II-3 | 612 | 49.5 | 0.602 | 0.388 | 99.2 | 23.7 | 46.6 | 0.86 | 0.62 | 0,54 |
| Comparative Example II-42 | Comparative Example II-15 | 614 | 35.3 | 0.597 | 0.391 | 93.9 | 15.4 | 39.8 | 0.58 | 0.65 | 0.38 |
| Comparative Example II-43 | Comparative Example II-23 | 613 | 48.5 | 0.600 | 0.390 | 99.4 | 22,8 | 44.1 | 0.81 | 0.62 | 0.51 |

### [Example II-27]

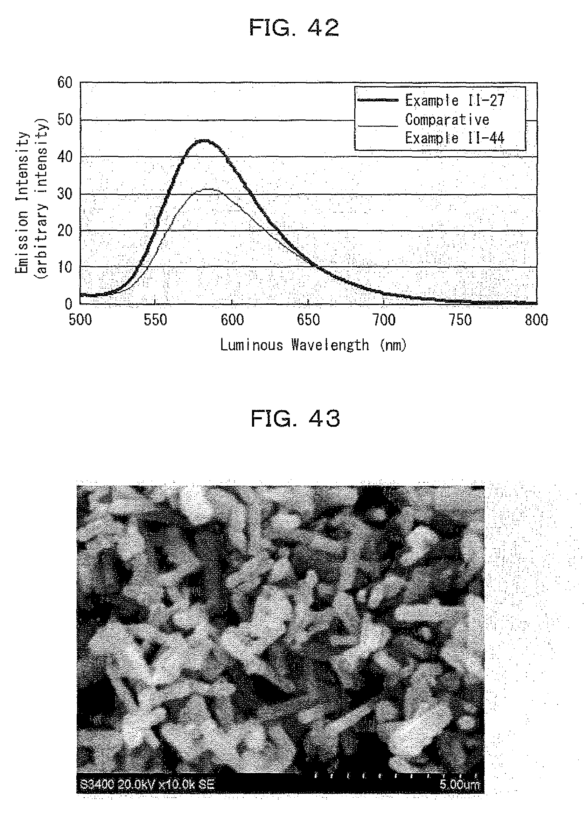

Phosphor materials BaNH (1.60 g), Si₃N₄ (1.37 g) of Example II-3, and Eu₂O₃ (0.02 g) were weighed out within a glove box filled with nitrogen to give a phosphor-material charge composition of Ea_{1.98}Eu_{0.02}Si₅N₈. They were then mixed well until they became homogeneous in an alumina mortar. The mixed powder thus obtained was fired in the same way as Example II-26. The obtained fired product was pulverized in an alumina mortar. The emission spectral map under excitation by light of 455-nm wavelength is shown in Fig. 42.
Also, the luminescent characteristics evaluated on the basis of the emission spectrum are shown in Table TI-12.

### [Comparative Example II-44]

A mixing and firing were performed in the same way as Example II-27 except that the Si₃N₄ of Example II-27 was changed to the Si₃N₄s of Comparative Example II-23 in Table II-2. The obtained fired product was pulverized in an alumina mortar. The emission spectral map of the obtained fired product under excitation by light of 455-nm wavelength is shown in Fig. 42.
Also, the luminescent characteristics evaluated on the basis of the emission spectrum are shown in Table II-12.

**[Table 29]**

| [Table II-12. Results of Example 11-27 and Comparative Example II-44] | | | | | | | | | | | |
|---|---|---|---|---|---|---|---|---|---|---|---|
| | material Si₃N₄ | luminescent characteristics | | | | L*a*b* colorimetric system | | | quantum efficiency | | |
| | | emission peak wavelength | emission peak intensity | CIEx | CIEy | L* | a* | b* | internal quantum efficiency | absorption efficiency | external quantum efficiency |
| Example II-27 | Example II-3 | 582 | 44,5 | 0.519 | 0.470 | 101.1 | 5.0 | 48.6 | 0.69 | 0.65 | 0.45 |
| Comparative Example II-44 | Comparative Example II-23 | 583 | 31.5 | 0.524 | 0.461 | 99.0 | 4.5 | 37.8 | 0.64 | 0.55 | 0.35 |

### [Example II-13]

BaCO₃ (manufactured by Hakushin Chemical Laboratory Co., Ltd., purity of 98%), SiO₂ (manufactured by Tatsumori, Ltd., 99.99%), Eu₂O₃ (manufactured by Shin-Etsu Chemical Co., Ltd., purity of 99.99%), Si₃N₄ obtained in Example II-3, and a flux ZnF_{2·}4H₂O (manufactured by Wako Pure Chemical Industries, Ltd., 99.99%) were weighed out to give a phosphor-material charge composition of Ba_{2.82}Eu_{0.18}Si₉O₁₂N₆.

The material powders of the BaCO₃ (10.83 g), SiO₂ (5.16 g), Eu₂O₃ (0.60 g), Si₃N₄ heated in Example II-3 (4.02 g), and a flux ZnF₂·4H₂O (0.31 g: 1.5 weight % relative to the material mixtures) were all transferred to an agate automatic mortar, and ethanol was added thereto. Then, they were mixed well until they became homogeneous by a wet-type mixing method. The pasty mixture thus obtained was dried, and then tightly filled into an alumina crucible. This was placed in a resistance-heating tubular electric furnace fitted with a temperature regulator and heated, as the primary firing, from room temperature to 800°C at a temperature rising rate of 4.8 °C/ minute, then from 800°C to 1200°C at a temperature rising rate of 3.0 °C/minute, in a 0.51/ minute mixed current of 96 volume % of nitrogen + 4 volume % of hydrogen under atmospheric pressure. That temperature was maintained for 4 hour and then the mixture was allowed to cool to room temperature.

The sample obtained as above was pulverized and mixed in an alumina mortar, and the particles with particle diameters of 50 µm or smaller were isolated by sieving. The sample filled tightly in an alumina crucible was placed in a resistance-heating tubular electric furnace fitted with a temperature regulator and heated, as the secondary firing, from room temperature to 800°C at a temperature rising rate of 4.8 °C/ minute, then from 800°C to 1300°C at a temperature rising rate of 3.0 °C/ minute, in a 0.5l/ minute mixed current of 96 volume % of nitrogen + 4 volume % of hydrogen under atmospheric pressure. That temperature was maintained for 4 hour and then the mixture was allowed to cool to room temperature. The sample obtained as above was pulverized and mixed in an alumina mortar, and the particles with particle diameters of 50 µm or smaller were isolated by sieving.

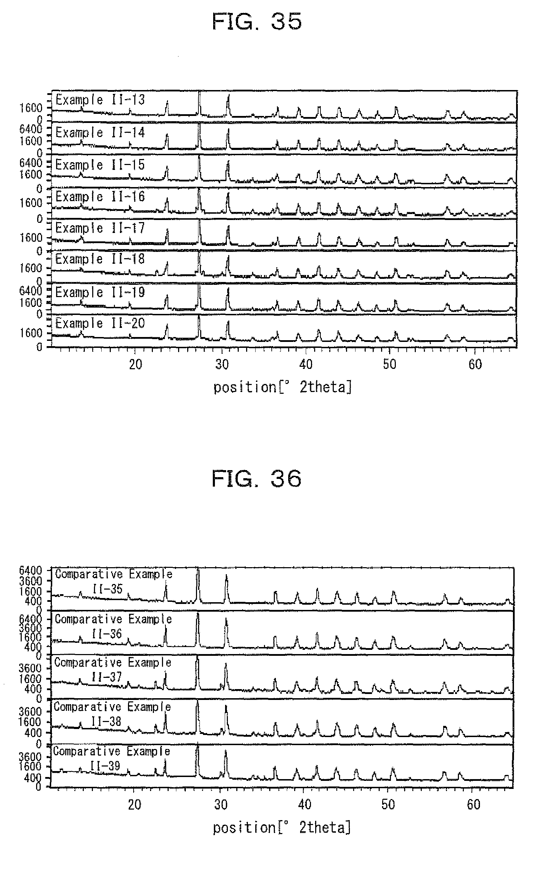

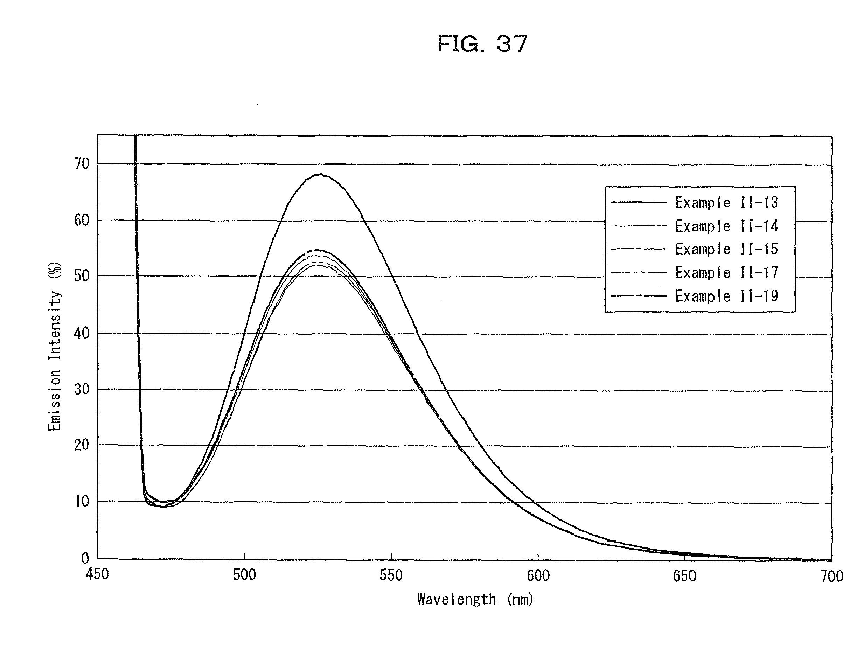

The fired product thrown in 100 ml of 1-N hydrochloric acid was stirred for 30minutes and then left to stand for 2 hours, followed by ejecting the supernatant fluid. A washing was done by adding 100 ml of purified water to the product, stirring for 15 minutes, leaving it to stand for 30 min minutes, and then ejecting the supernatant fluid. After repeating the washings three times, the product was filtered out and dried at 110°C for 12 hours. The X-ray diffraction pattern of the obtained fired product is shown in Fig. 35. The emission spectral map thereof under excitation by light of 455-nm wavelength is shown in Fig. 37.

The above X-ray diffraction pattern has revealed that the fired product obtained in Example II-13 has the same crystal phase as that of Example II-7. Also, the luminescent characteristics were evaluated on the basis of the emission spectrum. The results are shown in Table II-7.

### [Examples II-14 to II-20]

Respective phosphors were prepared in the same way as Example II-13 except that each material charge molar ratio was changed according to Table II-6. The X-ray diffraction patterns of the fired products obtained are shown in Fig. 35. The emission spectral maps of Example II-14, II-15, II-17, and II-19 measured under excitation by light of 455-nm wavelength are shown in Fig. 37. The luminescent characteristics evaluated on the basis of the emission spectra are shown in Table II-7.

**[Table 30]**

| [Table II-6. Charge Composition of Examples II-14 to II-20] | | | | | | | | | |
|---|---|---|---|---|---|---|---|---|---|
| | BaCO₃ | 1/3-Si₃N₄ | SiO₂ | 1/2-Al₂O₃ | 1/2-Eu₂O₃ | 1/2-Gd₂O₃ | 1/2-La₂O₃ | 1/2-Y₂O₃ | ZnF₂-4H₂O (flux) |
| Example II-13 | 2.82 | 4.5 | 4.5 | - | 0.18 | - | - | - | present |
| Example II-14 | 2.82 | 4.5 | 4.5 | - | 0.18 | - | - | - | - |
| Example II-15 | 2.79 | 4.46 | 4.46 | 0.09 | 0.18 | 0.028 | - | - | - |
| Example II-16 | 2.73 | 4.37 | 4.37 | 0.27 | 0.18 | 0.085 | - | - | - |
| Example II-17 | 2.79 | 4.46 | 4.46 | 0.09 | 0.18 | - | 0.028 | - | - |
| Example II-18 | 2.73 | 4.37 | 4.37 | 0.27 | 0.18 | - | 0.085 | - | - |
| Example II-19 | 2.79 | 4.45 | 4.46 | 0.09 | 0.18 | - | - | 0.028 | - |
| Example II-20 | 2.73 | 4.37 | 4.37 | 0.27 | 0.18 | - | - | 0.085 | - |

### [Comparative Examples II-35 to II-39]

Phosphors were produced in the same way as Example II-13, II-14, II-16, II-18, and II-20 except that the silicon nitride of Comparative Example II-4 was used as the material silicon nitride used in place of the Si₃N₄ heated in Example II-3. The X-ray diffraction patterns of the fired products obtained are shown in Fig. 36. The luminescent characteristics thereof evaluated on the basis of the emission spectra under excitation by light of 455-nm wavelength are shown in Table II-7.

**[Table 31]**

| [Table II-7. Results of Examples II-13 to II-20 and Comparative Examples II-35 to II-39] | | | | |
|---|---|---|---|---|
| | luminescent characteristics ex. 455 nm | | | |
| | emission peak wavelength (nm) | emission peak intensity | CIEx | CIEy |
| Example II-13 | 525 | 69 | 0.276 | 0.643 |
| Comparative Example II-35 | 524 | 45 | 0.274 | 0.639 |
| Example II-14 | 525 | 52 | 0.276 | 0.640 |
| Comparative Example II-36 | 526 | 41 | 0.276 | 0.637 |
| Example II-15 | 524 | 54 | 0.272 | 0.642 |
| Example II-16 | 523 | 44 | 0.265 | 0.641 |
| Comparative Example II-37 | 524 | 35 | 0.271 | 0.638 |
| Example II-17 | 525 | 53 | 0.276 | 0.640 |
| Example II-18 | 524 | 43 | 0.276 | 0.638 |
| Comparative Example II-38 | 528 | 30 | 0.287 | 0.632 |
| Example II-19 | 524 | 55 | 0.271 | 0.641 |
| Example II-20 | 523 | 45 | 0.265 | 0.640 |
| Comparative Example II-39 | 525 | 40 | 0.271 | 0.639 |

From the above results, it is evident that the phosphors of the present invention have higher relative peak intensity, relative brightness and emission efficiency than those of phosphors of Comparative Examples. Such advantageous effects are more conspicuous especially for low firing temperature such as 1600°C or lower, particularly 1500°C or lower.

### [Example II-28]

250 g of α-Si₃N₄ (SN-E10, manufactured by Ube Industries, Ltd.) was filled into a boron nitride crucible. This boron nitride crucible was placed in a resistance-heating vacuum pressurized-atmosphere heat-treating furnace (manufactured by Fujidenpa Kogyo Co., Ltd.), which was vacuum heated from room temperature to 800°C at a temperature rising rate of 20 °C/min under a reduced pressure of <5×10⁻³ Pa. When the temperature reached 800°C, a high-purity (99.9995%) nitrogen gas was introduced in 30 minutes until the pressure reached 0.92 MPa with the temperature maintained. Subsequently, while the pressure is maintained at 0.92 MPa, the temperature was raised further to 1200°C at a temperature rising rate of 20 °C/minute. After that temperature was maintained for 5 minutes, the thermometer was changed from a thermocouple to a radiation thermometer. Then, the temperature was raised further to 1800°C at a temperature rising rate of 20 °C/minute, and then to 2000°C at a temperature rising rate of 10 °C/minute, of which the temperature was maintained for 5 hours. The temperature was lowered to 1200°C at a temperature decreasing rate of 20 °C/minute, and then the product was allowed to cool spontaneously. Then, the particles with particle diameters of 250 µm or smaller were isolated by sieving.

The properties of β-Si₃N₄ obtained are shown in Table II-13. The specific surface area of each silicon nitride was measured by a continuous fluidized single-point BET method using an full automatic surface area analyzer (fluxion method) AMS1000A manufactured by OHKURA RIKEN Inc. A photo, which substitutes for a drawing, of the β-Si₃N₄ obtained taken with a scanning electron microscope is shown in Fig. 43.
A phosphor was prepared by using the β-Si₃N₄ obtained as above. Namely, a phosphor was obtained in the same way as Example III-15 described later except that the β-Si₃N₄ obtained as above was used. The properties of the obtained phosphor are shown in Table II-14.

### [Example II-29]

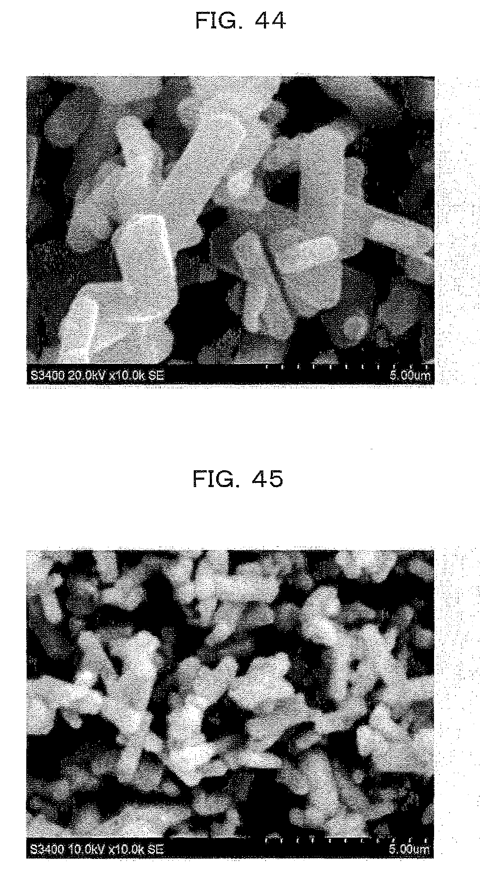

250 g of α-Si₃N₄ (SN-E10, manufactured by Ube Industries, Ltd.) was filled into a boron nitride crucible. This boron nitride crucible was placed in a resistance-heating vacuum pressurized-atmosphere heat-treating furnace (manufactured by Fujidenpa Kogyo Co., Ltd.), which was vacuum heated from room temperature to 800°C at a temperature rising rate of 20 °C/minute under a reduced pressure of <5×10⁻³ Pa. When the temperature reached 800°C, a high-purity (99.9995%) nitrogen gas was introduced in 30minutes until the pressure reached 0.92 MPa with the temperature maintained. However, the system did not become a closed one, and the heating was stopped at 0.84 MPa, followed by allowing spontaneous cooling. Subsequently, the silicon nitride was again subjected to a heat treatment by the same procedure as that of Example II-28, thereby to give β-Si₃N₄. The properties of β-Si₃N₄ obtained are shown in Table II-13. A photo, which substitutes for a drawing, of the β-Si₃N₄ obtained taken with a scanning electron microscope is shown in Fig. 44.

A phosphor was prepared by using the β-Si₃N₄ obtained as above. Namely, a phosphor was obtained in the same way as Example III-15 described later except that the β-Si₃N₄ obtained as above was used. The properties of the obtained phosphor are shown in Table II-14.

**[Table 32]**

| [Table II-13. Characteristics of β-Si₃N₄] | | | | | | | | |
|---|---|---|---|---|---|---|---|---|
| silicon nitride | visually-observed object color | carbon content (weight %) | reflectance | | | | specific surface area (m²/g) | SEM |
| | | | average reflectance (%) | 455 nm (%) | 525 nm (%) | 652 nm (%) | | |
| Example II-28 | white | 0.04 | 94.0 | 92.7 | 94.7 | 95.8 | 3.60 | Fig. 43 |
| Example II-29 | white | 0.04 | 94.0 | 92.1 | 95.1 | 96.5 | 1.30 | Fig. 44 |

**[Table 33]**

| [Table II-14. Characteristics of Phosphors] | | | | | |
|---|---|---|---|---|---|
| | luminescent characteristics | | | | |
| | emission peak wavelengt h (nm) | emission peak intensity | CIEx | CIEy | brightness |
| Example II-28 | 529 | 74.2 | 0.286 | 0.642 | 817.0 |
| Example II-29 | 529 | 81.0 | 0.287 | 0.642 | 893.6 |

It is evident from the above results that brightness of a phosphor tend to be higher when using β-Si₃N₄ with smaller specific surface area.

### [Example II-30; Production of β-silicon nitride by adding silica]

250 g of α-Si₃N₄ (SN-E10, manufactured by Ube Industries, Ltd.) and 15 g of SiO₂ were mixed and stirred sufficiently. The mixture was heated to give β-Si₃N₄ by the same procedure as that of Example II-28 except that the temperature rising rate from 1600°C to 2000°C was set at 5 °C/minute and the retention period was set at 4 hour. By adding silica, which increases oxygen in the raw material, large particles of β-silicon nitride with small specific surface areas were obtained. The properties of β-Si₃N₄ obtained are shown in Table II-15. A photo, which substitutes for a drawing, of the β-Si₃N₄ obtained taken with a canning electron microscope is shown in Fig. 45.

### [Example 11-31] Production of β-silicon nitride by firing in the air

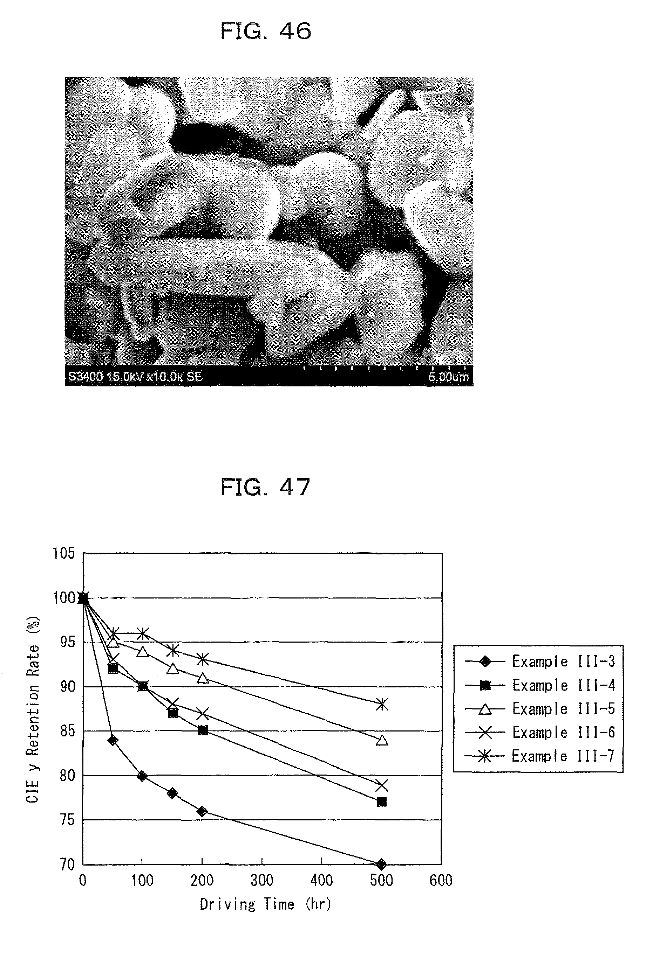

20 g of α-Si₃N₄ (SN-E10, manufactured by Ube Industries, Ltd.) was filled into an alumina crucible. This was placed in a resistance-heating electric furnace fitted with a temperature regulator and heated up to 1150°C at a temperature rising rate of 5 °C/minute in the air under atmospheric pressure. That temperature was maintained for 4 hours, and then the mixture was allowed to cool to room temperature.
This was heated to give β-Si₃N₄ by the same procedure as that of Example 11-28. By a firing process in the air, which increases oxygen in the raw material, large particles of β-silicon nitride with small specific surface areas were obtained. The properties of β-Si₃N₄ obtained are shown in Table II-15. A photo, which substitutes for a drawing, of the β-Si₃N₄ obtained taken with a scanning electron microscope is shown in Fig. 46.

**[Table 34]**

| [Table II-15. Characteristics of β-Si₃N₄] | | | | | | | | |
|---|---|---|---|---|---|---|---|---|
| silicon nitride | visually-observed object color | carbon content (weight %) | reflectance | | | | specific surface area (m²/g) | SEM |
| | | | average reflectance (%) | 455 nm (%) | 525 nm (%) | 650 nm (%) | | |
| Example II-29 | white | 0.04 | 94.0 | 92.1 | 95.1 | 96.5 | 1.3 | Fig. 44 |
| Example II-30 | white | 0.04 | 97.3 | 95.7 | 97.7 | 98.9 | 1.96 | Fig. 45 |
| Example II-31 | white | 0.04 | 90.6 | 87.4 | 92.4 | 94.5 | 0.96 | Fig. 46 |

It is evident from the above results that the specific surface areas of the resultant β-silicon nitride particles become smaller when treating silicon nitride in the presence of a minute amount of oxygen atoms.

### [Example group III: Investigation on production process]

### [Raw materials used]

The same phosphor materials were used as those of the above-mentioned Example group I, unless otherwise specified.

### [Example III-1]

Barium carbide, silica, and europium oxide were mixed to give an atomic ratio of 1.82:3:0.18. The mixture was fired for 5hours at 1100°C in the air to afford (Ba_{0.9}Eu_{0.1})₂Si₃O₈.
To the (Ba_{0.9}Eu_{0.1})₂Si₃O₈ obtained, 0.5 times by mole of Si₃N₄ (mean particle diameter (D₅₀): about 5 µm (after an ultrasonic dispersion) and about 85 µm (before an ultrasonic dispersion), impurity Fe contained: 10 ppm by weight) added and mixed. It was fired at 1220°C for 6hours in an atmosphere furnace under a flow of 4% H_{2/}N₂ (mixed current of 96 volume % of nitrogen + 4 volume % of hydrogen). To the fired product obtained, fluxes of BaF₂ 2 weight % and BaHPO₄ 2 weight % were added. They were fired at 1350°C for 20hours in an atmosphere furnace using a molybdenum crucible under a flow of 4% H₂/N₂. The fired product obtained was crushed in an alumina mortar, followed by sieving out particles of 200 µm in diameter. Thereby, a phosphor was obtained. The results are shown in Table III-1.

### [Example III-2]

A phosphor was obtained in the same way as Example III-1 except that the crucible used for the firing was changed from molybdenum one to alumina one.

**[Table 35]**

| [Table III-1] | | | | | | |
|---|---|---|---|---|---|---|
| | | emission peak wavelength (nm) | emission peak intensity | CIEx | CIEy | brightness |
| Example III-1 | molybdenum crucible | 529 | 85 | 0.286 | 0.641 | 940 |
| Example III-2 | alumina crucible | 529 | 76 | 0.286 | 0.640 | 846 |

### [Example III-3]

BaCO₃, SiO₂ and Eu₂O₃, weighed out according to Table III-2, were mixed by dry-type mixing and then filled into an alumina crucible. This was placed in a resistance-heating electric furnace fitted with a temperature regulator and heated from room temperature to 1200°C at a temperature rising rate of 5 °C/minute under atmospheric pressure. That temperature was maintained for 6 hours, and then the mixture was allowed to cool to room temperature. After pulverizing the fired product removed, Si₃N₄ and a flux of ZnF₂·4H₂O were added thereto in amounts according to Table III-2, and then they were mixed by dry-type mixing. The mixed sample was again filled into an alumina crucible. The alumina crucible was placed in a resistance-heating electric furnace fitted with a temperature regulator and heated from room temperature to 1300°C at a temperature rising rate of 5 °C/ minute in a 0.51/min mixed current of 96 volume % of nitrogen + 4 volume % of hydrogen under atmospheric pressure. That temperature was maintained for 8 hours, and then the product was allowed to cool to room temperature. The fired product obtained was crushed lightly and passed through a 305-mesh nylon sieve. The resultant powder was thrown into 1-N HC1, stirred for 30 minutes, and allowed to stand, followed by ejection of the supernatant fluid (decantation). Subsequently, it was washed with desalted water repeatedly 4 times. After the washings, it was dried for 3hours at 120°C, resulted in affording a phosphor having BSON phase.

**[Table 36]**

| [Table III-2] | | | | | |
|---|---|---|---|---|---|
| | Eu₂O₃ (g) | BaCO₃ (g) | SiO₂ (g) | Si₃N₄ (g) | ZnF₂·4H₂O (g) |
| Example III-3 | 0.34 | 6.02 | 2.87 | 2.23 | 0.15 |

### [Example III-4]

The phosphor obtained in Example III-3, 5 g, was thrown in a water solution in which 1 g of NH₄F was dissolved in 50 cc of water. After stirring it for 10minutes at room temperature, it was subjected to a solid-liquid separation. Then, it was dried at 150°C for 1 hour, thereby affording a phosphor.

### [Example III-5]

A phosphor was obtained in the same way as Example III-4 except that the amount of NH₄F was changed to 5 g.

### [Example III-6]

A phosphor was obtained in the same way as Example III-4 except that the stirring time was changed to 1 hour.

### [Example III-7]

A phosphor was obtained in the same way as Example III-4 except that the amount of NH₄F was changed to 5 g and the stirring time was changed to 1 hour.

Green light emitting devices were produced by the following procedure using respective phosphors of Examples III-3 to III-7. Durability tests were performed on the respective light emitting devices produced. The results are shown in Table III-3 and Fig. 47.

### (Durability test):

Surface-mount type white light emitting devices with a constitution shown in Fig. 2(b) were prepared following the below procedure. Their chromaticity was evaluated by means of the color coordinates (CIEx, CIEy).
The obtained light emitting devices were driven to emit light by energizing its blue LED with current of 20 mA at 25°C. The ratio of CIEy at each energization time, relative to that of just after beginning of the energization (this was set to be 100), was determined as CIEy retention rate.

### (Production method of light emitting device):

A blue light emitting diode (C460 EZ290, manufactured by Cree, Inc.) was used as the first luminous body (22) by being bonded to an electrode (27) disposed at the bottom of the recess in a frame (24) by means of die bonding using silver paste as adhesive. After curing the silver paste by heating at 150°C for 2 hours, the blue LED (22) and the electrode (26) disposed on the frame (24) were bonded together through wire bonding. As the wire, a gold wire with a diameter of 25 µm was used.
A phosphor slurry was prepared by mixing 0.08 g of each phosphor dried at 150°C for 2hours with 1.415 g of a silicone resin (SCR1011, manufactured by Shin-Etsu Chemical Co., Ltd.). A phosphor-containing part (23) was formed by pouring the slurry into the recess of the frame and curing it by heating at 70°C for 1 hour, then at 150°C for 5 hours. A surface-mount green light emitting device was thus produced.

**[Table 37]**

| [Table III-3] | | | | | | |
|---|---|---|---|---|---|---|
| | CIEy retention rate | | | | | |
| | driving time (hr) | | | | | |
| | 0 | 50 | 100 | 150 | 200 | 500 |
| Example III-3 | 100 | 84 | 80 | 78 | 76 | 70 |
| Example III-4 | 100 | 92 | 90 | 87 | 85 | 77 |
| Example III-5 | 100 | 95 | 94 | 92 | 91 | 84 |
| Example III-6 | 100 | 93 | 90 | 88 | 87 | 79 |
| Example III-7 | 100 | 96 | 96 | 94 | 93 | 88 |

### [Example III-8]

Barium carbide, silica, and europium oxide were mixed to give an atomic ratio of 1.82:3:0.18. The mixture was fired for 5hours at 1100°C in the air to afford (Ba_{0.9}Eu_{0.1})₂Si₃O₈.
To the (Ba_{0.9}Eu_{0.1})₂Si₃O₈ obtained, 0.5 times by mole of Si₃N₄ (the aforementioned heat-treated product in N₂ atmosphere of which the mean particle diameter (D₅₀) is about 5 µm (after an ultrasonic dispersion) and about 85 µm (before an ultrasonic dispersion), and the impurity Fe contained is 10 ppm by weight) added and mixed. It was fired at 1220°C for 6hours in an atmosphere furnace under a flow of 4% H₂/N₂ (mixed current of 96 volume % of nitrogen + 4 volume % of hydrogen).
To the fired product obtained, fluxes of BaF₂ 2 weight % and BaHPO₄ 2 weight % were added. They were fired at 1360°C for 9hours in an atmosphere furnace under a flow of 4% H₂/N₂. To the fired product obtained, BaCl₂ 8 weight %, BaHPO₄ 5 weight %, and BaF₂ 1 weight % were added. They were fired at 1220°C for 6hours in an atmosphere furnace under a flow of 4% H₂/N₂. The fired product obtained was crushed, pulverized with a wet-type ball mill in a dispersion medium of water, and washed with dilute hydrochloric acid. Subsequently, by performing further pulverization, classification, washed with water, and drying, a phosphor of which the mean particle diameter (D₅₀) was about 20 µm was prepared. The luminescent characteristics under excitation by light of 455-nm wavelength, quantum efficiency, and non-luminous object color measured are shown in table III-4.

### [Example III-9]

As material Si₃N₄, the Si₃N₄ used in Example III-8 which was subjected to a jet milling pulverization in the air was used. Namely, barium carbide, silica, and europium oxide were mixed to give an atomic ratio of 1.82:3:0.18. The mixture was fired for 5hours at 1100°C in the air to afford (Ba_{0.9}Eu_{0.1})₂Si₃O₈.
To the (Ba_{0.9}Eu_{0.1})₂Si₃O₈ obtained, 0.5 times by mole of Si₃N₄ (mean particle diameter (D₅₀): about 2 µm (after an ultrasonic dispersion) and about 5 µm (before an ultrasonic dispersion), impurity Fe contained: 147 ppm by weight) added and mixed. It was fired at 1220°C for 6hours in an atmosphere furnace under a flow of 4-% H₂/N₂ (mixed current of 96 volume % of nitrogen + 4 volume % of hydrogen).
To the fired product obtained, fluxes of BaF₂ 2 weight % and BaHPO₄ 2 weight % were added. They were fired at 1290°C for 10hours in an atmosphere furnace under a flow of 4% H₂/N₂. The fired product obtained was crushed, and thereby a phosphor of which the mean particle diameter (D₅₀) was about 20 µm was produced. The luminescent characteristics under excitation by light of 455-nm wavelength, quantum efficiency, and non-luminous object color evaluated are shown in table III-4.

### [Example III-10]

A phosphor was obtained in the same way as Example III-9 except that, as material Si₃N₄, the one used in Example III-9 further washed with 2-N hydrochloric acid, washed with water, dehydrated, dried, and sieved (mean particle diameter (D₅₀) : about 2 µm (after an ultrasonic dispersion) and about 3 µm (before an ultrasonic dispersion), impurity Fe contained: 13 ppm by weight) was used. The fired product obtained was crushed, and thereby a phosphor of which the mean particle diameter (D₅₀) was about 22 µm was afforded. The luminescent characteristics under excitation by light of 455-nm wavelength, quantum efficiency, and non-luminous object color evaluated are shown in table III-4.

**[Table 38]**

| [Table III-4] | | | | | | | | | | | | | | |
|---|---|---|---|---|---|---|---|---|---|---|---|---|---|---|
| | Si₃N₄ used | | | various characteristics of phosphor | | | | | | | | | | |
| | particle diameter | | Fe content (ppm by weight) | particle diameter (D50) (µm) | luminescent characteristics ex. 455 nm | | | | quantum efficiency ex. 455 nm | | | non-luminous object color | | |
| | before ultrasonic dispersion (µm) | after ultrasonic dispersion (µm) | | | emission peak wavelength intensity (nm) | emission peak intensity | CIEx | CIEy | internal quantum efficiency (%) | absorption efficiency (%) | external quantum efficiency (%) | L* | a* | b* |
| Example III-8 | 85 | 5 | 10 | 20 | 528 | 73 | 0.286 | 0.641 | 69 | 81 | 56 | 104 | -31 | 44 |
| Example III-9 | 5 | 2 | 147 | 20 | 527 | 56 | 0.284 | 0.638 | 65 | 76 | 50 | 99 | -27 | 38 |
| Example III-10 | 3 | 2 | 13 | 22 | 628 | 60 | 0.288 | 0.639 | 67 | 77 | 51 | 103 | -29 | 43 |

From the above results, it is evident that the object color of the resultant phosphor becomes obscure when using a material silicon nitride of which the Fe content is high due to a jet milling treatment, but the object color can be improved by lowering the Fe content by performing a washing with acid. In addition, a comparison between emission intensities or the like has shown that it is preferable to vary the firing conditions in accordance with the change in particle diameter of the material silicon nitride.

### [Example III-11]

Barium carbide, silica, and europium oxide were mixed to give an atomic ratio of 1.8:3:.2. The mixture was fired for 6hours at 1100°C in the air to afford (Ba_{0.9}Eu_{0.1})₂Si₃O₈. Si₃N₄ was weighed out in an amount 1.8 times (where, Si/Ba = 0.9) the Si/Ba ratio represented by 3(Ba_{0.9}Eu_{0.1})₂Si₃O₈ + Si₃N₄ → 2 (Ea_{0.9}Eu_{0.1})₃Si₆O₁₂N₂ (where, Si/Ba = 0.5).
To this was added fluxes of BaF₂ 2 weight % and BaHPO₄ 2 weight %. Then, they were fired at 1350°C for 8hours in an atmosphere furnace under a flow of 4-% H₂/N₂. To the fired product obtained, fluxes of BaCl₂ 10 weight %, BaHPO₄ 5 weight %, and BaF₂ 2 weight % were added. They were fired at 1170°C for 6hours in an atmosphere furnace under a flow of 4% H₂/N₂. The fired product obtained was crushed, pulverized with a wet-type ball mill in a dispersion medium of water, and washing with dilute hydrochloric acid. Subsequently, by performing further pulverization, classification, washed with water, and drying, a phosphor of which the mean particle diameter (D₅₀) was about 20 µm was prepared. The luminescent characteristics evaluated under excitation by light of 455-nm wavelength are shown in table III-5. In addition, results of an LED durability test performed in the same way as Example III-3 were also shown in Table III-5.

### [Example III-12]

1 g of the phosphor obtained in Example III-11 was placed in a quartz crucible with an inner diameter of 20 mm. Then, it was heated up to 700°C in the air in about 20 minutes, of which the temperature was maintained for 2 hours, followed by cooling to room temperature in 20 minutes. The luminescent characteristics evaluated under excitation by light of 455-nm wavelength are shown in table III-5. In addition, results of an LED durability test performed in the same way as Example III-3 were also shown in Table III-5.

### [Example III-13]

0.5 g of the phosphor obtained in Example III-12 was placed in a quartz cylindrical vessel with an inner diameter of 15 mm and height of about 20 mm, which was then put in a quartz tube with an inner diameter of 25 mm. After replacement of the atmosphere in the tube with argon gas, the temperature was raised from room temperature to 900°C in 2hours allowing 100% hydrogen gas to flow in a rate of 30 ml/min, which temperature was maintained for 2 h. After stopped heating, it was cooled to room temperature in 30minutes with hydrogen allowed to flow, and then the hydrogen was replaced with argon gas. Subsequently, the phosphor was taken out into the air. The luminescent characteristics evaluated under excitation by light of 455-nm wavelength are shown in table III-5. In addition, results of an LED durability test performed in the same way as Example III-3 were also shown in Table III-5.

**[Table 39]**

| [Table III-5] | | | | | | | | | |
|---|---|---|---|---|---|---|---|---|---|
| | luminescent characteristics | | | | | LED driving time (hr) | | | |
| | | | | | | 50 | 100 | 150 | 200 |
| | emission peak wavelengt h (nm) | CIEx | CIEy | emission peak intensity | brightness | CIEy retention rate (%) | | | |
| Example III-11 | 528 | 0.285 | 0.641 | 75 | 818 | 81 | 77 | 74 | 73 |
| Example III-12 | 525 | 0.279 | 0.642 | 51 | 549 | 97 | 96 | 95 | 94 |
| Example III-13 | 527 | 0.283 | 0.641 | 77 | 831 | 95 | 93 | 93 | 93 |

From the above results, it is evident that the durability of the phosphor can be improved by carrying out a refiring (annealing) process.

### [Example III-14]

The phosphor materials were weighed out to give a charge composition of Ba_{2.7}Eu_{0.3}Si_{6.9}O₁₂N_{3.2}. After BaCO₃ (267 g), SiO₂ (136 g) and Eu₂O₃ (26.5 g) were mixed and stirred sufficiently, the mixture was filled in an alumina mortar. This was placed in a resistance-heating tubular electric furnace fitted with a temperature regulator and heated up to 1100°C at a temperature rising rate of 5.0 °C/minute under atmospheric pressure. That temperature was maintained for 5 hours, and then the mixture was allowed to cool to room temperature. The sample obtained was pulverized in an alumina mortar to 100 µm or smaller.

The sample obtained as above (295 g) and a phosphor material, Si₃N₄ (45 g), were mixed and stirred sufficiently. It was filled into an alumina mortar and heated, as the primary firing, up to 1200°C under a 0.51/minute flow of mixed gas including 96 volume % of nitrogen + 4 volume % of hydrogen under atmospheric pressure. That temperature was maintained for 5 hours, and then the product was allowed to cool to room temperature. The fired powder obtained was pulverized in an alumina mortar to 100 µmor smaller.

The fired powder (300 g) obtained in the above primary firing and fluxes, BaF₂ (6 g) and BaHPO₄ (6 g), were mixed and stirred sufficiently. They were filled into an alumina mortar and subjected to a secondary firing up to 1350°C under a 0.51/min flow of mixed gas including 96 volume % of nitrogen + 4 volume % of hydrogen under atmospheric pressure. That temperature was maintained for 8 hours, and then the product was allowed to cool to room temperature. The fired powder obtained was pulverized in an alumina mortar to 100 µm or smaller.

Further, the sample (70 g) obtained in the above secondary firing and fluxes, BaCl₂ (5.6 g) and BaHPO₄ (3.5 g), were mixed and stirred sufficiently. They were filled into an alumina mortar and subjected to a tertiary firing up to 1200°C under a 0.51/min flow of mixed gas including 96 volume % of nitrogen + 4 volume % of hydrogen under atmospheric pressure. That temperature was maintained for 5 hours, and then the product was allowed to cool to room temperature. The fired powder obtained was dispersed by using glass beads to form a slurry. After sieving out particles of 100 µm or smaller, washing treatment was performed. Then, the phosphor particles were subjected to a surface coating treatment by using calcium nitrate water solution and sodium phosphate water solution.

The phosphor obtained, 2 g, placed in a quartz vessel with a diameter of 30 mm was heated up to 700°C in about 40minutes in the air. After the temperature was maintained for 10 minutes, the quartz vessel was taken out from the furnace and placed on a heat-resistant brick, followed by cooling it to room temperature.

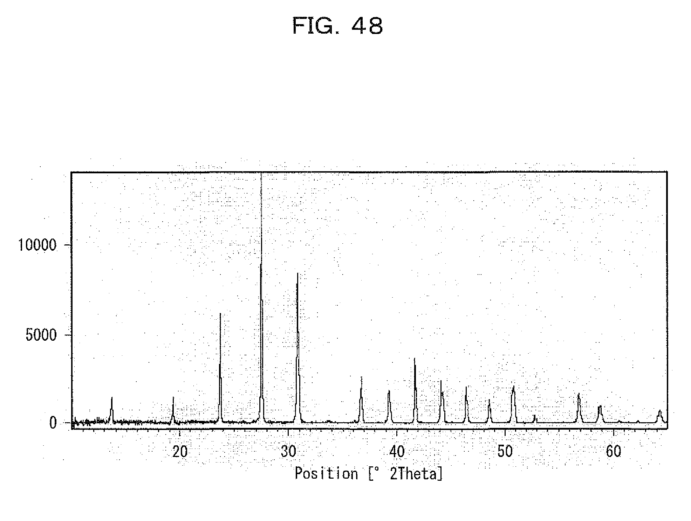

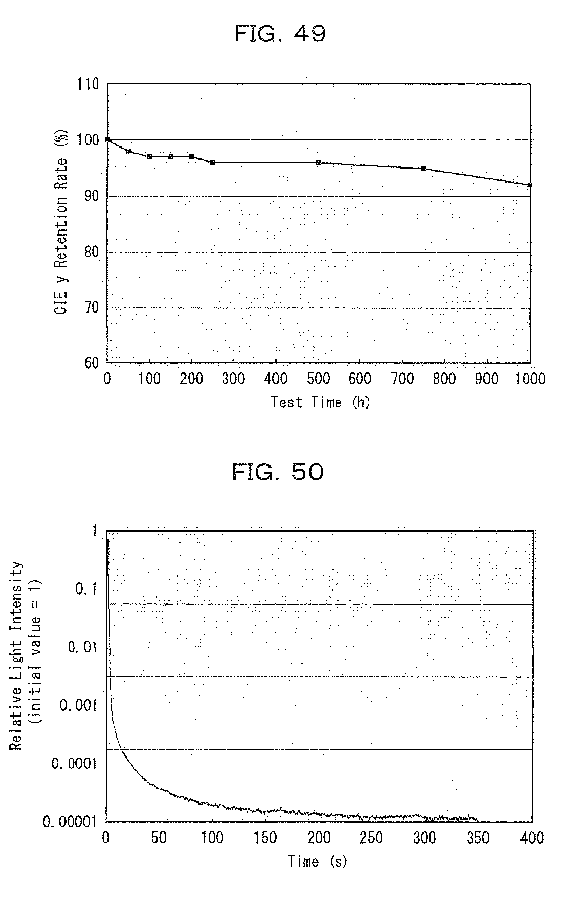

The X-ray diffraction pattern of the fired product obtained is shown in Fig. 48.
In addition, an LED durability test was performed on the obtained phosphor. The result is shown in Fig. 49.
Moreover, a persistence characteristic evaluation was performed on the obtained phosphor. The result is shown in Fig. 50.

From Fig. 48, formation of a BSON crystal phase has been recognized in the phosphor obtained by the present Example. At this point, the ratio of the peak intensity at 2θ of 33.7°, which is a peak originating from an impurity phase, relative to the peak intensity of 27.5° was 0.6%.
Moreover, from Fig. 49, it is evident that the phosphor obtained in the present Example has a significantly excellent durability, of which the value was actually 90% or more even after 1000 hours had passed.
Furthermore, from Fig. 50, the persistence period of the phosphor of the present Example was verified to be very short.

### [Example III-15]

The phosphor materials were weighed out to give a charge composition of Ba_{2.7}Eu_{0.3}Si_{6.9}O₁₂N_{3.2}. After BaCO₃ (293 g), SiO₂ (149 g) and Eu₂O₃ (29 g) were mixed and stirred sufficiently, the mixture was filled in an alumina crucible. This was placed in a resistance-heating tubular electric furnace fitted with a temperature regulator and heated up to 1100°C at a temperature rising rate of 4 °C/minute under atmospheric pressure. That temperature was maintained for 6 hours, and then the mixture was allowed to cool to room temperature. The sample obtained was pulverized in an alumina mortar to 100 µm or smaller.

The sample obtained as above (177 g) and Si₃N₄ (34 g) obtained in the same way as Example III-2 were mixed and stirred sufficiently. It was filled into an alumina crucible and heated, as the primary firing, up to 1170°C under a 31/min flow of mixed gas including 96 volume % of nitrogen + 4 volume % of hydrogen under atmospheric pressure. That temperature was maintained for 6 hours, and then the product was allowed to cool to room temperature. The fired powder obtained was pulverized in an alumina mortar to 100 µm or smaller.

The fired powder (200 g) obtained in the above primary firing and fluxes, BaF₂ (3 g) and BaHPO₄ (6 g), were mixed and stirred sufficiently. They were filled into an alumina crucible with molybdenum lining and subjected to a secondary firing up to 1320°C under a 31/min flow of mixed gas including 96 volume % of nitrogen + 4 volume % of hydrogen under atmospheric pressure. That temperature was maintained for 20 hours, and then the product was allowed to cool to room temperature. The fired powder obtained was pulverized in an alumina mortar to 100 µm or smaller.

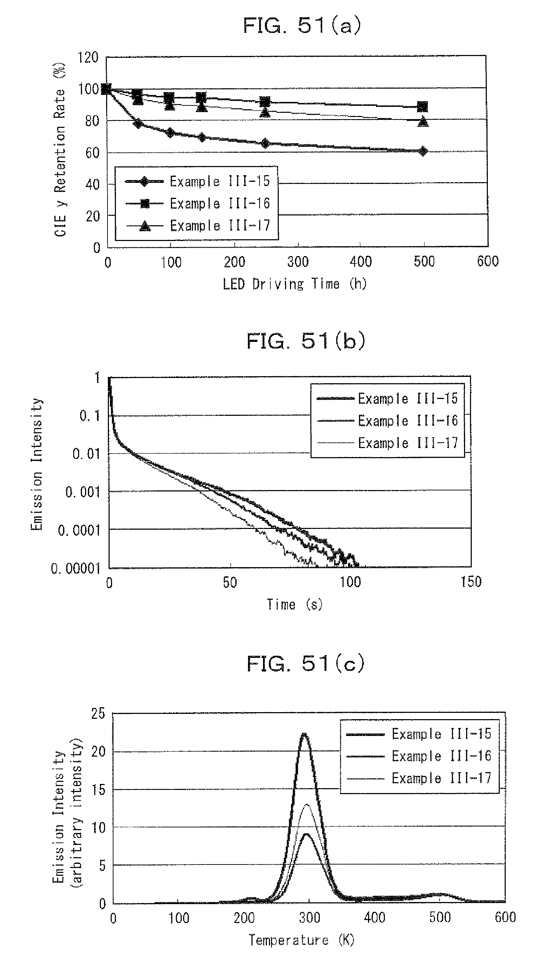

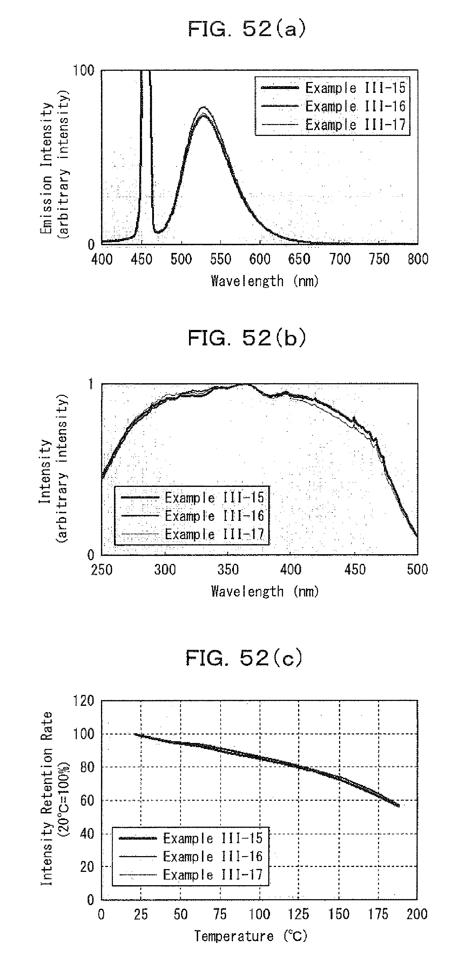

Further, the sample (200 g) obtained in the above secondary firing and fluxes, BaF₂ (4 g), BaCl₂ (20 g) and BaHPO₄ (10 g), were mixed and stirred sufficiently. They were filled into an alumina crucible and subjected to a tertiary firing up to 1170°C under a 31/min flow of mixed gas of 96 volume % of nitrogen + 4 volume % of hydrogen under atmospheric pressure. That temperature was maintained for 6 hours, and then the product was allowed to cool to room temperature. The fired powder obtained was dispersed by using glass beads to form a slurry. After sieving out particles of 60 µm or smaller, washing treatment was performed with 1-N hydrochloric acid. Then, it was dehydrated and dried, followed by sieving out particles with a size of 60 µm or smaller. The measurement results of luminescent characteristics, quantum yields, and temperature quenching characteristics at 100°C of the obtained phosphor are shown in Table III-6. The LED-durability, persistence characteristic, thermoluminescence (normalized by 510K), emission spectrum, excitation spectrum, and temperature characteristics evaluated are shown in Fig. 51(a), Fig. 51(b), Fig. 51(c), Fig. 52(a), Fig. 52(b), and Fig. 52(c), respectively.

### [Example III-16]

10 g of the phosphor obtained in Example III-15 was placed in an alumina boat and heated up to 1000°C under a 0.51/minute flow of mixed gas of 96 volume % of nitrogen + 4 volume % of hydrogen under atmospheric pressure. That temperature was maintained for 10 hours, and then the product was allowed to cool to room temperature. Particles of the fired powder with a size of 60 µm or smaller were sieved out.
The measurement results of luminescent characteristics, quantum yields, and temperature quenching characteristics at 100°C of the obtained phosphor are shown in Table III-6. The LED-durability, persistence characteristic, thermoluminescence (normalized by 510K), emission spectrum, excitation spectrum, and temperature characteristics evaluated are shown in Fig. 51(a), Fig. 51(b), Fig. 51(c), Fig. 52(a), Fig. 52(b), and Fig. 52(c), respectively.

### [Example III-17]

The phosphor (20 g) obtained in the same way as Example III-15 was thrown into an alumina crucible and heated up to 1000°C under a 0.51/minutesflow of mixed gas including 96 volume % of nitrogen + 4 volume % of hydrogen under atmospheric pressure. That temperature was maintained for 10 hours, and then the product was allowed to cool to room temperature. Particles of the fired powder with a size of 60 µm or smaller were sieved out.
The measurement results of luminescent characteristics, quantum yields, and temperature quenching characteristics at 100°C of the obtained phosphor are shown in Table III-6. The LED-durability, persistence characteristic, thermoluminescence (normalized by 510K), emission spectrum, excitation spectrum, and temperature characteristics evaluated are shown in Fig. 51(a), Fig. 51(b), Fig. 51(c), Fig. 52(a), Fig. 52(b), and Fig. 52(c), respectively.

**[Table 40]**

| [Table III-6] | | | | | | | | | | |
|---|---|---|---|---|---|---|---|---|---|---|
| | luminescent characteristics | | | | | quantum yield | | | temperature quenching characteristics | |
| | emission peak wavelength (nm) | emission peak intensity | CIEx | CIEy | brightness *1 | internal quantum efficiency | absorption efficiency | external quantum efficiency | intensity retention rate at 100°C | brightness retention rate at 100°C |
| Example III-15 | 529 | 73.5 | 0.292 | 0.639 | 822.6 | 0.75 | 0.78 | 0.59 | 85 | 86 |
| Example III-16 | 529 | 78.7 | 0.291 | 0.64 | 877.1 | 0.76 | 0.82 | 0.63 | 86 | 87 |
| Example III-17 | 528 | 75.1 | 0.29 | 0.64 | 837.1 | 0.78 | 0.77 | 0.60 | 86 | 87 |

It has been shown that, in phosphors of Examples III-16 and III-17, which were subjected to a reheating (annealing) process, the emission-peak intensity, internal quantum efficiency, temperature quenching property were improved, and the persistence period was shortened. Furthermore, the ratio of CIEy change after a 500h enegization test of the LED device which incorporated the phosphor was as high as 87% in Example III-16, and 79% in Example III-17, compared to 60% of Example III-15, which shows an remarkable improvement in phosphor durability. Also, the result of thermoluminescence evaluation illustrated in Fig. 51(c) has shown that a peak around 300K is significantly lowered by the annealing treatment. This is probably because an annealing treatment can decrease the concentration of crystal defects, which are cause of the grow curve peak around 300K, and therefore the luminescent characteristics and durability of the phosphor were improved.

### [Example III-18]

A phosphor was obtained in the same way as Example III-15 except that the primary firing temperature was changed to 1220°C and the secondary firing temperature to 1300°C in Example III-15.
The phosphor obtained was measured for its impurity elements content with a glow discharge mass spectrometry, VG9000, manufactured by VG. The results are shown in Table III-7.

**[Table 41]**

| [Table III-7] | |
|---|---|
| | ppm by weight |
| Li | 1.5 |
| F | 5 |
| Na | 10 |
| Mg | 0.35 |
| Al | 15 |
| P | 33 |
| S | 1.5 |
| CI | 330 |
| K | <0.5 |
| Ca | 15 |
| Cr | 0.5 |
| Mn | 0.05 |
| Fe | 2.5 |
| Co | 0.33 |
| Ni | 0.75 |
| Cu | <5 |
| Zn | <0.1 |
| Br | <0.1 |
| Sr | 130 |
| Y | <5 |
| Zr | <1 |
| Mo | <20 |
| I | <5 |
| Ce | <0.5 |
| Gd | 0.2 |

### [Comparative Example III-1]

The phosphor materials were weighed out to give a phosphor-material charge composition of Sr_{0.60}Ba_{0.26}Eu_{0.15}Si₂O₂N₂. Namely, phosphor materials SrCo₃ (11.28 g), BaCO₃ (6.46 g), SiO₂ (3.86 g), and Eu₂O₃ (3.39 g) were transferred to an agate automatic mortar and ethanol was added thereto, followed by wet-type mixing until they became homogeneous. The pasty mixture thus obtained was dried, and then tightly filled into an alumina crucible. This was placed in a resistance-heating electric furnace fitted with a temperature regulator and heated from room temperature to 800°C at a temperature rising rate of 5.0 °C/minute, then from 800°C to 1250°C at a temperature rising rate of 4.0 °C/minute, in a 0.51/minutemixed current of 96 volume % of nitrogen + 4 volume % of hydrogen under atmospheric pressure. That temperature was maintained for 3 hours, and then the mixture was allowed to cool to room temperature. The sample obtained was pulverized in an alumina mortar.

Next, the sample (20.18 g) obtained by the above primary firing, Si₃N₄ (9.01 g), and NH₄Cl (0.21 g) were transferred to an agate automatic mortar, and ethanol was added thereto. Then, they were mixed well until they became homogeneous by a wet-type mixing method. The pasty mixture thus obtained was dried, sieved out with a nylon sieve for obtaining particles with a size of 225 µm or smaller, and then tightly filled into an alumina crucible. This was placed in a resistance-heating electric furnace fitted with a temperature regulator and heated, as the secondary firing, from room temperature to 800°C at a temperature rising rate of 5.0 °C/minute, then from 800°C to 1400°C at a temperature rising rate of 4.0 °C/minute, in a mixed current of 96 volume % of nitrogen + 4 volume % of hydrogen under atmospheric pressure. That temperature was maintained for 6 hours, and then the mixture was allowed to cool spontaneously. The sample obtained was pulverized in an alumina mortar, and sieved out with a nylon sieve for obtaining particles with a size of 100 µm or smaller.

### [Example III-19]

The powder of the phosphor obtained in Comparative Example III-1 was placed on an alumina boat with its thickness be 3 mm. This was placed in a resistance-heating electric furnace fitted with a temperature regulator and heated from room temperature to 800°C at a temperature rising rate of 4.8 °C/minute, then from 800°C to 1000°C at a temperature rising rate of 3.0 °C/minute, in a mixed current of 96 volume % of nitrogen + 4 volume % of hydrogen under atmospheric pressure. That temperature was maintained for 10 hours, and then the mixture was allowed to cool spontaneously.

### [Example III-20]

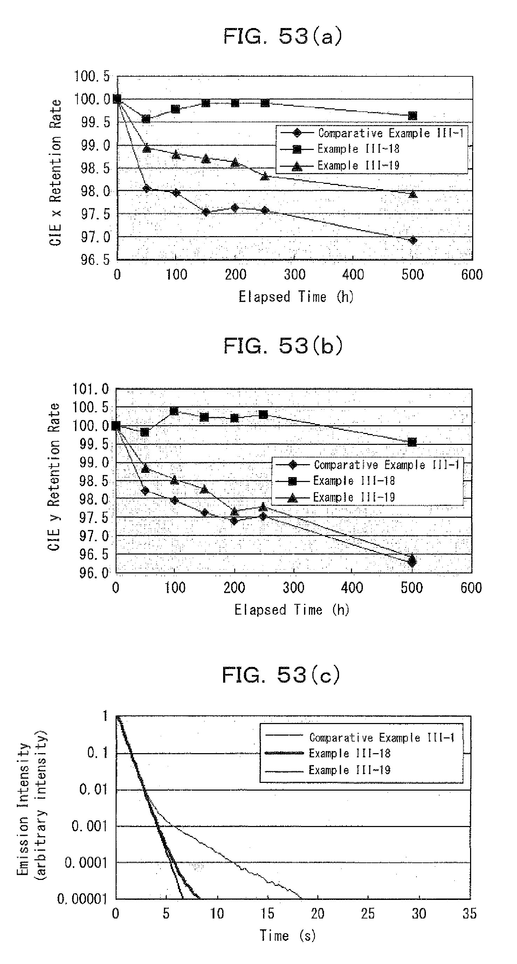

A phosphor was obtained in the same way as Example II-19 except that the heating temperature was changed from 1000°C to 1200°C.
The LED-durability test results of the phosphors of Comparative Example III-1 and Examples III-19 and III-20, performed at a temperature of 85°C and humidity of 85%, are shown in Fig. 53(a) and Fig. 53(b). In these figures showing durabilities evaluated, the values of CIEx retention rate, in addition to CIEy retention rate, are also shown. Also, the measurement and evaluation results of persistence period when irradiated with 254 nm excitation light at a room temperature of 25°C are shown in Fig. 53(c). These results have shown that the durability can be improved and persistence period can be shortened also in SION phosphors such as Sr_{0.60}Ba_{0.26}Eu_{0.15}Si₂O₂N₂ by performing a reheating (annealing) treatment, in the same way as in Examples III-15 to III-17.

### Industrial Applicability

The phosphor of the present invention can be used in any industrial fields, for example, it can be used for light emitting devices. Particularly, the phosphor of the present invention can be preferably used for white light emitting devices because it has usually less reduction in emission efficiency associated with temperature rising than YAG:Ce phosphors, which have been frequently used for white light emitting devices conventionally.
Furthermore, the phosphor of the present invention can be suitably used for heat-resistant materials because it usually has acid stability and high temperature stability.

In addition, the uses of the phosphor, phosphor-containing composition, and light emitting device of the present invention are broad, and for example, they can be used for illuminating devices or displays. Among them, it can be suitably used for high power LED lamps of general illuminating devices, and particularly suitably for white, back-lighting LEDs with high brightness and broad range of color reproduction.

The present invention has been explained in detail above with reference to specific embodiments. However, it is evident to those skilled in the art that various modifications can be added thereto without departing from the intention and the scope of the present invention.
The present application is based on Japanese Patent Application (Patent Application No. 2007-201238) filed on August 1, 2007, Japanese Patent Application (Patent Application No. 2007-201239) filed on August 1, 2007, Japanese Patent Application (Patent Application No. 2007-334882) filed on December 26, 2007, and Japanese Patent Application (Patent Application No. 2008-90396) filed on March 31, 2008, and their entireties are incorporated herewith by reference.

## Claims

1. An oxynitride phosphor represented by the formula [I] which is produced by firing a phosphor precursor in the presence of a flux.
M¹ₓBa_{y}M²_{z}LᵤOᵥN_{w} [I]
(In the above formula [I],
M¹ represents at least one kind of activation element selected from the group consisting of Mn, Ce, Pr, Nd, Sm, Eu, Tb, Dy, Ho, Er, Tm and Yb,
M² represents at least one kind of bivalent metal element selected from the group consisting of Sr, Ca, Mg and Zn,
L represents a metal element selected from the metal elements belonging to the fourth group or the fourteenth group of the periodic table, and
x, y, z, u, v and w are the numeric values in the following ranges:
0.00001≤x≤3
0≤y≤2.99999
2.6≤x+y+z≤3
0<u≤11
6<v≤25
0<w≤17.)

2. An oxynitride phosphor according to claim 1, wherein
u, v and w satisfy 5≤u≤7, 9<v<15 and 0<w<4, respectively, in the above formula [I].

3. An oxynitride phosphor according to claim 1 or claim 2, wherein
x satisfies 0.03≤x≤1.5 in the above formula [I].

4. An oxynitride phosphor according to any one of claims 1 to 3, wherein
z satisfies 0≤z≤1.5 in the above formula [I].

5. An oxynitride phosphor according to any one of claims 1 to 4, wherein
M¹ contains at least Eu and Pr in the above formula [I].

6. An oxynitride phosphor according to any one of claims 1 to 5, wherein
change in the color coordinate CIEy based on JIS Z 8701 of said phosphor that is dispersed in a silicone resin at a concentration of 6 weight %, measured after an energization with a current density of 255 mA/mm² and a light output of 0.25 to 0.35 W/mm² for 500 hr at a temperature of 85°C and relative humidity of 85%, is within the range of ± 30% of the color coordinate CIEy based on JIS Z 8701 of the same phosphor measured before the energization.

7. An oxynitride phosphor according to any one of claims 1 to 6, wherein
silicon nitride present in the phosphor precursor has a crystal phase and said silicon nitride is a crystalline silicon nitride having a reflectance of 85% or larger when irradiated with light of 525-nm wavelength.

8. An oxynitride phosphor represented by the formula [I] below of which the non-luminous object color represented by the L*a*b* colorimetric system satisfies any one of L* value is 97 or larger, a* value is -21 or smaller, and b* value is 35 or larger.
M¹ₓBa_{y}M²_{z}LᵤOᵥN_{w} [I]
(In the above formula [I],
M¹ represents at least one kind of activation element selected from the group consisting of Mn, Ce, Pr, Nd, Sm, Eu, Tb, Dy, Ho, Er, Tm and Yb,
M² represents at least one kind of bivalent metal element selected from the group consisting of Sr, Ca, Mg and Zn,
L represents a metal element selected from the metal elements belonging to the fourth group or the fourteenth group of the periodic table, at least a part of L being Si element, and
x, y, z, u, v and w are the numeric values in the following ranges:
0.00001≤x≤3
0≤y≤2.99999
2.6≤x+y+z≤3
0<u≤11
6<v≤25
0<w≤17.)

9. An oxynitride phosphor represented by the formula [I] below of which the external quantum efficiency is 0.35 or larger.
M¹ₓBa_{y}M²_{z}LᵤOᵥN_{w} [I]
(In the above formula [I],
M¹ represents at least one kind of activation element selected from the group consisting of Mn, Ce, Pr, Nd, Sm, Eu, Tb, Dy, Ho, Er, Tm and Yb,
M² represents at least one kind of bivalent metal element selected from the group consisting of Sr, Ca, Mg and Zn,
L represents a metal element selected from the metal elements belonging to the fourth group or the fourteenth group of the periodic table, at least a part of L being Si element, and
x, y, z, u, v and w are the numeric values in the following ranges:
0.00001≤x≤3
0≤y≤2.99999
2.6≤x+y+z≤3
0<u≤11
6<v≤25
0<w≤17.)

10. A production method of an oxynitride phosphor according to any one of claims 1 to 9 comprising steps of:
a fusing process in which the phosphor precursor is fused; and
a cooling process in which phosphor crystal is obtained by cooling the fused phosphor precursor.

11. A production method of an oxynitride phosphor according to any one of claims 1 to 9 comprising steps of:
a first firing process in which the phosphor precursor is fired;
a washing process in which washing is performed after the first firing process; and
a second firing process in which firing is performed after the washing process.

12. An oxynitride phosphor produced through a reheating process performed after a process in which a phosphor precursor is fired in the presence of a flux.

13. An oxynitride phosphor according to claim 12, wherein
said oxynitride phosphor is a phosphor selected from the group consisting of nitrido-silicate, nitride-aluminosilicate, oxonitrido-silicate, oxonitrido-aluminosilicate, and carbonitrido-aluminosilicate.

14. A production method of an oxynitride phosphor comprising a step of a reheating process after a process in which a phosphor precursor is fired in the presence of a flux.

15. A crystalline silicon nitride having a crystal phase and a reflectance of 85% or larger when irradiated with light of 525-nm wavelength.

16. A crystalline silicon nitride according to claim 15 wherein
the impurity carbon amount of said crystalline silicon nitride is 0.06 weight % or smaller.

17. A crystalline silicon nitride according to claim 15 or claim 16 wherein
the crystal phase of said crystalline silicon nitride is a β type.

18. A production method of an crystalline silicon nitride comprising a step of heat treatment of silicon nitride under an atmosphere containing nitrogen gas in which N₂ partial pressure is 0.4 MPa or higher at a temperature of 1500°C or higher.

19. A production method of an crystalline silicon nitride according to claim 18 wherein
the silicon nitride is preliminarily subjected to a heat treatment under an atmosphere containing oxygen gas in which O₂ partial pressure is 0.01 MPa or higher at a temperature of 800°C to 1300°C.

20. A production method of an crystalline silicon nitride according to claim 18 wherein
the heat treatment is performed in the presence of SiO₂.

21. A phosphor produced by using, as its raw material, a crystalline silicon nitride according to any one of claims 15 to 20.

22. A phosphor according to claim 21 wherein
said phosphor is a phosphor selected from the group consisting of nitrido-silicate, nitrido-aluminosilicate, oxonitrido-silicate, oxonitrido-aluminosilicate, and carbonitrido-aluminosilicate.

23. A phosphor represented by the formula [II] below of which the non-luminous object color represented by the L*a*b*colorimetric system satisfies any one of L* value is 103 or larger, a* value is -23 or smaller, and b* value is 63 or larger.
M³ₑ(Ca,Sr,Ba)₁₋ₑSi₂O₂N₂ [II]
(In the above formula [II],
M³ represents an activation element and
e represents a positive number satisfying 0<e≤0.2.)

24. A phosphor according to claim 23 represented by the formula [II'] below of which the emission-peak wavelength is 550 nm to 570 nm and the L* value is 100 or larger and b* value is 77 or larger.
M³ₑ(Sr,Ba)₁₋ₑSi₂O₂N₂ [II']
(In the above formula [III'],
M³ represents an activation element and
e represents a positive number satisfying 0<e≤0.2.)

25. A phosphor represented by the formula [II] below of which the external quantum efficiency is 0.57 or larger.
M³ₑ(Ca,Sr,Ba)₁₋ₑSi₂O₂N₂ [II]
(In the above formula [II],
M³ represents an activation element and
e represents a positive number satisfying 0<e≤0.2.)

26. A phosphor-containing composition comprising:
said phosphor according to any one of claims 1 to 9, 12, 13, and 21 to 25 and
a liquid medium.

27. A light emitting device comprising: a first luminous body and a second luminous body which emits visible light when irradiated with light from said first luminous body, wherein
said second luminous body comprises, as a first phosphor, at least one kind of said phosphor according to any one of claims 1 to 9, 12, 13, and 21 to 25.

28. A light emitting device according to claim 27, wherein
said second luminous body comprises, as a second phosphor, one or more kinds of phosphors of which emission-peak wavelength is different from that of said first phosphor.

29. A illuminating device comprising a light emitting device according to claim 27 or 28.

30. An display comprising a light emitting device according to claim 27 or 28.
